# EUROPÄISCHE PATENTSCHRIFT

(11) **EP 2 356 372 B1**
(45) Veröffentlichungstag und Bekanntmachung des Hinweises auf die Patenterteilung: **10.08.2016**
(21) Anmeldenummer: 09810763.4
(22) Anmeldetag: 09.12.2009
(51) Int. Cl.: B60Q 7/00, B60Q 3/06, H05B 33/22, F21S 10/02, G04C 19/02, G04G 11/00, B05B 1/18, F21S 8/04, F21S 9/03

(54) **ORGANISCHE LEUCHTDIODE UND BELEUCHTUNGSMITTEL**
ORGANIC LIGHT-EMITTING DIODE AND LUMINAIRE
DIODE ÉLECTROLUMINESCENTE ORGANIQUE ET MOYEN D'ÉCLAIRAGE

(30) Priorität: 11.12.2008 DE 102008061563
(43) Veröffentlichungstag der Anmeldung: 17.08.2011
(73) Patentinhaber: OSRAM OLED GmbH, 93049 Regensburg (DE)
(72) Erfinder: KASTNER-JUNG, Ulrich, 81247 München (DE); KLEIN, Markus, 93105 Tegernheim (DE); MAES, Stan, 3650 Dilsen - Stokkem (BE); SIGL, Romana, 5020 Salzburg (AT); HAID, Annette, 88316 Isny/Beuren (DE); LINTNER, Stephan, 5026 Salzburg (AT); HERGET, Julian, 83487 Marktschellenberg (DE); MATJAN, Gregor, 5101 Bergheim (AT)
(74) Vertreter: Epping - Hermann - Fischer
(86) Internationale Anmeldenummer: PCT/DE2009/001741
(87) Internationale Veröffentlichungsnummer: WO 2010/066245

(56) Entgegenhaltungen:
- WO-A1-2008/110959
- WO-A1-2008/146232
- DE-A1-102006 037 222
- JP-A- 2007 294 143
- US-A- 5 895 228
- US-A1- 2001 052 752
- US-A1- 2002 167 270
- US-A1- 2003 064 540
- US-A1- 2003 231 495
- US-A1- 2007 278 937
- US-A1- 2008 219 013
- US-B1- 6 236 622
- US-B1- 7 280 439

## Beschreibung

Es werden organische Leuchtdioden sowie Beleuchtungsmittel angegeben.

Eine zu lösende Aufgabe besteht darin, organische Leuchtdioden anzugeben, die besonders vielseitig einsetzbar sind. Eine weitere zu lösende Aufgabe besteht darin, Beleuchtungsmittel anzugeben, die solche organische Leuchtdioden als Lichtquelle enthalten.

Bei den im Folgenden beschriebenen organischen Leuchtdioden kann es sich beispielsweise um transparente, beidseitig emittierende, weißes Licht emittierende, farbiges Licht emittierende, Infrarotstrahlung emittierende, diffus Licht emittierende, starre, flexible und/oder gerichtete Strahlung emittierende organische Leuchtdioden handeln. Bei den Beleuchtungsmitteln kann es sich beispielsweise um Beleuchtungsmittel handeln, die als Wecker Verwendung finden, die den Teil einer Duschkabine bilden, die den Teil eines Duschkopfes bilden, die als Sonnenschutz dienen, die als Regenschutz dienen, die zur Allgemeinbeleuchtung vorgesehen sind, die mobil einsetzbar sind und/oder die mehrere dieser Funktionen in sich vereinen.

Die Erfindung wird durch die Ansprüche definiert und bezieht sich auf ein Beleuchtungsmittel mit Weckfunktion. Bekannte Beleuchtungsvorrichtungen mit Weckfunktion sind zum Beispiel in den Dokumenten US7280439 B1, US003/0231495 und US6236622 B1 offenbart.

Im Folgenden werden Ausführungsformen von hier beschriebenen organischen Leuchtdioden aufgeführt. Die Ausführungsformen der organischen Leuchtdioden sind dabei untereinander beliebig kombinierbar.

Gemäß zumindest einer Ausführungsform einer hier beschriebenen organischen Leuchtdiode umfasst die organische Leuchtdiode einen strahlungsemittierenden Bereich, in dem im Betrieb der organischen Leuchtdiode elektromagnetische Strahlung erzeugt wird.

Gemäß zumindest einer Ausführungsform einer hier beschriebenen organischen Leuchtdiode wird von der organischen Leuchtdiode im Betrieb elektromagnetische Strahlung im Spektralbereich von Infrarotstrahlung bis UV-Strahlung erzeugt.

Gemäß zumindest einer Ausführungsform einer hier beschriebenen organischen Leuchtdiode wird im Betrieb der organischen Leuchtdiode von der organischen Leuchtdiode Infrarotstrahlung emittiert.

Gemäß zumindest einer Ausführungsform einer hier beschriebenen organischen Leuchtdiode wird im Betrieb der organischen Leuchtdiode von der organischen Leuchtdiode farbiges Licht emittiert.

Gemäß zumindest einer Ausführungsform einer hier beschriebenen organischen Leuchtdiode wird im Betrieb der organischen Leuchtdiode von der organischen Leuchtdiode weißes Licht emittiert.

Gemäß zumindest einer Ausführungsform einer hier beschriebenen organischen Leuchtdiode umfasst die organische Leuchtdiode zumindest eine erste Ladungsträgertransportschicht und zumindest eine zweite Ladungsträgertransportschicht. Beispielsweise umfasst die organische Leuchtdiode eine Lochtransportschicht sowie eine Elektronentransportschicht als Ladungsträgertransportschichten.

Gemäß zumindest einer Ausführungsform einer hier beschriebenen organischen Leuchtdiode umfasst eine Lochtransportschicht der organischen Leuchtdiode ein Matrixmaterial, das p-dotiert ist.

Gemäß zumindest einer Ausführungsform einer hier beschriebenen organischen Leuchtdiode umfasst eine Elektronentransportschicht der organischen Leuchtdiode ein Matrixmaterial, das n-dotiert ist.

Gemäß zumindest einer Ausführungsform einer hier beschriebenen organischen Leuchtdiode umfasst eine Lochtransportschicht der organischen Leuchtdiode ein Matrixmaterial sowie einen p-Dotierstoff, der Lewis-Säure-Charakter hat oder eine Lewis-Säure ist.

Gemäß zumindest einer Ausführungsform einer hier beschriebenen organischen Leuchtdiode ist das Matrixmaterial und der Dotierstoff zumindest einer Ladungsträgertransportschicht der organischen Leuchtdiode derart gewählt, dass die organische Leuchtdiode im ausgeschalteten Betriebszustand einen vorbestimmten Farbeindruck erweckt. Das heißt, durch geeignete Wahl von Matrixmaterial und Dotierstoff erscheint die organische Leuchtdiode im ausgeschalteten Zustand beispielsweise transparent, bläulich, rötlich, grünlich oder in einer anderen Farbe. Darüber hinaus ist es möglich, dass die organische Leuchtdiode im ausgeschalteten Zustand weiß erscheint. Ferner kann die organische Leuchtdiode von unterschiedlichen Seiten betrachtet in unterschiedlichen Farben erscheinen.

Gemäß zumindest einer Ausführungsform einer hier beschriebenen organischen Leuchtdiode weist die organische Leuchtdiode eine Lochtransportschicht auf, die ein Matrixmaterial und einen Dotierstoff umfasst, die einen Charge-Transfer-Komplex bilden. Der Charge-Transfer-Komplex weist dabei ein erstes Absorptionsspektrum auf. Die Lochtransportschicht weist dabei im ausgeschalteten Betriebszustand der organischen Leuchtdiode einen vorbestimmten Farbeindruck auf.

Gemäß zumindest einer Ausführungsform der organischen Leuchtdiode umfasst die organische Leuchtdiode zumindest eine erste Elektrode und zumindest eine zweite Elektrode.

Gemäß zumindest einer Ausführungsform der organischen Leuchtdiode umfasst die organische Leuchtdiode zumindest eine transparente Elektrode.

Gemäß zumindest einer Ausführungsform einer hier beschriebenen organischen Leuchtdiode ist die transparente Elektrode mit einem transparenten leitfähigen Oxid (TCO) gebildet.

Gemäß zumindest einer Ausführungsform einer hier beschriebenen organischen Leuchtdiode ist die transparente Elektrode mit einer dünnen, transparenten Metallschicht gebildet.

Gemäß zumindest einer Ausführungsform einer hier beschriebenen organischen Leuchtdiode ist die transparente Elektrode mit einem transparenten leitfähigen Oxid (TCO) und einer dünnen, transparenten Metallschicht gebildet.

Gemäß zumindest einer Ausführungsform einer hier beschriebenen organischen Leuchtdiode ist die transparente Elektrode mit einer dünnen, transparenten Metallschicht gebildet, die eine Dicke von wenigstens 1 nm und höchstens 50 nm aufweist.

Gemäß zumindest einer Ausführungsform einer hier beschriebenen organischen Leuchtdiode ist zumindest eine Elektrode der organischen Leuchtdiode reflektierend ausgestaltet.

Gemäß zumindest einer Ausführungsform einer hier beschriebenen organischen Leuchtdiode beträgt die Reflektivität zumindest einer Elektrode der organischen Leuchtdiode wenigstens 80 %, besonders bevorzugt wenigstens 90 %. Die Reflektivität weist diese hohen Werte vorzugsweise zumindest für in der organischen Leuchtdiode im Betrieb erzeugte elektromagnetische Strahlung auf.

Gemäß zumindest einer Ausführungsform einer hier beschriebenen organischen Leuchtdiode weist die organische Leuchtdiode eine Elektrode auf, die auf einer einem strahlungsemittierenden Bereich der organischen Leuchtdiode zugewandten Seite eine Schicht umfasst, die LiF enthält. Vorzugsweise handelt es sich bei der Elektrode dann um eine Kathode. Beispielsweise steht die Elektrode in direktem Kontakt mit der Schicht, die LiF enthält. Zum Beispiel bedeckt diese Schicht, die LiF enthält, die Elektrode an einer Hauptfläche gänzlich, steht in direktem Kontakt mit der Elektrode und besteht aus LiF.

Gemäß zumindest einer Ausführungsform einer hier beschriebenen organischen Leuchtdiode umfasst die organische Leuchtdiode einen strahlungsemittierenden Bereich, der zumindest eine Emissionsschicht umfasst, die ein organisches Material enthält. Im Betrieb der organischen Leuchtdiode wird in der zumindest einen Emissionsschicht elektromagnetische Strahlung erzeugt.

Gemäß zumindest einer Ausführungsform einer hier beschriebenen organischen Leuchtdiode umfasst ein strahlungsemittierender Bereich der organischen Leuchtdiode zumindest zwei Emissionsschichten, die im Betrieb elektromagnetische Strahlung unterschiedlicher oder der gleichen Wellenlängenbereiche emittieren. Beispielsweise ist es möglich, dass eine Emissionsschicht im strahlungsemittierenden Bereich im Betrieb der organischen Leuchtdiode farbiges Licht emittiert. Die andere Emissionsschicht kann dazu eingerichtet sein, Infrarotstrahlung zu emittieren. Darüber hinaus ist es möglich, dass sämtliche Emissionsschichten des strahlungsemittierenden Bereichs farbiges Licht emittieren. Dabei können unterschiedliche Emissionsschichten Licht unterschiedlicher Farbe emittieren, das sich für einen externen Betrachter zu Mischlicht, zum Beispiel zu weißem Mischlicht, mischt.

Gemäß zumindest einer Ausführungsform einer hier beschriebenen organischen Leuchtdiode umfasst die Leuchtdiode in einem strahlungsemittierenden Bereich zumindest eine Emissionsschicht, die geeignet ist, Licht aus dem Spektralbereich für infrarotes Licht zu emittieren.

Gemäß zumindest einer Ausführungsform einer hier beschriebenen organischen Leuchtdiode umfasst die Leuchtdiode in einem strahlungsemittierenden Bereich zumindest eine Emissionsschicht, die geeignet ist, Licht aus dem Spektralbereich für rotes Licht zu emittieren.

Gemäß zumindest einer Ausführungsform einer hier beschriebenen organischen Leuchtdiode umfasst die Leuchtdiode in einem strahlungsemittierenden Bereich zumindest eine Emissionsschicht, die geeignet ist, Licht aus dem Spektralbereich für blaues Licht zu emittieren.

Gemäß zumindest einer Ausführungsform einer hier beschriebenen organischen Leuchtdiode umfasst die Leuchtdiode in einem strahlungsemittierenden Bereich zumindest eine Emissionsschicht, die geeignet ist, Licht aus dem Spektralbereich für grünes Licht zu emittieren.

Gemäß zumindest einer Ausführungsform einer hier beschriebenen organischen Leuchtdiode umfasst die organische Leuchtdiode eine erste Emissionsschicht im strahlungsemittierenden Bereich, die rotes Licht emittiert, eine zweite Emissionsschicht, die grünes Licht emittiert sowie eine dritte Emissionsschicht, die blaues Licht emittiert.

Die Emissionsschichten können dabei im strahlungsemittierenden Bereich der organischen Leuchtdiode zu einem Schichtenstapel angeordnet sein. Die der Anode zugewandte Emissionsschicht enthält beispielsweise ein Matrixmaterial, das geeignet ist, Löcher zu transportieren. In das Matrixmaterial ist dann das Emittermaterial eingebracht.

Die einer Kathode der organischen Leuchtdiode zugewandte Emissionsschicht enthält dann vorzugsweise ein Matrixmaterial, das geeignet ist, Elektronen zu transportieren, in welches das Emittermaterial eingebracht ist.

Die Emissionsschicht, die zwischen den beiden anderen Emissionsschichten angeordnet ist, enthält dann vorzugsweise sowohl ein Material, das geeignet ist, Löcher zu transportieren, als auch ein weiteres Material, das geeignet ist, Elektronen zu transportieren. Zwischen den Emissionsschichten sind dazu vorzugsweise ladungstransportierende Schichten angeordnet, die jeweils ein erstes und ein zweites Matrixmaterial aufweisen. Bei dem ersten Matrixmaterial handelt es sich dann um ein Loch transportierendes Matrixmaterial, bei dem zweiten Matrixmaterial handelt es sich um ein Elektronen leitendes Matrixmaterial.

Gemäß zumindest einer Ausführungsform einer hier beschriebenen organischen Leuchtdiode umfasst die organische Leuchtdiode einen strahlungsemittierenden Bereich mit zumindest drei Emissionsschichten, die im Betrieb weißes Mischlicht emittieren.

Gemäß zumindest einer Ausführungsform einer hier beschriebenen organischen Leuchtdiode handelt es sich bei der organischen Leuchtdiode um eine transparente organische Leuchtdiode. Sämtliche Schichten der organischen Leuchtdiode sind in diesem Fall strahlungsdurchlässig ausgebildet.

Gemäß zumindest einer Ausführungsform einer hier beschriebenen organischen Leuchtdiode ist die organische Leuchtdiode klarsichtig ausgebildet. Das heißt, elektromagnetische Strahlung, die durch die organische Leuchtdiode tritt, wird in dieser kaum oder gar nicht gestreut. Wird eine derart klarsichtig ausgebildete organische Leuchtdiode beispielsweise auf ein Blatt Papier mit gedrucktem Text gelegt, so ist der Text durch die organische Leuchtdiode hindurch noch lesbar. Vorzugsweise werden höchstens 50 % der durchtretenden elektromagnetischen Strahlung im Wellenlängenbereich von sichtbarem Licht beim Durchtritt durch die organische Leuchtdiode gestreut und/oder absorbiert. Besonders bevorzugt werden höchstens 25 % der durchtretenden elektromagnetischen Strahlung im Wellenlängenbereich von sichtbarem Licht beim Durchtritt durch die organische Leuchtdiode gestreut und/oder absorbiert.

Gemäß zumindest einer Ausführungsform einer hier beschriebenen organischen Leuchtdiode ist die organische Leuchtdiode derart strahlungsdurchlässig ausgebildet, dass zumindest 50 % der durchtretenden Strahlung in der organischen Leuchtdiode nicht absorbiert werden. Vorzugsweise werden wenigstens 75 % der durchtretenden Strahlung in der organischen Leuchtdiode nicht absorbiert.

Gemäß zumindest einer Ausführungsform einer hier beschriebenen organischen Leuchtdiode handelt es sich bei der organischen Leuchtdiode um eine beidseitig emittierende organische Leuchtdiode. Das heißt, die organische Leuchtdiode emittiert im Betrieb elektromagnetische Strahlung von zwei Strahlungsaustrittsflächen der organischen Leuchtdiode her. Die Strahlungsaustrittsflächen können parallel zueinander angeordnet sein. Vorzugsweise befindet sich ein strahlungsemittierender Bereich der organischen Leuchtdiode zwischen den beiden Strahlungsaustrittsflächen. Die organische Leuchtdiode kann dabei strahlungsdurchlässig oder strahlungsundurchlässig ausgebildet sein. Die organische Leuchtdiode kann darüber hinaus geeignet sein, von beiden Strahlungsdurchtrittsflächen her elektromagnetische Strahlung mit voneinander unterschiedlichen Wellenlängen zu emittieren. Beispielsweise kann durch eine Strahlungsdurchtrittsfläche sichtbares Licht treten, wohingegen durch die andere Strahlungsdurchtrittsfläche Infrarotstrahlung tritt.

Gemäß zumindest einer Ausführungsform einer hier beschriebenen organischen Leuchtdiode umfasst die organische Leuchtdiode zumindest eine ladungstransportierende Schicht, die ein Loch transportierendes Matrixmaterial und ein Elektronen transportierendes Matrixmaterial umfasst. Die ladungstransportierende Schicht ist dann geeignet, sowohl Löcher als auch Elektronen zu transportieren.

Gemäß zumindest einer Ausführungsform einer hier beschriebenen organischen Leuchtdiode umfasst die organische Leuchtdiode eine strahlungsdurchlässige Elektrode, die eine erste Schicht aus einem ersten TCO-Material aufweist, eine zweite Schicht, aus einem zweiten TCO-Material, sowie eine dritte Schicht, die zwischen erster und zweiter Schicht angeordnet ist und als transparente Metallschicht ausgeführt ist. Vorzugsweise unterscheiden sich dabei das erste und das zweite TCO-Material voneinander. Die Schichten können direkt aneinander grenzen. Die Dicke der Metallschicht beträgt dabei beispielsweise zwischen wenigstens 1 nm und höchstens 50 nm, besonders bevorzugt zwischen wenigstens 20 nm und höchstens 40 nm. Die dünne Metallschicht kann derart dünn ausgeführt sein, dass sie netzartig ist. In diesem Fall ist es möglich, dass sich die erste TCO-Schicht und die zweite TCO-Schicht in Öffnungen der dünnen Metallschicht in direktem Kontakt miteinander befinden können. Die organische Leuchtdiode kann dabei beispielsweise eine Anode und/oder eine Kathode aufweisen, die jeweils im beschriebenen Schichtaufbau ausgeführt sind. Sind beide Elektroden der organischen Leuchtdiode in der beschriebenen Weise ausgeführt, so kann es sich bei der organischen Leuchtdiode um eine strahlungsdurchlässige, eine transparente oder eine klarsichtige organische Leuchtdiode handeln. Darüber hinaus kann es sich bei der organischen Leuchtdiode dann um eine beidseitig emittierende organische Leuchtdiode handeln, die nicht strahlungsdurchlässig ausgeführt ist, sondern durch beide Elektroden elektromagnetische Strahlung emittiert.

Gemäß zumindest einer Ausführungsform einer hier beschriebenen organischen Leuchtdiode weist die organische Leuchtdiode im ausgeschalteten Betriebszustand einen anderen Farbausdruck als im eingeschalteten Betriebszustand auf. Beispielsweise kann die organische Leuchtdiode im ausgeschalteten Betriebszustand bläulich erscheinen, wohingegen sie im eingeschalteten Betriebszustand weißes Licht emittiert. Ferner ist es möglich, dass die organische Leuchtdiode von zwei Hauptflächen, beispielsweise von zwei Strahlungsdurchtrittsflächen, her im ausgeschalteten Zustand einen jeweils verschiedenen Farbeindruck erweckt.

Gemäß zumindest einer Ausführungsform einer hier beschriebenen organischen Leuchtdiode handelt es sich bei der organischen Leuchtdiode um eine transparente, beidseitig emittierende organische Leuchtdiode, die im ausgeschalteten Betriebszustand von beiden Emissionsseiten her farbig erscheint und im eingeschalteten Zustand weißes Licht emittiert. Dabei kann der farbige Eindruck an den beiden Emissionsseiten der organischen Leuchtdiode unterschiedlich sein. Beispielsweise kann die organische Leuchtdiode von einer Seite her rot erscheinen, wohingegen sie von der anderen Seite her blau erscheint.

Gemäß zumindest einer Ausführungsform einer hier beschriebenen organischen Leuchtdiode ist die organische Leuchtdiode verkapselt. Das heißt, die organische Leuchtdiode weist zumindest eine Verkapselung auf, die eine Versiegelung der funktionellen Schichten der organischen Leuchtdiode vor Umwelteinflüssen, wie Feuchtigkeit oder atmosphärische Gase, erlaubt. Bei den funktionellen Schichten der organischen Leuchtdiode handelt es sich beispielsweise um Elektroden, Ladungsträgerbarriereschichten, Ladungsträgertransportschichten und/oder strahlungsemittierende Schichten wie Emissionsschichten.

Gemäß zumindest einer Ausführungsform einer hier beschriebenen organischen Leuchtdiode umfasst die organische Leuchtdiode zumindest einen ersten Träger. Bei dem ersten Träger kann es sich um einen starren Träger handeln. Beispielsweise ist der erste Träger dann aus einem Glas, aus einem Keramikmaterial oder einem Metall gebildet. Darüber hinaus kann es sich bei dem ersten Träger um einen flexiblen Träger handeln. Der erste Träger ist dann beispielsweise aus einer Folie oder aus einem Laminat gebildet.

Gemäß zumindest einer Ausführungsform einer hier beschriebenen organischen Leuchtdiode umfasst die organische Leuchtdiode neben einem ersten Träger einen zweiten Träger. Der zweite Träger kann dabei aus den gleichen Materialien wie der erste Träger gebildet sein. Darüber hinaus ist es möglich, dass erster und zweiter Träger aus unterschiedlichen Materialien gebildet sind. Zumindest einer der Träger ist für im strahlungsemittierenden Bereich der organischen Leuchtdiode erzeugte elektromagnetische Strahlung zumindest teilweise durchlässig.

Gemäß zumindest einer Ausführungsform einer hier beschriebenen organischen Leuchtdiode sind der erste Träger und der zweite Träger mit einem Glas gebildet. Das heißt, der erste Träger und der zweite Träger enthalten ein Glas oder bestehen aus einem Glas. Beispielsweise bestehen dann beide Träger aus dem gleichen Glas.

Gemäß zumindest einer Ausführungsform einer hier beschriebenen organischen Leuchtdiode umfasst die organische Leuchtdiode zumindest einen Träger, der mit einem Bor-Silikat-Glas gebildet ist. Die organische Leuchtdiode kann beispielsweise zwei Träger umfassen, die aus diesem Glas bestehen.

Gemäß zumindest einer Ausführungsform einer hier beschriebenen organischen Leuchtdiode umfasst die organische Leuchtdiode zumindest einen Träger, der aus einem Kalk-Natron-Glas gebildet ist. Beispielsweise umfasst die organische Leuchtdiode dann zwei Träger, die aus diesem Glas bestehen.

Gemäß zumindest einer Ausführungsform einer hier beschriebenen organischen Leuchtdiode umfasst die organische Leuchtdiode einen ersten Träger, der strahlungsdurchlässig ausgebildet ist, und einen zweiten Träger, der strahlungsundurchlässig ausgebildet ist. Beispielsweise ist der zweite Träger für im strahlungsemittierenden Bereich der organischen Leuchtdiode erzeugte elektromagnetische Strahlung reflektierend und/oder absorbierend ausgebildet.

Gemäß zumindest einer Ausführungsform einer hier beschriebenen organischen Leuchtdiode umfasst die organische Leuchtdiode einen ersten Träger sowie einen zweiten Träger. Funktionelle Schichten der organischen Leuchtdiode sind zwischen erstem und zweitem Träger angeordnet. Darüber hinaus sind der erste Träger und der zweite Träger mittels eines Verbindungsmittels miteinander verbunden, welches die funktionellen Schichten der organischen Leuchtdiode seitlich umschließt und die beiden Träger miteinander verbindet. Mit anderen Worten ist durch das Verbindungsmittel und die beiden Träger eine Kavität gebildet, in welcher die funktionellen Schichten der organischen Leuchtdiode angeordnet sind. Das Verbindungsmittel, der erste Träger und der zweite Träger stellen die Verkapselung oder einen Teil der Verkapselung der organischen Leuchtdiode dar.

Gemäß zumindest einer Ausführungsform einer hier beschriebenen organischen Leuchtdiode umfasst das Verbindungsmittel ein Glaslotmaterial. Beispielsweise ist das Verbindungsmittel durch ein Glaslotmaterial gebildet. Das Glaslotmaterial kann zumindest stellenweise direkt an den ersten und/oder den zweiten Träger grenzen.

Gemäß zumindest einer Ausführungsform einer hier beschriebenen organischen Leuchtdiode umfasst das Verbindungsmittel ein Glasfrittenmaterial. Beispielsweise ist das Verbindungsmittel durch ein Glasfrittenmaterial gebildet. Das Glasfrittenmaterial kann zumindest stellenweise direkt an den ersten und/oder den zweiten Träger grenzen.

Gemäß zumindest einer Ausführungsform einer hier beschriebenen organischen Leuchtdiode umfasst das Verbindungsmittel einen Klebstoff. Beispielsweise ist das Verbindungsmittel durch einen Klebstoff gebildet. Der Klebstoff kann zumindest stellenweise direkt an den ersten und/oder den zweiten Träger grenzen.

Gemäß zumindest einer Ausführungsform einer hier beschriebenen organischen Leuchtdiode sind sowohl der erste als auch der zweite Träger strahlungsdurchlässig, transparent oder klarsichtig ausgebildet. Solche Träger eignen sich besonders gut zur Bildung von strahlungsdurchlässigen, transparenten oder klarsichtigen organischen Leuchtdioden.

Gemäß zumindest einer Ausführungsform einer hier beschriebenen organischen Leuchtdiode ist zumindest ein Teil der Verkapselung für die funktionellen Schichten der organischen Leuchtdiode durch eine Isolationsschicht gebildet, die zumindest eines der folgenden elektrisch isolierenden Materialien enthalten kann: Lack, Epoxidharz, Siliziumoxid, Siliziumnitrid. Die Isolationsschicht kann neben ihren Eigenschaften zur Verkapselung der funktionellen Schichten einer hier beschriebenen organischen Leuchtdiode auch zur elektrischen Isolation der ersten Elektrode der organischen Leuchtdiode von einer zweiten Elektrode der organischen Leuchtdiode dienen.

Gemäß zumindest einer Ausführungsform einer hier beschriebenen organischen Leuchtdiode weist die organische Leuchtdiode zumindest eine Dünnfilmverkapselung auf, die zumindest einen Teil der Verkapselung der organischen Leuchtdiode bildet. Die Dünnfilmverkapselung kann eine Grunddichtigkeit gegenüber Umwelteinflüssen, wie Feuchtigkeit und atmosphärische Gase, für die funktionellen Schichten der organischen Leuchtdiode herstellen. Beispielsweise ist die Dünnfilmverkapselung durch Aufbringen von Oxid und/oder Nitridschichten auf funktionelle Schichten der organischen Leuchtdiode hergestellt. Das Aufbringen kann beispielsweise mittels eines PECVD-Verfahrens erfolgen.

Gemäß zumindest einer Ausführungsform einer hier beschriebenen organischen Leuchtdiode umfasst die organische Leuchtdiode zur Verkapselung eine Diffusionsbarriere. Die Diffusionsbarriere kann beispielsweise aus einem amorphen Material, wie beispielsweise amorphem Siliziumdioxid, gebildet sein. Die Diffusionsbarriere kann beispielsweise mittels Atmosphärendruckplasma auf funktionelle Schichten der organischen Leuchtdiode und/oder eine Isolationsschicht und/oder eine Dünnfilmverkapselung aufgebracht werden.

Gemäß zumindest einer Ausführungsform einer hier beschriebenen organischen Leuchtdiode weist die organische Leuchtdiode eine Verkapselung auf, die wenigstens eine erste Schicht umfasst, die als Dünnfilmverkapselung ausgebildet ist sowie eine zweite Schicht, die als Diffusionsbarriere ausgebildet ist. Vorzugsweise grenzen diese beiden Schichten dann zumindest stellenweise direkt aneinander, wobei beispielsweise die Dünnfilmverkapselung auf funktionelle Schichten der organischen Leuchtdiode aufgebracht ist und die Diffusionsbarriere auf die Dünnfilmverkapselung.

Gemäß zumindest einer Ausführungsform einer hier beschriebenen organischen Leuchtdiode umfasst die organische Leuchtdiode eine Diffusionsbarriere, die eine Dicke von wenigstens 50 nm und höchstens 1000 nm, vorzugsweise von wenigstens 100 nm und höchstens 250 nm aufweist.

Gemäß zumindest einer Ausführungsform einer hier beschriebenen organischen Leuchtdiode umfasst die organische Leuchtdiode zur Verkapselung eine Diffusionsbarriere, die zumindest zwei Einzelschichten aufweist, wobei die Einzelschichten übereinander abgeschieden sind. Vorzugsweise weist jede der Einzelschichten eine Dicke von wenigstens 50 nm und höchstens 100 nm auf. Die Diffusionsbarriere kann dabei aus Einzelschichten aufgebaut sein, die jeweils aus Siliziumdioxid oder abwechselnd aus Siliziumdioxid und Siliziumnitrid bestehen.

Gemäß zumindest einer Ausführungsform einer hier beschriebenen organischen Leuchtdiode weist die organische Leuchtdiode zur Verkapselung eine Lackschicht auf. Die Lackschicht kann beispielsweise alternativ oder zusätzlich zu einer Diffusionsbarriere Verwendung finden.

Gemäß zumindest einer Ausführungsform einer hier beschriebenen organischen Leuchtdiode weist die organische Leuchtdiode einen Schichtenstapel aus einer Lackschicht und einer Dünnfilmverkapselung auf, die zur Versiegelung der funktionellen Schichten der organischen Leuchtdiode Verwendung finden. Beispielsweise ist die Lackschicht direkt auf die funktionellen Schichten der organischen Leuchtdiode angeordnet. Die Dünnfilmverkapselung ist dann direkt auf der Lackschicht angeordnet. Beispielsweise umschließt die Dünnfilmverkapselung die Lackschicht dann an allen freiliegenden Flächen der Dünnfilmverkapselung.

Gemäß zumindest einer Ausführungsform einer hier beschriebenen organischen Leuchtdiode umfasst die Verkapselung der organischen Leuchtdiode eine Vorverkapselungsschicht, die als Planarisierungsschicht für eine Dünnfilmverkapselung der organischen Leuchtdiode dienen kann. Beispielsweise handelt es sich bei der Vorverkapselungsschicht um ein transparentes Oxid oder einen strahlungsdurchlässigen Klebstoff. Die Vorverkapselungsschicht kann dann beispielsweise eine Dünnfilmverkapselung stellenweise bedecken. Vorzugsweise bedeckt die Vorverkapselungsschicht die Dünnfilmverkapselung dann an sämtlichen freiliegenden Außenflächen der Dünnfilmverkapselung.

Gemäß zumindest einer Ausführungsform einer hier beschriebenen organischen Leuchtdiode umfasst die organische Leuchtdiode als Verkapselung zumindest einen ersten Träger und einen zweiten Träger, die mittels eines Verbindungsmittels, welches die funktionellen Schichten der organischen Leuchtdiode seitlich umschließt, miteinander verbunden sind. Zugleich umfasst die Verkapselung zwischen den beiden Trägern zumindest eine der folgenden Schichten oder Verkapselungsmöglichkeiten: Isolationsschicht, Lackschicht, Vorverkapselungsschicht, Dünnfilmverkapselungsschicht, und/oder Diffusionsbarriere.

Gemäß zumindest einer Ausführungsform einer hier beschriebenen organischen Leuchtdiode umfasst die organische Leuchtdiode zur Verkapselung zumindest eine Verkapselungsschichtenfolge, die wenigstens zwei Verkapselungsschichten aufweist. Beispielsweise weist die Verkapselungsschichtenfolge zumindest eine erste Verkapselungsschicht auf, die mittels Plasma unterstützter, chemischer Dampfphasenabscheidung aufgebracht sein kann. Die erste Verkapselungsschicht kann dabei zumindest stellenweise direkt an die funktionellen Schichten der organischen Leuchtdiode grenzen. Alternativ kann die erste Verkapselungsschicht beispielsweise mittels Abscheidemethoden, wie physikalischer Gasphasenabscheidung, Sputtern oder dergleichen, aufgebracht sein.

Gemäß zumindest einer Ausführungsform einer hier beschriebenen organischen Leuchtdiode weist die erste Verkapselungsschicht der Verkapselungsschichtenfolge eine Dicke von wenigstens 50 nm, bevorzugt wenigstens 100 nm, besonders bevorzugt von wenigstens 1 *µ*m auf.

Gemäß zumindest einer Ausführungsform einer hier beschriebenen organischen Leuchtdiode umfasst die Verkapselungsschichtenfolge zumindest eine zweite Verkapselungsschicht, die direkt auf der ersten Verkapselungsschicht angeordnet sein kann. Das heißt, die zweite Verkapselungsschicht kann sich in unmittelbarem Kontakt mit der ersten Verkapselungsschicht befinden. Beispielsweise überdeckt die zweite Verkapselungsschicht die gesamte freiliegende Außenfläche der ersten Verkapselungsschicht.

Gemäß zumindest einer Ausführungsform einer hier beschriebenen organischen Leuchtdiode umfasst die organische Leuchtdiode zur Verkapselung eine zweite Verkapselungsschicht, die mittels Atomschichtenabscheidung auf eine erste Verkapselungsschicht abgeschieden ist.

Gemäß zumindest einer Ausführungsform einer hier beschriebenen organischen Leuchtdiode weist die zweite Verkapselungsschicht eine Dicke von wenigstens 1 nm, bevorzugt von wenigstens 10 nm und höchstens 30 nm auf.

Gemäß zumindest einer Ausführungsform einer hier beschriebenen organischen Leuchtdiode umfasst die organische Leuchtdiode einen ersten Träger, der zumindest stellenweise mit der Verkapselungsschichtenfolge, die eine erste Verkapselungsschicht und eine zweite Verkapselungsschicht aufweist, verkapselt ist. Bei dem ersten Träger kann es sich beispielsweise um einen flexiblen Träger handeln, der durch eine Kunststofffolie oder ein Laminat gebildet ist. Das heißt, die Verkapselungsschichtenfolge kann auch zur hermetischen Versiegelung von Trägern für funktionelle Schichten der organischen Leuchtdiode Verwendung finden.

Gemäß zumindest einer Ausführungsform einer hier beschriebenen organischen Leuchtdiode ist die gesamte organische Leuchtdiode allumseitig mit der Verkapselungsschichtenfolge bedeckt. Dabei ist es möglich, dass die organische Leuchtdiode einen ersten Träger, einen zweiten Träger sowie ein Verbindungsmittel umfasst, welche eine erste Verkapselung für die funktionellen Schichten der organischen Leuchtdiode bilden. Die Verkapselungsschichtenfolge kann dann stellenweise oder vollständig an den freiliegenden Außenflächen von erstem Träger, zweitem Träger und/oder Verbindungsmittel angeordnet sein. Darüber hinaus ist es auch möglich, dass zusätzlich oder alternativ die funktionellen Schichten direkt mit der Verkapselungsschichtenfolge versiegelt sind. Das heißt, die funktionellen Schichten der organischen Leuchtdiode grenzen dann direkt an die Verkapselungsschichtenfolge.

Gemäß zumindest einer Ausführungsform einer hier beschriebenen organischen Leuchtdiode umfasst die organische Leuchtdiode zur Verkapselung die Verkapselungsschichtenfolge mit einer ersten Verkapselungsschicht und einer zweiten Verkapselungsschicht, wobei die erste Verkapselungsschicht und die zweite Verkapselungsschicht jeweils ein anorganisches Material aufweisen, die erste Verkapselungsschicht direkt auf funktionellen Schichten der organischen Leuchtdiode angeordnet ist und die zweite Verkapselungsschicht direkt auf der ersten Verkapselungsschicht angeordnet ist.

Gemäß zumindest einer Ausführungsform einer hier beschriebenen organischen Leuchtdiode umfasst die organische Leuchtdiode zur Verkapselung die Verkapselungsschichtenfolge mit einer ersten Verkapselungsschicht, einer zweiten Verkapselungsschicht und einer dritten Verkapselungsschicht, wobei die dritte Verkapselungsschicht direkt auf den funktionellen Schichten der organischen Leuchtdiode angeordnet ist, die erste Verkapselungsschicht direkt auf der dritten Verkapselungsschicht angeordnet ist, die zweite Verkapselungsschicht direkt auf der ersten Verkapselungsschicht angeordnet ist, die erste und die zweite Verkapselungsschicht jeweils ein anorganisches Material aufweisen und die dritte Verkapselungsschicht ein amorphes anorganisches Material aufweist. Dabei ist es möglich, dass zweite und dritte Verkapselungsschicht gleich ausgebildet sind.

Gemäß zumindest einer Ausführungsform einer hier beschriebenen organischen Leuchtdiode umfasst die organische Leuchtdiode die Verkapselungsschichtenfolge mit einer ersten Schicht und einer zweiten Schicht, wobei die erste Verkapselungsschicht und die zweite Verkapselungsschicht jeweils ein anorganisches Material aufweisen, die zweite Verkapselungsschicht direkt auf der ersten Verkapselungsschicht angeordnet ist und die Verkapselungsschichtenfolge bei einer Temperatur von größer oder gleich 60° C und bei einer relativen Luftfeuchtigkeit von größer oder gleich 85 % länger als 500 Stunden hermetisch dicht ist.

Gemäß zumindest einer Ausführungsform einer hier beschriebenen organischen Leuchtdiode weisen die erste Verkapselungsschicht und die zweite Verkapselungsschicht der Verkapselungsschichtenfolge zur Verkapselung der organischen Leuchtdiode jeweils eine Volumenstruktur auf, wobei die Volumenstruktur der zweiten Verkapselungsschicht unabhängig von der Volumenstruktur der ersten Verkapselungsschicht ist. Dabei weist die Volumenstruktur der zweiten Verkapselungsschicht vorzugsweise eine höhere Amorphizität als die Volumenstruktur der ersten Verkapselungsschicht auf. Besonders bevorzugt ist die zweite Verkapselungsschicht amorph.

Gemäß zumindest einer Ausführungsform einer hier beschriebenen organischen Leuchtdiode weist die zweite Verkapselungsschicht der Verkapselungsschichtenfolge mit erster Verkapselungsschicht und zweiter Verkapselungsschicht eine Dicke mit einer Dickenvariation auf, die unabhängig von einer Oberflächenstruktur und/oder einer Volumenstruktur der ersten Verkapselungsschichtenfolge ist. Dabei ist die Dickenvariation vorzugsweise kleiner oder gleich 10 %.

Gemäß zumindest einer Ausführungsform einer hier beschriebenen organischen Leuchtdiode umfasst die organische Leuchtdiode zur Verkapselung eine Verkapselungsschichtenfolge mit einer Mehrzahl von ersten Verkapselungsschichten und einer Mehrzahl von zweiten Verkapselungsschichten, wobei die ersten und die zweiten Verkapselungsschichten abwechselnd direkt übereinander aufgebracht sind.

Gemäß zumindest einer Ausführungsform einer hier beschriebenen organischen Leuchtdiode umschließt die Verkapselungsschichtenfolge die funktionellen Schichten der organischen Leuchtdiode vollständig. Dabei kann die Verkapselungsschichtenfolge auch einen ersten und/oder einen zweiten Träger vollständig umschließen.

Gemäß zumindest einer Ausführungsform einer hier beschriebenen organischen Leuchtdiode weist die organische Leuchtdiode zur Verkapselung einen ersten Träger und einen zweiten Träger auf, sowie die Verkapselungsschichtenfolge, die zwischen erstem und zweitem Träger angeordnet ist.

Gemäß zumindest einer Ausführungsform einer hier beschriebenen organischen Leuchtdiode weist die organische Leuchtdiode zur Verkapselung einen ersten Träger und einen zweiten Träger sowie ein Verbindungsmittel auf, das ersten und zweiten Träger miteinander verbindet. Darüber hinaus weist die organische Leuchtdiode die Verkapselungsschichtenfolge mit zumindest zwei Verkapselungsschichten auf, die eine Grenzfläche zwischen dem Verbindungsmittel und dem ersten Träger und/oder dem zweiten Träger überdeckt und damit verkapselt.

Gemäß zumindest einer Ausführungsform einer hier beschriebenen organischen Leuchtdiode weist die organische Leuchtdiode eine Schutzschicht auf, die zwischen einer organischen Schichtenfolge der organischen Leuchtdiode und einer Elektrode der organischen Leuchtdiode angeordnet ist. Beispielsweise handelt es sich bei dieser Schutzschicht um eine Sputterschutzschicht, welche die organische Schichtenfolge vor Beschädigung bei Aufsputtern von Elektrodenmaterial auf die organische Schichtenfolge bewahrt.

Gemäß zumindest einer Ausführungsform einer hier beschriebenen organischen Leuchtdiode enthält oder besteht die Sputterschutzschicht aus einem Übergangsmetalloxid. Die Sputterschutzschicht kann sich dabei in direktem Kontakt mit einer Elektrode der organischen Leuchtdiode und/oder einer organischen Schicht der organischen Leuchtdiode befinden.

Gemäß zumindest einer Ausführungsform einer hier beschriebenen organischen Leuchtdiode weist das durch zumindest eine Strahlungsaustrittsfläche der organischen Leuchtdiode emittierte Licht keine lambertsche Abstrahlcharakteristik auf. Beispielsweise weist diese elektromagnetische Strahlung dann ein gerichtetes Abstrahlprofil auf. Das heißt, die Abstrahlung von elektromagnetischer Strahlung ist in diesem Fall nicht symmetrisch, sondern es findet eine verstärkte Abstrahlung in Richtung einer Hauptabstrahlrichtung statt.

Gemäß zumindest einer Ausführungsform einer hier beschriebenen organischen Leuchtdiode umfasst die organische Leuchtdiode eine strukturierte Strahlungsaustrittsfläche. Beispielsweise ist die Strahlungsaustrittsfläche der organischen Leuchtdiode in eine Vielzahl von parallel zueinander angeordneten Prismen strukturiert. Die Strahlungsaustrittsfläche kann dann beispielsweise erste Flächen und zweite Flächen aufweisen, wobei die ersten Flächen um einen ersten Winkel gegenüber einer Ebene, die beispielsweise parallel zu einer Haupterstreckungsebene der organischen Schichtenfolge der organischen Leuchtdiode verläuft, geneigt sind. Die zweiten Flächen sind dann um zweite Winkel gegenüber dieser Ebene geneigt.

Beispielsweise ist zur Bildung der strukturierten Strahlungsaustrittsfläche ein Träger der organischen Leuchtdiode entsprechend strukturiert. Darüber hinaus ist es möglich, dass die Verkapselungsschichtenfolge, beispielsweise die zweite Verkapselungsschicht, entsprechend strukturiert ist. Darüber hinaus ist es auch möglich, dass eine entsprechend strukturierte Schicht beispielsweise auf einem Träger für die organische Leuchtdiode oder einer anderen Verkapselung für die organische Leuchtdiode aufgebracht ist. Das heißt, die strukturierte Strahlungsaustrittsfläche kann durch die Strukturierung eines Elements der Verkapselung der organischen Leuchtdiode gebildet sein. Es ist jedoch auch möglich, dass die strukturierte Strahlungsaustrittsfläche, beispielsweise in Form einer weiteren Schicht, als eigenständiges Element auf die Verkapselung der organischen Leuchtdiode aufgebracht ist.

Gemäß zumindest einer Ausführungsform einer hier beschriebenen organischen Leuchtdiode ist die Strahlungsaustrittsfläche der organischen Leuchtdiode in eine Vielzahl von parallel zueinander angeordneten Prismen strukturiert. Die Prismen weisen dabei bevorzugt in eine Richtung makroskopische Größenordnungen auf. In diese Richtung kann die Länge der Prismen wenigstens 1 cm, bevorzugt wenigstens einen Dezimeter betragen. In eine dazu senkrechte Richtung können die Prismen eine Größenordnung aufweisen, die im Submillimeterbereich liegt, so dass keine Beugungseffekte in dieser Richtung an den Prismen auftreten können. Beispielsweise beträgt die Länge der Prismen in diese Richtung 500 *µ*m oder weniger.

Gemäß zumindest einer Ausführungsform einer hier beschriebenen organischen Leuchtdiode ist eine Strahlungsaustrittsfläche der organischen Leuchtdiode in eine Vielzahl erster Flächen und zweiter Flächen strukturiert, wobei die ersten Flächen strahlungsdurchlässig ausgebildet sind und die zweiten Flächen reflektierend ausgebildet sind. Auf diese Weise kann elektromagnetische Strahlung die Strahlungsdurchtrittsfläche nur durch die ersten Flächen hindurch verlassen. Dadurch erfolgt eine gerichtete Abstrahlung durch die erste Strahlungsdurchtrittsfläche hindurch, in Abhängigkeit vom ersten Winkel, um den die ersten Flächen geneigt sind.

Gemäß zumindest einer Ausführungsform der organischen Leuchtdiode handelt es sich bei der organischen Leuchtdiode um eine beidseitig emittierende organische Leuchtdiode, die zwei Strahlungsdurchtrittsflächen aufweist, die an gegenüberliegenden Seiten der organischen Leuchtdiode angeordnet sind. In dieser Ausführungsform ist es möglich, dass beide der Strahlungsaustrittsflächen in der beschriebenen Weise strukturiert sind. Das heißt, es wird dann durch beide Strahlungsaustrittsflächen gerichtete elektromagnetische Strahlung von der organischen Leuchtdiode abgegeben. Darüber hinaus ist es jedoch auch möglich, dass lediglich eine der Strahlungsaustrittsflächen in der beschriebenen Weise strukturiert ist. Von der anderen Strahlungsaustrittsfläche wird dann beispielsweise elektromagnetische Strahlung mit einer lambertschen Abstrahlcharakteristik von der organischen Leuchtdiode emittiert.

Gemäß zumindest einer Ausführungsform einer hier beschriebenen organischen Leuchtdiode ist zur Erzeugung von gerichteter elektromagnetischer Strahlung nicht eine Strahlungsaustrittsfläche der organischen Leuchtdiode strukturiert, sondern beispielsweise die Oberseite eines Trägers der organischen Leuchtdiode, auf welchen die funktionellen Schichten der organischen Leuchtdiode aufgebracht sind. Beispielsweise ist der Träger dann in eine Vielzahl paralleler Prismen mit ersten Flächen und zweiten Flächen strukturiert, die zueinander verkippt angeordnet sind. Die funktionellen Schichten können dann auf die ersten und/oder auf die zweiten Flächen an der Oberseite des Trägers aufgebracht sein. Dabei ist es möglich, dass funktionelle Schichten, die auf unterschiedlichen Flächen angeordnet sind, separat voneinander ansteuerbar sind. Es kann damit beispielsweise eine organische Leuchtdiode realisiert sein, die abwechselnd elektromagnetische Strahlung in zwei unterschiedliche Haupterstreckungsrichtungen abgibt. In einem einfachen Fall kann die separate Ansteuerbarkeit dadurch erreicht sein, dass zumindest eine Elektrode der organischen Leuchtdiode nicht durchgehend über der gesamten organischen Schichtenfolge angeordnet ist, sondern in Bereiche separiert ist, die den einzelnen Flächen des strukturierten Trägers entsprechen. Über den Winkel, den die Flächen des strukturierten Trägers miteinander einschließen sowie die Grundfläche der jeweiligen Flächen kann eine bestimmte gewünschte Abstrahlcharakteristik, das heißt eine gewünschte Abstrahlrichtung und Abstrahlintensität der von der organischen Leuchtdiode im Betrieb erzeugten elektromagnetischen Strahlung eingestellt werden.

Gemäß zumindest einer Ausführungsform einer hier beschriebenen organischen Leuchtdiode ist die organische Leuchtdiode zur Beleuchtung einer zu beleuchtenden Fläche vorgesehen, auf der die organische Leuchtdiode zumindest mittelbar befestigt ist. Das heißt, die organische Leuchtdiode ist zumindest mittelbar auf einem zu beleuchtenden Element mit einer zu beleuchtenden Fläche angeordnet. Die organische Leuchtdiode kann dabei beispielsweise mittels eines transparenten Klebstoffs auf das zu beleuchtende Element aufgeklebt sein. Auch andere Befestigungsmethoden wie Klettverschlüsse, Schraubverbindungen, Klemmverbindungen, Presspassungen oder dergleichen sind möglich. Die organische Leuchtdiode ist vorzugsweise zumindest stellenweise transparent oder klarsichtig ausgebildet, so dass im ausgeschalteten Zustand die zu beleuchtende Fläche durch die organische Leuchtdiode hindurch erkennbar ist. Bei der zu beleuchtenden Fläche kann es sich beispielsweise um die Oberfläche einer Fliese, eines Posters, einer Kachel, eines Verkehrszeichens, einer Hinweistafel, eines Schildes, eines Bildes, eines Spiegels, einer Glasscheibe, oder eines beliebigen anderen Elements handeln.

Gemäß zumindest einer Ausführungsform einer hier beschriebenen organischen Leuchtdiode ist die organische Leuchtdiode zur Beleuchtung einer zu beleuchtenden Fläche eingerichtet, wobei von der organischen Leuchtdiode im Betrieb ein erster Anteil elektromagnetischer Strahlung emittiert wird, der direkt aus dem strahlungsemittierenden Bereich der organischen Leuchtdiode nach außen tritt, ohne vorher auf die zu beleuchtende Fläche zu treffen. Darüber hinaus weist die Strahlung einen zweiten Anteil auf, der vor dem Austritt aus der organischen Leuchtdiode auf die zu beleuchtende Fläche trifft und von dieser zumindest teilweise reflektiert worden ist.

Gemäß zumindest einer Ausführungsform einer hier beschriebenen organischen Leuchtdiode ist das relative Verhältnis der Intensitäten der beiden genannten Strahlungsanteile, das heißt der Intensitäten von indirekt austretender elektromagnetischer Strahlung und direkt austretender elektromagnetischer Strahlung, durch eine optische Kavität und/oder durch unterschiedlich stark transparent eingestellte erste Elektroden und zweite Elektroden der organischen Leuchtdiode einstellbar und wählbar.

Gemäß zumindest einer Ausführungsform einer hier beschriebenen organischen Leuchtdiode handelt es sich bei der organischen Leuchtdiode um eine transparente oder klarsichtige organische Leuchtdiode, die auf einer zu beleuchtenden Fläche eines zu beleuchtenden Elements angeordnet ist, wobei die zu beleuchtende Fläche im ausgeschalteten Zustand der organischen Leuchtdiode durch die organische Leuchtdiode hindurch sichtbar ist. Im eingeschalteten Zustand kann die Intensität der direkt abgestrahlten elektromagnetischen Strahlung im Vergleich zur indirekt abgestrahlten elektromagnetischen Strahlung dann derart stark gewählt sein, dass die zu beleuchtende Fläche nicht mehr erkennbar ist. Das heißt, die organische Leuchtdiode kann von einem transparenten Betriebszustand in einen leuchtenden Betriebszustand geschaltet werden, in dem eine hinter der organischen Leuchtdiode angeordnete Fläche nicht mehr erkennbar ist. Eine derartige Intensitätsverteilung kann beispielsweise mittels einer optischen Kavität erreicht sein.

Gemäß zumindest einer Ausführungsform einer hier beschriebenen organischen Leuchtdiode handelt es sich bei der organischen Leuchtdiode um eine transparente organische Leuchtdiode, bei der an einer Strahlungsaustrittsfläche ein elektrisch schaltbares optisches Element angeordnet ist. Bei dem elektrisch schaltbaren optischen Element handelt es sich beispielsweise um einen elektrisch schaltbaren Diffusor oder um ein elektrochromes Material. Eine derartige Anordnung von organischer Leuchtdiode und elektrisch schaltbarem Element kann beispielsweise in Verbindung mit einem zu beleuchtenden Element eingesetzt werden, wobei es sich bei dem zu beleuchtenden Element beispielsweise um einen Spiegel oder ein transparentes Element wie eine Glasplatte handeln kann. Mittels des elektrisch schaltbaren optischen Elements kann eine solche Anordnung beispielsweise von transparent auf milchig geschaltet werden. Auf diese Weise ist beispielsweise ein ein- und ausschaltbarer Sichtschutz realisierbar, der auch als Beleuchtungsmittel genutzt werden kann.

Gemäß zumindest einer Ausführungsform einer hier beschriebenen organischen Leuchtdiode ist das elektrisch schaltbare optische Element strukturiert ausgebildet. Das heißt, das elektrisch schaltbare optische Element ist beispielsweise in einem bestimmten Muster auf eine Strahlungsaustrittsfläche der organischen Leuchtdiode aufgebracht. Auf diese Weise kann beispielsweise eine Information oder eine Verzierung mit Einschalten des elektrisch schaltbaren optischen Elements in den Strahlengang der organischen Leuchtdiode eingeblendet und mit Ausschalten des elektrisch schaltbaren optischen Elements wieder ausgeblendet werden.

Gemäß zumindest einer Ausführungsform einer hier beschriebenen organischen Leuchtdiode ist die organische Leuchtdiode zumindest strahlungsdurchlässig ausgebildet und mit einer ihrer Strahlungsaustrittsflächen auf einem reflektierenden optischen Element wie einem Spiegel oder einem Retro-Reflektor angeordnet.

Gemäß zumindest einer Ausführungsform einer hier beschriebenen organischen Leuchtdiode ist die organische Leuchtdiode strahlungsdurchlässig ausgebildet und mit einer ihrer Strahlungsaustrittsflächen auf einem reflektierenden optischen Element wie einem Spiegel oder einem Retro-Reflektor angeordnet. Darüber hinaus ist an der gegenüberliegenden Strahlungsaustrittsfläche der organischen Leuchtdiode ein Farbfilter angeordnet. Der Farbfilter hat beispielsweise eine hohe Transmission für einen ersten spektralen Teilbereich des sichtbaren Wellenlängenspektrums und eine hohe Absorption für einen zweiten spektralen Teilbereich des sichtbaren Wellenlängenspektrums. Ein Intensitätsmaximum der von der organischen Leuchtdiode im Betrieb erzeugten elektromagnetischen Strahlung liegt innerhalb des vom Farbfilter transmittierten ersten spektralen Teilbereichs. Mit Vorteil erzeugt auf diese Weise der Anteil des Umgebungslichts, der vom reflektierenden Element zur Strahlungsaustrittsfläche zurückreflektiert und aus der organischen Leuchtdiode ausgekoppelt wird, im Wesentlichen den gleichen Farbeindruck wie das von der organischen Leuchtdiode emittierte Licht.

Gemäß zumindest einer Ausführungsform umfasst eine hier beschriebene organische Leuchtdiode eine reflektierende Schicht, die von außen auf die Leuchtdiode treffende elektromagnetische Strahlung in Richtung der Strahlungsaustrittsfläche der organischen Leuchtdiode zurückreflektiert. Die organische Leuchtdiode umfasst ferner an der Strahlungsaustrittsfläche einen Farbfilter, derart, dass die organische Leuchtdiode unabhängig vom Betriebszustand den gleichen Farbeindruck hervorruft. Das heißt, die organische Leuchtdiode weist im ausgeschalteten Betriebszustand den gleichen Farbeindruck auf wie im eingeschalteten Betriebszustand.

Gemäß zumindest einer Ausführungsform einer hier beschriebenen organischen Leuchtdiode ist in die organische Leuchtdiode ein Berührungssensor integriert. Beispielsweise handelt es sich bei dem Berührungssensor um einen kapazitiv oder resistiv arbeitenden Berührungssensor. Das heißt, die organische Leuchtdiode bildet beispielsweise eine Lichtquelle und zugleich ein Bedienelement.

Im Folgenden werden Beleuchtungsmittel angegeben, die beispielsweise zur Allgemeinbeleuchtung oder als Leuchten im Straßenverkehr vorgesehen sind. Die Beleuchtungsmittel können dabei hier beschriebene organische Leuchtdioden als Lichtquellen umfassen. Die Beleuchtungsmittel können ferner jede Kombination von beschriebenen organischen Leuchtdioden als Lichtquellen umfassen. Darüber hinaus ist es auch möglich, die hier beschriebenen Beleuchtungsmittel oder Elemente der hier beschriebenen Beleuchtungsmittel zu weiteren Beleuchtungsmitteln zu kombinieren.

Gemäß zumindest einer Ausführungsform eines hier beschriebenen Beleuchtungsmittels umfasst das Beleuchtungsmittel zumindest eine organische Leuchtdiode gemäß zumindest einer hier beschriebenen Ausführungsform.

Gemäß zumindest einer Ausführungsform eines hier beschriebenen Beleuchtungsmittels ist das Beleuchtungsmittel zur Allgemeinbeleuchtung eingerichtet und weist darüber hinaus eine Weckfunktion auf. Das heißt, das Beleuchtungsmittel kann in einem Betriebszustand des Beleuchtungsmittels nach Art eines Weckers betrieben werden.

Gemäß zumindest einer Ausführungsform eines hier beschriebenen Beleuchtungsmittels umfasst das Beleuchtungsmittel eine Ansteuervorrichtung, über die eine Aktivierungszeit - beispielsweise eine Weckzeit - vom Benutzer des Beleuchtungsmittels einstellbar ist. Zu dieser Aktivierungszeit beginnt das Beleuchtungsmittel dann damit, Licht abzustrahlen.

Gemäß zumindest einer Ausführungsform eines hier beschriebenen Beleuchtungsmittels ist das Beleuchtungsmittel zur Allgemeinbeleuchtung und als Wecker ausgebildet, wobei das Beleuchtungsmittel zumindest eine transparente, klarsichtige organische Leuchtdiode gemäß zumindest einer der vorherigen Ausführungsformen umfasst. Die organische Leuchtdiode kann beispielsweise vor einer zu beleuchtenden Fläche angeordnet sein, die im ausgeschalteten Betriebszustand des Beleuchtungsmittels durch die organische Leuchtdiode hindurch sichtbar ist.

Gemäß zumindest einer Ausführungsform des Beleuchtungsmittels umfasst das Beleuchtungsmittel eine Ansteuervorrichtung, die ab einer bestimmten Aktivierungszeit die Lichtstärke des vom Beleuchtungsmittel emittierten Lichts, zum Beispiel kontinuierlich, erhöht.

Gemäß zumindest einer Ausführungsform eines hier beschriebenen Beleuchtungsmittels umfasst das Beleuchtungsmittel eine Ansteuervorrichtung, die eingerichtet ist, ab einer Aktivierungszeit die Lichtstärke des vom Beleuchtungsmittel emittierten Lichts stufenweise zu erhöhen, wobei für vorgebbare Zeiten vom Beleuchtungsmittel Licht einer konstanten Lichtstärke erzeugt wird, die in vorgebbaren Zeitintervallen erhöht wird.

Gemäß zumindest einer Ausführungsform eines hier beschriebenen Beleuchtungsmittels ist das Beleuchtungsmittel eingerichtet, Licht mit einer Lichtstärke zwischen Null und wenigstens 1000 cd, vorzugsweise wenigstens 5000 cd, besonders bevorzugt wenigstens 10000 cd zu erzeugen. Beispielsweise umfasst das Beleuchtungsmittel dazu zumindest eine organische Leuchtdiode, die ein phosphoreszentes Emittermaterial in ihrem strahlungserzeugenden Bereich aufweist. Die organische Leuchtdiode kann zusätzlich zum phophoreszenten Emittermaterial auch fluoreszente Emittermaterialien in ihrem strahlungserzeugenden Bereich aufweisen.

Gemäß zumindest einer Ausführungsform eines hier beschriebenen Beleuchtungsmittels umfasst das Beleuchtungsmittel zumindest ein berührungssensitives Bedienelement, das mittels eines Berührungssensors vom Benutzer des Beleuchtungsmittels bedient werden kann. Das Bedienelement kann beispielsweise in einer Strahlungsaustrittsfläche des Beleuchtungsmittels angeordnet sein. Besonders bevorzugt kommt zur Bildung des berührungssensitiven Bedienelements eine organische Leuchtdiode gemäß zumindest einer der vorherigen Ausführungsformen zur Anwendung, die einen integrierten Berührungssensor aufweist.

Gemäß zumindest einer Ausführungsform des Beleuchtungsmittels ist das Beleuchtungsmittel mittels einer Fernbedienung bedienbar. Beispielsweise kann die Fernbedienung mittels Funk oder infraroter Strahlung Informationen mit dem Beleuchtungsmittel austauschen.

Gemäß zumindest einer Ausführungsform des Beleuchtungsmittels ist das Beleuchtungsmittel in eine Vielzahl von Segmenten unterteilt. Beispielsweise können unterschiedliche Segmente zur Erzeugung von elektromagnetischer Strahlung mit unterschiedlichen Wellenlängen geeignet sein.

Gemäß zumindest einer Ausführungsform eines hier beschriebenen Beleuchtungsmittels umfasst das Beleuchtungsmittel eine Ansteuervorrichtung, die dazu eingerichtet ist, die Farbtemperatur des vom Beleuchtungsmittel emittierten Lichts kontinuierlich oder stufenweise zu erhöhen.

Gemäß zumindest einer Ausführungsform des Beleuchtungsmittels ist das Beleuchtungsmittel dazu eingerichtet, Licht, vorzugsweise weißes Licht mit Farbtemperaturen von wenigstens 4000 K bis Farbtemperaturen von höchstens 25000 K zu erzeugen.

Gemäß zumindest einer Ausführungsform eines hier beschriebenen Beleuchtungsmittels umfasst das Beleuchtungsmittel eine Ansteuervorrichtung, die dazu eingerichtet ist, die Lichtintensität sowie die Farbtemperatur des vom Beleuchtungsmittel im Betrieb erzeugten Lichts stufenweise oder kontinuierlich zu erhöhen, wobei beispielsweise mit der Erhöhung der Farbtemperatur eine Erhöhung der Lichtintensität erfolgt.

Gemäß zumindest einer Ausführungsform eines hier beschriebenen Beleuchtungsmittels ist das Beleuchtungsmittel dazu eingerichtet, einen Sonnenaufgang im Zeitraffer zu simulieren. Das heißt, vom Beleuchtungsmittel wird ab einer bestimmten Startzeit weißes Licht erzeugt, bei dem die Farbtemperatur kontinuierlich oder stufenweise von wenigstens 4000 K bis höchsten 25000 K erhöht wird, wobei gleichzeitig die Lichtintensität von 0 cd bis maximal 10000 cd erhöht wird. Dabei kann der Anstieg der Farbtemperatur gleichzeitig oder unabhängig von einem Anstieg der Lichtintensität erfolgen.

Gemäß zumindest einer Ausführungsform eines hier beschriebenen Beleuchtungsmittels dient das Beleuchtungsmittel neben seinem Einsatz als Leuchte zur Allgemeinbeleuchtung als Spritzwasserschutz. Beispielsweise bildet das Beleuchtungsmittel den Teil einer Duschkabine. So kann das Beleuchtungsmittel den Teil einer Wand einer Duschkabine bilden oder auf einer Wand der Duschkabine angeordnet sein. Darüber hinaus ist es möglich, dass das Beleuchtungsmittel die Wand für die Duschkabine bildet.

Gemäß zumindest einer Ausführungsform des Beleuchtungsmittels umfasst das Beleuchtungsmittel zumindest zwei Träger, zwischen denen zumindest eine organische Leuchtdiode oder funktionelle Schichten einer organischen Leuchtdiode angeordnet sind. Dabei ist vorzugsweise zumindest einer der Träger diffus Licht streuend ausgebildet, so dass das Beleuchtungsmittel nicht klarsichtig ist, sondern auch als Sichtschutz dient.

Gemäß zumindest einer Ausführungsform des Beleuchtungsmittels umfasst das Beleuchtungsmittel zumindest eine organische Leuchtdiode, die zumindest eine zweifache Verkapselung aufweist. Zweifache Verkapselung heißt dabei, dass zumindest zwei der hier beschriebenen Möglichkeiten zur Verkapselung einer organischen Leuchtdiode in Kombination Verwendung finden, um auf diese Weise eine besonders gut hermetisch versiegelte organische Leuchtdiode zu erhalten.

Gemäß zumindest einer Ausführungsform des hier beschriebenen Beleuchtungsmittels ist das Beleuchtungsmittel dazu eingerichtet, direkt mit Wasser in Kontakt zu kommen.

Gemäß zumindest einer Ausführungsform eines hier beschriebenen Beleuchtungsmittels ist das Beleuchtungsmittel dazu eingerichtet, im Sinne eines Abziehbildes auf die Wand einer Duschkabine geklebt zu werden.

Gemäß zumindest einer Ausführungsform eines hier beschriebenen Beleuchtungsmittels umfasst das Beleuchtungsmittel zumindest eine anorganische Leuchtdiode als Lichtquelle des Beleuchtungsmittels.

Gemäß zumindest einer Ausführungsform eines hier beschriebenen Beleuchtungsmittels umfasst das Beleuchtungsmittel zumindest eine organische Leuchtdiode als Lichtquelle sowie zumindest eine anorganische Leuchtdiode als Lichtquelle.

Gemäß zumindest einer Ausführungsform eines hier beschriebenen Beleuchtungsmittels weist das Beleuchtungsmittel zumindest einen Träger auf, der mit einem strahlungsdurchlässigen Material gebildet ist, das zur Lichtleitung geeignet ist. Beispielsweise handelt es sich bei dem Träger um eine Glasplatte.

Gemäß zumindest einer Ausführungsform eines hier beschriebenen Beleuchtungsmittels ist am als Lichtleiter ausgebildeten Träger des Beleuchtungsmittels zumindest eine anorganische Leuchtdiode angeordnet, welche elektromagnetische Strahlung in den Lichtleiter einkoppelt. Die eingekoppelte elektromagnetische Strahlung kann beispielsweise im Lichtleiter verteilt werden und von diesem großflächig nach außen abgegeben werden.

Gemäß zumindest einer Ausführungsform eines hier beschriebenen Beleuchtungsmittels weist das Beleuchtungsmittel einen Betriebszustand auf, in dem Infrarotstrahlung erzeugt wird. Beispielsweise findet die Infrarotstrahlung zur Erwärmung eines Benutzers des Beleuchtungsmittels zum Enteisen einer Scheibe oder zum Heizen einer feuchten Umgebung Verwendung. Beispielsweise kann mittels der Infrarotstrahlung der Benutzer einer Duschkabine, die das Beleuchtungsmittel umfasst, erwärmt werden und/oder die Duschkabine nach Abschluss des Duschvorgangs mittels der Infrarotstrahlung getrocknet werden. Die Infrarotstrahlung kann dabei durch zumindest eine anorganische oder durch zumindest eine organische Leuchtdiode erzeugt werden.

Gemäß zumindest einer Ausführungsform des Beleuchtungsmittels ist das Beleuchtungsmittel geeignet, im Betrieb ultraviolette Strahlung zu emittieren. Beispielsweise wird die ultraviolette Strahlung durch zumindest eine anorganische Leuchtdiode des Beleuchtungsmittels erzeugt. Die ultraviolette Strahlung kann dabei zur Bräunung eines Benutzers des Beleuchtungsmittels und/oder zur Desinfektion der Umgebung des Beleuchtungsmittels Verwendung finden. Beispielsweise kann ein Beleuchtungsmittel, das als Spritzwasserschutz in einer Dusche ausgebildet ist, oder das in einem Duschkopf integriert ist, in dieser Weise Verwendung finden.

Gemäß zumindest einer Ausführungsform des Beleuchtungsmittels ist das Beleuchtungsmittel in einer Dusche oder in einer Badewanne integriert. Beispielsweise bildet das Beleuchtungsmittel einen Spritzwasserschutz oder ist Teil eines Duschkopfes. Das Beleuchtungsmittel kann dann als Anzeigevorrichtung für die Wassertemperatur dienen. Beispielsweise kann das Beleuchtungsmittel geeignet sein, blaues Licht zu emittieren, welches kaltes Wasser anzeigt. Ferner kann das Beleuchtungsmittel geeignet sein, rotes Licht zu emittieren, welches heißes Wasser anzeigt und Mischfarben mit Rot- und Blauanteilen zur Anzeige von warmem Wasser.

Gemäß zumindest einer Ausführungsform eines hier beschriebenen Beleuchtungsmittels können der Farbort, die Lichtintensität und/oder die Farbtemperatur durch die Mischbatterie einer Wasserversorgung einstellbar sein. Die Mischbatterie ist dazu mit einer Ansteuervorrichtung für das Beleuchtungsmittel verbunden.

Gemäß zumindest einer Ausführungsform des Beleuchtungsmittels kann das Beleuchtungsmittel ein berührungssensitives Bedienungselement umfassen, mittels dem zusätzlich zu Betriebszuständen des Beleuchtungsmittels auch die Wassertemperatur und/oder der Wasserdruck beispielsweise in einer Duschkabine oder in einer Badewanne eingestellt werden können.

Gemäß zumindest einer Ausführungsform eines hier beschriebenen Beleuchtungsmittels dient das Beleuchtungsmittel als Leuchte zur Allgemeinbeleuchtung und bildet zumindest den Teil eines Brause- oder Duschkopfes.

Gemäß zumindest einer Ausführungsform eines hier beschriebenen Beleuchtungsmittels befindet sich das Beleuchtungsmittel im Betrieb in direktem Kontakt mit Wasser. Das heißt, beispielsweise wird ein Träger des Beleuchtungsmittels von Wasser umspült. Dabei kann das Beleuchtungsmittel von Wasser umspült werden, während es sich in einem eingeschalteten Betriebszustand befindet.

Gemäß zumindest einer Ausführungsform eines hier beschriebenen Beleuchtungsmittels befindet sich das Beleuchtungsmittel in direktem Kontakt mit Wasser, wobei das Wasser als Lichtleiter für die vom Beleuchtungsmittel erzeugte elektromagnetische Strahlung dient. Das heißt, das vom Beleuchtungsmittel im Betrieb erzeugte Licht wird zumindest teilweise in zumindest einen Wasserstrahl eingekoppelt, in dem es sich wie in einem Lichtleiter ausbreiten kann. Auf diese Weise kann - beispielsweise bei Beleuchtung einer Vielzahl von Wasserstrahlen mit verschiedenen Farben - der Eindruck eines Regenbogens erweckt werden.

Gemäß zumindest einer Ausführungsform eines hier beschriebenen Beleuchtungsmittels umfasst das Beleuchtungsmittel zumindest eine organische Leuchtdiode, die eine Öffnung aufweist. Die Öffnung erstreckt sich dabei vorzugsweise durchgehend von einer Hauptseite der organischen Leuchtdiode zur gegenüberliegenden Hauptseite der organischen Leuchtdiode. Die Öffnung kann randseitig mit einem Verbindungsmittel wie einem Glaslotmaterial oder einer Glasfritte verschlossen sein. Darüber hinaus können noch weitere Maßnahmen zur Versiegelung der organischen Leuchtdiode im Bereich der Öffnung wie eine Verkapselungsschichtenfolge, eine Dünnfilmverkapselung, eine Diffusionsbarriere oder dergleichen zum Einsatz kommen. Vorzugsweise fließt in zumindest einem Betriebszustand der organischen Leuchtdiode Wasser durch die Öffnung. Dabei ist es auch möglich, dass die organische Leuchtdiode eine Vielzahl von Öffnungen aufweist, durch die im Betrieb der organischen Leuchtdiode Wasser fließen kann.

Gemäß zumindest einer Ausführungsform eines hier beschriebenen Beleuchtungsmittels ist das Beleuchtungsmittel neben einer Leuchte zur Allgemeinbeleuchtung ein Spiegel sowie eine Anzeigevorrichtung zur Anzeige einfacher grafischer Elemente. Das Beleuchtungsmittel kann in diesem Fall beispielsweise als Badezimmerspiegel oder Garderobenspiegel Verwendung finden. Das Beleuchtungsmittel weist vorzugsweise wenigstens drei Betriebszustände auf: Einen ersten Betriebszustand, in dem das Beleuchtungsmittel zur Allgemeinbeleuchtung dient und Licht emittiert, einen zweiten Betriebszustand, in dem das Beleuchtungsmittel keine elektromagnetische Strahlung aktiv emittiert und als Spiegel dient, sowie einen dritten Betriebszustand, in dem das Beleuchtungsmittel einfache grafische Elemente wie Muster oder dergleichen anzeigt. Im dritten Betriebszustand kann das Beleuchtungsmittel zusätzlich als Spiegel und/oder zur Allgemeinbeleuchtung dienen, wobei die abgestrahlte Lichtintensität im Vergleich zum ersten Betriebszustand dann vorzugsweise reduziert ist.

Gemäß zumindest einer Ausführungsform eines hier beschriebenen Beleuchtungsmittels umfasst das Beleuchtungsmittel ein strukturiertes elektrisch schaltbares Element. Das elektrisch schaltbare Element ist beispielsweise gemäß einem vorgegebenen Muster strukturiert. Zum Beispiel wenn das elektrisch schaltbare optische Element in einem eingeschalteten elektrischen Betriebszustand betrieben wird, ist das darzustellende Muster sichtbar. Beim elektrisch schaltbaren optischen Element handelt es sich beispielsweise um einen elektrisch schaltbaren Diffusor oder um ein elektrochromes Material. Beispielsweise kann das elektrisch schaltbare optische Element in einem Beleuchtungsmittel Verwendung finden, das zur Allgemeinbeleuchtung und als Spiegel dient.

Gemäß zumindest einer Ausführungsform eines hier beschriebenen Beleuchtungsmittels ist das Beleuchtungsmittel mittels einer Gestensteuerung bedienbar. Das heißt, das Beleuchtungsmittel umfasst einen optischen Sensor, beispielsweise eine Kamera, sowie eine Auswerteschaltung zur Auswertung der Signale des optischen Sensors. Ein Einschalten, Ausschalten oder andere Änderungen von Betriebszuständen können dann mittels Gestensteuerung erfolgen.

Gemäß zumindest einer Ausführungsform eines hier beschriebenen Beleuchtungsmittels bildet das Beleuchtungsmittel eine Fliese oder den Teil einer Fliese.

Vorzugsweise ist das Beleuchtungsmittel in diesem Fall trittfest ausgebildet.

Gemäß zumindest einer Ausführungsform eines hier beschriebenen Beleuchtungsmittels umfasst das Beleuchtungsmittel zwei Träger, zwischen denen in regelmäßigen Abständen Abstandshalter angeordnet sind. Bei den Abstandshaltern kann es sich beispielsweise um Pfosten oder Dämme handeln, welche die beiden Träger miteinander verbinden. Die Abstandshalter sind beispielsweise mit einem Glaslot oder einem Glasfrittenmaterial gebildet oder bestehen aus einem dieser Materialien.

Gemäß zumindest einer Ausführungsform eines hier beschriebenen Beleuchtungsmittels dient das Beleuchtungsmittel als Wand- oder Fußbodenheizung. Das Beleuchtungsmittel muss dabei nicht zwingend zur Erzeugung von sichtbarer elektromagnetischer Strahlung geeignet sein. Es ist beispielsweise ausreichend, wenn das Beleuchtungsmittel zumindest eine organische Leuchtdiode umfasst, die zur Erzeugung von Infrarotstrahlung geeignet ist. Darüber hinaus ist es möglich, dass das Beleuchtungsmittel organische Leuchtdioden umfasst, die Infrarotstrahlung emittieren sowie organische Leuchtdioden, die sichtbares Licht emittieren. Ferner ist es möglich, dass das Beleuchtungsmittel zumindest eine organische Leuchtdiode umfasst, die in ihrem strahlungserzeugenden Bereich eine Emissionsschicht mit einem Infrarot emittierenden Emittermaterial umfasst, sowie zumindest eine Emissionsschicht mit einem Emittermaterial, das farbiges Licht emittiert.

Gemäß zumindest einer Ausführungsform des Beleuchtungsmittels ist das Beleuchtungsmittel flexibel ausgebildet und nach Art eines Abziehbildes auf einen Träger aufbringbar. Beispielsweise handelt es sich bei dem Träger um ein zu beleuchtendes Element. Das Beleuchtungsmittel kann in diesem Fall transparent und beidseitig emittiert ausgebildet sein, so dass im Betrieb des Beleuchtungsmittels das vom Beleuchtungsmittel zu beleuchtende Element sichtbar ist. Beispielsweise kann das Beleuchtungsmittel auf diese Weise auf eine Fliese aufgeklebt werden, die mittels des Beleuchtungsmittels hervorgehoben dargestellt wird.

Gemäß zumindest einer Ausführungsform eines hier beschriebenen Beleuchtungsmittels ist das Beleuchtungsmittel mittels Induktion oder kapazitiver Ansteuerung betreibbar. Das heißt, das Beleuchtungsmittel weist in diesem Fall keine externen Anschlussleiter auf, die mit einer Stromquelle verbunden sind. Vielmehr umfasst das Beleuchtungsmittel zum Beispiel eine Antenne, die zur Aufnahme elektromagnetischer Strahlung geeignet ist, mit der das Beleuchtungsmittel betrieben wird.

Gemäß zumindest einer Ausführungsform eines hier beschriebenen Beleuchtungsmittels handelt es sich um ein großflächiges Beleuchtungsmittel, das eine Vielzahl organischer Leuchtdioden aufweist. Die organischen Leuchtdioden können in diesem Fall beispielsweise in einer kombinierten Reihen- und Parallelschaltung angeordnet sein. Das großflächige, segmentierte Beleuchtungsmittel kann beispielsweise eine Deckleuchte oder einen Sonnenschutz bilden.

Gemäß zumindest einer Ausführungsform eines hier beschriebenen Beleuchtungsmittels umfasst das Beleuchtungsmittel zumindest zwei organische Leuchtdioden, die geeignet sind Licht voneinander unterschiedlicher Farben zu erzeugen.

Gemäß zumindest einer Ausführungsform eines hier beschriebenen Beleuchtungsmittels umfasst das Beleuchtungsmittel zumindest zwei organische Leuchtdioden, die mittels Anschlussleiter mechanisch miteinander verbunden sind. Neben einer mechanischen Stabilisierung des Beleuchtungsmittels dienen die Anschlussleiter dann auch zum elektrischen Kontaktieren der organischen Leuchtdioden des Beleuchtungsmittels.

Gemäß zumindest einer Ausführungsform eines hier beschriebenen Beleuchtungsmittels ist das Beleuchtungsmittel flexibel ausgebildet, derart, dass es verbiegbar ist. Dabei ist es möglich, dass das Beleuchtungsmittel nach dem Verbiegen seine Form beibehält. Das heißt, das Beleuchtungsmittel kann zum Beispiel vom Benutzer des Beleuchtungsmittels durch Biegen in eine gewünschte Form gebracht werden.

Gemäß zumindest einer Ausführungsform eines hier beschriebenen Beleuchtungsmittels weist das Beleuchtungsmittel eine Leuchtfläche auf, die einen Flächeninhalt von wenigstens 0,1 m² umfasst.

Gemäß zumindest einer Ausführungsform eines hier beschriebenen Beleuchtungsmittels weist das Beleuchtungsmittel eine Leuchtfläche mit einem Flächeninhalt von wenigstens 0,5 m² auf.

Gemäß zumindest einer Ausführungsform eines hier beschriebenen Beleuchtungsmittels weist das Beleuchtungsmittel eine Leuchtfläche mit einem Flächeninhalt von wenigstens 1,0 m² auf.

Gemäß zumindest einer Ausführungsform eines hier beschriebenen Beleuchtungsmittels weist das Beleuchtungsmittel eine Leuchtfläche mit einem Flächeninhalt von wenigstens 2,5 m² auf.

Gemäß zumindest einer Ausführungsform eines hier beschriebenen Beleuchtungsmittels weist das Beleuchtungsmittel eine Leuchtfläche mit einem Flächeninhalt von wenigstens 5,0 m² auf.

Gemäß zumindest einer Ausführungsform eines hier beschriebenen Beleuchtungsmittels weist das Beleuchtungsmittel eine Leuchtfläche mit einem Flächeninhalt von wenigstens 10,0 m² auf.

Gemäß zumindest einer Ausführungsform eines hier beschriebenen Beleuchtungsmittels dient das Beleuchtungsmittel zur Abdeckung einer Vorrichtung, die zum Kühlen oder Heizen eines Raums Verwendung findet. Beispielsweise handelt es sich bei der Vorrichtung um einen Heizkörper, eine Klimaanlage oder einen Belüftungsschacht.

Gemäß zumindest einer Ausführungsform eines hier beschriebenen Beleuchtungsmittels dient das Beleuchtungsmittel als einfache Temperaturanzeige. Beispielsweise umfasst das Beleuchtungsmittel in diesem Fall einen Temperatursensor, der die Umgebungstemperatur oder die Temperatur eines Objekts, mit dem das Beleuchtungsmittel verbunden ist, detektiert. Das Beleuchtungsmittel strahlt in diesem Fall Licht mit einem Farbort und/oder einer Farbtemperatur ab, die mit der gemessenen Temperatur korreliert ist.

Beispielsweise ist das Beleuchtungsmittel als Abdeckung direkt auf einem Heizkörper aufgebracht. In diesem Fall kann das Beleuchtungsmittel je nach Temperatur des Heizkörpers bläuliches Licht - für einen kalten Heizkörper - oder rötliches Licht - für einen warmen Heizkörper - emittieren.

Gemäß zumindest einer Ausführungsform eines hier beschriebenen Beleuchtungsmittels weist das Beleuchtungsmittel eine Rückwand auf, die zumindest eine Kühlvorrichtung umfasst. Bei der Kühlvorrichtung kann es sich beispielsweise um Kühllamellen, Kühlkanäle, oder eine Wasserkühlung handeln.

Gemäß zumindest einer Ausführungsform eines hier beschriebenen Beleuchtungsmittels ist das Beleuchtungsmittel mittels eines Befestigungsmittels an einem weiteren Element befestigbar. Beispielsweise handelt es sich bei dem Befestigungsmittel um einen Klebestreifen, einen Magneten, Schrauben, Klemmen oder einen Klettverschluss.

Gemäß zumindest einer Ausführungsform eines hier beschriebenen Beleuchtungsmittels weist das Beleuchtungsmittel eine Ansteuervorrichtung auf, mittels der das Beleuchtungsmittel flackernd betreibbar ist. Das heißt, das Beleuchtungsmittel emittiert Licht, das wie eine Kerze flackert. Dies kann beispielsweise durch eine zeitliche Variation der Stromstärke realisiert sein, mit der das Beleuchtungsmittel betrieben wird.

Gemäß zumindest einer Ausführungsform eines hier beschriebenen Beleuchtungsmittels dient das Beleuchtungsmittel als Schreibtischlampe zur Beleuchtung einer Arbeitsfläche.

Gemäß zumindest einer Ausführungsform eines hier beschriebenen Beleuchtungsmittels strahlt das Beleuchtungsmittel in gerichteter Weise elektromagnetische Strahlung ab. Das Beleuchtungsmittel kann dazu beispielsweise eine gerichtetes Licht abstrahlende organische Leuchtdiode umfassen. Darüber hinaus ist es möglich, dass das Beleuchtungsmittel eine strukturierte Strahlungsaustrittsfläche aufweist, die zu einer gerichteten Abstrahlung von Licht durch Lichtbrechung und/oder Lichtreflektion führt.

Gemäß zumindest einer Ausführungsform eines hier beschriebenen Beleuchtungsmittels findet das Beleuchtungsmittel als Leuchte zur Allgemeinbeleuchtung und als Raumteiler Verwendung. Das Beleuchtungsmittel kann in diesem Fall beispielsweise als großflächiges Beleuchtungsmittel ausgeführt sein, das nicht transparent und nicht klarsichtig ausgeführt ist, sondern diffus Licht streuend. Auf diese Weise kann das Beleuchtungsmittel auch als Sichtschutz dienen.

Gemäß zumindest einer Ausführungsform eines hier beschriebenen Beleuchtungsmittels handelt es sich bei dem Beleuchtungsmittel um ein beidseitig abstrahlendes Beleuchtungsmittel, das diffus Licht streuend ausgebildet ist. Das heißt, das Beleuchtungsmittel weist zumindest zwei gegenüberliegend angeordnete Strahlungsaustrittsflächen auf, durch die beispielsweise Licht das Beleuchtungsmittel verlassen kann. Das Beleuchtungsmittel ist dabei blickdicht ausgebildet, so dass es als Sichtschutz dient.

Gemäß zumindest einer Ausführungsform eines hier beschriebenen Beleuchtungsmittels ist das Beleuchtungsmittel aufrollbar und abrollbar ausgebildet. Beispielsweise kann das Beleuchtungsmittel dazu in einzelne Teilstücke unterteilt sein, die jeweils durch eine einzige organische Leuchtdiode oder zumindest zwei organische Leuchtdioden gebildet sind, die ihrerseits starr ausgebildet sein können. Darüber hinaus ist es möglich, dass das Beleuchtungsmittel vollflexibel ausgebildet ist und auf diese Weise abrollbar und aufrollbar ist. Das Beleuchtungsmittel kann in diesem Fall beispielsweise eine einzige organische Leuchtdiode umfassen, die flexibel ausgebildet ist.

Gemäß zumindest einer Ausführungsform eines hier beschriebenen Beleuchtungsmittels dient das Beleuchtungsmittel neben seiner Eigenschaft als Leuchte zur Allgemeinbeleuchtung auch zur Schalldämmung. Beispielsweise umfasst das Beleuchtungsmittel in diesem Fall ein Dämmmaterial, das zur akustischen Dämmung geeignet ist.

Gemäß zumindest einer Ausführungsform eines hier beschriebenen Beleuchtungsmittels ist das Beleuchtungsmittel als Jalousie ausgebildet. Das Beleuchtungsmittel umfasst dabei beispielsweise eine Vielzahl organischer Leuchtdioden, die über eine Haltevorrichtung elektrisch kontaktiert und mechanisch miteinander verbunden sind.

Gemäß zumindest einer Ausführungsform eines hier beschriebenen Beleuchtungsmittels dient das Beleuchtungsmittel zur Raumverdunkelung und/oder als Sichtschutz. Das heißt, das Beleuchtungsmittel kann eine Strahlungsaustrittsfläche aufweisen, die beispielsweise einem Fenster abgewandt ist. Die der Strahlungsaustrittsfläche abgewandte Seite des Beleuchtungsmittels kann eine strahlungsabsorbierende oder strahlungsreflektierende Fläche umfassen, die dem Fenster zugewandt ist.

Gemäß zumindest einer Ausführungsform eines hier beschriebenen Beleuchtungsmittels bilden zumindest Teile des Beleuchtungsmittels eine Häusung mit wenigstens einer Seitenwand und gegebenenfalls einer Decke. Das Beleuchtungsmittel oder zumindest Teile des Beleuchtungsmittels können dann beispielsweise eine Umkleidekabine, ein Wartehäuschen, einen Regenunterstand oder dergleichen bilden. Beispielsweise sind sämtliche Wände und Deckenteile der Häusung durch zumindest ein Beleuchtungsmittel gebildet.

Gemäß zumindest einer Ausführungsform eines hier beschriebenen Beleuchtungsmittels umfasst das Beleuchtungsmittel eine Lichtschranke, mittels der ein Betriebszustand des Beleuchtungsmittels geschaltet werden kann. Beispielsweise kann das Beleuchtungsmittel über die Lichtschranke ein- beziehungsweise ausgeschaltet werden.

Gemäß zumindest einer Ausführungsform eines hier beschriebenen Beleuchtungsmittels bildet das Beleuchtungsmittel eine Abtrennwand in einem Großraumbüro.

Gemäß zumindest einer Ausführungsform eines hier beschriebenen Beleuchtungsmittels bildet das Beleuchtungsmittel neben seinen Eigenschaften zur Allgemeinbeleuchtung einen Sonnenschutz. Das Beleuchtungsmittel kann in diesem Fall beispielsweise eine der Strahlungsaustrittsfläche des Beleuchtungsmittels abgewandte, absorbierend oder reflektierend ausgeschaltete Außenfläche aufweisen.

Gemäß zumindest einer Ausführungsform eines hier beschriebenen Beleuchtungsmittels umfasst das Beleuchtungsmittel zumindest eine Solarzelle, die zur Erzeugung von elektrischem Strom bei Bestrahlung mit Sonnenlicht geeignet ist. Beispielsweise ist die zumindest eine Solarzelle auf einer der Strahlungsaustrittsfläche des Beleuchtungsmittels gegenüberliegende Seite des Beleuchtungsmittels angeordnet. Das Beleuchtungsmittel kann darüber hinaus einen Akku umfassen, der mit Licht der Solarzelle aufladbar ist. Auf diese Weise kann beispielsweise eine tagsüber mittels der Solarzelle erzeugte Strommenge bei schlechten Sichtverhältnissen zur Lichterzeugung dienen.

Gemäß zumindest einer Ausführungsform eines hier beschriebenen Beleuchtungsmittels handelt es sich bei dem Beleuchtungsmittel um eine Notbeleuchtung. Beispielsweise ist die Notbeleuchtung mittels vom Beleuchtungsmittel erzeugten Solarstroms betreibbar.

Gemäß zumindest einer Ausführungsform eines hier beschriebenen Beleuchtungsmittels bildet das Beleuchtungsmittel zumindest den Teil eines Bekleidungsstückes oder einer Tasche. Das Beleuchtungsmittel kann in diesem Fall zumindest eine organische Leuchtdiode mit einem Retro-Reflektor umfassen, so dass das Beleuchtungsmittel auch im ausgeschalteten Betriebszustand die Sichtbarkeit des Verwenders des Beleuchtungsmittels erhöht.

Gemäß zumindest einer Ausführungsform eines hier beschriebenen Beleuchtungsmittels handelt es sich bei dem Beleuchtungsmittel um einen Regenschirm. Der Regenschirm kann als Lichtquelle eine organische Leuchtdiode und/oder zumindest eine anorganische Leuchtdiode umfassen. Darüber hinaus ist es möglich, dass der Regenschirm sowohl anorganische als auch organische Leuchtdioden als Lichtquellen umfasst.

Gemäß zumindest einer Ausführungsform eines hier beschriebenen Beleuchtungsmittels ist das Beleuchtungsmittel in das Fenster eines Kraftfahrzeuges integriert. Dabei ist es möglich, dass nur Teile des Fensters eine organische Leuchtdiode umfassen. Darüber hinaus ist es aber auch möglich, dass das gesamte Fenster des Kraftfahrzeuges durch eine transparente, organische Leuchtdiode gebildet ist. Beispielsweise können sämtliche Fenster des Kraftfahrzeuges dann durch organische Leuchtdioden gebildet sein.

Gemäß zumindest einer Ausführungsform eines hier beschriebenen Beleuchtungsmittels bildet das Beleuchtungsmittel eine Anzeigevorrichtung oder ein Signallicht eines Kraftfahrzeugs. Beispielsweise ist das Beleuchtungsmittel ein Bremslicht, ein Blinklicht, ein Rücklicht oder dergleichen. Das Beleuchtungsmittel kann dabei zumindest den Teil eines Fensters eines Kraftfahrzeugs bilden.

Gemäß zumindest einer Ausführungsform eines hier beschriebenen Beleuchtungsmittels bildet das Beleuchtungsmittel ein Warnschild oder ein Verkehrsschild.

Im Folgenden werden die hier beschriebenen organischen Leuchtdioden sowie die hier beschriebenen Beleuchtungsmittel anhand von Ausführungsbeispielen zu den zugehörigen Figuren näher erläutert.
- Die Figur 1: zeigt anhand eines schematischen Banddiagramms den Aufbau einer organischen Leuchtdiode gemäß einem Ausführungsbeispiel.
- Die Figur 2: zeigt anhand einer schematischen Schnittdarstellung den Aufbau einer organischen Leuchtdiode gemäß einem Ausführungsbeispiel.
- Die Figur 3: zeigt anhand einer schematischen Schnittdarstellung den Aufbau einer organischen Leuchtdiode gemäß einem Ausführungsbeispiel, wobei die organische Leuchtdiode 1 im Betrieb weißes Licht emittiert.
- Die Figur 4: zeigt eine transparente erste Elektrode für ein Ausführungsbeispiel einer hier beschriebenen organischen Leuchtdiode.
- Die Figur 5: zeigt eine transparente zweite Elektrode für ein Ausführungsbeispiel einer hier beschriebenen organischen Leuchtdiode.
- Die Figuren 6A, 6B, 6C und 6D: zeigen anhand schematischer Schnittdarstellungen den Aufbau von organischen Leuchtdioden gemäß verschiedener Ausführungsbeispiele, die im ausgeschalteten Betriebszustand einen gewünschten farbigen Eindruck erwecken.
- Die Figur 7: zeigt anhand einer schematischen Draufsicht ein Ausführungsbeispiel einer mittels eines Verbindungsmittels verkapselten organischen Leuchtdiode.
- Die Figur 8: zeigt anhand einer schematischen Schnittdarstellung ein Ausführungsbeispiel einer mittels eines Verbindungsmittels verkapselten organischen Leuchtdiode.
- Die Figur 9: zeigt anhand einer schematischen Schnittdarstellung ein Ausführungsbeispiel zur Verkapselung einer organischen Leuchtdiode.
- Die Figuren 10 bis 13, 14A und 14B: zeigen anhand schematischer Schnittdarstellungen Ausführungsbeispiele von organischen Leuchtdioden, die mittels Lackschichten, Isolationsschichten, Diffusionsbarrieren, Dünnfilmverkapselungen und/oder Vor-Verkapselungsschichten versiegelt sind.
- Die Figuren 15 bis 19: zeigen anhand schematischer Schnittdarstellungen Ausführungsbeispiele von organischen Leuchtdioden, die mittels einer Verkapselungsschichtenfolge versiegelt sind.
- Die Figur 20: zeigt anhand einer schematischen Schnittdarstellung ein Ausführungsbeispiel einer organischen Leuchtdiode mit einer Sputterschutzschicht.
- Die Figuren 21 bis 25: zeigen anhand schematischer Darstellungen den Aufbau von organischen Leuchtdioden mit gerichtetem Abstrahlprofil gemäß verschiedenen Ausführungsbeispielen.
- Die Figuren 26A, 26B und 27: zeigen anhand schematischer Schnittdarstellungen den Aufbau von Ausführungsbeispielen organischer Leuchtdioden, die zur Beleuchtung eines zu beleuchtenden Elements Verwendung finden.
- Die Figur 28: zeigt anhand einer schematischen Schnittdarstellung den Aufbau eines Ausführungsbeispiels einer organischen Leuchtdiode 1, der ein Wellenlängenkonversionsstoff nachgeordnet ist.
- Die Figuren 29 und 30: zeigen anhand schematischer Schnittdarstellungen Ausführungsbeispiele organischer Leuchtdioden, die jeweils einen Retro-Reflektor aufweisen.
- Die Figuren 31A und 31B: zeigen anhand schematischer Schnittdarstellungen ein Ausführungsbeispiel einer hier beschriebenen organischen Leuchtdiode, bei dem die organische Leuchtdiode einen Berührungssensor umfasst.
- Die Figuren 32A bis 32I: zeigen anhand schematischer Darstellungen Ausführungsbeispiele eines hier beschriebenen Beleuchtungsmittels, das eine Weckfunktion besitzt.
- Die Figuren 33A bis 33D: zeigen anhand schematischer Darstellungen Ausführungsbeispiele eines hier beschriebenen Beleuchtungsmittels, das einen Spritzwasserschutz darstellt.
- Die Figuren 34A, 34B, 34C und 35: zeigen anhand schematischer Darstellungen weitere Ausführungsbeispiele eines Beleuchtungsmittels, das einen Spritzwasserschutz darstellt.
- Die Figuren 36, 37A, 37B, 38, 39A, 39B, 40A, 40B: zeigen anhand schematischer Darstellungen Ausführungsbeispiele eines hier beschriebenen Beleuchtungsmittels mit Duschkopf.
- Die Figuren 41A bis 41D und 42A bis 42C: zeigen anhand schematischer Darstellungen ein Ausführungsbeispiel eines hier beschrieben Beleuchtungsmittels, das als Spiegel genutzt werden kann.
- Die Figuren 43 und 44A, 44B: zeigen anhand schematischer Darstellungen ein Ausführungsbeispiel eines hier beschrieben Beleuchtungsmittels, das als Fliese genutzt werden kann.
- Die Figuren 45A bis 45C und 46A, 46B: zeigen anhand schematischer Darstellungen ein Ausführungsbeispiel eines hier beschriebenen Beleuchtungsmittels, das eine großflächige Deckenleuchte bildet.
- Die Figuren 47A bis 47D, 48 bis 49A, 49B: zeigen anhand schematischer Darstellungen ein Ausführungsbeispiel eines hier beschriebenen Beleuchtungsmittels, das zur Abdeckung eines Objekts dient.
- Die Figuren 50A bis 50D: zeigen anhand schematischer Darstellungen Ausführungsbeispiele von hier beschriebenen Beleuchtungsmitteln 2, die als großflächige Schreibtischleuchten Verwendung finden können.
- Die Figuren 51A, 51B, 52A bis 52C und 53: zeigen anhand schematischer Darstellungen Ausführungsbeispiele von hier beschriebenen Beleuchtungsmitteln 2, die als Raumteiler Verwendung finden können.
- Die Figuren 54A bis 54C: zeigen anhand schematischer Darstellungen Ausführungsbeispiele von hier beschriebenen Beleuchtungsmitteln 2, die als Jalousien Verwendung finden können.
- Die Figuren 55A bis 55D: zeigen anhand schematischer Darstellungen Ausführungsbeispiele von hier beschriebenen Beleuchtungsmitteln 2, die als Umkleidekabinen Verwendung finden können.
- Die Figuren 56A bis 56C: zeigen anhand schematischer Darstellungen ein Ausführungsbeispiel eines hier beschriebenen Beleuchtungsmittels, das als Sonnenschutz Verwendung finden kann.
- Die Figuren 57A und 57B: zeigen anhand schematischer Darstellungen ein Ausführungsbeispiel eines hier beschriebenen Beleuchtungsmittels, das eine Tasche bildet.
- Die Figuren 58A und 58B: zeigen anhand schematischer Darstellungen ein Ausführungsbeispiel eines hier beschriebenen Beleuchtungsmittels, das als Notleuchte dient.
- Die Figur 59: zeigt anhand einer anhand einer schematischen Darstellung ein Ausführungsbeispiel eines hier beschriebenen Beleuchtungsmittels, das als Werbemittel an Fahrzeugen Verwendung finden kann.
- Die Figuren 60A bis 60D: zeigen anhand schematischer Darstellungen ein Ausführungsbeispiel eines hier beschriebenen Beleuchtungsmittels, das als Regenschirm dient.
- Die Figuren 61A bis 61C: zeigen anhand schematischer Darstellungen Ausführungsbeispiele von Beleuchtungsmitteln, die als Signallampen in einem Kraftfahrzeug Verwendung finden.
- Die Figuren 62 und 63: zeigen anhand einer schematischen Darstellung Ausführungsbeispiele eines Beleuchtungsmittels, das zur Beleuchtung in einem Kraftfahrzeug Verwendung findet.
- Die Figuren 64A bis 64C: zeigen anhand schematischer Darstellungen Ausführungsbeispiele eines Beleuchtungsmittels, das als Warnschild Verwendung findet.
- Die Figuren 65A bis 65C: zeigen anhand schematischer Darstellungen Ausführungsbeispiele eines Beleuchtungsmittels, das einen Regenschutz bildet.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

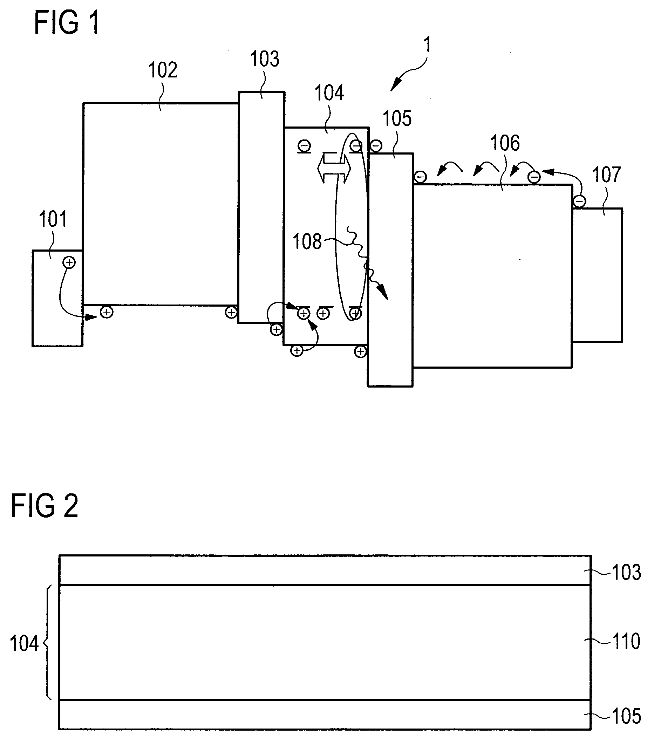

Die Figur 1 zeigt anhand eines schematischen Banddiagramms den Aufbau einer organischen Leuchtdiode 1 gemäß einem Ausführungsbeispiel.

Die organische Leuchtdiode 1 umfasst eine erste Elektrode 101. Bei der ersten Elektrode handelt es sich beispielsweise um eine Anode. Über die erste Elektrode 1 werden positive Ladungsträger - so genannte Löcher - in die organische Leuchtdiode eingeprägt.

An die erste Elektrode 101 grenzt die Lochtransportschicht 102. Die Lochtransportschicht 102 transportiert die positiven Ladungsträger zum strahlungsemittierenden Bereich 104 der organischen Leuchtdiode 1 hin.

Der Lochtransportschicht 102 folgt einer Elektronenbarriereschicht 103 nach, welche das Eindringen von Elektronen aus dem strahlungsemittierenden Bereich 104 in die Lochtransportschicht 102 verhindert.

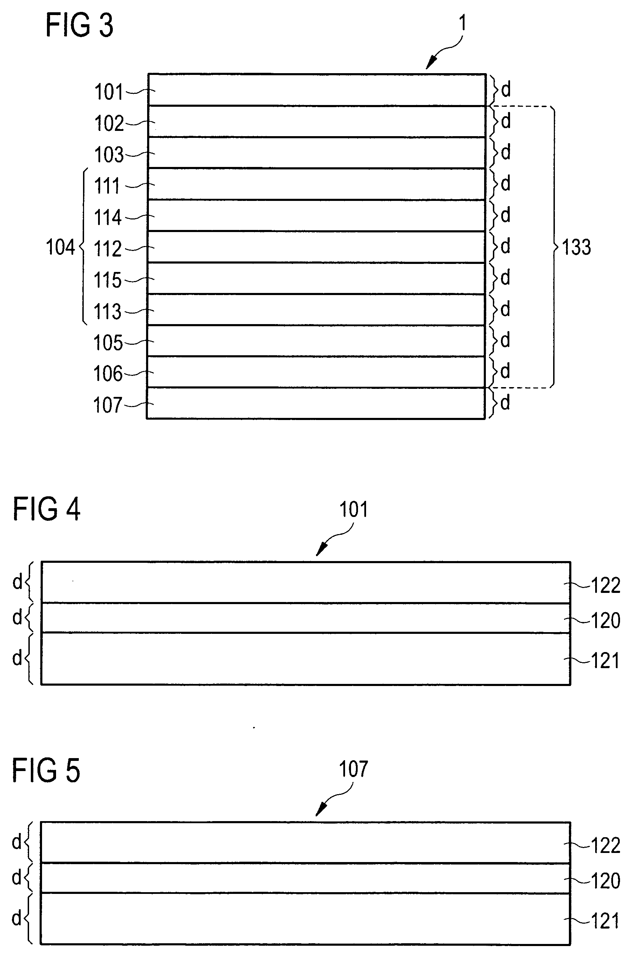

Der Elektronenbarriereschicht 3 folgt der strahlungsemittierende Bereich 104 nach. Im Betrieb der organischen Leuchtdiode 1 wird im strahlungsemittierenden Bereich elektromagnetische Strahlung erzeugt. Im strahlungsemittierenden Bereich kommt es also zur Emission 108 von elektromagnetischer Strahlung. Vorzugsweise wird dabei elektromagnetische Strahlung im Spektralbereich von Infrarotstrahlung bis UV-Strahlung erzeugt. Der strahlungsemittierende Bereich ist beispielsweise anhand der Figuren 2 und 3 näher erläutert.

Dem strahlungsemittierenden Bereich 104 folgt eine Lochbarriereschicht 105 nach, welche das Eindringen von positiven Ladungsträgern in die angrenzende Elektronentransportschicht 106 verhindert.

Die Elektronentransportschicht 106 grenzt an die Lochbarriereschicht 105 an und transportiert negative Ladungsträger - Elektronen - von der als Kathode ausgebildeten zweiten Elektrode 107 zum strahlungsemittierenden Bereich 104.

Die Lochtransportschicht 102 und die Elektronentransportschicht 106 sind erste und zweite Ladungsträgertransportschichten. Die Lochtransportschicht 102 und die Elektronentransportschicht 106 umfassen beispielsweise ein Matrixmaterial, das p- beziehungsweise n-dotiert ist.

Das Matrixmaterial kann je nach Ausführung der Ladungsträgertransportschicht als Lochtransportschicht 102 oder als Elektronentransportschicht 106 aus einer Gruppe ausgewählt sein, die Phenanthrolinderivate, Imidazolderivate, Triazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie Kombinationen aus zumindest zwei oder mehreren der genannten Materialien umfasst.

Für eine als Lochtransportschicht 102 ausgebildete Ladungsträgertransportschicht eignen sich insbesondere folgende Matrixmaterialien:
N,N'-Bis(naphthalen-1-yl)-N,N'-bis(phenyl)-benzidin (NPB),
N,N'-Bis(naphthalen-2-yl)-N,N'-bis(phenyl)-benzidin (β-NPB),
N,N'-Bis(3-methylphenyl)-N,N'-bis(phenyl)-benzidin (TPD),
N,N'-Bis(3-methylphenyl)-N,N'-bis(phenyl)-9,9-spirobifluoren (Spiro-TPD),
N,N'-Bis(naphthalen-1-yl)-N,N'-bis(phenyl)-9,9-spirobifluoren (Spiro-NPB),
N,N'-Bis(3-methylphenyl)-N,N'-bis(phenyl)-9,9-dimethyl-fluoren (DMFL-TPD),
N,N'-Bis(naphthalen-1-yl)-N,N'-bis(phenyl)-9,9-dimethylfluoren (DMFL-NPB),
N,N'-Bis-(3-methyIphenyl)-N,N'-bis(phenyl)-9,9-diphenyl-fluoren (DPFL-TPD),
N,N'-Bis(naphthalen-1-yl)-N,N'-bis(phenyl)-9,9-diphenyl-fluoren (DPFL-NPB),
2,2',7,7'-Tetrakis(N,N-diphenylamino)-9,9'-spirobifluoren (Spiro-TAD),
9,9-Bis[4-(N,N-bis-biphenyl-4-yl-amino)phenyl]-9H-fluoren (BPAPF),
9,9-Bis [4-(N,N-bis-naphthalen-2-yl-amino)phenyl]-9H-fluoren (NPAPF),
9,9-Bis[4-(N,N'-bis-naphthalen-2-yl-N,N'-bis-phenyl-amino)-phenyl]-9H-fluoren (NPBAPF),
2,2',7,7'-Tetrakis [N-naphthalenyl(phenyl)-amino]-9,9-spirobifluoren (Spiro-2NPB),
N,N'-Bis(phenanthren-9-yl)-N,N'-bis(phenyl)-benzidin (PAPB),
2,7-Bis[N,N-bis(9,9-spiro-bifluorene-2-yl)-amino]-9,9-spirobifluoren (Spiro-S),
2,2'-Bis[N,N-bis(biphenyl-4-vl)amino]-9,9-spirobifluoren (2,2'-Spiro-DBP),
2,2'-Bis(N,N-di-phenyl-amino)-9,9-spirobifluoren (Spiro-BPA).

Der Dotierstoff für die Lochtransportschicht 102 ist ein p-Dotierstoff und kann dabei ein Metalloxid, eine metallorganische Verbindung, ein organisches Material oder eine Mischung daraus aufweisen oder sein. Der Dotierstoff kann zusätzlich oder alternativ eine Mehrzahl verschiedener Metalloxide und/oder eine Mehrzahl verschiedener metallorganischer Verbindungen und/oder einer Mehrzahl verschiedener organischer Verbindungen aufweisen. Insbesondere kann der Dotierstoff Lewis-Säure-Charakter haben oder eine Lewis-Säure sein. Lewis-Säuren, das heißt Elektronenpaarakzeptoren, können besonders gut geeignet sein zur Bildung von Charge-Transfer-Komplexen.

Der Dotierstoff kann eines oder mehrere Metalloxide mit einem oder mehreren Metallen aufweisen, wobei die Metalle ausgewählt sind aus Wolfram, Molybdän, Vanadium und Rhenium. Besonders bevorzugt kann der Dotierstoff eines oder mehrere der Metalloxide WO₃, MoO₃, V₂O₅, Re₂O₇ und Re₂O₅ aufweisen. Während Rheniumpentoxid geeignet ist, als Dotierstoff eine Lochtransportschicht 102 mit einem blauen Farbeindruck zu ermöglichen, sind die anderen genannten Metalloxide geeignet, einen gelben bis orangefarbigen Farbeindruck zu ermöglichen. Insbesondere Oxide des Rheniums sind Lewis-Säuren, die bei einer Temperatur von weniger als 250°C und bei einem Druck von 10⁻⁶ mbar leicht verdampfbar sind und sich daher gut für eine p-Dotierung eignen. Experimentell konnte gezeigt werden, dass sich die Dotierungseigenschaften hinsichtlich der elektronischen Eigenschaften der Lochtransportschicht 102 von Rheniumpentoxid und Rheniumheptoxid nur wenig unterscheiden, so dass derartige Metalloxide je nach vorbestimmten Farbeindruck gewählt werden können. Die anderen genannten Metalloxide zeigen ähnliche Verarbeitungseigenschaften zur p-Dotierung.

Weiterhin kann der Dotierstoff zur p-Dotierung der Lochtransportschicht 102 auch metallorganische Verbindungen mit Lewis-Säure-Charakter aufweisen. Insbesondere bei metallorganischen Verbindungen beziehungsweise Komplexen mit Schaufelradstruktur ist der Lewis-Säure-Charakter der axialen Position besonders ausgeprägt.

Ferner können die metallorganischen Verbindungen Ruthenium und/oder Rhodium aufweisen. Beispielsweise kann der Dotierstoff als metallorganische Verbindung ein Trifluoroacetat (TFA) aufweisen, beispielsweise Di-rhodiumtetra-trifluoroacetat (Rh₂(TFA)₄), das mit (NPB) einen bläulichen Farbeindruck erwecken kann, oder die isoelektronische Rutheniumverbindung Ru₂(TFA)₂(CO)₂, die einen orangefarbigen Farbeindruck ermöglicht.

Weiterhin kann der Dotierstoff zur p-Dotierung organische Materialien aufweisen, die aromatische funktionelle Gruppen aufweisen oder aromatische organische Materialien sind. Insbesondere kann der Dotierstoff aromatische Materialien mit einer ausgeprägten Anzahl von Fluor- und/oder Cyanid(CN)-Substituenten aufweisen.

Für eine als Elektronentransportschicht 106 ausgebildete Ladungsträgertransportschicht eignen sich insbesondere auch folgende Matrixmaterialien:
8-Hydroxyquinolinolato-lithium (Liq),
2,2',2"-(1,3,5-Benzinetriyl)-tris(1-phenyl-1-H-benzimidazol) (TPBi),
2-(4-Biphenylyl)-5-(4-tert-butylphenyl)-1,3,4-oxadiazol (PBD),
2,9-Dimethyl-4,7-diphenyl-1,10-phenanthrolin (BCP),
4,7-Diphenyl-1,10-phenanthrolin (BPhen),
Bis-(2-methyl-8-quinolinolat)-4-(phenylphenolato)aluminium (BAlq),
1,3-Bis[2-(2,2'-bipyridin-6-yl)-1,3,4-oxadiazo-5-yl]benzen (Bpy-OXD),
6,6'-Bis[5-(biphenyl-4-yl)-1,3,4-oxadiazo-2-yl]-2,2'-bipyridyl (BP-OXD-Bpy),
3-(4-Biphenylyl)-4-phenyl-5-tert-butylphenyl-1,2,4-triazol (TAZ),
4-(Naphthalen-1-yl)-3,5-diphenyl-4H-1,2,4-triazol (NTAZ),
2,9-Bis(naphthalen-2-yl)-4,7-diphenyl-1,10-phenanthrolin (NBphen),
2,7,-Bis[2-(2,2'-bipyridin-6-yl)-1,3,4-oxadiazo-5-yl]-9,9-dimethylfluoren (Bby-FOXD),
1,3-Bis[2-(4-tert-butylphenyl)-1,3,4-oxadiazo-5-yl]benzen (OXD-7).

Für eine Elektronentransportschicht 106 wird das Matrixmaterial n-dotiert. Das kann bedeuten, dass der Dotierstoff eine n-Dotierung des Matrixmaterials der ersten Ladungsträgertransportschicht ermöglicht. Insbesondere kann der Dotierstoff als Elektronendonator mit einem niedrigen Ionisierungspotential, das heißt einem hoch liegenden HOMO (Highest Occupied Molecular Orbital), ausgebildet sein.

Der Dotierstoff kann dabei ein Alkalimetallsalz, ein Erdalkalimetallsalz, eine metallorganische Verbindung oder eine Mischung daraus aufweisen oder sein. Der Dotierstoff kann zusätzlich oder alternativ eine Mehrzahl verschiedener Alkalimetallsalze und/oder eine Mehrzahl verschiedener Erdalkalimetallsalze und/oder einer Mehrzahl verschiedener metallorganischer Verbindungen aufweisen. Insbesondere kann der Dotierstoff ein Carbonat aufweisen. Weiterhin kann der Dotierstoff besonders bevorzugt Cäsium aufweisen. Beispielsweise Cs₂CO₃ kann in BCP oder in BPhen als Matrixmaterial einen bläulichen Farbeindruck erwecken.

Weiterhin kann der Dotierstoff zur n-Dotierung ein Metallocen aufweisen, also eine metallorganische Verbindung mit einem Metall M und zwei Cyclopentadienylresten (Cp) in der Form M(Cp)₂. Alternativ oder zusätzlich kann der Dotierstoff auch einen Metall-Hydropyrimidopyrimidin-Komplex aufweisen. Das Metall kann beispielsweise Wolfram, Molybdän und/oder Chrom umfassen oder sein.

Beispielsweise können Chromocen oder Decamethylchromocen graufarbige Farbeindrücke für eine n-dotierte Elektronentransportschicht 106 ermöglichen, während metallorganische Verbindungen mit 1,2,4,6,7,8-Hexahydro-2H-pyrimido[1,2-a]pyrimidin (hpp) wie etwa W₂(hpp)₄, MO₂(hpp)₄ und Cr₂(hpp)₄ rote bis orangefarbige Farbeindrücke ermöglichen.

Die hier genannten Matrixmaterialien der Ladungsträgertransportschichten 102, 106 und die hier genannten Dotierstoffe für die Matrixmaterialien können Charge-Transfer-Komplexe bilden, die einen Teil einer von außen auf die organische Leuchtdiode 1 fallenden elektromagnetischen Strahlung mit einem ersten Absorptionsspektrum absorbieren und in einem ausgeschalteten elektronischen Betriebszustand einen vorbestimmten Farbeindruck des Bauelements hervorrufen, der beispielsweise durch die erste Elektrode 101 hindurch von einem externen Beobachter wahrnehmbar ist. Dabei bilden das Matrixmaterial und der Dotierstoff Elektronen-Donor-Akzeptor-Komplexe, deren Absorptionsbande vorzugsweise im sichtbaren Wellenlängenbereich liegen. Die Absorptionsbande der Charge-Transfer-Komplexe hängt dabei von der jeweiligen energetischen Lage ihrer HOMOs (Highest Occupied Molecular Orbital) und LUMOs (Lowest Unoccupied Molecular Orbital) relativ zueinander ab. Die Charge-Transfer-Komplexe können somit zusätzlich zu der Ladungsträgerleitfähigkeit für Löcher und/oder für Elektronen, das erste Absorptionsspektrum aufweisen, das den vorbestimmten Farbeindruck ermöglichen kann.

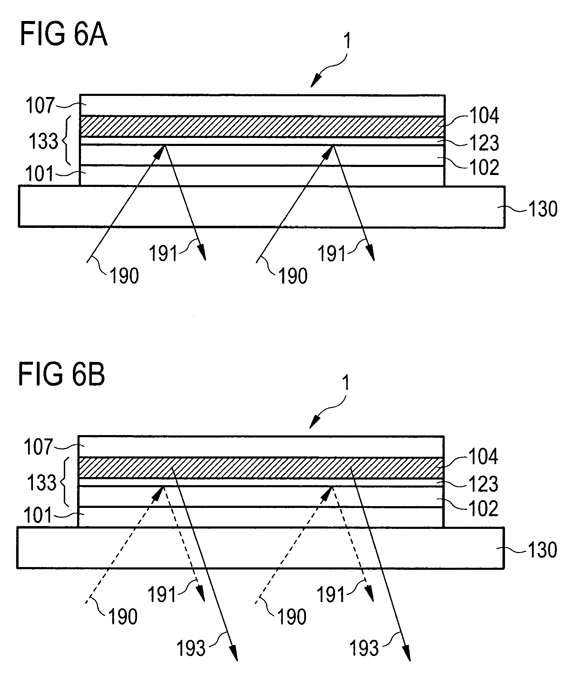

Durch eine geeignete Wahl des Matrixmaterials und des Dotierstoffs, zumindest der Ladungsträgertransportschicht, welche an eine strahlungsdurchlässige oder transparente Elektrode grenzt, können elektronische Eigenschaften im Hinblick auf die elektronische Funktionsfähigkeit der organischen Leuchtdiode, wie etwa elektrische Leitfähigkeit und/oder die Ladungsträgerinjektion, und gleichzeitig der vorbestimmte Farbeindruck für das gewünschte äußere Erscheinungsbild, zumindest im ausgeschalteten elektronischen Betriebszustand, gewährleistet werden (siehe dazu auch die Ausführungsbeispiele der Figuren 6A bis 6D).

Bei der ersten Elektrode 101 handelt es sich beispielsweise um eine transparente Anode. Die erste Elektrode 101 ist daher vorzugsweise für im strahlungsemittierenden Bereich 104 erzeugte elektromagnetische Strahlung zumindest teilweise durchlässig. Vorzugsweise ist die erste Elektrode 101 für diese Strahlung transparent. Dabei kann die erste Elektrode beispielsweise ein transparentes, leitendes Oxid aufweisen oder aus einem transparenten, leitenden Oxid bestehen. Transparente, leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃, gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter, leitender Oxide, zu der Gruppe der TCOs. Weiterhin entsprechen die TCOs nicht zwingend einer stöchiometrischen Zusammensetzung und können auch p- oder n-dotiert sein.

Die zweite Elektrode 107 kann als Kathode ausgeführt sein und somit als Elektronen-injizierendes Material dienen. Die zweite Elektrode 107 kann eine reflektierend ausgestaltete Kathode sein, die im strahlungsemittierenden Bereich 104 erzeugte elektromagnetische Strahlung zumindest teilweise reflektiert. Vorzugsweise beträgt die Reflektivität dann wenigstens 70 %, wenigstens 80% oder besonders bevorzugt wenigstens 90 %.

Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Zusätzlich kann die zweite Elektrode 107 auf einer dem strahlungsemittierenden Bereich 104 zugewandten Seite eine Schicht umfassend LiF aufweisen, das gute Elektroneninjektionseigenschaften aufweist. Alternativ oder zusätzlich kann die zweite Elektrode auch eines der oben genannten TCOs oder eine Schichtenfolge aus TCO-Schichten und einer Metallschicht aufweisen. Die zweite Elektrode 107 kann dann ebenfalls transparent sein.

Alternativ kann die erste Elektrode 101 auch als Kathode und die zweite Elektrode 107 als Anode ausgeführt sein.

Die Elektronenbarriereschicht 103 kann beispielsweise α-NPD (N,N'-Di-1-Naphthyl-N,N'-diphenyl-4,4'-diamino-biphenyl) enthalten oder aus diesem bestehen.

Dieses Material weist ein HOMO von -5 ± 0,4 eV und ein LUMO von mehr als -2,2 eV auf. Die Lochmobilität beträgt etwa 10⁻⁴ cm²/Vs.

Die Lochbarriereschicht 105 kann als Material BCP oder BPhen aufweisen. Wichtig ist hier die Elektronenmobilität von mehr als 10⁻⁶ cm²/Vs, vorzugsweise mehr als 10⁻⁵ cm²/Vs, bei einer sehr geringen bis gar keinen Lochmobilität.

Die Figur 2 zeigt anhand einer schematischen Schnittdarstellung eine Ausschnittsvergrößerung einer hier beschriebenen organischen Leuchtdiode 1. Die Figur 2 zeigt dabei den strahlungsemittierenden Bereich 104, an welchen die Elektronenbarriereschicht 103 und die Lochbarriereschicht 105 grenzen. Vorliegend umfasst der strahlungsemittierende Bereich 104 eine Emissionsschicht. Die Emissionsschicht 101 umfasst zumindest ein organisches Material, welches unter Bestromung zur Erzeugung von elektromagnetischer Strahlung geeignet ist.

Beispielsweise kann das Material der Emissionsschicht 101 zur Erzeugung von infraroter Strahlung geeignet sein. Die Emissionsschicht 101 enthält dann beispielsweise zumindest eines der folgenden Materialien: Yb--tris(8-Hydroxychinolin), Er-tris(8-Hydroxychinolin), YbQ3, ErQ3.

Ferner ist es möglich, dass die Emissionsschicht 101 Emittermaterialien zur Erzeugung von rotem, grünem und/oder blauem Licht aufweist, die in Matrixmaterialien eingebettet sein können. Beispielsweise sind geeignete Emittermaterialien in Verbindung mit der Figur 3 beschrieben.

Die Figur 3 zeigt anhand einer schematischen Schnittdarstellung ein weiteres Ausführungsbeispiel einer hier beschriebenen organischen Leuchtdiode 1. Anhand der Figur 3 ist verdeutlicht, dass der strahlungsemittierende Bereich 104 mehrere Emissionsschichten 111, 112, 113 aufweisen kann.

Bei der ersten Emissionsschicht 111 handelt es sich beispielsweise um eine Emissionsschicht, die geeignet ist, rotes Licht zu emittieren. Die Emissionsschicht 101 enthält dann zum Beispiel das folgende, phosphoreszente Emittermaterial: Ir(DBQ)₂acac (Iridium(III)bis(2-methyldibenzo-[f,h]quinoxalin)(acetylacetonat)). Dieses Emittermaterial hat eine Hauptemissionswellenlänge von über 600 nm, und im CIE-Diagramm von 1931 einen x-Wert von > 0,6 und einen y-Wert von < 0,36.

Die rote Emissionsschicht 101 kann eine Matrix aufweisen, die Löcher transportiert. Ein geeignetes Matrixmaterial ist α-NPD (N,N'-di-1-naphthyl-N,N'-diphenyl-4,4'-diamino-biphenyl). Das Material weist ein HOMO von -5,5 ± 0,4 eV und ein LUMO von -2,1 ± 0,4 eV auf. Die Lochmobilität beträgt etwa 10⁻⁴ cm²/Vs und die Triplettlage T1 liegt bei über 1,8 eV.

Bei der zweiten Emissionsschicht 112 handelt es sich beispielsweise um eine Emissionsschicht, die im Betrieb der organischen Leuchtdiode 1 grünes Licht emittiert. Die Emissionsschicht 112 enthält dann beispielsweise ein grünes Emittermaterial, das in einem ersten und zweiten Matrixmaterial eingebettet sein kann. Als grünes Emittermaterial kann beispielsweise Irppy (fac-Tris(2-phenyl-pyridyl)-iridium) eingesetzt werden. Das Material hat eine Hauptemissionswellenlänge bei 500 bis 570 nm und im CIE-Diagramm von 1931 einen x-Wert von etwa 0,37 und einen y-Wert von etwa 0,6.

Ein Loch transportierendes, erstes Matrixmaterial in der zweiten Emissionsschicht 112 kann beispielsweise TCTA (4,4',4"-Tris(carbazol-9-yl)triphenylamin) sein, oder es kann CBP (4,4'-Bis(carbazol-9-yl)biphenyl) sein.

Diese Materialien haben ein HOMO von -6,0 bis - 5,3 eV und ein LUMO von -2,3 ± 0,1 eV, ein T1 von über 2,5 eV und eine Lochmobilität von etwa 10⁻⁴ cm²/Vs.

Ein Elektronen leitendes, zweites Matrixmaterial in der zweiten Emissionsschicht 112 ist beispielsweise BCP oder BPhen, wobei die Elektronenmobilität größer als 10⁻⁵ cm²/Vs, vorzugsweise 10⁻⁴ cm²/Vs sein sollte.

Bei der dritten Emissionsschicht 113 handelt es sich dann beispielsweise um eine Emissionsschicht, die im Betrieb der organischen Leuchtdiode 1 blaues Licht emittiert. Die blaue, dritte Emissionsschicht 113 kann eine fluoreszente Emissionsschicht sein, mit dem blauen fluoreszenten Emittermaterial DPVBi (4,4'-Bis(2,2-diphenyl-ethen-1-yl)-diphenyl)

Dieses Material hat eine Hauptemissionswellenlänge bei 450 bis 770 nm, eine Halbwertsbreite von etwa 60 nm und im CIE-Diagramm von 1931 x-Werte von 0,14 bis 0,22 und y-Werte von 0,11 bis 0,20.

Das blaue Emittermaterial kann in einer Elektronen leitenden Matrix vorhanden sein, die als Material TBADN (2-tert-Butyl-9,10-di(2-naphhtyl)anthracen) umfassen kann. Dieses Material weist ein HOMO von -5,8 bis -5,3 eV und ein LUMO von -2,5 bis -1,8 eV auf. Die Bandlücke beträgt mehr als 3 eV und die Elektronenmobilität ist größer als 10⁻⁶ cm²/Vs, vorzugsweise größer als 10⁻⁵ cm²/Vs.

Insgesamt wird beim Betrieb der organischen Leuchtdiode 1 im strahlungsemittierenden Bereich 104 von den drei Emissionsschichten 111, 112 und 113 weißes Mischlicht emittiert.

Die erste Elektrode 101 und die zweite Elektrode 107 können wie in Verbindung mit der Figur 1 angegeben gewählt sein. Ferner können die Lochtransportschicht 102, die Elektronenbarriereschicht 103, die Lochbarriereschicht 105 und die Elektronentransportschicht 106, wie in Verbindung mit der Figur 1 beschrieben, gewählt sein.

Im Ausführungsbeispiel der Figur 3 ist für die Lochtransportschicht 102 beispielsweise die Verwendung zumindest eines der folgenden Matrixmaterialien vorteilhaft: 1-TNATA (4,4',4"-Tris(N-(naphth-1-yl)-N-phenyl-amino)triphenylamin), MTDATA (4,4',4"-Tris(N-3-metylphenyl-N-phenyl-amino)triphenylamin), , 2-TNATA (4,4',4"-Tris(N-(naphth-2-yl)-N-phenyl-amino)triphenylamin), α-NPB (N,N'-Bis(napthalen-1-yl)-N,N'-bis(phenyl)benzidin), β-NPB (N,N'-Bis(naphthalen-2-yl)-N,N'-bis(phenyl)benzidin), TPD (N,N'-Bis(3-methylphenyl)-N,N'-bis(phenyl)benzidin), spTAD (2,2',7,7'-Diphenylamino-spiro-9,9'-bifluoren), Cu-PC (Phthalocyaninkupferkomplexe), weitere Phthalocyanin-MetallKomplexe, Pentacen und TAPC (1,1-Bis-[(4-phenyl-)-bis-(4', 4"-methyl-phenyl)-amino]-cyclohexan).

Diese Materialien weisen ein HOMO von -5,2 ± 0,4 eV und ein LUMO von -2,2 ± 0,4 eV auf. Die Lochmobilität beträgt etwa 10⁻⁴ cm²/VS und die Leitfähigkeit einer dotierten Schicht bei 2 bis 10 Vol% des Dotierstoffs beträgt etwa 10⁻⁵ S/cm.

Als Dotierstoff in der Lochtransportschicht 102 dient beispielsweise F₄-TCNQ (2,3,5,6-Tetrafluoro-7,7,8,8-tetracyanoquinodimethan). Weitere Dotierstoffe sind beispielsweise Molybdänoxid und Rheniumoxid.

Die Elektronentransportschicht 106 kann mit Vorteil eines der folgenden Materialien als Matrixmaterial enthalten oder aus einem der folgenden Materialien bestehen: BPhen, Alq₃ (Tris(8-Hydroxichinolin)aluminium), BAlq₂ (Bis-[2-methyl-8-quinolinato]-[4-phenylphenolato]-aluminium(III)), BCP, TPBi (1,3,5-Tris-(1-phenyl-1H-benzimidazol-2-yl)-benzen), TAZ (3-(4-Biphenyl)-4-phenyl-5-(4-tert-butylphenyl)-1,2,4-triazol), TAZ2 (3,5-Diphenyl-4-näphth-1-yl-1,2,4-triazol), t-Bu-PBD (2-(4-Biphenylyl)-5-(4-tert-butyl-phenyl)-1,3,4-oxadiazol), Triazin oder Triazinderivate. Das Matrixmaterial weist ein HOMO von -6,4 bis -6,0 eV, ein LUMO von -2,3 bis -1,8 eV, eine Elektronenmobilität von mehr als 10⁻⁶ cm²/Vs, vorzugsweise mehr als 10⁻⁵ cm²/Vs und eine Leitfähigkeit in einer dotierten Schicht (bei 6 bis 50 Vol% Dotierstoff) von 10⁻⁵ S/cm auf. Als Dotierstoff kann beispielsweise Lithium, Cäsium oder Calcium eingesetzt werden.

Für alle Schichten sind natürlich auch andere Matrixmaterialien, Dotierstoffe oder Emittermaterialien möglich, sowie andere Zusammensetzungen der gemischten Matrixmaterialien. Weitere Materialien für Emittermaterialien, Transportmaterialien und Dotierstoffe sind möglich und können jederzeit ausgetauscht werden.

Zusätzlich zum in Verbindung mit der Figur 1 beschriebenen Ausführungsbeispiel einer hier beschriebenen organischen Leuchtdiode weist der strahlungsemittierende Bereich 104 im Ausführungsbeispiel gemäß der Figur 3 eine erste ladungstransportierende Schicht 114 und eine zweite ladungstransportierende Schicht 115 auf.

Zwischen der ersten, rot emittierenden Emissionsschicht 111 und der zweiten, grünen emittierenden Emissionsschicht 112 ist die erste ladungstransportierende Schicht 114 angeordnet.

Die erste ladungstransportierende Schicht 114 weist zum Beispiel ein erstes und zweites Matrixmaterial auf.

Das erste Matrixmaterial der ersten ladungstransportierenden Schicht 114 kann ein Loch transportierendes Matrixmaterial umfassen, das beispielsweise 1-TNATA oder α-NPD sein kann. Diese Materialien haben ein HOMO von -5,5 ± 0,6 eV und ein LUMO von -2,1 ± 0,4 eV. Die Lochmobilität beträgt etwa 10⁻⁴ cm²/Vs und die Triplettlage T1 ist > 1,8 eV.

Ein Elektronen leitendes, zweites Matrixmaterial in der ersten ladungstransportierenden Schicht 114 kann beispielsweise BCP (2,9-Dimethyl-4,7-diphenyl-1,10-phenanthrolin) sein. Ein weiteres Beispiel ist BPhen (4,7-diphenyl-1,10-phenantrolin).

Diese Materialien haben die Eigenschaft, dass das HOMO -6,4 bis -5,7 eV und das LUMO -2,3 bis -1,8 eV beträgt, T1 > 2,5 eV ist, und die Elektronenmobilität etwa 10⁻⁶ cm²/Vs beträgt.

Zwischen der zweiten Emissionsschicht 112, die grünes Licht emittiert, und der dritten Emissionsschicht 113, die blaues Licht emittiert, ist eine zweite ladungstransportierende Schicht 115 angeordnet.

Die zweite ladungsträgertransportierende Schicht 115 setzt sich auch aus einem ersten und einem zweiten Matrixmaterial zusammen. Das erste Matrixmaterial kann ein Loch transportierendes Matrixmaterial sein, das TCTA oder CBP sein kann. Das zweite Elektronen leitende Matrixmaterial kann BCP oder BPhen sein.

Im in Verbindung mit der Figur 3 beschriebenen Ausführungsbeispiel wird elektromagnetische Strahlung durch die transparente erste Elektrode 101, die als Anode ausgebildet ist, emittiert. Die erste Elektrode 101 weist dabei eine Dicke zwischen 80 nm und 140 nm, beispielsweise 120 nm auf.

Die Lochtransportschicht 102 weist vorzugsweise eine Dicke zwischen 10 nm und 400 nm auf. Die Elektronenbarriereschicht 103 weist vorzugsweise eine Dicke zwischen 5 nm und 10 nm auf. Die erste Emissionsschicht 111 weist vorzugsweise eine Dicke zwischen 5 nm und 15 nm auf, die erste ladungsträgertransportierende Schicht 114 weist vorzugsweise eine Dicke zwischen 5 nm und 10 nm auf. Die zweite Emissionsschicht 112 weist vorzugsweise eine Dicke zwischen 5 nm und 15 nm auf. Die zweite ladungsträgertransportierende Schicht 115 weist vorzugsweise eine Dicke zwischen 5 nm und 10 nm auf. Die dritte Emissionsschicht 113 weist vorzugsweise eine Dicke zwischen 5 nm und 10 nm auf. Die Lochbarriereschicht 105 weist vorzugsweise eine Dicke zwischen 5 nm und 10 nm auf. Die Elektronentransportschicht 106 weist vorzugsweise eine Dicke zwischen 20 nm und 300 nm auf. Die als Kathode ausgebildete zweite Elektrode 107 weist vorzugsweise eine Dicke zwischen vorzugsweise 100 nm und 200 nm auf.

Ferner ist es möglich, dass erste Elektrode 101 und zweite Elektrode 107 jeweils transparent ausgebildet sind. Bei der organischen Leuchtdiode 1 handelt es sich dann um ein Bauteil, das in zumindest zwei entgegengesetzte Richtungen elektromagnetische Strahlung emittieren kann. Beispielsweise kann es sich dann um ein Bauteil handeln, das in zwei entgegengesetzte Richtungen weißes Licht emittiert. Darüber hinaus kann es sich bei einer solchen organischen Leuchtdiode 1 um eine transparente organische Leuchtdiode handeln. Transparent heißt dabei, dass die organische Leuchtdiode 1 für elektromagnetische Strahlung vorzugsweise im sichtbaren Frequenzbereich durchlässig ist, so dass wenigstens 50 % der durchtretenden Strahlung, ohne absorbiert zu werden, durch die organische Leuchtdiode 1 treten kann. Die organische Leuchtdiode 1 kann dabei auch klarsichtig sein. Das heißt, das durchtretende Licht wird nicht oder kaum von der organischen Leuchtdiode 1 gestreut.

Bei der organischen Leuchtdiode gemäß der Figur 3 handelt es sich also um eine strahlungsemittierende Vorrichtung, bei der zwischen zwei Emissionsschichten jeweils eine ladungstransportierende Schicht angeordnet ist.

Die ladungstransportierenden Schichten umfassen dabei jeweils eine Matrix, die ein Loch- und ein Elektronen-leitendes Matrixmaterial umfasst oder eine Mischung eines ersten, Loch transportierenden Matrixmaterials und eines zweiten, Elektronen transportierenden Matrixmaterials ist.

In Verbindung mit den schematischen Schnittdarstellungen der Figuren 4 und 5 sind weitere Ausführungsbeispiele für die erste Elektrode 101 (Figur 4) und die zweite Elektrode (Figur 5) näher beschrieben. Diese Elektroden können in hier beschriebenen organischen Leuchtdioden Verwendung finden.

Die erste Elektrode 101 und zweite Elektrode 107 weisen dazu vorzugsweise beide ein transparentes, elektrisch leitendes Oxid (TCO)-Material auf.

Zumindest eine der ersten 101 und zweiten Elektrode 107 kann dabei eine Schichtenfolge umfassen, die eine erste TCO-Schicht 121 mit einem ersten transparenten, elektrisch leitenden Oxid (TCO), eine zweite TCO-Schicht 122 mit einem transparenten Metall und eine dritte Metallschicht 120 mit einem zweiten TCO aufweist. Durch die Schichtenfolge mit zwei Schichten, die jeweils ein TCO aufweisen, und einer Schicht dazwischen, die als transparente Metallschicht ausgeführt ist, kann eine Elektrode ermöglicht werden, die dank der transparenten Metallschicht 120 eine hohe Querleitfähigkeit und dank der hochbrechenden TCO-aufweisenden Schichten 121, 122 ein reduziertes Reflexionsvermögen aufweist. Für ein beidseitig transparentes, also volldurchsichtiges, organisches optoelektronisches Bauelement können auch beide Elektroden 101, 107 jeweils eine solche Schichtenfolge umfassen. Insbesondere kann dadurch erreicht werden, dass durch die zwei transparenten Elektroden gerade kein optischer Mikroresonator ausgebildet wird oder zumindest ein Mikroresonator mit geringer Güte.

Das erste TCO und/oder das zweite TCO kann dabei eines oder mehrere der oben genannten Materialien für TCOs aufweisen. Insbesondere kann das erste TCO und/oder das zweite TCO ITO, Indiumzinkoxid, Aluminiumzinkoxid und/oder Zinkoxid aufweisen oder aus einem solchen sein. Weiterhin können das erste und/oder das zweite TCO mit Aluminium, Vanadium und/oder Gallium oder einer Kombination oder Mischung daraus dotiert sein. Eine Dicke d einer TCO-Schicht 121, 122 mit einem TCO kann insbesondere größer oder gleich 5 nm und kleiner oder gleich 150 nm sein.

Das transparente Metall kann Aluminium, Chrom, Molybdän, Nickel, Silber, Platin, Barium, Indium, Gold, Magnesium, Calcium oder Lithium sowie Verbindungen, Kombinationen und Legierungen aufweisen oder aus einem der genannten Materialien oder Kombinationen oder Legierungen daraus bestehen. Dabei kann eine Metallschicht 120 mit einem transparenten Metall eine Dicke d von größer oder gleich 1 nm und kleiner oder gleich 50 nm, insbesondere größer oder gleich 20 nm und kleiner oder gleich 40 nm, aufweisen.

Insbesondere können die erste Elektrode 101 und/oder die zweite Elektrode 107 flächig oder alternativ in erste beziehungsweise zweite Elektrodenteilbereiche strukturiert ausgeführt sein. Beispielsweise kann die erste Elektrode 101 in Form parallel nebeneinander angeordneter erster Elektrodenstreifen ausgeführt sein und die zweite Elektrode 107 als senkrecht dazu verlaufende parallel nebeneinander angeordnete zweite Elektrodenstreifen. Überlappungen der ersten und zweiten Elektrodenstreifen können damit als separat ansteuerbare Leuchtbereiche ausgeführt sein. Weiterhin kann auch nur die erste 101 oder die zweite Elektrode 107 strukturiert sein.

Durch die Kombination einer transparenten Metallschicht 120 und einer transparenten TCO-Schicht 121, 122 kann eine erste 101 und/oder eine zweite Elektrode 107 realisiert werden, die sowohl gute elektrische als auch gute optische Eigenschaften aufweist.

"Gute elektrische Eigenschaften" kann dabei bedeuten, dass die Elektrode 101, 107 einen für Metalle typischen geringen elektrischen Widerstand aufweist und damit auch eine gute Querleitfähigkeit, also eine hohe, für ein Metall typische elektrische Leitfähigkeit entlang der Erstreckungsrichtung der Elektrode aufweist. Insbesondere kann durch die Kombination einer transparenten Metallschicht 120 und einer transparenten TCO-Schicht 121, 122 ein geringerer elektrischer Widerstand und damit eine höhere Querleitfähigkeit erreicht werden als beispielsweise mit einer Schicht aus einem transparenten, elektrisch leitenden Oxid alleine.

"Gute optische Eigenschaften" kann insbesondere bedeuten, dass die Elektrode eine hohe Transparenz und weiterhin eine geringe Reflektivität, insbesondere eine geringere Reflektivität als eine Schicht mit einem transparenten Metall alleine, aufweist. Das kann dadurch erreicht werden, dass die TCO-Schicht 121, 122 als Entspiegelung wirken kann. Hierzu können Materialien mit hohem Brechungsindex wie etwa dielektrische Oxide, etwa Siliziumoxid oder Tantaloxid, und insbesondere transparente, elektrisch leitende Oxide oder Mischungen daraus geeignet sein.

Ein hoher Brechungsindex kann dabei beispielsweise ein Brechungsindex von größer oder gleich 1,9 sein. Beispielsweise können TCOs Brechungsindizes im Bereich von etwa 1,9 bis etwa 2,1 aufweisen.

Alternativ oder zusätzlich kann die erste und/oder zweite Elektrode auch eine oder mehrere zur Entspiegelung geeignete Schichten aus einem weiteren Material mit hohem Brechungsindex aufweisen, etwa aus dem Bereich der Telluride oder Sulfide, etwa ZnSe mit einem Brechungsindex von etwa 2,5. Darüber hinaus können die genannten Materialien auch in Kombinationen oder Mischungen in der ersten 101 und/oder zweiten Elektrode 107 vorliegen.

Die Figuren 6A bis 6D zeigen weitere Ausführungsbeispiele von hier beschriebenen organischen Leuchtdioden 1.

In den Figuren 6A und 6B ist eine organische Leuchtdiode 1 in einem ausgeschalteten elektronischen Betriebszustand (Figur 6A) und in einem eingeschalteten elektronischen Betriebszustand (Figur 6B) gezeigt.

Die organische Leuchtdiode 1 weist einen ersten Träger 130 auf, der strahlungsdurchlässig ausgebildet ist. Zum Beispiel besteht der erste Träger 130 aus einem Glas. Auf dem ersten Träger 130 ist eine transparente erste Elektrode 101 und eine zweite Elektrode 107 angeordnet sind. Zwischen der transparenten ersten Elektrode 101 und der zweiten Elektrode 107 ist eine organische Schichtenfolge 133 angeordnet ist. Im gezeigten Ausführungsbeispiel ist die organische Leuchtdiode 1 somit als Bottom-Emitter ausgeführt, da sie durch den ersten Träger 130 hindurch emittieren kann.

Die organische Schichtenfolge 133 weist zumindest einen strahlungsemittierenden Bereich 104 sowie eine Lochtransportschicht 102 auf. Die Lochtransportschicht 102 ist dabei zwischen der ersten Elektrode 101 und dem strahlungsemittierenden Bereich 104 angeordnet.

Die transparente erste Elektrode 101 ist im gezeigten Ausführungsbeispiel aus Indiumzinnoxid (ITO) ausgeführt und dient als Anode, während die zweite Elektrode 107 eine 0,7 nm dicke LiF-Schicht und eine 200 nm dicke Aluminiumschicht aufweist.

Die Lochtransportschicht 102 weist ein Matrixmaterial und einen Dotierstoff auf, die Charge-Transfer-Komplexe bilden. Die Charge-Transfer-Komplexe weisen dabei ein erstes Absorptionsspektrum auf. Elektromagnetische Strahlung mit einer Wellenlänge im Absorptionsbereich kann von den Charge-Transfer-Komplexen unter Anregung dieser absorbiert werden. Der Teil einer von außen auf die organische Leuchtdiode 1 einfallenden elektromagnetischen Strahlung, hier angedeutet mittels der Pfeile 190, der mit dem Absorptionsspektrum übereinstimmt, wird somit absorbiert, während der nicht-absorbierte Teil 191 der elektromagnetischen Strahlung 190 von der Lochtransportschicht 102 gestreut und reflektiert werden kann. Dadurch ist die Lochtransportschicht 102 von einem externen Beobachter wahrnehmbar und ruft im ausgeschalteten elektronischen Betriebszustand der organischen Leuchtdiode 1 einen vorbestimmten Farbeindruck in Form der elektromagnetischen Strahlung 191 hervor.

Im gezeigten Ausführungsbeispiel besteht die Lochtransportschicht 102 aus NPB als Matrixmaterial, das mit 5 % Re₂O₇ p-dotiert ist. Der Dotierstoff ist dabei homogen im Matrixmaterial verteilt. Dadurch ergibt sich ein gleichmäßiger gelblicher Farbeindruck im ausgeschalteten Betriebszustand.

Der strahlungsemittierende Bereich 104 weist beispielsweise eine 40 nm dicke Schicht aus Tris(8-hydroxyquinoline)aluminium (Alq₃) als fluoreszierendes elektrolumineszierendes Material auf, das gleichzeitig als Elektronentransportmaterial dient. Zwischen der Lochtransportschicht 102 und dem aktiven Bereich 30 ist eine 10 nm dicke NPB-Schicht 123 angeordnet, die die Lochinjektion von der Lochtransportschicht 102 den strahlungsemittierenden Bereich 104 verbessert. Alternativ dazu kann die Lochtransportschicht 102 auch den Dotierstoff mit einem Dickegradienten im Matrixmaterial aufweisen, wobei die Dotierstoff-Konzentration zum strahlungsemittierenden Bereich 104 hin kontinuierlich oder sprunghaft abnehmen kann.

Wie in Figur 6B durch die Pfeile 193 angedeutet ist, emittiert die organische Leuchtdiode 1 im eingeschalteten Betriebszustand durch die strahlungsemittierenden Bereich 104, die erste Elektrode 101 und den ersten Träger 1 grünfarbige elektromagnetische Strahlung. Durch die gestrichelten Pfeile 190 und 191 ist dabei angedeutet, dass zwar immer noch elektromagnetische Strahlung, die von außen auf die organische Leuchtdiode 1 fällt, gestreut und reflektiert werden kann, aber dass der dadurch hervorgerufene Farbeindruck von der im strahlungsemittierenden Bereich erzeugten elektromagnetischen Strahlung 193 überstrahlt wird und daher nicht wahrnehmbar ist.

In weiteren Ausführungsbeispielen ist die Lochtransportschicht 102 als 50 nm dicke Schicht mit NPB als Matrixmaterial und mit Re₂O₅ als Dotierstoff mit Dotierstoff-Konzentrationen von 5 %, 20 % und 50 % ausgeführt. Dabei zeigt sich, dass sich der wahrnehmbare Farbeindruck Leuchtdioden 1 im ausgeschalteten elektronischen Betriebszustand mit zunehmender Konzentration des Dotierstoffs von hellblau bis tiefblau ändert. Im eingeschalteten elektronischen Betriebszustand wird dahingegen stets grüne elektromagnetischen Strahlung 193 emittiert.

In einem weiteren Ausführungsbeispiel weist die Lochtransportschicht 102 NPB als Matrixmaterial und Dirhodium-tetra-trifluoroacetat als Dotierstoff bei einer Dicke von 200 nm auf. Während im eingeschalteten elektronischen Betriebszustand grüne elektromagnetische Strahlung 193 emittiert wird, erweckt die Lochtransportschicht 102 im ausgeschalteten elektronischen Betriebszustand einen bläulichen Farbeindruck.

Ein organisches elektronisches Bauelement als Vergleichsbauelement mit einem Aufbau gemäß den Figuren 6A und 6B, aber einer undotierten Lochtransportschicht 102 aus NPB, emittiert ebenso grüne elektromagnetische Strahlung 193 und erweckt im ausgeschalteten elektronischen Betriebszustand aber lediglich einen blassblauen Farbeindruck mit geringer Farbsättigung.

Die hier rein beispielhaft gezeigten Ausführungsbeispiele der Figuren 6A und 6B zeigen also, dass ein vorbestimmter Farbeindruck im ausgeschalteten elektronischen Betriebszustand einstellbar und mittels der Wahl des Matrixmaterials und des Dotierstoffs wählbar ist, während die im eingeschalteten elektronischen Betriebszustand emittierte elektromagnetische Strahlung stets denselben Leuchteindruck erwecken kann.

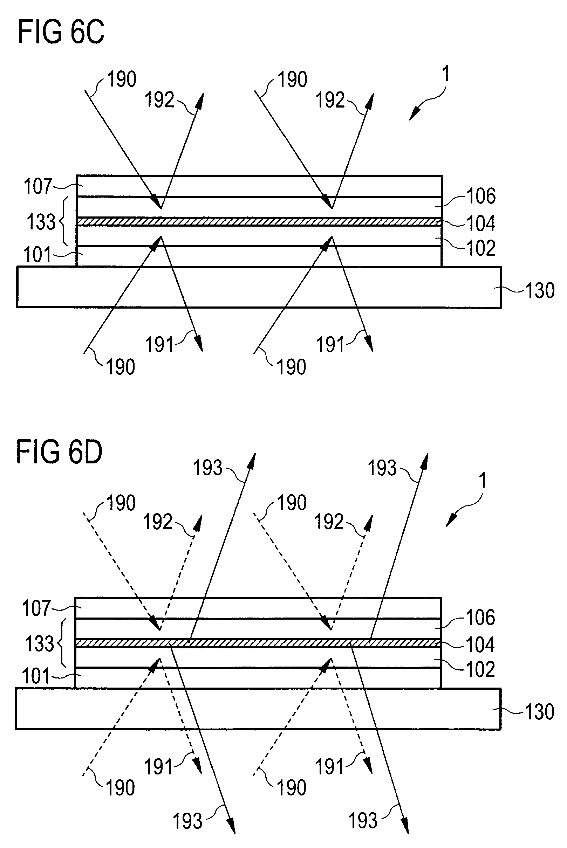

In den Figuren 6C und 6D ist ein weiteres Ausführungsbeispiel für eine organische Leuchtdiode 1 in einem ausgeschalteten elektronischen Betriebszustand (Figur 6C) und in einem eingeschalteten elektronischen Betriebszustand (Figur 6D) gezeigt, das eine Modifikation des vorherigen Ausführungsbeispiels darstellt.

Im Gegensatz zur organischen Leuchtdiode 1 der Figuren 6A und 6B weist die organische Leuchtdiode 1 hier zusätzlich eine transparente zweite Elektrode 107 aus einem transparenten Metallfilm auf, sowie eine Elektronentransportschicht 106 zwischen dem strahlungsemittierenden Bereich 104 und der zweiten Elektrode 107. Die organische Leuchtdiode 1 ist damit im gezeigten Ausführungsbeispiel als beidseitig emittierende OLED ausgebildet. Die Lochtransportschicht 107 kann, wie im Zusammenhang mit den vorherigen Ausführungsbeispielen beschrieben, ausgeführt sein und beispielsweise im ausgeschalteten elektronischen Betriebszustand einen hellblauen Farbeindruck erwecken.

Die Elektronentransportschicht 106 weist ein Matrixmaterial und einen Dotierstoff auf, die Charge-Transfer-Komplexe bilden, die einen Teil der von außen auf die Leuchtdiode 1 fallenden elektromagnetischen Strahlung 190 mit einem zweiten Absorptionsspektrum absorbieren. Die nicht-absorbierte elektromagnetische Strahlung, hier durch die Pfeile 192 angedeutet, ist durch einen externen Beobachter als vorbestimmter Farbeindruck durch die zweite Elektrode 102 wahrnehmbar. Der Farbeindruck, der durch die Elektronentransportschicht 106 durch die zweite Elektrode 107 im ausgeschalteten elektronischen Betriebszustand wahrnehmbar ist, kann dabei verschieden vom Farbeindruck sein, der durch die erste Elektrode 101 aufgrund der Lochtransportschicht 102 wahrnehmbar ist.

Die Elektronentransportschicht 106 ist im gezeigten Ausführungsbeispiel 150 nm dick und weist BCP als Matrixmaterial und Cs₂CO₃ als Dotierstoff mit einer Konzentration von 10 % auf. Dadurch erweckt die Elektronentransportschicht 106 im ausgeschalteten elektronischen Betriebzustand einen tiefblauen Farbeindruck bei einem externen Beobachter. Im eingeschalteten Betriebszustand, wie in Figur 6D gezeigt, wird dieser Farbeindruck durch die im strahlungsemittierenden Bereich 104 erzeugte elektromagnetische Strahlung überstrahlt, die wie in den vorherigen Ausführungsbeispielen einen grünen Leuchteinruck erweckt.

Während die organische Leuchtdiode im ausgeschalteten elektronischen Betriebzustand durch die Lochtransportschicht 102 einen anderen Farbeindruck erwecken kann als durch die Elektronentransportschicht 106, wird im eingeschalteten elektronischen Betriebzustand beidseitig derselbe Leuchteindruck durch die im strahlungsemittierenden Bereich 104 erzeugte elektromagnetische Strahlung 193 erweckt.

In einem weiteren Ausführungsbeispiel mit einem Aufbau gemäß den Figuren 6C und 6D weist die Elektronentransportschicht 106 bei einer Dicke von 150 nm als Matrixmaterial Bpyppy und als Dotierstoff Cs₂CO₃ bei einer Konzentration von 10 % auf. Die Charge-Transfer-Bande der Elektronentransportschicht 106 ist so intensiv, dass diese für den Farbeindruck durch die zweite Elektrode 107 hindurch bestimmend wird. Dadurch kann die Elektronentransportschicht 106 im ausgeschalteten elektronischen Betriebzustand einen roten Farbeindruck erwecken, während im eingeschalteten elektronischen Betriebzustand wiederum grüne elektromagnetische Strahlung emittiert wird.

Es ist möglich, die Ausführungsbeispiele gemäß der Figuren 1 bis 6 zu kombinieren. Eine solche Kombination kann zum Beispiel in einer transparenten, beidseitig emittierenden organischen Leuchtdiode resultieren, die im ausgeschalteten Betriebszustand von beiden Seiten gemäß einer gewünschten Farbe farbig erscheint und im eingeschalteten Zustand weißes Licht emittiert.

Im Folgenden wird die Verkapselung und hermetische Versiegelung von hier beschriebenen organischen Leuchtdioden 1 näher erläutert. Der Schichtaufbau der funktionellen Schichten, wie der Elektroden 101, 107, und der organischen Schichtenfolge 133 kann dabei, wie in Verbindung mit den Figuren 1 bis 6 beschrieben, sein. Ferner kann der Schichtaufbau einer beliebigen Kombination der in Verbindung mit den Figuren 1 bis 6 beschriebenen Schichten und Materialien folgen.

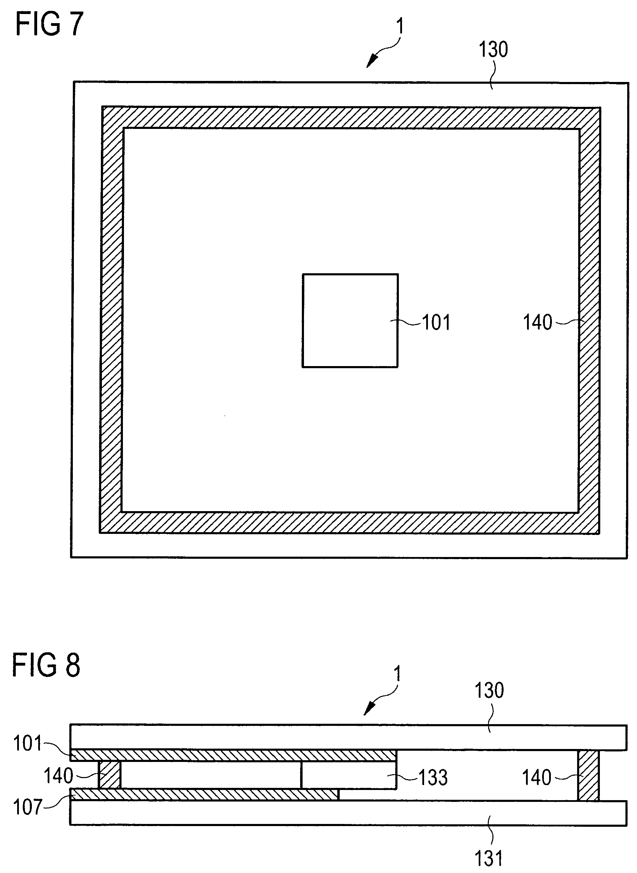

In Verbindung mit der Figur 7 ist anhand einer schematischen Draufsicht ein weiteres Ausführungsbeispiel einer hier beschriebenen organischen Leuchtdiode 1 näher erläutert. Die Figur 8 zeigt eine dazugehörige Schnittdarstellung.

Die organische Leuchtdiode 1 umfasst einen ersten Träger 130 und einen zweiten Träger 131. Erster Träger 130 und zweiter Träger 131 sind dabei vorzugsweise plattenartig ausgebildet. Das heißt, erster Träger 130 und zweiter Träger 132 sind im Wesentlichen ebene Scheiben. Die funktionalen Schichten der organischen Leuchtdiode 1 sind zwischen erstem Träger 130 und zweitem Träger 131 angeordnet. Erster Träger 130 und zweiter Träger 131 dienen auf diese Weise zur Verkapselung der organischen Schichtenfolge 133.

Erster Träger 130 und zweiter Träger 131 können aus dem gleichen Material oder aus unterschiedlichen Materialien gebildet sein. Zumindest einer der beiden Träger ist für im strahlungsemittierenden Bereich 104 der organischen Leuchtdiode 1 erzeugte elektromagnetische Strahlung zumindest teilweise durchlässig. Darüber hinaus ist es möglich, dass beide Träger für diese elektromagnetische Strahlung zumindest teilweise durchlässig sind.

Beispielsweise ist zumindest einer der Träger mit einem Glas gebildet. Das heißt, dieser Träger enthält ein Glas oder besteht vorzugsweise aus einem Glas. Bei dem Glas kann es sich beispielsweise um ein Bor-Silikatglas handeln. Ferner ist es möglich, dass es sich bei dem Glas um ein Kalk-Natronglas (auch: Fensterglas oder Soda-Lime-Glas) handelt. Ein Kalk-Natronglas zeichnet sich gegenüber einem Bor-Silikatglas durch geringere Herstellungskosten aus.

Ist einer der beiden Träger als nichtstrahlungsdurchlässiger Träger ausgebildet, so kann dieser Träger aus einem Metall bestehen oder ein Metall enthalten oder aus einem keramischen Material bestehen oder ein keramisches Material enthalten.

Darüber hinaus ist es möglich, dass erster Träger 130 und zweiter Träger 131 jeweils aus einem Glas bestehen. Die beiden Träger können dann auch aus dem gleichen Glas bestehen.

Die organische Schichtenfolge 133, die zwischen erstem Träger 130 und zweitem Träger 131 angeordnet ist, kann beispielsweise mittels der ersten Elektrode 101 und der zweiten Elektrode 107 elektrisch kontaktierbar sein, wobei erste Elektrode 101 und zweite Elektrode 101 von außerhalb der organischen Leuchtdiode 1 zugänglich sein können, wie dies beispielsweise in der Figur 8 angedeutet ist.

Zum Verbinden von erstem Träger 130 und zweitem Träger 131 befindet sich in den Ausführungsbeispielen der Figuren 7 und 8 ein Verbindungsmittel 140 zwischen erstem Träger 130 und zweitem Träger 131. Das Verbindungsmittel umschließt die organische Schichtenfolge 133 rahmenartig. Der Ausdruck "rahmenartig" bezieht sich dabei nicht auf die geometrische Form des Verlaufs des Verbindungsmittels 140. Wichtig ist lediglich, dass das Verbindungsmittel 140 die organische Schichtenfolge 133 seitlich vollständig umschließt. Das Verbindungsmittel 140 ist also als Bahn um die organische Schichtenfolge 133 herumgeführt, wobei sich das Verbindungsmittel 130 mit erstem Träger 130 und zweitem Träger 131 in direktem Kontakt befinden kann.

Bei dem Verbindungsmittel 140 kann es sich beispielsweise um ein Glaslotmaterial, ein Glasfrittenmaterial oder einen Klebstoff handeln. Darüber hinaus ist es möglich, dass die organische Leuchtdiode 1 neben dem Verbindungsmittel 140 ein weiteres Verbindungsmittel aufweist, das ebenfalls rahmenartig um die organische Schichtenfolge 133 herum angeordnet ist. Die Materialien der beiden Verbindungsmittel können sich dann voneinander unterscheiden. Beispielsweise kann ein Verbindungsmittel mit einem Klebstoff gebildet sein, das andere Verbindungsmittel kann dann mit einem Glaslot oder einem Glasfrittenmaterial gebildet sein.

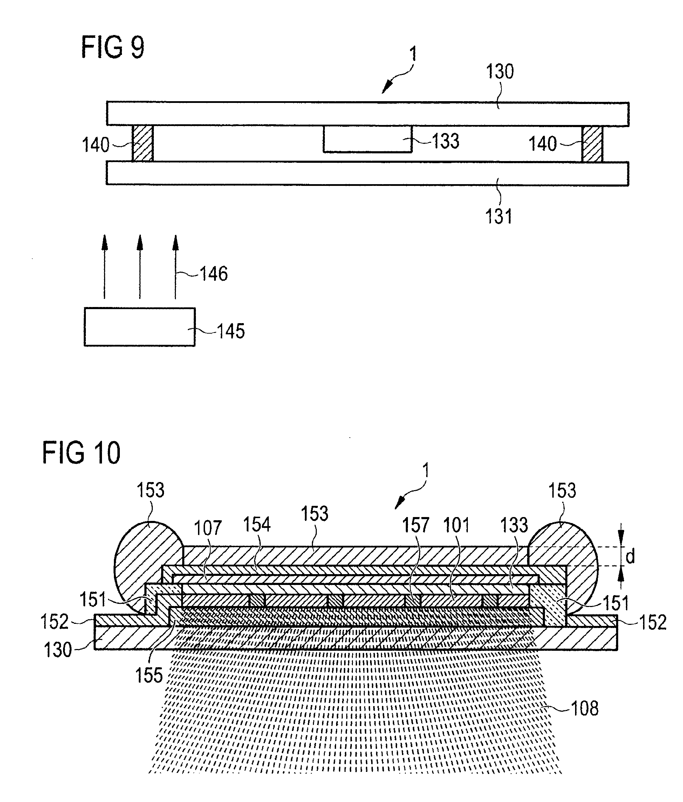

Anhand der schematischen Schnittdarstellung der Figur 9 ist erläutert, dass das Verbindungsmittel 140 mittels einer Quelle 145 von elektromagnetischer Strahlung 146 gehärtet oder erweicht werden kann.

Handelt es sich bei dem Verbindungsmittel 140 beispielsweise um einen Klebstoff, wie Nagase oder Three-Bond, dann kann die Quelle 145 zum lokalen Aushärten des Klebstoffs Verwendung finden. Die Quelle 145 ist dabei derart angeordnet, dass auf die organische Schichtenfolge 133 kaum oder gar keine elektromagnetische Strahlung 146 trifft. Das heißt, die organische Schichtenfolge 133 kann durch die elektromagnetische Strahlung 146 der Quelle 145 nicht beschädigt werden.

Handelt es sich bei dem Verbindungsmittel 140 um ein Glaslot oder ein Glasfrittenmaterial, so kann mittels der elektromagnetischen Strahlung 146 ein Erweichen des Glaslots oder des Glasfrittenmaterials 140 erfolgen. Das erweichte Glaslot oder Glasfrittenmaterial benetzt dann zumindest einen der Träger, wodurch eine hermetisch dichte Versiegelung der organischen Leuchtdiode 1 entsteht. Insbesondere kann es sich in diesem Fall bei der Quelle 145 um einen Laser handeln, der beispielsweise Infrarotstrahlung 146 aussendet, welche den zweiten Träger 131 durchdringt und erst im Verbindungsmittel 140 absorbiert wird.

Die Figur 10 zeigt anhand einer schematischen Schnittdarstellung ein weiteres Ausführungsbeispiel einer hier beschriebenen organischen Leuchtdiode 1. Die organische Leuchtdiode 1 umfasst einen ersten Träger 130, der beispielsweise aus einem Glas bestehen kann. Das Glas ist für im strahlungsemittierenden Bereich 104 der organischen Leuchtdiode 1 erzeugte elektromagnetische Strahlung vorzugsweise zumindest teilweise durchlässig.

Dem ersten Träger 130 folgt eine Anschlussleitung 155 nach. Bei der Anschlussleitung 155 handelt es sich um eine strahlungsdurchlässige, elektrisch leitfähige Schicht. Die Anschlussleitung 155 kann beispielsweise durch eines der oben aufgeführten transparenten Elektrodenmaterialien gebildet sein. Auf der Anschlussleitung 155 ist die erste Elektrode 101 angeordnet, die ebenfalls transparent ausgeführt ist.

In oder an der ersten Elektrode 101 können Busbars 157 angeordnet sein. Die Busbars können beispielsweise durch dünne Metallstreifen gebildet sein. Zur Bildung der Busbars eignet sich beispielsweise eine Schichtenfolge mit Schichten aus Chrom und Aluminium. Ferner können die Busbars aus Aluminium, Chrom, Silber oder Mischungen dieser Materialien bestehen. Die Busbars verbessern die Querleitfähigkeit der ersten Elektrode 101. Sie können beispielsweise durch eine Isolationsschicht von der darüber liegenden organischen Schichtenfolge 133 isoliert sein, sodass keine direkte Stromeinprägung von den Busbars 157 in die organische Schichtenfolge 133 erfolgt. Die Busbars 157 dienen dann lediglich zur besseren Verteilung von elektrischem Strom innerhalb der ersten, transparenten Elektrode 101.

Auf die organische Schichtenfolge 133 folgt die zweite Elektrode 107 nach. Die zweite Elektrode 107 ist beispielsweise, wie oben beschrieben, reflektierend ausgebildet.

Die erste Elektrode 101 kann mittels der Anschlussstelle 152, die mit einem TCO-Material oder einem Metall gebildet sein kann, von außerhalb der organischen Leuchtdiode 1 elektrisch kontaktiert werden. Die Anschlussstelle 152 ist über eine Isolationsschicht 151, die ein elektrisch leitendes Material, wie einen Lack, ein Epoxidharz oder ein Siliziumoxid, enthält, von der zweiten Elektrode 107 elektrisch isoliert.

Im Betrieb der organischen Leuchtdiode 1 erfolgt eine Emission 108 von in der organischen Schichtenfolge 133, insbesondere im strahlungsemittierenden Bereich 104, erzeugter elektromagnetischer Strahlung durch den ersten Träger 130 hindurch nach außen.

Die organische Leuchtdiode 1 weist ferner eine Dünnfilmverkapselung 154 auf, die zur Verkapselung der organischen Schichtenfolge 133 dient. Die Dünnfilmverkapselung 154 stellt eine Grunddichtigkeit gegenüber Umwelteinflüssen, wie Feuchtigkeit und atmosphärischen Gasen, für die organische Schichtenfolge 133 her. Die Dünnfilmverkapselung 154 kann beispielsweise mittels einem PECVD-Verfahren (plasma enhanced chemical vapor deposition) aufgebracht werden. Die Dünnfilmverkapselung 154 kann beispielsweise aus Oxid- und/oder Nitridschichten, wie SiO oder SiN, bestehen oder diese Materialien enthalten. Dabei ist es auch möglich, dass die Dünnverkapselung 154 eine Schichtenfolge umfasst, welche abwechselnd Nitrid- und Oxidschichten aufweist.

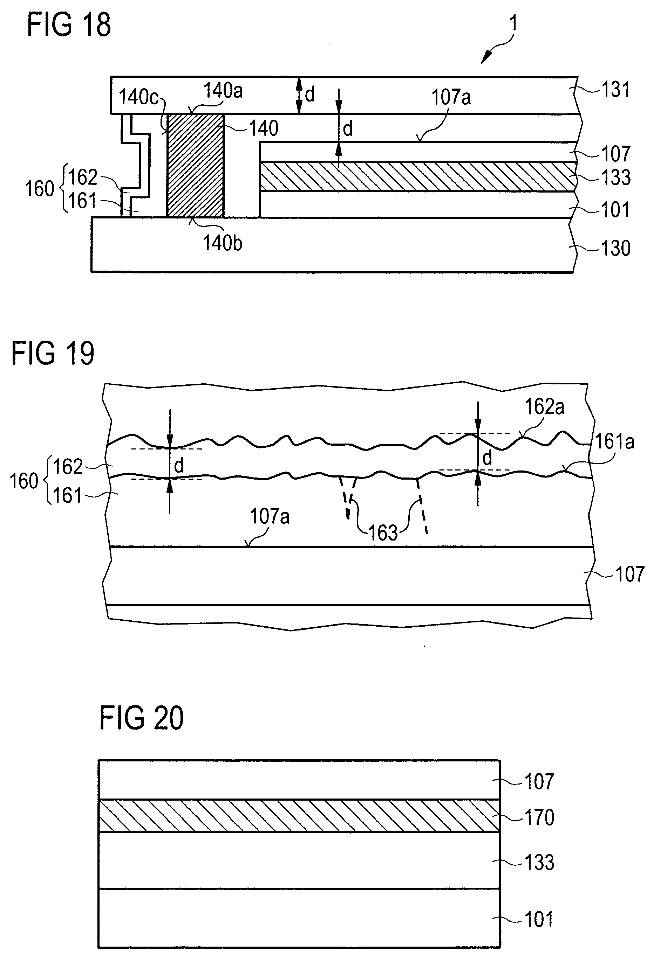

Die Dünnfilmverkapselung 154 kann dabei Gitterfehler 163 (siehe dazu auch die Figur 19) aufweisen. Diese Gitterfehler 163 können beispielsweise in so genannten Pinholes oder anderen Fehlstellen resultieren, die zu einer Durchlässigkeit der Dünnfilmverkapselung 154 für atmosphärische Gase oder Feuchtigkeit führen.

Im Ausführungsbeispiel der Figur 10 ist auf der Dünnfilmverkapselung 154 eine Diffusionsbarriere 153 angeordnet. Die Diffusionsbarriere 153 ist beispielsweise aus amorphem SiO₂ gebildet. Die Diffusionsbarriere 153 ist dabei beispielsweise mittels Atmosphärendruckplasma abgeschieden. Die Diffusionsbarriere 153 kann insbesondere auch auf die Seitenflächen der organischen Leuchtdiode 1 abgeschieden sein. So kann die Diffusionsbarriere 153 auch die Isolationsschicht 151 und die Anschlussstellen 152 zumindest stellenweise bedecken. Die organische Leuchtdiode 1 ist damit sowohl von ihrer dem ersten Träger 130 abgewandten Außenfläche als auch an ihren Seitenflächen mit der Diffusionsbarriere 153 verkapselt und vor Umweltschutzeinflüssen geschützt.

Die Diffusionsbarriere 153 kann auch mittels Atmosphärendruckplasma in mehreren Einzelschichten aufgetragen werden. Somit können die unterschiedlichen Teilbereiche der Diffusionsbarriere 153 auch unterschiedliche Dicken aufweisen. Auf diese Weise kann dort, wo die Gefahr der Bildung von Gitterfehlern 163 am größten ist - beispielsweise an Kanten von Schichten - eine Diffusionsbarriere 153 erhöhter Dicke aufgebracht werden.

Unter einem Atmosphärendruckplasma (auch AD-Plasma oder Normaldruckplasma) ist dabei der Sonderfall eines Plasmas verstanden, bei welchem der Druck ungefähr dem der umgebenden Atmosphäre entspricht. Die Verwendung eines Atmosphärendruckplasma weist gegenüber der Nutzung einer Niedrigdruckplasmaverkapselungstechnik einige Vorteile auf. Der apparative Aufwand zur Beschichtung mit einem Atmosphärendruckplasma ist deutlich geringer als beim Niederdruckplasma. Beim Niederdruckplasma ist es beispielsweise notwendig, dass das zu beschichtende Bauelement in eine Kammer eingebracht wird und in dieser dann der Druck vermindert wird. Nach dem Abscheideprozess muss der Druck wieder auf Normaldruck angepasst werden und das Bauelement wieder aus der Kammer entnommen werden. Bei der Verwendung eines Atmosphärendruckplasmas ist es hingegen nicht notwendig, das Bauelement - hier die organische Leuchtdiode 1 - in eine geschlossene Kammer einzubringen. Die Beschichtung mit der Diffusionsbarriere 153 ist unter Verwendung eines Atmosphärendruckplasmas daher beispielsweise auch auf einem Fließband möglich.

Die Diffusionsbarriere kann eine Dicke d von 50 nm bis 1000 nm aufweisen. Vorzugsweise weist die Diffusionsbarriere 153 eine Dicke d von wenigstens 100 nm und höchstens 250 nm auf. An den Rändern der organischen Leuchtdiode 1 kann die Dicke der Diffusionsbarriere 153 auch größer gewählt sein.

Die Diffusionsbarriere 153 kann auch aus Einzelschichten erzeugt werden. Hierbei können zwei oder mehrere Einzelschichten übereinander abgeschieden werden. Jede der Einzelschichten kann eine Dicke von beispielsweise wenigstens 50 nm und höchstens 100 nm aufweisen. Durch das Aufbringen von Einzelschichten kann die Dichtigkeit der Gesamtschicht erhöht werden.

Die Diffusionsbarriere 153 kann Siliziumdioxid umfassen oder aus diesem bestehen. Das Siliziumdioxid kann hierbei erst in der Gasphase gebildet werden. Zur Bildung des Siliziumdioxids kann ein Silan und eine weitere Verbindung, welche als Sauerstoffquelle dient, verwendet werden. Als Silan kann beispielsweise SiH₄ verwendet werden und als Sauerstoffquelle N₂O.

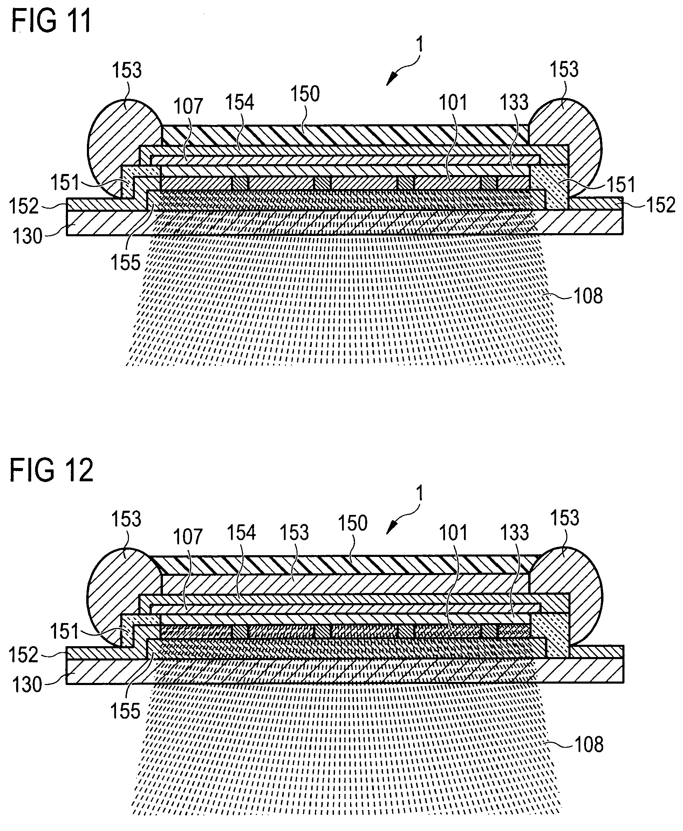

Die Figur 11 zeigt anhand einer schematischen Schnittdarstellung ein weiteres Ausführungsbeispiel einer hier beschriebenen organischen Leuchtdiode. Im Unterschied zum Ausführungsbeispiel der Figur 10 ist die Diffusionsbarriere 153 in diesem Ausführungsbeispiel lediglich an den Seitenflächen der organischen Leuchtdiode 1 angeordnet. Auf die dem ersten Träger 130 abgewandte Außenfläche der organischen Leuchtdiode ist anstatt einer Diffusionsbarriere 153 eine Lackschicht 150 aufgebracht. Das heißt, in diesem Ausführungsbeispiel ist die dem ersten Träger 130 abgewandte Außenfläche durch eine Kombination einer Dünnfilmverkapselung 154 mit einer Lackschicht 150 verkapselt.

In Verbindung mit der Figur 12 ist ein weiteres Ausführungsbeispiel einer hier beschriebenen organischen Leuchtdiode 1 näher erläutert. Im Unterschied zum Ausführungsbeispiel der Figur 11 ist in diesem Ausführungsbeispiel zwischen der Dünnfilmverkapselung 154 und der Lackschicht 150 eine Diffusionsbarriere 153 angeordnet, die mittels eines Atmosphärendruckplasmas erzeugt wird. Die Lackschicht bedeckt die Diffusionsbarriere 153 zumindest stellenweise.

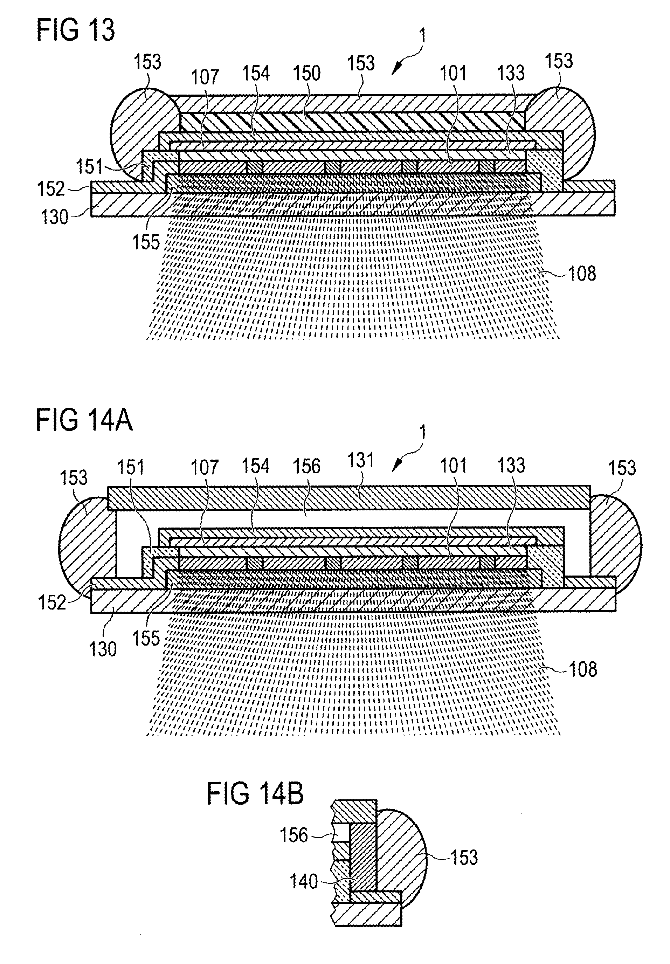

In Verbindung mit der Figur 13 ist ein weiteres Ausführungsbeispiel einer hier beschriebenen organischen Leuchtdiode 1 näher erläutert. Im Unterschied zum Ausführungsbeispiel der Figur 11 ist in diesem Ausführungsbeispiel auf die Lackschicht 150 zusätzlich eine Diffusionsbarriere 153 aufgebracht, die mittels eines Atmosphärendruckplasmas erzeugt ist. Die Diffusionsbarriere 153 bedeckt die Lackschicht 150 an sämtlichen freiliegenden Oberflächen. Dadurch ist eine besonders dichte Verkapselung der organischen Schichtenfolge 133 vor äußeren Umwelteinflüssen realisiert.

In Verbindung mit der Figur 14A ist ein weiteres Ausführungsbeispiel einer hier beschriebenen organischen Leuchtdiode näher erläutert. In diesem Ausführungsbeispiel sind die Isolationsschicht 151, die Anschlussstelle 152 sowie die Dünnfilmverkapselung 154 zumindest stellenweise von einer Vor-Verkapselungsschicht 156 bedeckt, die zur Verkapselung der organischen Schichtenfolge 133 und als Planarisierungsschicht für die Dünnfilmverkapselung 153 an den Seitenflächen der organischen Leuchtdiode 1 dient. Die Vor-Verkapselungsschicht 156 kann beispielsweise ein transparentes Epoxid oder einen strahlungsdurchlässigen Klebstoff umfassen. Auf die Vor-Verkapselungsschicht 156 ist auf ihre dem ersten Träger 130 abgewandte Außenfläche ein zweiter Träger 131 aufgebracht. Bei dem zweiten Träger 131 kann es sich beispielsweise um eine Glasplatte handeln. Es ist dann möglich, dass eine Emission 108 sowohl durch den ersten Träger 130 als auch durch den zweiten Träger 131 hindurch erfolgt. Bei der organischen Leuchtdiode 1 kann es sich dann um eine beidseitig abstrahlende organische Leuchtdiode 1 handeln. Die mittels Atmosphärendruckplasma erzeugte Diffusionsbarriere 153 dient dabei im Wesentlichen zum seitlichen Abdichten der organischen Leuchtdiode 1.

Dabei ist es weiter möglich, dass erster Träger 130 und zweiter Träger 131 durch voneinander unterschiedlichen Materialien gebildet sein können. Beispielsweise kann einer der beiden Träger durch ein nichtstrahlungsdurchlässiges Material, wie beispielsweise eine Metallplatte, gebildet sein.

Darüber hinaus ist es möglich, dass erster Träger 130 und zweiter Träger 131, wie beispielsweise in Verbindung mit den Figuren 7 und 8 beschrieben, mittels eines Verbindungsmittels 140 miteinander verbunden sind. Bei dem Verbindungsmittel kann es sich dann um ein Glaslot oder ein Glasfrittenmaterial oder einen Klebstoff handeln. Das Verbindungsmittel 140 ist an den Seitenflächen der organischen Leuchtdiode 1 zusätzlich durch die Diffusionsbarriere 153 abgedichtet. Eine solche organische Leuchtdiode 1 ist in der Figur 14B anhand einer schematischen Schnittdarstellung näher erläutert.

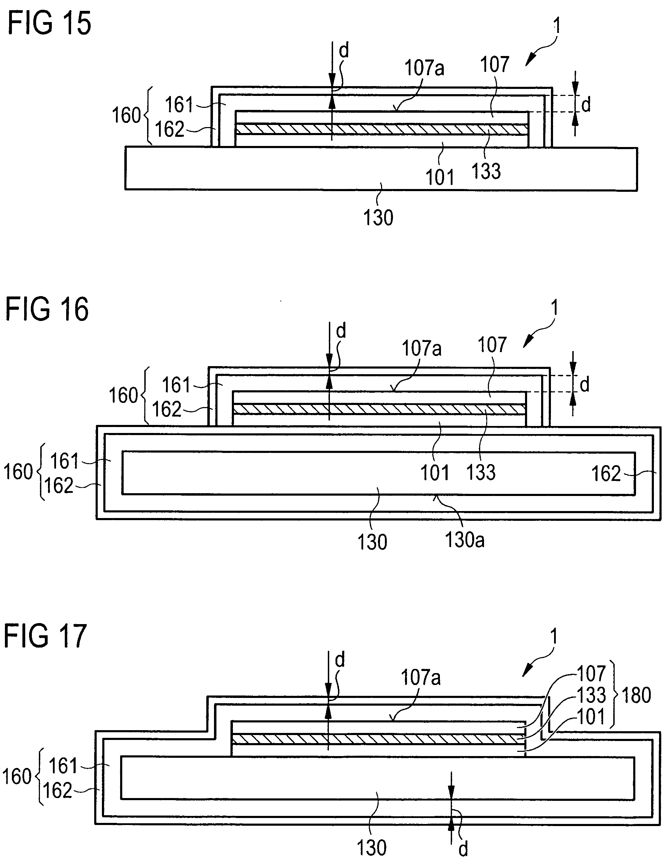

In Verbindung mit den Figuren 15, 16, 17, 18 und 19 sind Ausführungsbeispiele von hier beschriebenen organischen Leuchtdioden 1 näher erläutert, bei denen zumindest Teile der organischen Leuchtdiode 1 durch zumindest zwei Verkapselungsschichten 161, 162 verkapselt sind, welche eine Verkapselungsschichtenfolge 160 bilden. Das heißt, die Verkapselungsschichtenfolge 160 weist zumindest eine erste Verkapselungsschicht 161 und eine zweite Verkapselungsschicht 162 auf, wodurch eine wirksame und effektive Verkapselung ermöglicht ist. Die effektive Verkapselung kann dabei gerade durch die Kombination der zwei Verkapselungsschichten 161, 162 bewirkt werden.

Die erste Verkapselungsschicht 161 und die zweite Verkapselungsschicht 162 können jeweils Materialien aufweisen, die geeignet sind, durch die Kombination der ersten Verkapselungsschicht 161 und der zweiten Verkapselungsschicht 162 die organische Leuchtdiode 1 vor schädlichen Einflüssen der Umgebung, wie atmosphärische Gase und Feuchtigkeit, zu schützen. Die erste Verkapselungsschicht 161 und die zweite Verkapselungsschicht 162 können dabei jeweils ein anorganisches Material aufweisen oder aus einem anorganischen Material bestehen.

Die erste Verkapselungsschicht 161 kann ein Oxid, ein Nitrid oder ein Oxinitrid aufweisen oder aus einem solchen bestehen. Beispielsweise kann das Oxid, Nitrid oder Oxinitrid Aluminium, Silizium, Zinn, Zink, Titan, Zirkonium, Tantal, Niobium oder Hafnium umfassen. Besonders bevorzugt kann die erste Schicht Siliziumnitrid, wie etwa Si₂N₃, Siliziumoxid (SiOₓ), wie etwa Siliziumdioxid, Aluminiumoxid, wie etwa Al₂O₃, und/oder Titanoxid, wie TiO₂, aufweisen. Weiterhin kann die erste Verkapselungsschicht 161 auch aus einem TCO-Material bestehen oder ein solches enthalten. Ferner ist es möglich, dass die erste Verkapselungsschicht 161 ein Metall oder eine Metalllegierung aufweist oder aus einer solchen besteht. Die erste Verkapselungsschicht 161 kann dabei beispielsweise Aluminium und/oder Aluminiumlegierungen aufweisen.

Die vorab genannten Materialien können zur Herstellung der ersten Verkapselungsschicht 161 beispielsweise mittels plasmaunterstützter, chemischer Dampfphasenabscheidung (PECVD - plasma enhanced chemical vapor deposition) aufgebracht werden. Dabei kann in einem Volumen über und/oder um die strahlungsemittierende Schichtenfolge 133 und die Elektroden 101, 107 herum ein Plasma erzeugt werden, wobei dem Volumen zumindest zwei gasförmige Ausgangsverbindungen zugeführt werden, die in dem Plasma ionisiert und zur Reaktion miteinander angeregt werden können. Durch die Erzeugung des Plasmas kann es möglich sein, dass die Temperatur, auf die die zumindest eine Oberfläche des Bauelements aufgeheizt werden muss, um eine Erzeugung der ersten Verkapselungsschicht 161 zu ermöglichen, im Vergleich zu einem plasmalosen CVD-Verfahren erniedrigt werden kann.

Alternativ dazu kann die erste Verkapselungsschicht 161 mittels einer physikalischen Gasphasenabscheidung, wie etwa Sputtern, aufgebracht werden.

Weiterhin kann die erste Verkapselungsschicht 161 auch ein Glas aufweisen oder aus einem Glas bestehen. Das Glas kann dabei beispielsweise eines oder mehrere der oben genannten Oxide aufweisen und mittels Plasmaspritzen aufbringbar sein.

Beim Plasmaspritzen kann in einem so genannten Plasmabrenner zwischen zumindest einer Anode und zumindest einer Kathode durch Hochspannung ein Lichtbogen erzeugt werden, durch den ein Gas oder Gasgemisch geleitet und dadurch ionisiert werden kann. Das Gas oder Gasgemisch kann beispielsweise Argon, Stickstoff, Wasserstoff und/oder Helium aufweisen. In die durch den Lichtbogen und die Gas- beziehungsweise Gasgemischströmung erzeugte Plasmaströmung kann beispielsweise pulverförmiges Material für die erste Verkapselungsschicht 161 eingesprüht werden. Das pulverförmige Material kann durch die Temperatur des Plasmas aufgeschmolzen und mittels der Plasmaströmung beispielsweise auf die Oberseite 107a der zweiten Elektrode 107 aufgebracht wird. Das pulverförmige Material kann beispielsweise mit einer mittleren Korngröße von kleiner oder gleich einigen hundert Mikrometer, bevorzugt kleiner oder gleich 100 µm, und ferner größer oder gleich 100 nm, bevorzugt größer oder gleich 1 µm, bereitgestellt werden. Je feiner das Material bereitgestellt wird, also je geringer die mittlere Korngröße ist, desto gleichmäßiger kann die erste Verkapselungsschicht 161 aufgebracht werden. Je gröber das Material bereitgestellt wird, also je größer die mittlere Korngröße ist, desto rascher kann die erste Verkapselungsschicht 161 aufgebracht werden. Weiterhin können die Struktur und auch die Qualität der ersten Verkapselungsschicht von der Geschwindigkeit, der Temperatur und/oder der Zusammensetzung des Plasmagases abhängen.

Alternativ zum Plasmaspritzen kann eine Glas aufweisende erste Verkapselungsschicht 161 auch mittels Flammspritzen oder mittels eines thermischen Verdampfungsverfahrens aufgebracht werden.

Durch die genannten Verfahren zum Aufbringen der ersten Verkapselungsschicht 161 kann diese kostengünstig mit einer hohen Wachstumsrate aufgebracht werden. Insbesondere kann die erste Verkapselungsschicht 161 nach dem Aufbringen eine Dicke d von größer oder gleich 50 nm und besonders bevorzugt eine Dicke 3 von größer oder gleich 100 nm aufweisen. Weiterhin kann die erste Verkapselungsschicht 161 eine Dicke d von kleiner oder gleich 1 µm aufweisen. Durch eine derart dicke erste Verkapselungsschicht kann die Verkapselungsanordnung neben der Verkapselung auch einen mechanischen Schutz die organische Leuchtdiode 1 gegenüber schädigenden äußeren Einflüssen ermöglichen.

Durch die genannten Verfahren, insbesondere bei Temperaturen des Bauelements von kleiner als 120° C und besonders bevorzugt von kleiner als 80° C, kann die erste Verkapselungsschicht 161 direkt auf dem Bauelement aufbringbar sein, ohne dass das Bauelement oder Teile davon beschädigt würden.

Die Volumenstruktur der ersten Verkapselungsschicht 161 kann beispielsweise in kristalliner und/oder polykristalliner Form vorliegen. Dabei kann es möglich sein, dass die Volumenstruktur der ersten Verkapselungsschicht beispielsweise Struktur- und/oder Gitterfehler 163 wie etwa Versetzungen, Korngrenzen und/oder Stapelfehler aufweist.

Weiterhin kann die erste Verkapselungsschicht 161 auf der der organischen Schichtenfolge 133 abgewandten Seite, auf der die zweite Verkapselungsschicht 161 angeordnet ist, eine Oberflächenstruktur in Form von makroskopischen topographischen Strukturen wie etwa Steigungen, Erhebungen, Winkel, Kanten, Ecken, Vertiefungen, Gräben, Furchen, Mikrolinsen und/oder Prismen und/oder in Form von mikroskopischen topographischen Strukturen wie etwa einer Oberflächenrauigkeit und/oder Poren aufweisen (siehe dazu insbesondere die Figur 19). Hierbei werden Strukturen der Oberflächenstruktur, die mittels sichtbaren Lichts auflösbar sind, den makroskopischen Strukturen zugerechnet, während mikroskopische Strukturen gerade nicht mehr mittels sichtbaren Lichts auflösbar sind. Das kann bedeuten, dass hier als makroskopisch bezeichnete Strukturen Abmessungen von größer oder gleich etwa 400 nm aufweisen, während mikroskopische Strukturen Abmessungen aufweisen, die kleiner als etwa 400 nm sind.

Die Oberflächenstruktur kann durch die genannten Aufbringverfahren selbst bedingt sein oder auch, insbesondere im Falle von makroskopischen Strukturen, durch geeignete weitere Verfahrensschritte wie etwa das Abscheiden durch eine Maske und/oder nachträgliches Bearbeiten mittels mechanischen und/oder chemischen abtragenden Verfahren herstellbar sein. Makroskopische Strukturen können beispielsweise bei einer transparenten Verkapselungsschichtenfolge 160 zur Lichtbrechung und/oder -streuung geeignet sein.

Insbesondere sowohl die vorab genannten Struktur- und Gitterfehler der Volumenstruktur der ersten Verkapselungsschicht 161 als auch Poren in der Oberflächenstruktur der ersten Verkapselungsschicht 161 können unerwünschte Permeationspfade für Feuchtigkeit und/oder Sauerstoff bilden, die eine Diffusion durch die erste Verkapselungsschicht ermöglichen oder zumindest erleichtern können.

Die zweite Verkapselungsschicht 162 kann geeignet sein, in Kombination mit der ersten Verkapselungsschicht 161 die hermetisch dichte Verkapselung der organischen Leuchtdiode 1 zu ermöglichen. Dazu kann die zweite Verkapselungsschicht 162 insbesondere geeignet sein, die vorab genannten Permeationspfade, die in der ersten Verkapselungsschicht vorkommen können, abzudichten.

Die zweite Verkapselungsschicht 162 kann dazu direkt auf der ersten Verkapselungsschicht 161 und in unmittelbarem Kontakt mit der ersten Verkapselungsschicht 161 angeordnet sein. Das kann bedeuten, dass die zweite Verkapselungsschicht 162 mit der ersten Verkapselungsschicht 161 eine gemeinsame Grenzfläche aufweist und weiterhin eine von der gemeinsamen Grenzfläche abgewandte obere Oberfläche. Die gemeinsame Grenzfläche ist zum Beispiel an der Oberseite 161a der ersten Verkapselungsschicht 161 angeordnet.

Die zweite Verkapselungsschicht 162 kann derart ausgebildet sein, dass sie der Oberflächenstruktur der ersten Verkapselungsschicht 161 zumindest teilweise oder annähernd folgen kann, was bedeuten kann, dass insbesondere auch die Oberseite der zweiten Verkapselungsschicht 162 der topographischen Struktur der Grenzfläche zumindest teilweise oder annähernd folgt.

Dass die obere Oberfläche der zweiten Verkapselungsschicht 162 der Grenzfläche zwischen der ersten 161 und zweiten Verkapselungsschicht 162 und damit der Oberflächenstruktur der ersten Verkapselungsschicht 161 zumindest teilweise folgt, kann hier und im Folgenden bedeuten, dass die obere Oberfläche der zweiten Verkapselungsschicht 162 ebenfalls eine topographische Oberflächenstruktur aufweist. Die topographische Oberflächenstruktur an der Oberseite 162a der zweiten Verkapselungsschicht 162 kann dabei bevorzugt gleich oder ähnlich der topographischen Oberflächenstruktur an der Oberseite 161a der ersten Verkapselungsschicht 161 ausgebildet sein. "Gleich" oder "ähnlich" kann im Zusammenhang mit zwei oder mehreren topographischen Oberflächenstrukturen insbesondere bedeuten, dass die zwei oder mehreren topographischen Oberflächenstrukturen gleiche oder ähnliche Höhenprofile mit einander entsprechenden Strukturen, wie etwa Erhebungen und Vertiefungen, aufweisen. Beispielsweise können die zwei oder mehreren topographischen Oberflächenstrukturen in diesem Sinne jeweils lateral nebeneinander angeordnete Erhebungen und Vertiefungen in einer bestimmten charakteristischen Abfolge aufweisen, die beispielsweise abgesehen von relativen Höhenunterschieden der Erhebungen und Vertiefungen für die zwei oder mehreren topographischen Oberflächenstrukturen gleich sind.

Mit anderen Worten kann eine Oberfläche, die der topographischen Oberflächenstruktur einer anderen Fläche zumindest teilweise folgt, eine Erhebung, angeordnet über einer Erhebung der topographischen Oberflächenstruktur der anderen Fläche, beziehungsweise eine Vertiefung, angeordnet über einer Vertiefung der topographischen Oberflächenstruktur der anderen Fläche, aufweisen. Der relative Höhenunterschied zwischen benachbarten Erhebungen und Vertiefungen der einen Oberfläche kann dabei auch unterschiedlich zum relativen Höhenunterschied der entsprechenden Erhebungen und Vertiefungen der topographischen Oberflächenstruktur der anderen Fläche sein.

Mit anderen Worten kann das bedeuten, dass die obere Oberfläche der zweiten Verkapselungsschicht und die Grenzfläche zwischen der ersten und zweiten Verkapselungsschicht parallel oder zumindest annähernd parallel verlaufen. Damit kann die zweite Verkapselungsschicht eine Dicke aufweisen, die unabhängig oder annähernd unabhängig von der Oberflächenstruktur der dem Bauelement abgewandten Oberfläche der ersten Verkapselungsschicht ist. "Annähernd parallel", "annähernd unabhängig" und "annähernd gleich bleibend" kann im Hinblick auf die Dicke der zweiten Verkapselungsschicht bedeuten, dass diese eine Dickenvariation kleiner oder gleich 10 % und besonders bevorzugt von kleiner oder gleich 5 % gemessen an der Gesamtdicke der zweiten Verkapselungsschicht aufweist. Eine derartige Ausbildung der zweiten Verkapselungsschicht mit einer derartigen geringen Dickenvariation kann auch als so genanntes "conformal coating" bezeichnet werden.

Weiterhin kann die zweite Verkapselungsschicht 162 eine Dicke d aufweisen, die kleiner als die Abmessungen von zumindest einigen Strukturen und insbesondere den oben genannten makroskopischen Strukturen der Oberflächenstruktur der ersten Verkapselungsschicht ist. Insbesondere kann die zweite Verkapselungsschicht auch denjenigen mikroskopischen Strukturen der Oberflächenstruktur der ersten Verkapselungsschicht folgen, deren Abmessungen größer als die Dicke der zweiten Verkapselungsschicht sind.

Die Dicke der zweiten Verkapselungsschicht 162 kann weiterhin unabhängig von einer Volumenstruktur der ersten Verkapselungsschicht sein. Das kann bedeuten, dass die erste Verkapselungsschicht keine Dickenvariation von größer als 10 % und besonders bevorzugt keine Dickenvariation von größer als 5 % auch über den Teilbereichen der ersten Verkapselungsschicht aufweist, in der sich oben genannte Gitter- und/oder Strukturfehler 163 der Volumenstruktur der ersten Verkapselungsschicht 161 befinden und die sich insbesondere bis zur gemeinsamen Grenzfläche 161a mit der zweiten Verkapselungsschicht 161 erstrecken.

Weiterhin kann die Dicke d der zweiten Verkapselungsschicht 161 insbesondere auch unabhängig von Öffnungen, Erhebungen, Vertiefungen und Poren in der der zweiten Verkapselungsschicht zugewandten Oberfläche der ersten Verkapselungsschicht sein. Im Falle, dass derartige Oberflächenstrukturen hinsichtlich ihrer Abmessungen größer als die Dicke d der zweiten Verkapselungsschicht 162 sind, können diese durch die zweite Verkapselungsschicht mit gleichmäßiger und im obigen Sinne zumindest nahezu gleicher Dicke bedeckt sein, indem die zweite Verkapselungsschicht 162 der Oberflächenstruktur folgt. Im Falle, dass die Oberflächenstrukturen hinsichtlich ihrer Abmessungen kleiner oder gleich der Dicke der zweiten Verkapselungsschicht 162 sind, kann die zweite Verkapselungsschicht 162 die Oberflächenstrukturen abdecken, ohne diesen zu folgen, und dabei aber ebenfalls eine im obigen Sinne zumindest nahezu gleich bleibende Dicke aufweisen.

Insbesondere kann die zweite Verkapselungsschicht 162 Öffnungen und/oder Poren in der ersten Verkapselungsschicht abdichten, die ein Tiefe-zu-Durchmesser-Verhältnis von größer oder gleich 10 und besonders bevorzugt von größer oder gleich 30 haben. Die Verkapselungsschichtenfolge 160 kann die hier beschriebene zumindest annährend gleiche Dicke d der zweiten Verkapselungsschicht 162 insbesondere auch dann aufweisen, wenn die erste Verkapselungsschicht 161 eine Oberflächenstruktur mit überhängenden Strukturen, insbesondere überhängenden makroskopischen Strukturen, mit negativen Winkeln aufweisen.

Weiterhin kann die zweite Verkapselungsschicht 162 eine Volumenstruktur aufweisen, die unabhängig von der Oberflächenstruktur der der zweiten Verkapselungsschicht 162 zugewandten Oberseite 161a der ersten Verkapselungsschicht 161 ist. Zusätzlich kann die zweite Verkapselungsschicht 162 eine Volumenstruktur aufweisen, die unabhängig von der Volumenstruktur der ersten Verkapselungsschicht 161 ist. Das kann bedeuten, dass oberflächen- und/oder volumenspezifische Eigenschaften und Merkmale der ersten Verkapselungsschicht 161 wie etwa die oben erwähnten Oberflächenstrukturen und/oder Gitter- und/oder Strukturfehler in der Volumenstruktur der ersten Verkapselungsschicht 161 keinen Einfluss auf die Volumenstruktur der zweiten Verkapselungsschicht haben.

Die zweite Verkapselungsschicht 162 kann ein Oxid, ein Nitrid und/oder ein Oxinitrid wie im Zusammenhang mit der ersten Verkapselungsschicht beschrieben aufweisen. Besonders bevorzugt kann die zweite Verkapselungsschicht Aluminiumoxid, etwa Al₂O₃, und/oder Tantaloxid, etwa Ta₂O₅, aufweisen.

Insbesondere kann die zweite Verkapselungsschicht 162 eine Volumenstruktur aufweisen, die eine höhere Amorphizität, also Unregelmäßigkeit im Sinne von Nah- und/oder Fernordnung der enthaltenen Materialien, als die erste Verkapselungsschicht aufweist. Das kann insbesondere bedeuten, dass die zweite Verkapselungsschicht eine derart hohe Amorphizität aufweist, dass keine Kristallinität beziehungsweise Kristallstruktur feststellbar ist. Die zweite Verkapselungsschicht 162 kann dabei gänzlich amorph sein, so dass die die zweite Verkapselungsschicht 162 bildenden Materialien keine messbare Nah- und/oder Fernordnung aufweisen, sondern eine rein statistische, unregelmäßige Verteilung aufweisen.

Als Referenz zur Feststellung der Amorphizität der zweiten Verkapselungsschicht 162 und auch der ersten Verkapselungsschicht 161 kann dabei beispielsweise eine Flachwinkelmessung in einem Röntgendiffraktometer dienen, bei der für die amorphe zweite Verkapselungsschicht 162 keine Kristallinität in Form einer kristallinen, teilkristallinen und/oder polykristallinen Struktur feststellbar ist.

Obwohl Verkapselungsschichten mit kristalliner, also nicht amorpher, Volumenstruktur oft eine höhere Dichte als Verkapselungsschichten mit amorpher Volumenstruktur aufweisen, wurde in Verbindung mit der hier beschriebenen Vorrichtung mit der Verkapselungsschichtenfolge 160 überraschend festgestellt, dass die zweite Verkapselungsschicht 162, wenn sie eine hohe Amorphizität aufweist, dennoch in Kombination mit der ersten Verkapselungsschicht 161 eine hermetisch dichte Verkapselungsschichtenfolge 160 ermöglicht. Insbesondere kann es dabei von Vorteil sein, dass die amorphe zweite Verkapselungsschicht 162 keine Struktur- und/oder Gitterfehler 163 der ersten Verkapselungsschicht 161 fortsetzt, so dass sich dadurch auch keine durchgehenden Permeationspfade für Feuchtigkeit und/oder Sauerstoff durch die Verkapselungsanordnung ausbilden können. Gerade durch die Kombination der ersten Verkapselungsschicht 161 mit der amorphen zweiten Verkapselungsschicht 162 kann eine Verkapselungsschichtenfolge 160 erreicht werden, die eine hermetische Dichtigkeit gegenüber Feuchtigkeit und/oder Sauerstoff und gleichzeitig eine ausreichend große Gesamtdicke aufweist, um auch einen mechanischen Schutz des Bauelements zu gewährleisten.

Die zweite Verkapselungsschicht 162 kann durch ein Verfahren auf der ersten Verkapselungsschicht 161 herstellbar sein, bei dem die Oberflächenstruktur und/oder die Volumenstruktur der ersten Verkapselungsschicht 161 keinen Einfluss auf die Volumenstruktur der aufzubringenden zweiten Verkapselungsschicht 162 haben. Die zweite Verkapselungsschicht 162 kann insbesondere mittels eines Verfahrens herstellbar sein, dass das oder die für die zweite Verkapselungsschicht 162 aufzubringenden Materialien ohne Fernordnung, also in einer unregelmäßigen Verteilung zur Herstellung einer amorphen Volumenstruktur aufbringbar sind. Die zweite Verkapselungsschicht 162 kann dabei beispielsweise in Form von Einzelschichten des oder der aufzubringenden Materialien, so genannten Monolagen, aufgebracht werden, wobei jede der Monolagen der Oberflächenstruktur der zu beschichtenden Fläche folgt. Dabei können die Bestandteile und Materialien einer Monolage statistisch verteilt und unabhängig voneinander auf der gesamten zu beschichtenden Fläche verteilt und aufgebracht werden, wobei besonders bevorzugt die gesamte Fläche durchgehend mit der Monolage bedeckt ist. Die zu beschichtende Fläche kann hierbei die von der organischen Schichtenfolge 133 abgewandte Oberfläche der ersten Verkapselungsschicht 161 oder eine bereits auf der ersten Verkapselungsschicht 161 aufgebrachte Monolage sein.

Ein Verfahren, mit dem es möglich sein kann, derartige Einzelschichten aufzubringen, kann als Variante einer Atomschichtenabscheidung bezeichnet werden. Eine Atomschichtenabscheidung ("atomic layer deposition", ALD) kann ein Verfahren bezeichnen, bei dem im Vergleich zu einem oben beschriebenen CVD-Verfahren zur Herstellung einer Verkapselungsschicht 162 auf einer Oberfläche zuerst eine erste von zumindest zwei gasförmigen Ausgangsverbindungen einem Volumen zugeführt wird, im dem das Bauelement bereitgestellt wird. Die erste Ausgangsverbindung kann auf der Oberfläche adsorbieren. Für die hier beschriebene Verkapselungsschichtenfolge 160 kann es vorteilhaft sein, wenn die erste Ausgangsverbindung unregelmäßig und ohne eine Fernordnung auf der Oberfläche adsorbiert. Nach einer bevorzugt vollständigen oder nahezu vollständigen Bedeckung der Oberfläche mit der ersten Ausgangsverbindung kann eine zweite der zumindest zwei Ausgangsverbindungen zugeführt werden. Die zweite Ausgangsverbindung kann mit der an der Oberfläche möglichst unregelmäßig aber bevorzugt vollständig flächendeckend adsorbierten ersten Ausgangsverbindung reagieren, wodurch eine Monolage der zweiten Verkapselungsschicht 162 ausgebildet werden kann. Wie bei einem CVD-Verfahren kann es vorteilhaft sein, wenn die zumindest eine Oberfläche auf eine Temperatur über der Raumtemperatur erhitzt wird. Dadurch kann die Reaktion zur Bildung einer Monolage thermisch initiiert werden. Die Oberflächentemperatur, die beispielsweise auch die Bauelementtemperatur, also die Temperatur des Bauelements, sein kann, kann dabei von den Edukten, also der ersten und zweiten Ausgangsverbindung, abhängen. Durch Wiederholen dieser Verfahrensschritte kann nacheinander eine Mehrzahl von Monolagen aufeinander aufgebracht werden. Dabei ist es für die Herstellung der hier beschriebenen Verkapselungsschichtenfolge 160 vorteilhaft, wenn die Anordnungen der Materialien beziehungsweise Ausgangsverbindungen der einzelnen Monolagen unabhängig voneinander von Monolage zu Monolage sind, so dass sich nicht nur lateral entlang der Erstreckungsebene der zu beschichtenden Oberfläche, sondern auch in die Höhe eine amorphe Volumenstruktur ausbilden kann.

Die erste und zweite Ausgangsverbindung können beispielsweise im Zusammenhang mit den weiter oben genannten Materialien für die zweite Verkapselungsschicht metallorganische Verbindungen wie etwa Trimethylmetallverbindungen sowie sauerstoffhaltige Verbindungen sein. Zur Herstellung einer zweiten Verkapselungsschicht mit Al₂O₃ können beispielsweise Trimethylaluminium sowie Wasser oder N₂O als Ausgangsverbindungen bereitgestellt werden.

Eine plasmalose Variante einer Atomschichtenabscheidung ("plasma-less atomic layer deposition", PLALD) kann dabei ein ALD-Verfahren bezeichnen, für das kein Plasma wie im Folgenden beschrieben erzeugt wird, sondern bei dem zur Bildung der Monolagen die Reaktion der oben genannten Ausgangsverbindungen nur über die Temperatur der zu beschichtenden Oberfläche initiiert wird.

Die Temperatur der zumindest einen Oberfläche und/oder des Bauelements kann bei einem PLALD-Verfahren beispielsweise größer oder gleich 60° C und kleiner oder gleich 120° C sein.

Eine plasmaunterstützte Variante einer Atomschichtabscheidung ("plasma enhanced atomic layer deposition", PEALD) kann ein ALD-Verfahren bezeichnen, bei dem die zweite Ausgangsverbindung bei gleichzeitiger Erzeugung eines Plasmas zugeführt wird, wodurch es wie bei PECVD-Verfahren möglich sein kann, dass die zweite Ausgangsverbindung angeregt wird. Dadurch kann im Vergleich zu einem plasmalosen ALD-Verfahren die Temperatur, auf die die zumindest eine Oberfläche aufgeheizt wird, verringert werden und durch die Plasmaerzeugung dennoch die Reaktion zwischen Ausgangsverbindungen initiiert werden. Die Monolagen können dabei beispielsweise bei einer Temperatur von kleiner als 120° C und bevorzugt kleiner oder gleich 80° C aufgebracht werden. Um weitere Monolagen zu erzeugen, können die Schritte des Zuführens der ersten Ausgangsverbindung und danach des Zuführens der zweiten Ausgangsverbindung wiederholt werden.

Der Grad der Amorphizität der zweiten Verkapselungsschicht 162 kann durch die Wahl geeigneter Ausgangsverbindungen, Temperaturen, Plasmabedingungen und/oder Gasdrücke erfolgen.

Die zweite Verkapselungsschicht 162 kann nach dem Aufbringen eine Dicke d von größer oder gleich 1 nm, besonders bevorzugt von größer oder gleich 10 nm, und kleiner oder gleich 30 nm aufgebracht werden. Das kann bedeuten, dass die zweite Verkapselungsschicht 162 größer oder gleich 1 Monolage, besonders bevorzugt größer oder gleich 10 Monolagen, und kleiner oder gleich 50 Monolagen der Materialien der zweiten Verkapselungsschicht aufweist. Durch die hohe Dichte und Qualität der zweiten Verkapselungsschicht 162 kann eine solche Dicke ausreichend sein, um einen wirkungsvollen Schutz vor Feuchtigkeit und/oder Sauerstoff für das darunter liegende Bauelement in Kombination mit der ersten Verkapselungsschicht 161 zu gewährleisten. Aufgrund der geringen Dicke d der zweiten Verkapselungsschicht 162 kann eine kurze Prozesszeit und damit eine hohe Wirtschaftlichkeit der hier beschriebenen Verkapselungsanordnung gewährleistet sein. Die Verkapselungsschichtenfolge 160 kann insbesondere direkt und unmittelbar auf einer Elektrode 107, 101 angeordnet sein. Das kann bedeuten, dass die erste Verkapselungsschicht 161 der Verkapselungsschichtenfolge 160 direkt und unmittelbar beispielsweise der zweiten Elektrode 107 angeordnet ist.

Weiterhin kann die Verkapselungsschichtenfolge 160 eine dritte Verkapselungsschicht aufweisen, die zwischen der ersten Verkapselungsschicht 161 und der organischen Schichtenfolge 133 angeordnet ist. Die dritte Verkapselungsschicht kann dabei insbesondere ein anorganisches Material, wie im Zusammenhang mit der zweiten Verkapselungsschicht 162 beschrieben, aufweisen. Weiterhin kann die dritte Verkapselungsschicht amorph sein. Darüber hinaus kann die dritte Verkapselungsschicht eines oder mehrere weitere Merkmale, wie im Zusammenhang mit der zweiten Verkapselungsschicht 162 beschrieben, aufweisen. Weiterhin können die zweite und die dritte Verkapselungsschicht gleich ausgebildet sein.

Die erste Verkapselungsschicht 161 kann direkt und unmittelbar auf der dritten Verkapselungsschicht angeordnet sein. Weiterhin kann die dritte Verkapselungsschicht direkt auf dem Bauelement angeordnet sein. Die dritte Verkapselungsschicht kann dabei für die erste Verkapselungsschicht eine homogene Aufbringoberfläche unabhängig von der Oberfläche des Bauelements ermöglichen.

Weiterhin kann die Verkapselungsschichtenfolge 160 eine Mehrzahl von ersten 161 und eine Mehrzahl von zweiten Verkapselungsschichten 162 aufweisen, die abwechselnd übereinander angeordnet sind, wobei die der organischen Schichtenfolge 133 am nächsten angeordnete Verkapselungsschicht eine erste Verkapselungsschicht 161 ist. Die ersten 161 und zweiten Verkapselungsschichten 162 der Mehrzahl der ersten 161 beziehungsweise zweiten Verkapselungsschichten 162 können jeweils gleich oder verschieden ausgebildet sein. Eine "Mehrzahl" kann dabei hier und im Folgenden zumindest eine Anzahl von zwei bedeuten.

Durch eine derartige Wiederholung des Verkapselungsschichtaufbaus mit der ersten und zweiten Verkapselungsschicht kann die Verkapselung der organischen Leuchtdiode 1 verbessern. Weiterhin kann die mechanische Robustheit der Verkapselungsschichtenfolge 160 erhöht werden. Durch geeignete Wahl der Materialien der jeweiligen ersten und zweiten Verkapselungsschichten können die optischen Eigenschaften der Verkapselungsanordnung angepasst werden.

Konkret kann zu den einzelnen Figuren 15 bis 19 noch Folgendes ausgeführt werden:
In Verbindung mit der Figur 15 ist anhand einer schematischen Schnittdarstellung ein weiteres Ausführungsbeispiel einer hier beschriebenen organischen Leuchtdiode 1 näher erläutert. Die organische Leuchtdiode 1 umfasst einen ersten Träger 130. Der erste Träger kann aus einem strahlungsdurchlässigen Material, wie beispielsweise einem Glas, oder einem strahlungsundurchlässigen Material, wie beispielsweise einem Metall oder einem Keramikmaterial, gebildet sein. Auf dem ersten Träger 130 sind die funktionellen Schichten 180, das heißt die erste Elektrode 101, die organische Schichtenfolge 133 sowie die zweite Elektrode 107, angeordnet. Auf die Seitenflächen sowie an der Oberseite 107a der zweiten Elektrode 107 ist eine erste Verkapselungsschicht 161, wie sie soeben näher erläutert wurde, aufgebracht. Die freiliegende Außenfläche der ersten Verkapselungsschicht 161 ist vollständig von der zweiten Verkapselungsschicht 162 bedeckt, die ebenfalls wie gerade ausgeführt aufgebaut ist. Die erste Verkapselungsschicht 161 und die zweite Verkapselungsschicht 162 bilden die Verkapselungsschichtenfolge 160.

In Verbindung mit der Figur 16 ist ein weiteres Ausführungsbeispiel einer hier beschriebenen organischen Leuchtdiode 1 anhand einer schematischen Schnittdarstellung näher erläutert. Im Unterschied zum in Verbindung mit der Figur 15 beschriebenen Ausführungsbeispiel ist der erste Träger 130 in diesem Ausführungsbeispiel als flexibler Träger ausgebildet. Der flexible Träger ist dabei allumseitig durch eine oben beschriebene Verkapselungsschichtenfolge 60 hermetisch versiegelt. Alternativ zu einer allumseitigen Verkapselung des ersten Trägers 130 ist es auch möglich, dass lediglich die der organischen Schichtenfolge 133 zugewandte Oberseite des flexiblen Trägers mit der Verkapselungsschichtenfolge 160 versehen ist. In jedem Fall ist auf diese Weise ein Träger realisiert, der flexibel ist und zugleich hermetisch dicht gegen äußere Einflüsse wie Feuchtigkeit und atmosphärische Gase versiegelt ist. Auf diese Weise kann der erste Träger 130 beispielsweise durch eine an sich gas- und/oder feuchtigkeitsdurchlässige Kunststofffolie gebildet sein, die aufgrund der Verkapselung mit der Verkapselungsschichtenfolge 160 die organische Leuchtdiode 1 hermetisch abschließen kann.

In Verbindung mit der Figur 17 ist ein weiteres Ausführungsbeispiel einer hier beschriebenen organischen Leuchtdiode 1 anhand einer schematischen Schnittdarstellung näher erläutert. In diesem Ausführungsbeispiel sind der erste Träger 130 und die auf dem ersten Träger 130 angeordneten funktionellen Schichten 180 gemeinsam, allumseitig von der Verkapselungsschichtenfolge 160 umschlossen. Eine solche Ausführungsform eignet sich besonders gut zur Bildung einer flexiblen organischen Leuchtdiode 1. Der erste Träger 130 kann dabei flexibel ausgestaltet sein, beispielsweise als Folie. Die funktionellen Schichten 180 sind gemeinsam mit dem ersten Träger 130 verkapselt, sodass sich für die gesamte organische Leuchtdiode eine gewisse Flexibilität ergibt. Das heißt, die organische Leuchtdiode ist biegbar und geeignet, einer Vielzahl von Biegezyklen, ohne beschädigt zu werden, zu widerstehen.

In Verbindung mit der Figur 18 ist ein weiteres Ausführungsbeispiel einer hier beschriebenen organischen Leuchtdiode näher erläutert. In diesem Ausführungsbeispiel umfasst die organische Leuchtdiode zwei Träger 130, 131. Beide Träger 130, 131 können als starre Träger ausgebildet sein. Beispielsweise sind die Träger 130, 131 jeweils mit einem Glas gebildet oder bestehen aus einem Glas. Die Träger 130 und 131 sind durch ein Verbindungsmittel 140, wie es weiter oben beispielsweise mit den Figuren 7 oder 8 beschrieben ist, miteinander verbunden. Beispielsweise handelt es sich bei dem Verbindungsmittel 140 um ein Glaslot oder ein Glasfrittenmaterial. Das Verbindungsmittel 140 grenzt an seiner Oberseite 140a und seiner Unterseite 140b zumindest stellenweise an den zweiten Träger 131 beziehungsweise den ersten Träger 130. Die Seitenflächen 140c des Verbindungsmittels 140 sind mit der Verkapselungsschichtenfolge 160 abgedichtet. Dabei kann sich die Verkapselungsschichtenfolge 140 auch über die Seitenflächen von erstem Träger 130 und zweitem Träger 131 erstrecken (nicht dargestellt).

Die Figur 18 stellt ein allgemeines Beispiel dafür dar, dass die hier beschriebenen Versiegelungs- und Verkapselungstechniken miteinander kombiniert werden können. So kann die in Verbindung mit den Figuren 15 bis 19 beschriebene Verkapselungsschichtenfolge 160 auch in Kombination mit dem hier beschriebenen Verbindungsmittel 140, der Diffusionsbarriere 153, der Dünnfilmverkapselung 154, der Vorverkapselungsschicht 156 und/oder der Lackschicht 150 kombiniert werden. Je nach den Anforderungen an die organische Leuchtdiode 1 kann somit eine Verkapselung gewählt werden, die eine möglichst lange Lebensdauer der organischen Leuchtdiode 1 in der jeweiligen Umgebung, in der die organische Leuchtdiode 1 eingesetzt werden soll, ermöglicht.

In Verbindung mit der Figur 19 ist die Verkapselungsschichtenfolge 160 mit der ersten Verkapselungsschicht 161 und der zweiten Verkapselungsschicht 162 vergrößert dargestellt. Wie aus der Figur 19 ersichtlich ist, weist die Oberseite 161a der ersten Verkapselungsschicht, auf der die zweite Verkapselungsschicht 162 aufgebracht ist, eine Oberflächenstruktur in Form einer Rauigkeit auf, die beispielsweise durch das Aufbringverfahren, mit dem die erste Verkapselungsschicht 161 hergestellt ist, bedingt ist. Weiterhin weist die Volumenstruktur der ersten Verkapselungsschicht 161 Strukturbeziehungsweise Gitterfehler 163, wie etwa Poren oder Versetzungen, auf, die lediglich schematisch und rein beispielhaft angedeutet sind. Die Struktur- und Gitterfehler 163 können sich dabei - wie gezeigt - bis zur Oberseite 161a der ersten Verkapselungsschicht 161, also bis zur Grenzfläche zwischen der ersten 161 und der zweiten Verkapselungsschicht 162 erstrecken. Die zweite Verkapselungsschicht 162 ist derart ausgebildet, dass derartige Struktur- und Gitterfehler 163 keinen Einfluss auf die Volumenstruktur der zweiten Verkapselungsschicht 162 haben. Die zweite Verkapselungsschicht 162 ist somit mit einer gleichmäßig amorphen Volumenstruktur ausgebildet und deckt die erste Verkapselungsschicht 161 ganzflächig ab, wodurch auch mögliche durch Gitter- und Strukturfehler 163 der Volumenstruktur der ersten Verkapselungsschicht 161 gebildete Permationspfade für Feuchtigkeit und/oder atmosphärische Gase abgedichtet sind. Dadurch kann mittels der Verkapselungsschichtenfolge 160 und insbesondere mittels der Kombination der ersten 161 und der zweiten Verkapselungsschicht 162 eine hermetische Verkapselung der organischen Leuchtdiode 1, insbesondere gegen Feuchtigkeit und/oder Sauerstoff, ermöglicht werden.

Insbesondere die in Verbindung mit den Figuren 10 bis 19 beschriebenen Verkapselungstechniken und Kombinationen dieser Verkapselungstechniken eignen sich besonders gut zur Bildung einer flexiblen organischen Leuchtdiode. Eine flexible organische Leuchtdiode 1 zeichnet sich unter anderem dadurch aus, dass sie bis zu einem gewissen Grad biegbar ist, ohne dabei beschädigt zu werden. Vorzugsweise ist die flexibel ausgebildete organische Leuchtdiode 1 mehrmals biegbar, ohne dabei beschädigt zu werden. Die organische Leuchtdiode 1 ist dann also geeignet, eine Mehrzahl von Biegezügen unbeschadet zu überstehen. Besonders bevorzugt kann die organische Leuchtdiode 1 beispielsweise derart flexibel ausgebildet sein, dass sie auf eine Rolle aufwickelbar und von der Rolle abwickelbar ist, ohne dabei beschädigt zu werden.

Insbesondere die hier beschriebene Verkapselungsschichtenfolge 160 ermöglicht eine derart flexible organische Leuchtdiode 1. Zur Bildung einer flexiblen organischen Leuchtdiode 1 ist auch die Verkapselung der organischen Leuchtdiode flexibel ausgeführt. Flexibel bedeutet dabei unter anderem, dass die Verkapselung bis zu einem gewissen Grad biegbar ist, ohne dass die Verkapselung beim Biegen beschädigt wird.

Ferner ist bei einer flexiblen organischen Leuchtdiode 1 auch der erste 130 und der zweite Träger 131 flexibel ausgebildet. Beispielsweise handelt es sich bei den Trägern 130, 131 um eine dünne Glasschicht, ein Laminat oder um eine Folie. Beispielsweise kann es sich bei dem flexiblen Träger 130, 131 um ein Kunststoff-Glas-Kunststoff-Laminat oder um ein Kunststoff-Metall-Kunststoff-Laminat handeln.

In Verbindung mit der Figur 20 ist ein weiteres Ausführungsbeispiel einer hier beschriebenen, organischen Leuchtdiode 1 näher erläutert. Die organische Leuchtdiode umfasst dabei zumindest eine erste Elektrode 101, eine organische Verkapselungsschichtenfolge 133 und eine zweite Elektrode 107. Zwischen die organische Schichtenfolge 133 und die zweite Elektrode 107 ist eine Sputterschutzschicht 170 aufgebracht. Bei der Sputterschutzschicht 170 handelt es sich um eine elektrisch leitende, anorganische Schutzschicht.

Die organische Schichtenfolge 133 wird durch die elektrisch leitende, anorganische Sputterschutzschicht 170, insbesondere bei der Herstellung der organischen Leuchtdiode 1, vor Beeinträchtigung und/oder Schädigungen geschützt. Solche Beeinträchtigungen oder Schädigungen können etwa bei der Herstellung der organischen Leuchtdiode 1 auftreten. Eine solche Beeinträchtigung oder Schädigung der organischen Schichtenfolge 133 kann dann in einer geringeren Lebensdauer der organischen Leuchtdiode 1 oder in einer geringeren Leuchtdichte der von der organischen Leuchtdiode 1 erzeugten elektromagnetischen Strahlung resultieren.

Beispielsweise wird die zweite Elektrode 107 mittels eines hochenergetischen Prozesses, wie Sputtern, auf die organische Schichtenfolge 133 abgeschieden. Ein derart hochenergetischer Prozess kann bei der Abwesenheit der Sputterschutzschicht 170 durch den Beschuss der organischen Schichtenfolge 133 mit Gasionen und/oder dem aufzusputternden Material zu Beschädigungen der organischen Schichtenfolge 133 führen. Mittels des hochenergetischen Prozesses kann beispielsweise eine zweite Elektrode 107, die aus einem TCO-Material oder einem Metall besteht, auf die organische Schichtenfolge 133 aufgebracht werden.

Die Sputterschutzschicht 170 kann beispielsweise ein Übergangsmetalloxid umfassen, das beispielsweise Wolframoxid, Vanadiumoxid, Molybdänoxid, Rheniumoxid, Nickeloxid oder Kombinationen oder Mischungen daraus aufweisen kann oder aus diesen Materialien besteht. Weiter kann die Sputterschutzschicht 170 auch Metalle, wie etwa Magnesium oder Silber, aufweisen.

Im Ausführungsbeispiel gemäß der Figur 20 enthält oder besteht die Sputterschutzschicht 170 aus einem Übergangsmetalloxid, wie WO₃, V₂O₅, MoO₃, Re₂O₇ oder NiO. Über der Sputterschutzschicht 170 ist die zweite Elektrode 107 aufgebracht. Die zweite Elektrode 107 ist beispielsweise mittels eines hochenergetischen Abscheideprozesses, wie Sputtern, direkt auf die Sputterschutzschicht 170 aufgebracht.

Die in Verbindung mit den Figuren 7 bis 20 beschriebenen Möglichkeiten zur Verkapselung, Versiegelung und zum Schutz der organischen Schichtenfolge 133 vor Beschädigungen und äußeren Einflüssen können für alle hier beschriebenen organischen Leuchtdioden und Beleuchtungsmittel Verwendung finden. Insbesondere kann jede Kombination der in Verbindung mit den Figuren 1 bis 6 beschriebenen organischen Leuchtdioden 1 mittels einer oder einer Kombination der in Verbindung mit den Figuren 7 bis 20 beschriebenen organischen Leuchtdioden 1 kombiniert werden. Auf diese Weise können beispielsweise weißes Licht emittierende, transparente, beidseitig abstrahlende organische Leuchtdioden 1 hergestellt werden, die mittels Diffusionsbarrieren, Dünnfilmverkapselungen, Verkapselungsschichtenfolgen, und/oder Verbindungsmitteln besonders gut vor äußeren Einflüssen geschützt sind. Kombinationen der in Verbindung mit den Figuren 7 bis 20 beschriebenen Schutzmethoden für organische Leuchtdioden 1 können beispielsweise in einer organischen Leuchtdiode 1 resultieren, die eine mittels einer Verkapselungsschichtenfolge 160 hermetisch versiegelte organische Schichtenfolge 133 aufweist, wobei die derart verkapselte organische Schichtenfolge 133 zwischen einem ersten Träger 130 und einem zweiten Träger 131 angeordnet ist. Dabei können erster Träger 130 und zweiter Träger 131 mittels eines Verbindungsmittels 140, wie beispielsweise eines Glaslots, miteinander verbunden sein. Die organische Leuchtdiode 1 zeichnet sich dann durch eine besonders gute Verkapselung aus, die beispielsweise den Einsatz der organischen Leuchtdiode in besonders feuchten Räumen, wie einem Badezimmer, erlaubt. Eine solche organische Leuchtdiode 1 kann dann sogar in der Nähe oder in sanitären Einrichtungen, wie einer Badewanne oder einer Dusche, Verwendung finden.

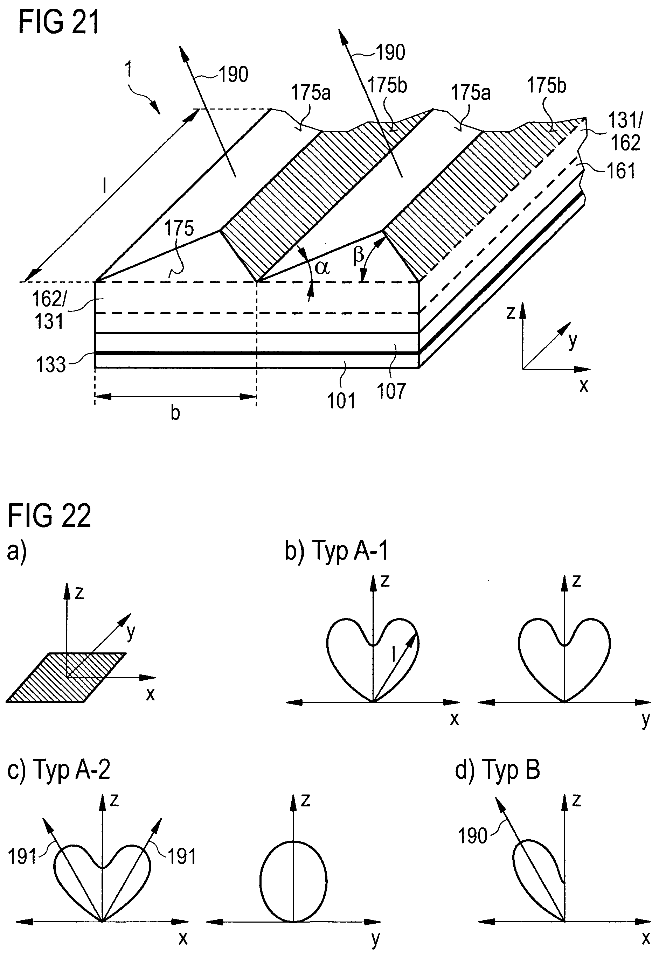

Bei den in Verbindung mit den Figuren 1 bis 20 beschriebenen Ausführungsbeispielen sind die Strahlungsaustrittsflächen der organischen Leuchtdiode 1 jeweils flach ausgebildet. Solche organische Leuchtdioden 1 weisen in der Regel eine Lambertsche Abstrahlcharakteristik auf. In Verbindung mit den Figuren 21 bis 25 werden nun Ausführungsbeispiele von hier beschriebenen organischen Leuchtdioden 1 näher beschrieben, bei denen die organische Leuchtdiode 1 ein gerichtetes Abstrahlprofil aufweist.

In Verbindung mit der Figur 1 ist anhand einer schematischen Perspektivdarstellung ein erstes Ausführungsbeispiel einer hier beschriebenen organischen Leuchtdiode 1 mit gerichtetem Abstrahlprofil näher erläutert. Die organische Leuchtdiode 1 umfasst funktionelle Schichten 180 mit beispielsweise einer ersten Elektrode 101, einer zweiten Elektrode 107 und einer organischen Schichtenfolge 133, die zwischen erster 101 und zweiter Elektrode 107 angeordnet ist.

Die organische Leuchtdiode 1 weist darüber hinaus einen zweiten Träger 131 auf. Der zweite Träger 131 umfasst eine strukturierte Strahlungsaustrittsfläche 175. Die strukturierte Strahlungsaustrittsfläche 175 weist eine Vielzahl von ersten Flächen 175a und zweiten Flächen 175b auf. Die ersten Flächen 175a sind um einen Winkel a gegenüber einer Ebene, die beispielsweise parallel zur Haupterstreckungsebene (xy-Ebene) der organischen Schichtenfolge 133 verläuft, geneigt. Die zweiten Flächen 175b sind um einen Winkel ß gegenüber dieser Ebene geneigt.

Die Emission von elektromagnetischer Strahlung, die in der organischen Schichtenfolge 133 erzeugt wird, erfolgt durch den zweiten Träger 131 sowie die Strahlungsdurchtrittsfläche 175 hindurch. Die strukturierte Strahlungsaustrittsfläche 175 kann dabei in Form einer separaten Schicht auf die der organischen Schichtenfolge 133 abgewandten Oberseite des zweiten Trägers 131 aufgebracht sein. Darüber hinaus ist es möglich, dass die strukturierte Strahlungsaustrittsfläche 175 durch eine Strukturierung des zweiten Trägers 131 gebildet ist. Ferner ist es möglich, dass anstatt des zweiten Trägers 131 beispielsweise eine Verkapselungsschichtenfolge 160, wie sie in Verbindung mit den Figuren 15 bis 19 näher beschrieben ist, auf der zweiten Elektrode 107 angeordnet ist. In diesem Fall kann beispielsweise die zweite Verkapselungsschicht 162 als strukturierte Strahlungsaustrittsfläche ausgeführt sein. Die zweite Verkapselungsschicht kann dabei direkt auf der ersten Verkapselungsschicht 161 angeordnet sein. Dies ist in der Figur 21 durch die gestrichelte Line angedeutet.

Im Ausführungsbeispiel der Figur 21 ist die strukturierte Strahlungsaustrittsfläche 175 in eine Vielzahl von parallel zueinander angeordneten Prismen strukturiert, wobei die ersten Flächen 175a und die zweiten Flächen 175b, die der organischen Schichtenfolge 133 abgewandte Deckfläche der organischen Leuchtdiode 1 bilden. Aus Gründen der Übersichtlichkeit sind in der Figur 21 jeweils nur zwei der Vielzahl von ersten Flächen 175a und zweiten Flächen 175b dargestellt.

Weder die ersten Flächen 175a noch die zweiten Flächen 175b sind parallel zur organischen Schichtenfolge 133 angeordnet. Somit sind diese Flächen auch nicht parallel zu der Ebene (xy-Ebene), in der die organische Leuchtdiode 1 - also zum Beispiel die organische Schichtenfolge - flächig ausgebildet ist, angeordnet.

Die Ausdehnung der Prismen in y-Richtung liegt dabei bevorzugt in makroskopischen Größenordnungen, also beispielsweise im Bereich von Millimetern bis Dezimetern. Zum Beispiel kann sich die Ausdehnung der Prismen in y-Richtung über die gesamte Länge der organischen Leuchtdiode 1 erstrecken. Die Breite der Prismen in x-Richtung ist bevorzugt größer als die Wellenlänge des von der organischen Leuchtdiode 1 erzeugten Lichts, so dass Beugungseffekte an den Prismen kaum oder nicht stattfinden. Die Breite der Prismen liegt bevorzugt in mikroskopischen Größenordnungen, beispielsweise im Submillimeterbereich, so dass für den menschlichen Betrachter eine Strukturierung in x-Richtung der Strahlungsaustrittsfläche 175 nicht sichtbar ist. Die Breite b eines Prismas kann 500 *µ*m oder weniger, vorzugsweise 250 *µ*m oder weniger betragen. Die Länge 1 eine Prismas kann 1 cm oder mehr, vorzugsweise 5 cm oder mehr betragen.

Die ersten Flächen 175a der strukturierten Strahlungsaustrittsfläche 175 sind transparent beziehungsweise zumindest strahlungsdurchlässig ausgebildet, wohingegen die zweiten Flächen 176 reflektierend für die in der organischen Leuchtdiode erzeugte elektromagnetische Strahlung sind. Die zweiten Flächen 175b können beispielsweise durch Bedampfen mit Metallpartikeln unter einem flachen Einfallswinkel reflektierend gemacht werden.

Auf diese Weise stellen im Ausführungsbeispiel der Figur 21 lediglich die ersten Flächen 175a Strahlungsaustrittsflächen der organischen Leuchtdiode 1 dar. Das heißt, nur durch die ersten Flächen 175a kann elektromagnetische Strahlung die organische Leuchtdiode 1 verlassen. Auf diese Weise weist die organische Leuchtdiode 1 ein Abstrahlungsprofil auf, das eine Hauptabstrahlungsrichtung aufweist, die gegenüber der z-Achse in Richtung der x-Achse geneigt ist. Der Neigungswinkel der Hauptabstrahlrichtung der organischen Leuchtdiode 1 ist dabei im Wesentlichen vom Winkel a bestimmt.

Von der organischen Schichtenfolge 133 erzeugte elektromagnetische Strahlung, die an den zweiten Flächen 175b reflektiert wird, kann nach einer oder mehrerer interner Reflektionen ebenfalls durch die strahlungsdurchlässigen ersten Flächen 175a aus der Licht emittierenden Vorrichtung austreten. Alternativ ist es möglich, dass es sich bei der organischen Leuchtdiode 1 um eine beidseitig abstrahlende organische Leuchtdiode 1 handelt, bei der die organische Schichtenfolge 133 sowie die Elektroden 101, 107 strahlungsdurchlässig ausgebildet sind. Auf diese Weise kann reflektierte Strahlung beispielsweise auf der gegenüberliegenden Seite der dargestellten Strahlungsaustrittsfläche 175 aus der organischen Leuchtdiode 1 austreten. Auch die gegenüberliegende Strahlungsaustrittsfläche kann dabei in der beschriebenen Weise strukturiert sein, so dass sich eine organische Leuchtdiode 1 ergibt, die beidseitig gerichtet elektromagnetische Strahlung abstrahlt.

Die Winkel a und ß, in denen die ersten 175a und zweiten Flächen 175b angeordnet sind, beeinflusst die Winkelverteilung der abgestrahlten elektromagnetischen Strahlung und die Häufigkeit der internen Reflektionen.

Bei der strukturierten Strahlungsaustrittsfläche 175 kann es sich beispielsweise um eine separate, entsprechend strukturierte Folie handeln, die auf den zweiten Träger 132 aufgebracht ist. Darüber hinaus ist es möglich - wie oben bereits angesprochen -, dass die strukturierte Strahlungsaustrittsfläche 175 direkt in den zweiten Träger 131 strukturiert ist oder durch den Teil einer Verkapselungsschichtenfolge 160 gebildet ist.

In Verbindung mit der Figur 22 sind verschiedene Abstrahlprofile (winkelabhängige Verteilung der abgestrahlten Intensität) von organischen Leuchtdioden 1 mit strukturierter Strahlungsaustrittsfläche 175 dargestellt. In der Figur 22a ist zunächst das zugrunde liegende Koordinatensystem dargestellt. Die organische Leuchtdiode 1 bildet mit ihrer lateralen, flächig ausgebildeten organischen Schichtenfolge 133 die xy-Ebene des Koordinatensystems. Bei einer nichtstrukturierten Strahlungsaustrittsfläche 175, ergibt sich in der Regel für die organische Leuchtdiode 1 ein Lambertsches Abstrahlprofil in Richtung der z-Achse. Durch die Strukturierung der Strahlungsaustrittsfläche 175 können nun gerichtete Abstrahlprofile erreicht werden.

Beispielsweise ist in Verbindung mit den Figuren 22b und 22c ein Typ A-1 beziehungsweise Typ A-2 Abstrahlprofil gezeigt, das durch eine symmetrische, herzförmige Strahlungsrichtungsverteilung mit zwei Maxima sowohl in x- als auch in y-Richtung (Typ A-1) oder in eine der beiden Richtungen (Typ A-2) ausgezeichnet ist. Solche Abstrahlmuster sind beispielsweise zur Allgemeinbeleuchtung in Räumen besonders gut geeignet.

Das in Figur 22d gezeigte Abstrahlprofil, Typ B genannt, ist stark asymmetrisch in zumindest einer der Richtungen x und y und ist beispielsweise zur gerichteten Beleuchtung besonders gut geeignet. Beispielsweise kann ein solches Abstrahlungsprofil für eine Schreibtischbeleuchtung Verwendung finden, bei der eine Arbeitsfläche gerichtet beleuchtet wird, ohne den Benutzer zu blenden. Ein solches Abstrahlprofil lässt sich mit dem in Verbindung mit der Figur 21 beschriebenen Ausführungsbeispiel einer hier beschriebenen organischen Leuchtdiode 1 erreichen.

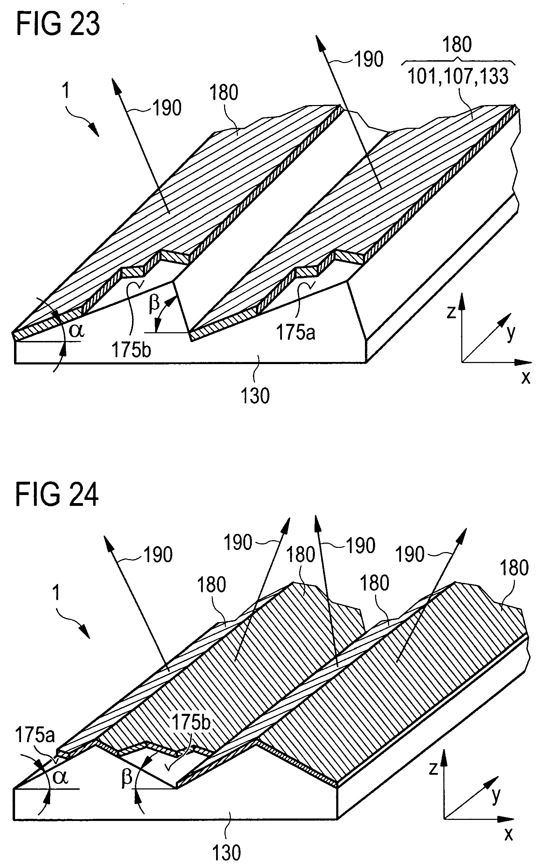

In Verbindung mit der Figur 23 ist ein weiteres Ausführungsbeispiel einer hier beschriebenen organischen Leuchtdiode 1 anhand einer perspektivischen schematischen Darstellung näher erläutert.

In diesem Ausführungsbeispiel ist die den funktionellen Schichten 180 zugewandte Oberseite des ersten Trägers 130 in parallele Prismen mit ersten Flächen 175a und zweiten Flächen 175b strukturiert. Die laterale, flächige Ausdehnung der organischen Leuchtdiode 1 und damit des ersten Trägers 130 liegt in der xy-Ebene. Gegenüber dieser xy-Ebene sind die ersten Flächen 175a um den Winkel a und die zweiten Flächen 175b um den Winkel ß geneigt. Auf die ersten Flächen 175a sind die funktionellen Schichten 180 aufgebracht. Die zweiten Flächen 175b sind frei von funktionellen Schichten. Der erste Träger 130 kann dabei beispielsweise mit einem Metall, mit einem Glas, mit einem Keramikmaterial oder mit einem Kunststoffmaterial gebildet sein. Der erste Träger kann dabei insbesondere auch flexibel ausgebildet sein und ist durch eine Folie oder ein Laminat gebildet.

Eine Verkapselung und hermetische Versiegelung der in Verbindung mit der Figur 23 beschriebenen organischen Leuchtdiode 1 kann beispielsweise mittels einer Verkapselungsschichtenfolge 160 oder mit anderen in Verbindung mit den Figuren 7 bis 19 beschriebenen Verkapselungsmethoden erfolgen.

Mit Vorteil und im Unterschied zum in Verbindung mit der Figur 21 dargestellten Ausführungsbeispiel können die funktionellen Schichten 180 im Ausführungsbeispiel der Figur 23 separat ansteuerbar sein. Auf diese Weise kann die Helligkeit des von der organischen Leuchtdiode 1 erzeugten Lichts besonders gut reguliert werden, indem - je nach gewünschter Helligkeit - mehr oder weniger der funktionellen Schichten 180 bestromt werden. Darüber hinaus ist es möglich, dass sich die funktionellen Schichten 180 insbesondere im Hinblick auf den Aufbau der organischen Schichtenfolge 133 unterscheiden, so dass unterschiedliche funktionelle Schichten elektromagnetische Strahlung unterschiedlicher Wellenlänge emittieren können.

In Verbindung mit der Figur 24 ist anhand einer schematischen Perspektivdarstellung ein weiteres Ausführungsbeispiel einer hier beschriebenen organischen Leuchtdiode 1 näher erläutert. In diesem Ausführungsbeispiel ist der erste Träger 130 in eine Vielzahl von parallelen Prismen strukturiert. Im Unterschied zum Ausführungsbeispiel der Figur 23 sind nicht nur die ersten Flächen 175a mit funktionellen Schichten 180, sondern auch die zweiten Flächen 175b mit funktionellen Schichten 180 belegt.

Beim Ausführungsbeispiel der Figur 24 ist die strukturierte Strahlungsaustrittsfläche 175 in Form von Prismen strukturiert, die den Querschnitt eines gleichschenkligen Dreiecks aufweisen. Die gezeigte Anordnung resultiert in einer symmetrischen Abstrahlcharakteristik vom Typ A-2, mit zwei Hauptstrahlungsrichtungen, die von der z-Achse um den Winkel a = ß in positive und negative x-Richtung geneigt sind. In y-Richtung ergibt sich bei ausreichender Ausdehnung der organischen Leuchtdiode 1 in erster Näherung ein Lambertsches Abstrahlprofil. Falls die Winkel a und ß nicht gleich gewählt sind, sind die beiden Hauptstrahlungsrichtungen um unterschiedliche Winkel von der z-Achse neigt. Gleichzeitig ist die Intensität, mit der in die Hauptabstrahlrichtung emittiert wird, aufgrund der sich ergebenden unterschiedlich großen Flächen der funktionellen Schichten 180, verschieden.

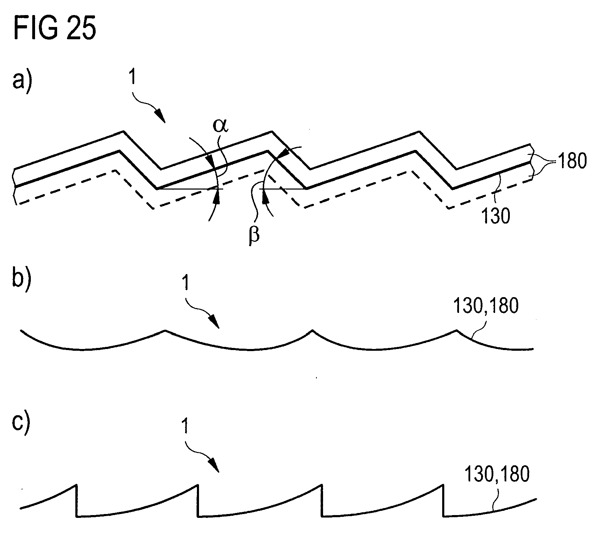

Weitere Möglichkeiten zur Strukturierung des ersten Trägers 130 oder allgemein zur Strukturierung der Strahlungsaustrittsfläche 175 sind in Verbindung mit den Figuren 25a, b, c anhand von schematischen Schnittdarstellungen beschrieben. Im in Verbindung mit der Figur 25a beschriebenen Ausführungsbeispiel sind die Winkel a und ß unterschiedlich groß gewählt. Es ergibt sich auf diese Weise eine Verteilung vom Typ A-2 mit unterschiedlichen Intensitäten in beiden Hauptabstrahlrichtungen. Beispielsweise für eine beidseitig abstrahlende organische Leuchtdiode 1 kann auch die Unterseite des ersten Trägers 130 entsprechend strukturiert sein, wie dies durch die gestrichelte Linie in der Figur 25a angedeutet ist.

Anhand der Figuren 25b und 25c ist verdeutlicht, dass die Strukturierung der Strahlungsaustrittsfläche 175 nicht zwingend durch die Bildung von planen Flächen 175a, 175b erfolgen muss, die in bestimmten Winkeln zueinander angeordnet sind, sondern dass eine Strukturierung in beliebiger Weise beispielsweise nach Art von Zylinderschnitten und dergleichen erfolgen kann.

Insgesamt ist anhand der Figuren 21 bis 25 verdeutlicht, dass durch die Strukturierung von Trägern, Verkapselungsschichten und/oder funktionellen Schichten eine organische Leuchtdiode 1 angegeben werden kann, die eine gerichtete Abstrahlcharakteristik aufweist. Die Strahllenkung kann dabei beispielsweise durch Reflektion, Brechung und/oder entsprechende Ausrichtung der funktionellen Schichten 180 erfolgen.

Entsprechende Strukturierungen können dabei für alle in Verbindung mit den Figuren 7 bis 20 beschriebenen Verkapselung- und Versiegelungstechniken Verwendung finden. Darüber hinaus können alle in Verbindung mit den Figuren 1 bis 6 beschriebenen strahlungsemittierende Schichtenfolgen für organische Leuchtdioden 1 mit gerichteter Abstrahlcharakteristik zum Einsatz kommen. Auch beliebige Kombinationen der in Verbindung mit den Figuren 1 bis 25 beschriebenen organischen Leuchtdioden 1 sind möglich.

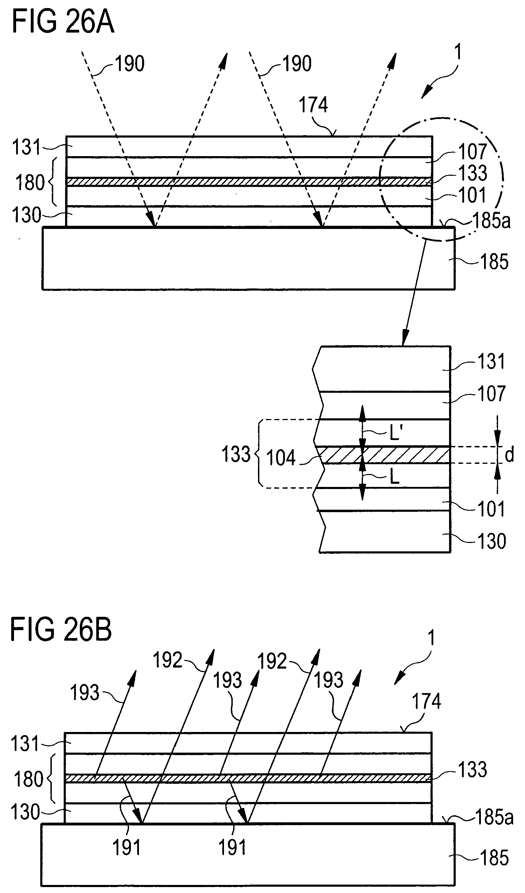

In Verbindung mit den schematischen Schnittdarstellungen der Figuren 26A und 26B ist ein weiteres Ausführungsbeispiel einer hier beschriebenen organischen Leuchtdiode 1 näher erläutert. Die in Verbindung mit den Figuren 26A und 26B beschriebene organische Leuchtdiode 1 eignet sich besonders gut zur Beleuchtung einer zu beleuchtenden Fläche 185a eines zu beleuchtenden Elements 185.

Die zu beleuchtende Fläche 185a des Elements 185 ist beispielsweise der Teil einer Außenfläche des zu beleuchtenden Elements 185.

Beispielsweise kann es sich bei dem zu beleuchtenden Element 185 um eine Fliese, ein Poster, eine Kachel, ein Verkehrszeichen, eine Hinweistafel, ein Schild, ein Bild oder ein beliebiges anderes Element handeln. Das zu beleuchtende Element 185 kann beispielsweise auch ein Spiegel sein, der als zu beleuchtende Fläche 185a, eine reflektierende Spiegelfläche aufweist.

Die organische Leuchtdiode 1 ist zumindest mittelbar auf das zu beleuchtende Element 185 aufgebracht. Die organische Leuchtdiode 1 kann beispielsweise direkt auf dem zu beleuchtenden Element 185 befestigt sein. Beispielsweise kann die organische Leuchtdiode 1 mittels eines transparenten Klebstoffs auf das zu beleuchtende Element 185 aufgeklebt sein. Auch andere Befestigungsmethoden, wie Klettverschlüsse, Schraubverbindungen, Klemmverbindungen, Presspassungen oder dergleichen sind möglich.

Bei der organischen Leuchtdiode 1 handelt es sich um eine strahlungsdurchlässige, vorzugsweise um eine transparente organische Leuchtdiode 1, wie sie hier beschrieben ist.

Im Ausführungsbeispiel der Figuren 26a und 26b umfasst die organische Leuchtdiode 1 einen ersten Träger 130 und einen zweiten Träger 131. Zwischen erstem Träger 130 und zweitem Träger 131 sind die funktionellen Schichten 180, das heißt beispielsweise die erste Elektrode 101, die zweite Elektrode 107 sowie die organische Schichtenfolge 133 angeordnet. Die organische Leuchtdiode 1 kann dabei wie hier beschrieben verkapselt sein. Das heißt, die organische Leuchtdiode 1 muss nicht zwei Träger 130, 131 aufweisen, sondern sie kann beispielsweise auch mittels einer Diffusionsbarriere 153, einer Dünnfilmverkapselung 154, einer Vorverkapselungsschicht 156 und/oder einer Verkapselungsschichtenfolge 160 verkapselt sein. Dabei ist es insbesondere auch möglich, dass die organische Leuchtdiode 1 mit der Verkapselungsschichtenfolge 160 auf die zu beleuchtende Fläche 185a des zu beleuchtenden Elements 185 aufgebracht, beispielsweise aufgeklebt ist. Ferner kann es vorteilhaft sein, wenn die organische Leuchtdiode 1 flexibel ausgebildet ist. Sie kann sich dann besonders gut dem Verlauf der zu beleuchtenden Fläche 185a anpassen.

Die Figur 26a zeigt die organische Leuchtdiode 1 in einem ausgeschalteten Betriebszustand. Das heißt, im strahlungsemittierenden Bereich 104 der organischen Leuchtdiode 1 wird keine elektromagnetische Strahlung erzeugt. Von außen auf die zu beleuchtende Fläche 185a auftreffende elektromagnetische Strahlung 190 kann die transparente organische Leuchtdiode 1 durchdringen und wird von der zu beleuchtenden Fläche 185a reflektiert. Auf diese Weise sieht ein Betrachter lediglich die zu beleuchtende Fläche 185a, beispielsweise ein Bild, ein Verkehrszeichen, eine Hinweistafel, eine Spiegel oder dergleichen.

In der Figur 26b ist die organische Leuchtdiode 1 schematisch in einem angeschalteten Betriebszustand dargestellt. In diesem angeschalteten Betriebszustand emittiert der strahlungsemittierende Bereich 104 der organischen Leuchtdiode 1 elektromagnetische Strahlung 191, die auf die zu beleuchtende Fläche 185a trifft und dort zumindest teilweise reflektiert wird. Darüber hinaus kann elektromagnetische Strahlung 193 auch direkt aus der organischen Leuchtdiode 1 austreten, ohne vorher auf die zu beleuchtende Fläche 185a zu treffen. Das relative Verhältnis von den Intensitäten von indirekt austretender elektromagnetischer Strahlung 192 und direkt austretender elektromagnetischer Strahlung 193 kann beispielsweise durch eine optische Kavität oder auch durch unterschiedlich stark transparente erste Elektroden 101 und zweite Elektroden 107 einstellbar und wählbar sein.

Eine "optische Kavität" kann dabei hier und im Folgenden insbesondere bedeuten, dass die organische Leuchtdiode 1 einen optischen Resonator bildet, in dem elektromagnetische Strahlung mit einer oder mehreren bestimmten Wellenlängen und/oder einer oder mehreren bestimmten Abstrahlrichtungen bevorzugt erzeugt werden kann, die auch als Resonanzen oder Moden bezeichnet werden können. Dazu können beispielsweise die erste Elektrode 101, die organische Schichtenfolge 133 und die zweite Elektrode 107 als optische Kavität ausgebildet sein. Das kann bedeuten, dass die zumindest teilweise transparente erste Elektrode 101 und die zumindest teilweise transparente zweite Elektrode 107 zusätzlich auch eine Reflektivität für die im strahlungsemittierenden Bereich 104 erzeugte elektromagnetische Strahlung aufweisen. Alternativ oder zusätzlich können die erste Elektrode 101, die organische Schichtenfolge 133 und die zweite Elektrode 107 zwischen teilweise reflektierenden Schichten angeordnet sein, die zusätzlich auch teilweise transparent sind. Die folgende Beschreibung der optischen Kavität ist rein beispielhaft für teilweise reflektierende Elektroden 101, 107 ausgeführt.

Die erste Elektrode 101 und/oder die zweite Elektrode 107 können einen Reflexionsgrad R beziehungsweise R' aufweisen und die organische Schichtenfolge 133 kann einen Brechungsindex n für die im strahlungsemittierenden Bereich 104 erzeugte elektromagnetische Strahlung aufweisen. Da die erste 101 und zweite Elektrode 107 teilweise transparent sind, gilt dabei R<1 und R'<1. Der Brechungsindex n kann über die organische Schichtenfolge 133 konstant sein oder zumindest in Teilbereichen, beispielsweise in verschiedenen organischen Schichten, konstant sein. Weiterhin kann der Brechungsindex n auch über die organische Schichtenfolge 133 variieren. Der strahlungsemittierende Bereich 104 der organischen Schichtenfolge kann eine Dicke d aufweisen und mit einem mittleren Abstand L von der ersten Elektrode 101 und mit einem mittleren Abstand L' von der zweiten Elektrode 107 beabstandet angeordnet sein. Der mittlere Abstand L und der mittlere Abstand L' bezeichnen dabei die über die Dicke d des strahlungsemittierenden Bereichs 104 gemittelten Abstände zur ersten Elektrode 101 beziehungsweise zur zweiten Elektrode 107. Dabei können die Parameter R, R', n, d, L und L' derart gewählt sein, dass die organische Schichtenfolge eine bestimmte Abstrahlcharakteristik aufweist.

Beispielsweise können die Reflexionsgrade R und R' der ersten und zweiten Elektrode und der Brechungsindex n der organischen Schichtenfolge 133 aufgrund der jeweiligen Materialwahl vorgegeben sein, so dass durch Wahl der mittleren Abstände L und L' und der Dicke d des strahlungsemittierenden Bereichs 104 die gewünschte Abstrahlcharakteristik ermöglicht werden kann. Alternativ dazu können die Abmessungen der organischen Schichtenfolge 133 und des strahlungsemittierenden Bereichs 104, also die mittleren Abstände L und L' und die Dicke d, vorgegeben sein, beispielsweise durch den Aufbau oder das Herstellungsverfahren der organischen Leuchtdiode 1. In diesem Fall kann durch Wahl des Materials für die erste 101 und zweite Elektrode 107 über deren Reflexionsgrad R und R' die gewünschte Abstrahlcharakteristik ermöglicht werden.

Beispielsweise können die mittleren Abstände L und L' in der Größenordnung der Wellenlänge der im strahlungsemittierenden Bereich 104 erzeugten elektromagnetischen Strahlung oder kleiner sein. Weist die elektromagnetische Strahlung eine spektrale Verteilung von mehreren Wellenlängen und/oder Wellenlängenbereichen auf, kann die elektromagnetische Strahlung dabei auch durch eine mittlere Wellenlänge charakterisiert werden und die Abmessungen der organischen Schichtenfolge 133 hier und im Folgenden auf die mittlere Wellenlänge der elektromagnetischen Strahlung bezogen sein. Weiterhin können die mittleren Abstände L, L' auch kleiner oder gleich der halben Wellenlänge der elektromagnetischen Strahlung sein oder kleiner oder gleich einem Viertel der Wellenlänge der elektromagnetischen Strahlung oder auch kleiner oder gleich einem Achtel der Wellenlänge der elektromagnetischen Strahlung sein. Weiterhin oder zusätzlich können die mittleren Abstände L und L' größer oder gleich 1/20 der Wellenlänge der elektromagnetischen Strahlung sein oder auch größer oder gleich 1/10.

Solche mittleren Abstände L und L' können in Verbindung mit der teilweise reflektierenden ersten 101 und zweiten Elektrode 107 die Ausbildung einer zumindest halbseitig reflektierenden Kavität in der strahlungsemittierenden Schichtenfolge bewirken. Ein von einem angeregten Zustand (Exciton) im strahlungsemittierenden Bereich 104 abgestrahltes Photon oder Wellenpaket kann dabei an der ersten Elektrode 101 und an der zweiten Elektrode 107 reflektiert werden. Dadurch, dass die mittleren Abstände L und L' in der Größenordnung der Wellenlänge der elektromagnetischen Strahlung oder kleiner sein können, kann, vereinfacht gesprochen, eine Rückkopplung des abgestrahlten Wellenpakets mit dem angeregten Zustand noch während der Abstrahlung des Wellenpakets möglich sein, so dass der angeregte Zustand während der Abstrahlung des Wellenpakets vom elektromagnetischen Feld seines "eigenen" reflektierten Wellenpakets beeinflusst werden kann. Je nach Phasenlage des reflektierten Wellenpakets kann somit eine Verstärkung oder Abschwächung der Abstrahlung des angeregten Zustands ermöglicht werden. Die Phasenlage kann dabei vom Brechungsindex n der organischen Schichtenfolge 133, den Reflektivitäten R, R' der ersten 101 und zweiten Elektrode 107 in Verbindung mit der Eindringtiefe der elektromagnetischen Strahlung in die erste 101 und zweite Elektrode 107 sowie von den Abständen zwischen dem angeregten Zustand und der ersten 101 und zweiten Elektrode 107 in Verbindung mit der Abstrahlrichtung des Wellenpakets abhängig sein. Dadurch kann sich in der organischen Schichtenfolge eine Modenstruktur ausbilden, die eine Abstrahlung der elektromagnetischen Strahlung in bestimmte Richtungen begünstigen und/oder bewirken kann. Weiterhin kann auch die Dicke d des strahlungsemittierenden Bereichs 104 die Ausbildung von Abstrahlungsmoden beeinflussen.

Die organische Leuchtdiode 1 kann eine Abstrahlcharakteristik der im strahlungsemittierenden Bereich 104 erzeugten elektromagnetischen Strahlung aufweisen, so dass in Richtung des zu beleuchtenden Elements 185 die elektromagnetische Strahlung mit einer ersten Intensität und in Richtung der Strahlungsaustrittsfläche 174 mit einer zweiten Intensität abgestrahlt wird. Die erste Intensität und die zweite Intensität können dabei an Außenflächen der organischen Leuchtdiode 1 definiert sein, also beispielsweise an von der organischen Schichtenfolge 133 abgewandten Oberflächen der ersten 101 oder zweiten Elektrode 107, eines Trägers 130, 133 oder einer Verkapselungsschichtenfolge 160. Mit "Intensität in Richtung" des zu beleuchtenden Elements 185 beziehungsweise der Strahlungsaustrittsfläche 174 kann für die erste und zweite Intensität die jeweilige Gesamtintensität in die Halbräume auf der dem zu beleuchtenden Element 185 zugewandten beziehungsweise abgewandten Seite der organischen Leuchtdiode 1 bezeichnet sein.

Die elektromagnetische Strahlung mit der ersten Intensität, die in Richtung des zu beleuchtenden Elements 185 von der organischen Leuchtdiode 1 abgestrahlt wird, kann dabei die zumindest teilweise nicht-transparente zu beleuchtende Fläche 185a beleuchten. Dadurch, dass die zu beleuchtende Fläche 185a zumindest teilweise nicht-transparent ist, kann zumindest ein Teil der elektromagnetischen Strahlung mit der ersten Intensität in Richtung der Strahlungsaustrittsfläche 174 reflektiert werden und durch die Strahlungsaustrittsfläche 174 hindurch von einem externen Beobachter wahrnehmbar sein. Mit anderen Worten kann das bedeuten, dass für einen externen Beobachter die zu beleuchtende Fläche 185a des Trägerelements beleuchtet und damit in einem eingeschalteten Betriebszustand der organischen Leuchtdiode 1 wahrnehmbar ist. Dies kann insbesondere der Fall sein, wenn die erste Intensität größer als die zweite Intensität ist.

Eine derartige Abstrahlcharakteristik kann dabei beispielsweise durch die optische Kavität wie oben beschrieben ermöglicht werden.

Alternativ oder zusätzlich können die erste 101 und zweite Elektrode 107 voneinander verschiedene Durchlässigkeiten, also Transmittivitäten, aufweisen. Ist etwa die erste Elektrode 101 auf der dem zu beleuchtenden Element 185 zugewandten Seite der organischen Schichtenfolge 133 angeordnet und weist eine größere Transmittivität als die zweite Elektrode 107 auf, kann es möglich sein, dass die im strahlungsemittierenden Bereich 104 erzeugte elektromagnetische Strahlung mit einer ersten Intensität in Richtung des zu beleuchtenden Elements 185 abgestrahlt wird, die größer als die zweite Intensität ist.

Alternativ dazu kann die zweite Intensität größer als die erste Intensität sein. Eine derartige Abstrahlcharakteristik kann wiederum beispielsweise durch eine optische Kavität ermöglicht werden. Alternativ oder zusätzlich kann beispielsweise die zweite Elektrode 107 auf der zu beleuchtenden Element 185 abgewandten Seite der organischen Schichtenfolge 133 angeordnet sein und eine größere Transmittivität als die erste Elektrode 101 aufweisen. In diesem Fall kann es möglich sein, dass die zu beleuchtende Fläche 185a im Vergleich zum ausgeschalteten Betriebszustand der organischen Leuchtdiode 1 weniger deutlich wahrnehmbar ist, da ein externer Beobachter die reflektierte elektromagnetische Strahlung mit der ersten Intensität und die direkt über die Strahlungsaustrittsfläche der strahlungsemittierenden Anordnung abgestrahlte elektromagnetische Strahlung mit der zweiten Intensität als Überlagerung wahrnehmen kann. Weiterhin kann im eingeschalteten Betriebszustand die zu beleuchtende Fläche 185a gar nicht mehr wahrnehmbar sein, wenn die an der zumindest teilweise nicht-transparenten Hauptoberfläche reflektierte elektromagnetische Strahlung mit der ersten Intensität von der elektromagnetischen Strahlung mit der zweiten Intensität im obigen Sinne überstrahlt wird.

Damit können die organische Leuchtdiode 1 und die Strahlungsaustrittsfläche 174 im ausgeschalteten Betriebszustand durchsichtig erscheinen und im eingeschalteten Betriebszustand je nach Verhältnis der ersten Intensität zur zweiten Intensität undurchsichtig oder ebenfalls zumindest teilweise durchsichtig erscheinen.

Die organische Leuchtdiode 1 kann beispielsweise derart strukturiert ausgebildet sein, dass im eingeschalteten Betriebszustand durch erste Bereiche der Strahlungsaustrittsfläche 174 hindurch zu beleuchtende Fläche 185a wahrnehmbar ist und durch zweite Bereiche hindurch nicht. Dabei kann die organische Leuchtdiode 1 beispielsweise nur in Teilbereichen elektromagnetische Strahlung abstrahlen oder auch großflächig elektromagnetische Strahlung abstrahlen. Durch ein derartiges segmentiertes Ausleuchten und/oder ein segmentiertes Abstrahlen der elektromagnetischen Strahlung in Richtung eines externen Beobachters kann es möglich sein, dass sich beispielsweise verschiedene Beleuchtungsmuster erzeugen oder temporär Hinweise oder Informationen einblenden lassen. Im ausgeschalteten Betriebszustand sind diese Muster, Hinweise und/oder Informationen nicht sichtbar und beeinträchtigen die Erscheinungsform und die Wahrnehmbarkeit der zu beleuchtenden Fläche nicht.

Aufgrund des einstellbaren Intensitätsverhältnisses ist es also möglich, dass von einem Betrachter, beispielsweise nur von der organischen Leuchtdiode 1, direkt abgestrahltes Licht 193 wahrgenommen wird. Darüber hinaus ist es möglich, dass vom Betrachter hauptsächlich die zu beleuchtende Fläche 185a des zu beleuchtenden Elements 185 wahrgenommen wird. Dies ist dann möglich, wenn die direkt nach außen abgestrahlte elektromagnetische Strahlung 193 eine geringere Intensität als die auf die zu beleuchtende Fläche 185a gerichtete elektromagnetische Strahlung 191 aufweist.

Ferner kann der Eindruck der zu beleuchtenden Fläche 185a, der vom Betrachter wahrgenommen wird, auch durch eine Veränderung der Wellenlänge des von der organischen Leuchtdiode 1 im Betrieb erzeugten Lichts erreicht sein. Für eine besonders realistische Wiedergabe der zu beleuchtenden Fläche 185a kann es jedoch wünschenswert sein, dass es sich bei der organischen Leuchtdiode 1 um eine weißes Licht emittierende organische Leuchtdiode 1 handelt, welche transparent ist. Dafür kann eine der hier beschriebenen organischen Leuchtdioden 1 Verwendung finden.

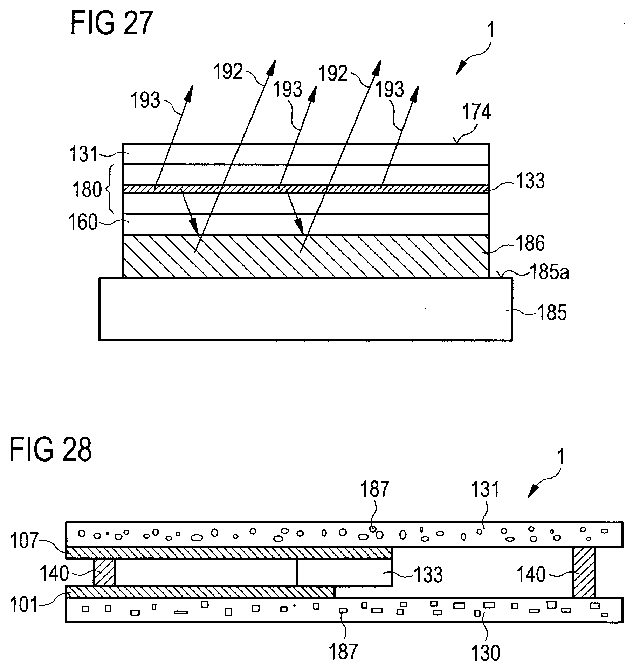

In Verbindung mit der Figur 27 ist anhand einer schematischen Schnittdarstellung ein weiteres Ausführungsbeispiel einer hier beschriebenen organischen Leuchtdiode 1 näher erläutert. In diesem Ausführungsbeispiel ist im Unterschied zum Ausführungsbeispiel der Figuren 26a und 26b der erste Träger 130 durch eine Verkapselungsschichtenfolge 160 ersetzt, wie sie hier beschrieben ist. Bei der organischen Leuchtdiode 1 handelt es sich wiederum um eine transparente organische Leuchtdiode 1, die vorzugsweise weißes Licht emittiert. Zwischen der organischen Leuchtdiode 1 und dem zu beleuchtenden Element 185 ist ein elektrisch schaltbares optisches Element 186 angeordnet. Beispielsweise kann es sich bei diesem Element um einen elektrisch schaltbaren Diffusor handeln. Dieser Diffusor kann zwei Funktionszustände aufweisen: Zum einen kann er diffus streuend, das heißt opak geschaltet sein, zum anderen kann der Diffusor transparent geschaltet sein.

Beispielsweise kann der Diffusor durch ein Elektrodenpaar gebildet sein, welches flächige, transparente Elektrodenschichten aufweist, zwischen denen eine Flüssigkristallschicht angeordnet ist. Durch Anlegen einer äußeren Spannung kann die Transmission von elektromagnetischer Strahlung durch den Diffusor hindurch gezielt beeinflusst werden.

Ist das elektrisch schaltbare optische Element 186 diffus geschaltet, so wie dies in der Figur 27 dargestellt ist, wird von der organischen Leuchtdiode 1 erzeugte elektromagnetische Strahlung 192 im elektrisch schaltbaren optischen Element 16a diffus gestreut. Vom Beobachter ist daher die zu beleuchtende Fläche nur mehr verschwommen oder gar nicht mehr wahrnehmbar. Auf diese Weise ist es möglich, dass die Anordnung von organischer Leuchtdiode 1, elektrisch schaltbarem optischem Element 186 sowie zu beleuchtendem Element 185 im Sinne eines Beleuchtungsmittels zur Allgemeinbeleuchtung verwendet wird.

Bei transparent geschaltetem, elektrisch schaltbarem optischem Element 186 ist die zu beleuchtende Fläche 185a sichtbar.

Im Ausführungsbeispiel der Figur 27 kann es sinnvoll sein, dass die zu beleuchtende Fläche 185a und das zu beleuchtende Element 185 selbst transparent sind. Auf diese Weise stellt die Anordnung ein transparentes Beleuchtungsmittel dar, das bei Bedarf diffus geschaltet werden kann. Solche Beleuchtungsmittel können beispielsweise als Umkleidekabinen, Raumteiler oder ähnliche Elemente Verwendung finden. Auch im diffus geschalteten Zustand kann noch elektromagnetische Strahlung durch das schaltbare optische Element 186 und damit durch das Element 185 hindurch gelangen. Auf diese Weise dient die organische Leuchtdiode 1 mit dem schaltbaren optischen Element 186 und dem zu beleuchtenden Element 185 als beidseitig abstrahlenden Beleuchtungsmittel, das blickdicht ist.

Darüber hinaus ist es möglich, dass es sich bei dem elektrisch schaltbaren optischen Element 186 um ein elektrochromes Element handelt, das bei Anlegen einer äußeren Spannung seine Farbe verändern kann. Auf diese Weise kann beispielsweise - je nach Höhe der angelegten Spannung - ein Dimmen des Lichts erfolgen, das von der zu beleuchtenden Fläche 185a zurückreflektiert wird.

Insgesamt ist es beim Ausführungsbeispiel der Figur 27 auch möglich, dass es sich bei der zu beleuchtenden Fläche 185a um einen Spiegel handelt. In diesem Fall kann mittels des elektrisch schaltbaren optischen Elements 186 der Spiegel von einem reflektierenden Betriebszustand zu einem diffus streuenden und damit beleuchtenden Betriebszustand geschaltet werden.

Beim Ausführungsbeispiel der Figur 27 ist es darüber hinaus auch möglich, dass das elektrisch schaltbare optische Element 186 strukturiert ist, derart, dass es Bereiche gibt, in denen zwischen der organischen Leuchtdiode 1 und der zu beleuchtenden Fläche 185a kein elektrisch schaltbares optisches Element 186 angeordnet ist. Auf diese Weise können mittels des elektrisch schaltbaren optischen Elements 186 beispielsweise Muster oder räumlich begrenzte Farbschattierungen erzeugt werden.

In Verbindung mit der Figur 28 ist ein weiteres Ausführungsbeispiel einer organischen Leuchtdiode 1 näher erläutert. In diesem Ausführungsbeispiel ist der organischen Schichtenfolge 133 zumindest in einer Abstrahlrichtung ein Wellenlängenkonversionsstoff 187 nachgeordnet. Dabei ist es möglich - wie in Figur 28 dargestellt -, dass es sich bei der organischen Leuchtdiode 1 um eine beidseitig emittierende organische Leuchtdiode 1 handelt, wobei der organischen Leuchtdiode 1 in beide Hauptabstrahlrichtungen ein Wellenlängenkonversionsstoff 187 nachgeordnet ist. Für unterschiedliche Hauptabstrahlrichtungen können unterschiedliche Wellenlängenkonversionsstoffe 187 Verwendung finden.

Beispielsweise wird im strahlungsemittierenden Bereich 104 der organischen Leuchtdiode 1 blaues Licht emittiert. Die beidseitig abstrahlende organische Leuchtdiode 1 kann dann in eine Richtung weißes Licht emittieren und in die andere Richtung beispielsweise farbiges Licht. Der gewünschte Farbeindruck ist dabei jeweils durch die Auswahl eines geeigneten Wellenlängenkonversionsstoffs 187 einstellbar. Beispielsweise kommen dazu die folgenden Wellenlängenkonversionsstoffe 187 in Frage: Granate der Seltenen Erden und der Erdalkalimetalle, beispielsweise YAG:Ce³⁺, weiterhin auch Nitride, Nitridosilikate, Sione, Sialone, Aluminate, Oxide, Halophosphate, Orthosilikate, Sulfide, Vanadate, Perylene, Cumarin und Chlorosilikate, oder Mischungen dieser Stoffe.

Im Ausführungsbeispiel der Figur 28 ist der Wellenlängenkonversionsstoff 187 in den ersten Träger 130 sowie den zweiten Träger 131 eingebracht. Der Wellenlängenkonversionsstoff 187 kann jedoch auch in ein Matrixmaterial als Schicht auf eine Außenfläche des ersten Trägers 130 und/oder des zweiten Trägers 131 aufgebracht sein. Darüber hinaus ist es möglich, dass die organische Leuchtdiode 1 keinen oder nur einen Träger aufweist und auf andere Weise verkapselt ist. Anhand des Ausführungsbeispiels der Figur 28 ist lediglich näher erläutert, dass die von der organischen Leuchtdiode 1 im Betrieb abgestrahlte elektromagnetische Strahlung hinsichtlich ihres Farbeindrucks auch durch die Verwendung von Wellenlängenkonversionsstoffen bestimmt oder mitbestimmt sein kann.

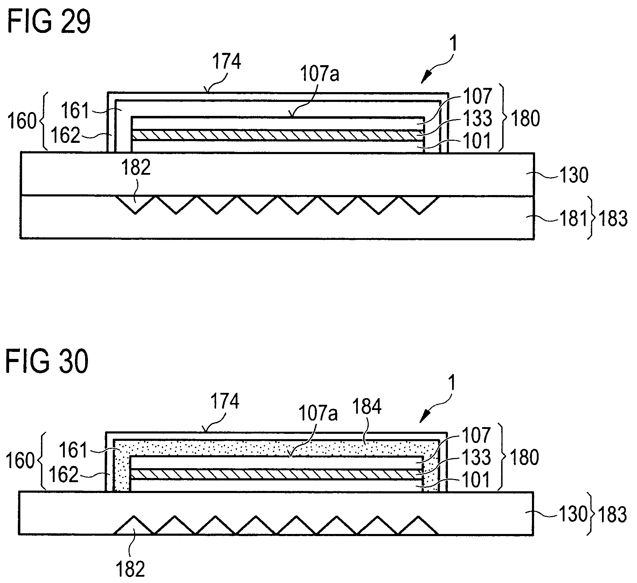

Die Figuren 29 und 30 zeigen anhand schematischer Schnittdarstellungen Ausführungsbeispiele organischer Leuchtdioden, die jeweils einen Retro-Reflektor 183 aufweisen.

Bei einem Retro-Reflektor handelt es sich um ein reflektives, optisches Element, das für einen großen Bereich von Einfallswinkeln einfallendes Umgebungslicht im Wesentlichen in die gleiche Richtung zurückreflektiert, aus der es kommt. Anders ausgedrückt verlaufen ein auf den Retro-Reflektor 183 einfallender Teil und ein von dem Retro-Reflektor reflektierter Teil eines Lichtstrahls im Wesentlichen parallel. Der Einfallswinkel ist dabei der Winkel zwischen dem einfallen Teil des Lichtstrahls und der Flächennormalen einer Haupterstreckungsebene des Retro-Reflektors 183.

Insbesondere schließen der einfallende und der reflektierte Teil einen Winkel von kleiner oder gleich 15°, vorzugsweise von kleiner oder gleich 10°, besonders bevorzugt von kleiner oder gleich 5° ein. Eine Obergrenze für den Einfallswinkel ist beispielsweise größer oder gleich 45°, vorzugsweise größer oder gleich 60°, besonders bevorzugt größer oder gleich 75°.

Der Retro-Reflektor 183 weist dabei vorzugsweise eine geringfügige Streuung auf. Anders ausgedrückt wird der einfallende Teil des Lichtstrahls in einen schmalen, divergenten Strahlenkegel zurückreflektiert. Der Strahlenkegel hat eine Mittelachse, die im Wesentlichen parallel zu dem einfallen Teil des Lichtstrahls verläuft, also mit diesem beispielsweise einen Winkel von kleiner oder gleich 15°, bevorzugt von kleiner oder gleich 10° und besonders bevorzugt von kleiner oder gleich 5° einschließt. Der Strahlkegel kann einen Öffnungswinkel von 5° oder weniger aufweisen.

Die Retroreflektion durch den Retro-Reflektor 183 in einen schmalen, divergenten Strahlenkegel ist vorteilhaft, wenn der von einer externen Lichtquelle - wie einem Scheinwerfer eines Fahrzeugs - einfallende Lichtstrahl nicht direkt in die externe Lichtquelle zurückreflektiert werden soll, sondern zum Beispiel von einem Beobachter in der Nähe der externen Lichtquelle - etwa vom Fahrzeugführer - wahrgenommen werden soll.

Im Ausführungsbeispiel gemäß der Figur 29 sind die Elektroden 101, 107 sowie die organische Schichtenfolge 133 zumindest strahlungsdurchlässig, vorzugsweise transparent ausgebildet. Die funktionellen Schichten 180 sind dabei auf einen ersten Träger 130 aufgebracht, der beispielsweise durch eine transparente Folie oder mit einem Glas gebildet sein kann. In jedem Fall ist der erste Träger 130 vorzugsweise transparent ausgeführt. Rein beispielhaft ist die organische Leuchtdiode 1 im Ausführungsbeispiel der Figur 29 mit einer Verkapselungsschichtenfolge 160 aus erster Verkapselungsschicht 161 und zweiter Verkapselungsschicht 162, wie sie hier beschrieben ist, verkapselt. Alternativ sind auch alle anderen hier beschriebenen Verkapselungsmethoden und Kombinationen dieser Verkapselungsmethoden zur Bildung der organischen Leuchtdiode 1 möglich.

Bei der organischen Leuchtdiode 1 kann es sich insbesondere um eine transparente, weißes Licht emittierende, flexibel ausgebildete organische Leuchtdiode 1 handeln. Die organische Leuchtdiode 1 ist an ihrer der organischen Schichtenfolge 133 abgewandten Außenfläche, das heißt mit dem ersten Träger 130, auf den Retro-Reflektor 183 aufgebracht.

Vorliegend ist der Retro-Reflektor 183 aus einer reflektierenden Platte 182 gebildet, in welche Strahlungsformelemente 182 eingebracht sind. Beispielsweise handelt es sich bei den Strahlungsformelementen 182 um pyramidenförmige Vertiefungen. Die Strahlungsformelemente 182 können dabei so genannte Triple-Spiegel darstellen. Anders ausgedrückt hat jedes Strahlungsformelement 182 vorzugsweise genau drei Seitenflächen. Die Seitenflächen können dabei jeweils einen Winkel von etwa 90°, zum Beispiel einen Winkel zwischen 85° und 95° miteinander einschließen, wobei die Grenzen eingeschlossen sind.

Die Strahlungsformelemente 182 können in die reflektierende Platte 181 eingeprägt sein. Vorzugsweise besteht die reflektierende Platte 181 dazu aus einem reflektierenden Metall.

Im Unterschied zum Ausführungsbeispiel der Figur 29 ist im Ausführungsbeispiel der Figur 30 der Retro-Reflektor durch einen Teil des ersten Trägers 130 gebildet. Beispielsweise ist der erste Träger 130 als transparente Kunststofffolie oder als Glassubstrat ausgebildet. Die Strahlungsformelemente 182 befinden sich als Vertiefungen auf der der organischen Schichtenfolge 133 abgewandten Seite des ersten Trägers 130. Die Strahlungsformelemente sind von dieser Seite vorzugsweise mit einer reflektierenden Schicht, beispielsweise einer aufgedampften Metallschicht, beschichtet.

Ferner ist der organischen Schichtenfolge 133 ein Farbfilter 184 nachgeordnet, der beispielsweise durch Farbfilterpartikel gebildet sein kann, die in die erste Verkapselungsschicht 161 eingebracht sind. Darüber hinaus ist es möglich, dass der organischen Schichtenfolge 133 ein Farbfilter 184 als separates Bauelement nachgeordnet ist oder als separate Schicht auf die Verkapselungsschichtenfolge 160 aufgebracht ist.

Der Farbfilter 184 hat eine hohe Transmission für einen ersten spektralen Teilbereich des sichtbaren Wellenlängenspektrums und eine hohe Absorption für einen zweiten spektralen Teilbereich des sichtbaren Wellenlängenspektrums. Ein Intensitätsmaximum der vom strahlungsemittierenden Bereich 104 im Betrieb erzeugten elektromagnetischen Strahlung liegt innerhalb des vom Farbfilter 184 transmittierten ersten spektralen Teilbereichs. Alternativ zu einem Farbfilter ist es auch möglich, dass der Retro-Reflektor 183 selbst eine wellenlängenselektive Spiegelschicht zur Reflektion des Umgebungslichts enthält, die den ersten Teilbereich reflektiert und den zweiten Teilbereich absorbiert und/oder transmittiert.

Mit Vorteil erzeugt auf diese Weise der Anteil des Umgebungslichts, der vom Retro-Reflektor 183 zur Strahlungsaustrittsfläche 174 zurückreflektiert und aus der organischen Leuchtdiode 1 ausgekoppelt wird, im Wesentlichen den gleichen Farbeindruck wie das von der organischen Leuchtdiode 1 emittierte Licht. Mit Vorteil ruft also die organische Leuchtdiode 1 unabhängig vom Betriebszustand den gleichen Farbeindruck hervor.

Für Ausführungsformen, in denen es lediglich auf den Farbeindruck ankommt, kann der Retro-Reflektor 183 dabei auch durch eine beliebig andere reflektierend ausgebildete Schicht oder ein anderes reflektierend ausgebildetes Element ersetzt sein, das keine retroreflektierenden Eigenschaften aufweisen muss.

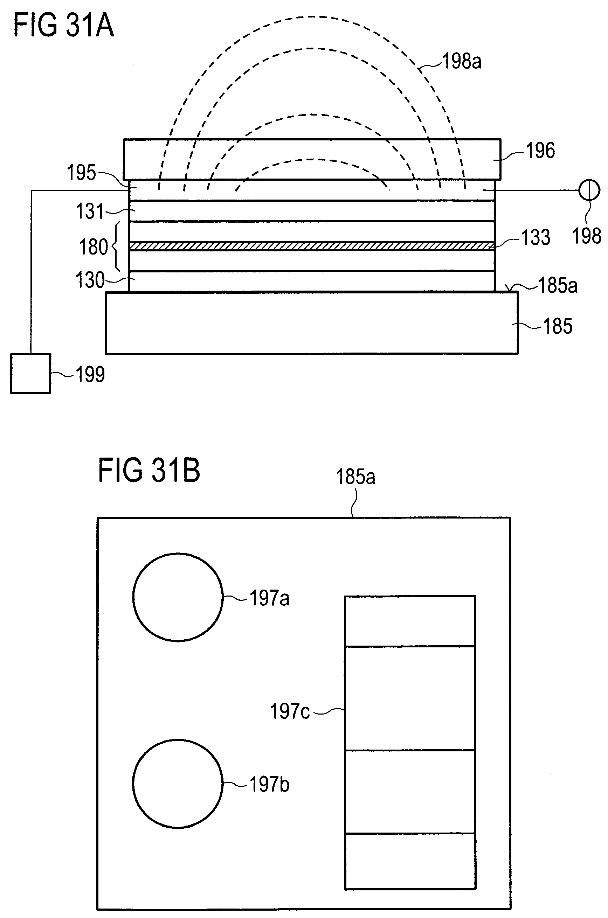

In Verbindung mit den Figuren 31A und 31B ist anhand schematischer Schnittdarstellungen ein Ausführungsbeispiel einer hier beschriebenen organischen Leuchtdiode 1 näher erläutert, bei dem die organische Leuchtdiode einen Berührungssensor umfasst. Mittels des Berührungssensors können beispielsweise Funktionen der organischen Leuchtdiode 1 oder anderer Geräte gesteuert werden.

Im Ausführungsbeispiel der Figuren 31A und 31B umfasst die organische Leuchtdiode einen ersten Träger 130, eine auf den ersten Träger angeordnete funktionelle Schichtenfolge 180, sowie einen zweiten Träger 131. Die Verkapselung der organischen Leuchtdiode kann dabei wie hier beschrieben erfolgen. Mit der den funktionellen Schichten 180 abgewandten Seite des ersten Trägers 130 ist die organische Leuchtdiode 1 auf ein zu beleuchtendes Element 185 aufgebracht, das eine zu beleuchtende Fläche 185a umfasst.

In der Figur 31B ist dargestellt, dass auf die zu beleuchtende Fläche 185a bildliche Darstellungen von Bedienelementen 197a, 197b, 197c aufgebracht sind. Im Betrieb der organischen Leuchtdiode können diese Bedienelemente durch im strahlungsemittierenden Bereich 104 erzeugte elektromagnetische Strahlung beleuchtet werden.

An der den funktionellen Schichten 180 abgewandten Seite des zweiten Trägers 131 ist eine dritte Elektrode 195 angeordnet. Der dritten Elektrode 195 folgt eine Abdeckplatte 196 nach. Bei der Abdeckplatte kann es sich beispielsweise um eine transparente Folie, Scheibe oder Schicht handeln. Die Abdeckplatte 196 kann als Kratzschutz dienen. Darüber hinaus ist es möglich, dass die Abdeckplatte 196 die Lichtauskopplung von in der organischen Leuchtdiode 1 erzeugter elektromagnetischer Strahlung erhöht.

Die dritte Elektrode 195 ist mit einer Stromquelle 198 elektrisch leitend verbunden, die mit Gleichstrom oder gepulst betrieben werden kann. Dadurch werden von der organischen Leuchtdiode 1 Feldlinien 198a erzeugt. Beispielsweise ein Finger oder ein Stift, der die Abdeckplatte 196 berührt, verändert den Verlauf der elektrischen Feldlinien 198a. Mit Hilfe einer Auswerteschaltung 199 kann die Position beispielsweise des Fingers ermittelt werden und auf diese Weise die Zuordnung zur Bedienung eines der Bedienelemente 197a, 197b, 197c erfolgen.

Dabei ist es auch möglich, dass anstatt des beschriebenen kapazitiv arbeitenden Berührungssensors, der in eine hier beschrieben organische Leuchtdiode integriert ist, ein anderer Berührungssensor Verwendung findet.

Solche Berührungssensoren sind beispielsweise auch in den Druckschriften DE 10332956 A1 sowie DE 10308514 A2 beschrieben, deren Offenbarungsgehalt hiermit durch Rückbezug aufgenommen wird.

Darüber hinaus ist es auch möglich, dass die Bedienelemente 197a, 197b, 197c nicht durch Bilder auf einer zu beleuchtenden Fläche 185a dargestellt sind, sondern dass die organische Leuchtdiode 1 zumindest stellenweise nach Art eines einfachen organischen Displays aufgebaut ist, das zur Darstellung von einfachen Bildern oder Piktogrammen geeignet ist.

Im Folgenden werden Beleuchtungsmittel 2 näher erläutert. Bei den Beleuchtungsmitteln 2 kann es sich um Beleuchtungsmittel 2 zur Allgemeinbeleuchtung wie Lampen oder Leuchten handeln, die - neben ihrer Verwendung zur Allgemeinbeleuchtung - weitere Funktionen haben. So können die Beleuchtungsmittel 2 einen Sichtschutz, eine Lärmschutz, einen Schutz gegen Regen oder Spritzwasser, einen Sonnenschutz oder ähnliches bilden. Bei den im Folgenden beschriebenen Beleuchtungsmitteln 2 kann jeweils zumindest eine organische Leuchtdiode 1, wie sie in Verbindung mit den Figuren 1 bis 31 beschrieben ist, als Lichtquelle zum Einsatz kommen. Ferner können auch Kombinationen der in Verbindung mit den Figuren 1 bis 31 beschriebenen organischen Leuchtdioden 1 als Lichtquelle zum Einsatz kommen.

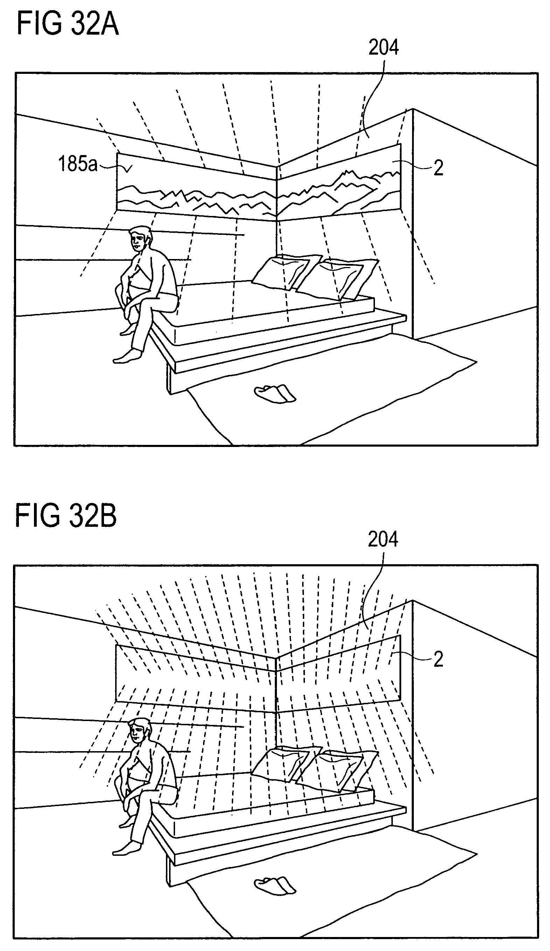

Das in Verbindung mit den Figuren 32A bis 32G beschriebene Beleuchtungsmittel 2 weist neben seiner Funktion zur Allgemeinbeleuchtung eine Weckfunktion auf. Das heißt das Beleuchtungsmittel 2 bildet eine Leuchte - zum Beispiel zur Raumbeleuchtung und einen Wecker. Mittels der Weckfunktion kann ein Benutzer des Beleuchtungsmittels 2 zu einer einstellbaren Uhrzeit durch eine Erhöhung der Helligkeit des Beleuchtungsmittels geweckt werden.

Die Figur 32A zeigt ein Ausführungsbeispiel eines solchen Beleuchtungsmittels 2 anhand einer schematischen Perspektivdarstellung. Das Beleuchtungsmittel 2 ist dabei nach Art eines Bildes auf einer Wand 204 befestigt. Die Figur 32A zeigt das Beleuchtungsmittel 2 dabei in einem ausgeschalteten Betriebszustand.

Das Beleuchtungsmittel 2 umfasst beispielsweise eine organische Leuchtdiode 1, wie sie in Verbindung mit den Figuren 26 und 27 näher erläutert ist. Das heißt, die organische Leuchtdiode 1 des Beleuchtungsmittels 2 kann transparent und in einer zu beleuchtenden Fläche 185a nachgeordnet sein. Bei der zu beleuchtenden Fläche 185a der organischen Leuchtdiode 1 handelt es sich beispielsweise um ein Bild, ein Poster, eine Tapete, Fliesen oder ähnlichem. Ferner kann es sich bei der zu beleuchtenden Fläche 185a um die reflektierende Oberfläche eines Spiegels handeln.

Wie aus der Figur 32A ersichtlich ist, ist im ausgeschalteten Zustand des Beleuchtungsmittels 2 die zu beleuchtende Fläche 185a durch die transparenten Schichten der organischen Leuchtdiode 1 hindurch sichtbar.

Die Figur 32B zeigt das Beleuchtungsmittel 2 in einem angeschalteten Betriebszustand. In diesem Betriebszustand ist die zu beleuchtende Fläche 185a nicht mehr erkennbar. Dies kann beispielsweise durch die Ausnutzung einer optischen Kavität erreicht sein, wie dies in Verbindung mit den Figuren 26A und 26B beschrieben ist. Darüber hinaus kann dies durch ein elektrisch schaltbares, optisches Element 186 erreicht sein, wie dies beispielsweise in Verbindung mit der Figur 27 beschrieben ist. Das Beleuchtungsmittel 2 weist also zumindest zwei Betriebszustände auf: In einem ersten Betriebszustand ist die zu beleuchtende Fläche 185a erkennbar, in einem zweiten Betriebszustand dient das Beleuchtungsmittel 2 lediglich zur Allgemeinbeleuchtung.

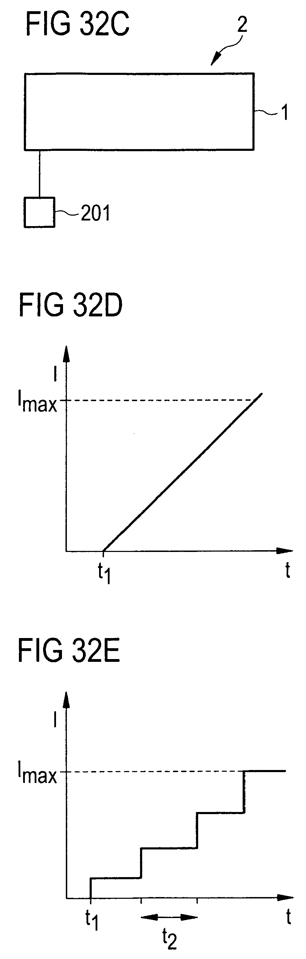

Anhand der schematischen Prinzipskizze der Figur 32C ist ein Ausführungsbeispiel des Beleuchtungsmittels 2 näher erläutert. Das Beleuchtungsmittel 2 umfasst dabei die organische Leuchtdiode 1 sowie eine Ansteuervorrichtung 201. Über die Ansteuervorrichtung 201 ist eine Aktivierungszeit für das Beleuchtungsmittel 2 einstellbar. Bei dieser Aktivierungszeit kann es sich beispielsweise um eine gewünschte Weckzeit t1 handeln.

Es ist dabei möglich, dass die Ansteuervorrichtung 201 lediglich zwei Betriebszustände der organischen Leuchtdiode 1 regelt. So kann mittels der Ansteuervorrichtung 201 die organische Leuchtdiode 1 zur gewünschten Weckzeit t1 vom ausgeschalteten Betriebszustand in den eingeschalteten Betriebszustand mit maximaler Lichtstärke Imax geschaltet werden.

In einer anderen Ausführungsform des Beleuchtungsmittels 2, wie sie anhand der grafischen Auftragung der Figur 32D erläutert ist, findet aber bei der Weckzeit t1 ein langsames, kontinuierliches Erhöhen der Lichtstärke I bis zur maximalen Lichtstärke Imax statt.

Aus der grafischen Auftragung der Figur 32D ist dabei ersichtlich, dass die von der organischen Leuchtdiode 1 erzeugte Lichtstärke durch ein Einschalten der organischen Leuchtdiode 1 zur Weckzeit t1 einen endlichen Wert annimmt und von dort langsam ansteigt. Ein solches Ansteigen kann beispielsweise durch ein entsprechend langsames Erhöhen der Stromstärke, mit der die organische Leuchtdiode 1 betrieben wird, stattfinden. Darüber hinaus ist es möglich, dass die Erhöhung der Lichtstärke I mittels einer Pulsweitenmodulation erfolgt. Auch eine Kombination dieser beiden Möglichkeiten kann sich als vorteilhaft erweisen.

Anhand der grafischen Darstellung der Figur 32E ist eine alternative Möglichkeit zum langsamen Erhöhen der Lichtstärke I näher beschrieben. Hier wird ab der Weckzeit t1 die Lichtstärke I in Stufen erhöht, wobei die Lichtstärke für gewisse Zeitintervalle t2 konstant jeweils gehalten wird.

Insgesamt ist mit den in Verbindung mit den Figuren 32D und 32E beschriebenen zeitlichen Verläufen der Lichtstärke ein besonders sanftes Wecken des Benutzers des Beleuchtungsmittels möglich. Die Lichtstärke erhöht sich beispielsweise über einen Zeitraum von 5 Minuten von Lichtstärke I=0 bis zu einer Lichtstärke Imax.

Die Lichtstärke Imax beträgt dabei vorzugsweise wenigstens 1000 cd, besonders bevorzugt wenigstens 5000 cd. Im Extremfall ist es möglich, dass die Lichtstärke Imax 10000 cd beträgt.

Solch hohe Lichtstärken sind insbesondere mit denen in Verbindung mit den Figuren 1 bis 6 beschriebenen, phosphoreszenten Emittermaterialien möglich. Aufgrund ihres hohen Wirkungsgrades erlauben diese Materialien die Erzeugung von besonders hellem Licht. Eine eventuelle zeitliche Verzögerung der Strahlungsemission durch diese phosphoreszenten Emittermaterialien fällt bei dem Beleuchtungsmittel 2 gemäß den Ausführungsbeispielen der Figuren 32D und 32E nicht ins Gewicht, da die Lichtstärke I relativ langsam erhöht werden soll.

Beispielsweise kann das Beleuchtungsmittel 2 eine organische Leuchtdiode 1 umfassen, wie sie in Verbindung mit der Figur 3 beschrieben ist. Die organische Leuchtdiode 1 emittiert dann vorzugsweise weißes Licht.

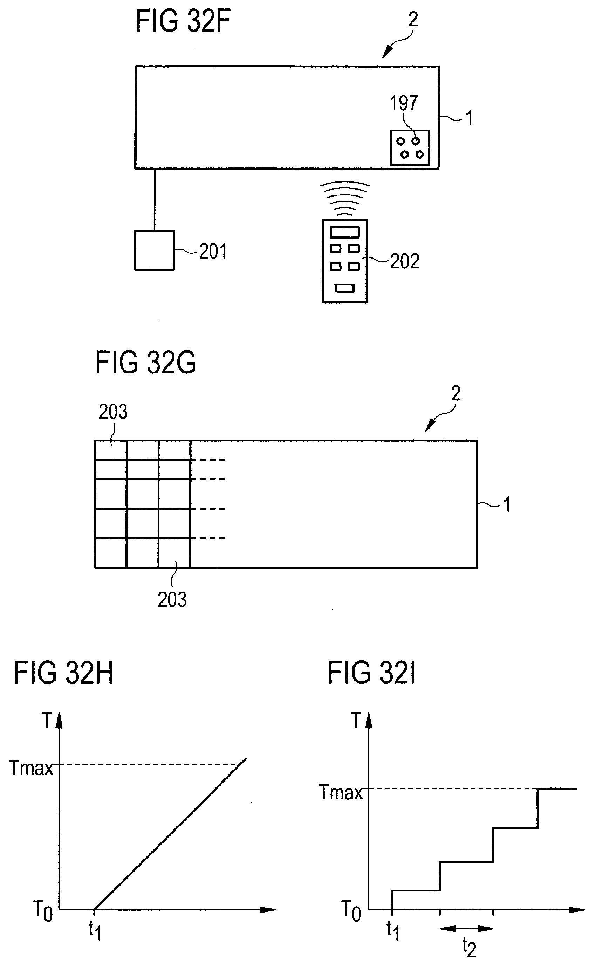

In Verbindung mit der Figur 32F ist ein Ausführungsbeispiel eines Beleuchtungsmittels beschrieben, das auf verschiedene Arten vom Benutzer gesteuert und/oder geregelt werden kann. Zum einen kann das Beleuchtungsmittel 2 beispielsweise im Bereich einer Ecke des Beleuchtungsmittels Bedienelemente 197 umfassen. Die Bedienelemente 197 können erfindungsgemäss, wie in Verbindung mit den Figuren 31A und 31B beschrieben, mittels eines Berührungssensors vom Benutzer bedient werden. Das heißt, das Beleuchtungsmittel 2 umfasst beispielsweise eine organische Leuchtdiode 1 mit einem kapazitiv arbeitenden Berührungssensor.

Alternativ oder zusätzlich ist die Bedienung des Beleuchtungsmittels 2 mittels einer Fernbedienung 202 möglich.

Mittels der Bedienelemente 197 kann beispielsweise der Betriebszustand des Beleuchtungsmittels eingestellt werden. So kann über die Bedienelemente 197 und/oder die Fernbedienung 202 die gewünschte Weckzeit vorgegeben werden. Ferner kann über die Bedienelemente 197 und/oder die Fernbedienung 202 eine Auswahl des Betriebszustands des Beleuchtungsmittels erfolgen. Beispielsweise kann das Beleuchtungsmittel 2 dadurch vom unausgeschalteten Betriebszustand, in dem die zu beleuchtende Fläche 185a sichtbar ist, zu einem leuchtenden Betriebszustand geschaltet werden, bei dem das Beleuchtungsmittel 2 zur Raumbeleuchtung dient.

In Verbindung mit der schematischen Darstellung der Figur 32G ist ein weiteres Ausführungsbeispiel eines hier beschriebenen Beleuchtungsmittels näher erläutert. In diesem Ausführungsbeispiel ist die organische Leuchtdiode 1 des Beleuchtungsmittels 2 in eine Vielzahl von Segmenten 203 unterteilt. Bei den Segmenten 203 handelt es sich um einzeln ansteuerbare, funktionelle Schichten 180, die sich voneinander, beispielsweise durch unterschiedliche Emittermaterialien, unterscheiden können. Ferner kann es sich bei den Segmenten um einzelne organische Leuchtdioden 1 handeln. Mit einem solchen Beleuchtungsmittel 2 ist es möglich, neben oder alternativ zu einem zeitlichen Verlauf der Lichtstärke I auch einen zeitlichen Verlauf des Farbortes und/oder der Farbtemperatur T zu realisieren.

Beispielsweise kann zur Weckzeit t1 zunächst warmweißes, rötliches Licht mit einer Farbtemperatur T von zirka 4000 K erzeugt werden, wobei beispielsweise Segmente 203 hauptsächlich betrieben werden, die ein rötlich weißes Licht erzeugen.

Im zeitlichen Verlauf ist es dann möglich, dass die Farbtemperatur bis hin zu einer maximalen Farbtemperatur Tmax von zirka 25000 K ansteigt. Bei dieser Farbtemperatur wird von der organischen Leuchtdiode 1 des Beleuchtungsmittels 2 kaltes, bläuliches, weißes Licht erzeugt.

Das Beleuchtungsmittel 2 ist auf diese Weise also dazu eingerichtet, weißes Licht mit Farbtemperaturen T von wenigstens 4000 K bis höchstens 25000 K zu erzeugen, wobei gleichzeitig ein Ansteigen der Lichtstärke I von 0 cd bis 10000 cd erfolgen kann. Im zeitlichen Verlauf wird vom Beleuchtungsmittel 2 also ein Sonnenaufgang im Zeitraffer simuliert. Das Beleuchtungsmittel 2 ermöglicht auf diese Weise ein besonders natürliches und sanftes Wecken des Benutzers des Beleuchtungsmittels.

In den Figuren 32H und 32I sind dabei anhand von grafischen Auftragungen zwei Möglichkeiten zur zeitlichen Veränderung der Farbtemperatur T grafisch dargestellt. Dabei kann die Farbtemperatur T von T0 ungefähr 4000 K bis Tmax ungefähr 25000 K kontinuierlich (siehe Figur 32H) beziehungsweise stufenweise (siehe Figur 32I) erhöht werden. Gleichzeitig kann die in Verbindung mit den Figuren 32D und 32E beschriebene Erhöhung der Lichtstärke I erfolgen.

Insgesamt sind in Verbindung mit den Figuren 32A bis 32E Ausführungsbeispiele eines Beleuchtungsmittels beschrieben, das neben seiner Funktion zur Allgemeinbeleuchtung auch eine Weckfunktion umfasst. Die organische Leuchtdiode 1 des Beleuchtungsmittels 2 kann transparent und flexibel ausgebildet sein. Das Beleuchtungsmittel kann zur Erzeugung von weißem Licht mit unterschiedlichen Farbtemperaturen geeignet sein und kann vorgesehen sein, Licht mit unterschiedlichen Farbtemperaturen und Lichtstärken zu erzeugen. Hinter der organischen Leuchtdiode 1 des Beleuchtungsmittels 2 kann eine zu beleuchtende Fläche 185a angeordnet sein, die vom Benutzer austauschbar ist. Auf diese Weise kann das Beleuchtungsmittel 2 mit beliebigen Postern, Wandfliesen, Bildern, Spiegeln oder dergleichen kombiniert werden, was eine besonders vielseitige Benutzung des Beleuchtungsmittels erlaubt. Das Beleuchtungsmittel 2 enthält dabei zumindest eine organische Leuchtdiode 1 wie sie in Verbindung mit den Figuren 1 bis 31 näher beschrieben ist oder eine organische Leuchtdiode 1, die eine Kombination der in Verbindung mit den Figuren 1 bis 31 beschriebenen organischen Leuchtdioden 1 darstellt.

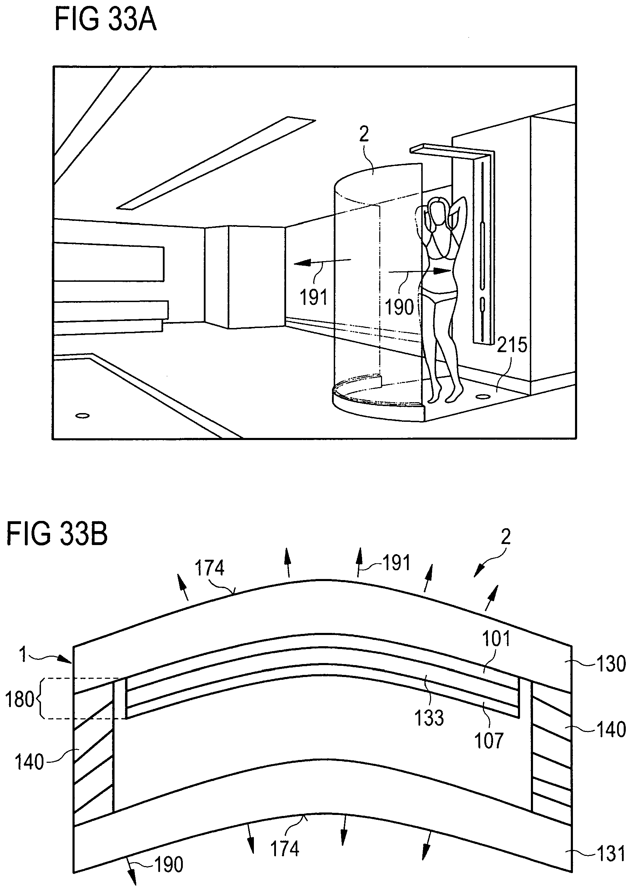

In Verbindung mit den schematischen Darstellungen der Figuren 33A bis 33D ist ein weiteres Ausführungsbeispiel eines hier beschriebenen Beleuchtungsmittels 2 näher erläutert.

Die Figur 33A zeigt anhand einer schematischen Perspektivdarstellung ein weiteres Ausführungsbeispiel eines hier beschriebenen Beleuchtungsmittels 2. Das Beleuchtungsmittel 2 bildet dabei eine großflächige Raumbeleuchtung, die als Teil einer Duschkabine 215 genutzt werden kann. Das heißt das Beleuchtungsmittel 2 nimmt eine Doppelfunktion wahr: es dient zum einen als Leuchte zur Allgemeinbeleuchtung, zum anderen stellt es einen Spritzwasserschutz dar.

Das Beleuchtungsmittel 2 ist dabei beidseitig abstrahlend, so dass elektromagnetische Strahlung 190 vom Beleuchtungsmittel 2 in das Innere der Duschkabine 215 gelenkt werden kann. Darüber hinaus wird elektromagnetische Strahlung 191 in entgegengesetzte Richtungen aus der Duschkabine in den zu beleuchtenden Raum hinein abgestrahlt.

In Verbindung mit der schematischen Schnittdarstellung der Figur 33B ist ein Ausführungsbeispiel für ein Beleuchtungsmittel 2, das als Teil - zum Beispiel als Begrenzungswand - einer Duschkabine 215 genutzt werden kann, näher erläutert. Das Beleuchtungsmittel 2 umfasst zumindest eine organische Leuchtdiode 1, wie sie in Verbindung oder in Kombination der Figuren 1 bis 32 näher erläutert ist.

Die organische Leuchtdiode 1 umfasst dabei einen ersten Träger 130 sowie einen zweiten Träger 131, die parallel oder im Wesentlichen parallel zueinander angeordnet sind. Erster Träger 130 und zweiter Träger 131 sind vorzugsweise jeweils aus einem strahlungsdurchlässigen Material gebildet. Erster Träger 130 und zweiter Träger 131 sind dabei nicht zwingend transparent, es reicht, wenn einer der Träger, oder beide Träger beispielsweise diffus strahlungsdurchlässig ausgebildet sind. Die funktionellen Schichten 180 der organischen Leuchtdiode müssen dabei nicht zwingendermaßen transparent ausgebildet sein, es reicht, wenn die funktionellen Schichten 180 beidseitig abstrahlend sind.

Ein diffus ausgebildeter erster und/oder zweiter Träger 130, 131 hat dabei den Vorteil, dass das Beleuchtungsmittel 2 neben seinen Eigenschaften zur Beleuchtung und zum Spritzwasserschutz auch als Sichtschutz der Duschkabine fungiert. Erster Träger 130 und zweiter Träger 131 können beispielsweise mit einem Milchglas gebildet sein oder aus einem Milchglas bestehen. Darüber hinaus ist es möglich, dass zumindest einer der beiden Träger eine Oberflächenstrukturierung oder eine Musterung aufweist, welche - zusätzlich zu einer Lichtstreuung - auch zur künstlerischen Verzierung der Außenfläche des Beleuchtungsmittels 2 und/oder zur Strahllenkung der elektromagnetischen Strahlung 190, 191 dienen kann.

Erster Träger 130 und zweiter Träger 131 können als ebene Platten ausgebildet sein. Darüber hinaus ist es möglich, dass die Träger - wie in den Figuren 33A und 33B dargestellt - nach Art eines Zylindermantelsegments gebogen sind und damit das Beleuchtungsmittel 2 gekrümmte Strahlungsaustrittsflächen 174 aufweist.

Die funktionellen Schichten 180 der organischen Leuchtdiode 1 können in der durch den ersten Träger 130 und den zweiten Träger 131 gebildeten Kavität mittels der Träger 130, 131 und einem randseitig angeordneten Verbindungsmittel 140 verkapselt sein. Darüber hinaus sind auch andere Techniken zur Verkapselung und Versiegelung der funktionellen Schichten 180, wie sie beispielsweise in Verbindung mit den Figuren 7 bis 20 beschrieben sind, möglich. Darüber hinaus sind auch Kombinationen dieser Versiegelungs- und Verkapselungstechniken möglich.

Der Einsatz einer organischen Leuchtdiode in einem Badezimmer stellt dabei hohe Anforderungen an die hermetische Versiegelung der organischen Leuchtdiode 1. Die organische Leuchtdiode 1 muss für lange Zeiten einem Raumklima mit hoher Luftfeuchtigkeit und relativ hohen Temperaturen widerstehen.

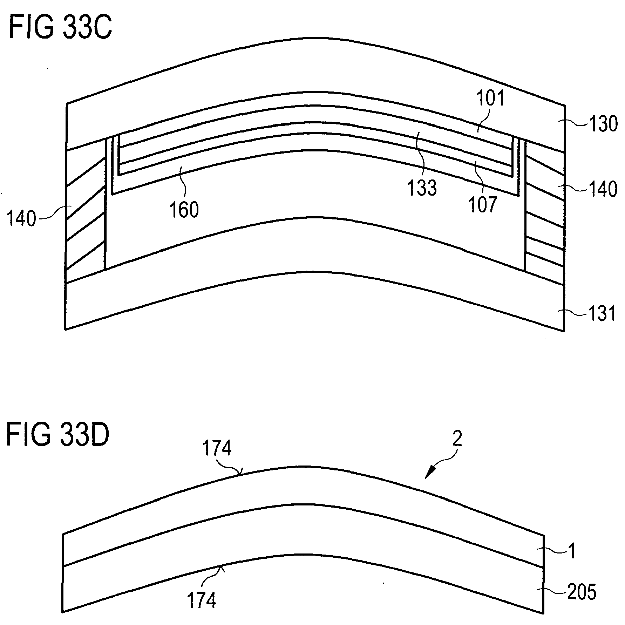

Beispielsweise die Figur 33C zeigt eine schematische Schnittdarstellung eines Ausführungsbeispiels des Beleuchtungsmittels 2, bei dem eine solch gute hermetische Versiegelung besonders effizient erreicht sein kann. In diesem Fall ist die Versiegelung mittels des ersten Trägers 130 und des zweiten Trägers 131 sowie des Verbindungsmittels 140 mit einer Verkapselung der funktionellen Schichten 180 durch eine Verkapselungsschichtenfolge 160 kombiniert. Das heißt, die organische Leuchtdiode 1 weist in diesem Fall eine doppelte Verkapselung auf: Zum einen ist sie durch die Träger 130, 131 und das Verbindungsmittel 140 geschützt, zum anderen durch die besonders dichte Verkapselungsschichtenfolge 160.

Dies ermöglicht eine besonders effiziente Verkapselung des Beleuchtungsmittels und damit den Einsatz in einem Badezimmer bei langen Lebensdauern des Beleuchtungsmittels 2.

Bei dem Verbindungsmittel 140 kann es sich zum Beispiel um ein Glaslot oder ein Glasfrittenmaterial handeln, das rahmenartig um die funktionellen Schichten 180 sowie die Verkapselungsschichtenfolge 160 herumgeführt ist.

Darüber hinaus kann zur Verkapselung eine der weiteren in Verbindung mit den Figuren 7 bis 20 beschriebenen Verkapselungstechniken, wie beispielsweise eine Diffusionsbarriere oder eine Dünnfilmverkapselung Verwendung finden.

In Verbindung mit der Figur 33D ist anhand einer schematischen Schnittdarstellung ein weiteres Ausführungsbeispiel des Beleuchtungsmittels 2 erläutert, bei dem die organische Leuchtdiode 1 zumindest vor Spritzwasser aus der Dusche gut geschützt ist. In diesem Ausführungsbeispiel ist die organische Leuchtdiode 1 auf die der Dusche abgewandte Außenfläche einer strahlungsdurchlässigen Platte 205 aufgebracht.

Bei der organischen Leuchtdiode 1 kann es sich dann beispielsweise um eine flexibel ausgebildete, beidseitig abstrahlende organische Leuchtdiode 1 handeln. Eine solche organische Leuchtdiode 1 kann als Träger eine flexible Folie aufweisen. Darüber hinaus ist es möglich, dass die organische Leuchtdiode 1 im Sinne eines Abziehbildes auf die Außenfläche der strahlungsdurchlässigen Platte 205 aufgebracht wird.

Insgesamt ermöglicht das Aufbringen der organischen Leuchtdiode 1 auf eine Außenfläche der strahlungsdurchlässigen Platte 205 ein schnelles Entfernen und damit ein schnelles Austauschen der organischen Leuchtdiode 1. Es sind daher an eine solche Leuchtdiode 1 nicht so hohe Anforderungen hinsichtlich der Verkapselung zu stellen, wie dies beispielsweise bei Beleuchtungsmitteln gemäß der Figuren 33B und 33C der Fall ist. Das heißt, im Ausführungsbeispiel der Figur 33D limitiert die Lebensdauer der organischen Leuchtdiode 1 nicht die Lebensdauer der Duschkabine, sondern die organische Leuchtdiode 1 kann nach ihrer Beschädigung durch eine neue organische Leuchtdiode 1 ersetzt werden.

In den Ausführungsbeispielen der Figuren 33B bis 33D ist die organische Leuchtdiode 1 des Beleuchtungsmittels 2 als großflächige organische Leuchtdiode 1 dargestellt. Die organische Leuchtdiode 1 kann jedoch auch in eine Vielzahl von Segmenten 203 aufgeteilt sein, die beispielsweise geeignet sein können, elektromagnetische Strahlung unterschiedlicher Wellenlänge zu erzeugen. Darüber hinaus ist es möglich, dass das Beleuchtungsmittel 2 eine Vielzahl von organischen Leuchtdioden 1 umfasst, die beispielsweise jeweils einen gemeinsamen ersten Träger 130 aufweisen können. Zur Bildung der organischen Schichtenfolge 133 sowie der Elektroden 101 und 107 der organischen Leuchtdiode 1 können beispielsweise die in Verbindung mit den Figuren 1 bis 6 beschriebenen Materialien und die in Verbindung mit diesen Figuren beschriebenen Schichtaufbauten Verwendung finden. Insgesamt kann es sich bei der organischen Leuchtdiode 1 also - je nach Ausführungsform - um eine transparente, beidseitig emittierende, weißes Licht emittierende, und/oder flexible organische Leuchtdiode 1 handeln.

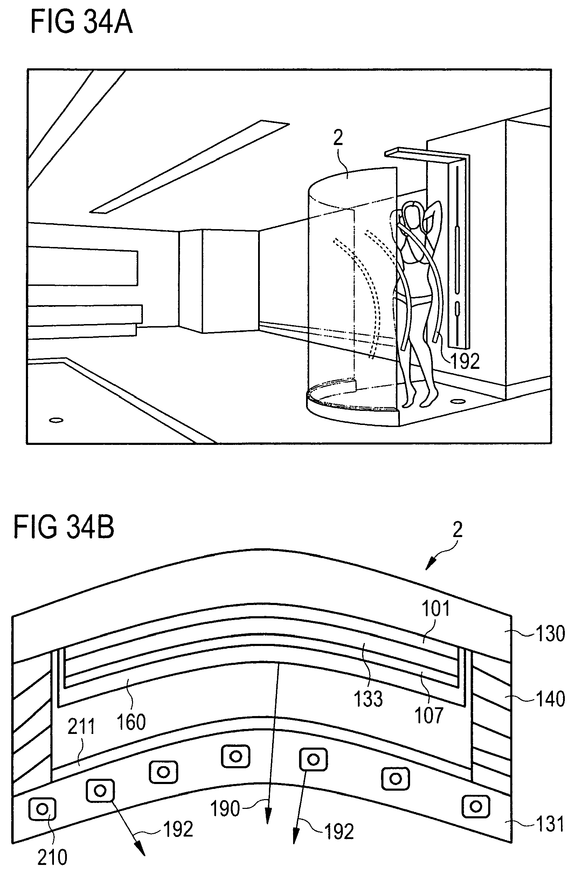

In Verbindung mit den schematischen Darstellungen der Figuren 34A bis 34C ist ein weiteres Ausführungsbeispiel eines hier beschriebenen Beleuchtungsmittels 2 näher erläutert. Auch in diesem Ausführungsbeispiel stellt das Beleuchtungsmittel 2 eine großflächige Raumbeleuchtung sowie den Teil, beispielsweise die Wand, einer Duschkabine 215 dar.

In Ergänzung beispielsweise zum in Verbindung mit der Figur 33C beschriebenen Ausführungsbeispiel weist das Beleuchtungsmittel 2 zusätzlich zu der zumindest einen organischen Leuchtdiode 1 zumindest eine zweite Lichtquelle auf, die vorliegend als Leuchtdiode 210 ausgebildet ist (vergleiche dazu beispielsweise die Figur 34B). Die Leuchtdioden 210 sind beispielsweise an der Deckfläche und/oder der Bodenfläche des zweiten Trägers 131 angeordnet. Sie können aber auch auf Deck- und/oder Bodenfläche einer strahlungsdurchlässigen Platte 205, wie sie in Verbindung mit der Figur 33D beschrieben ist, aufgebracht sein. Allgemein kann zumindest eine anorganische Leuchtdiode 210 an einer Seitenfläche eines strahlungsdurchlässigen Trägers oder einer strahlungsdurchlässigen Platte angeordnet sein, wobei der Träger oder die Platte als großflächiger Lichtleiter für von der Leuchtdiode erzeugte elektromagnetische Strahlung dienen kann.

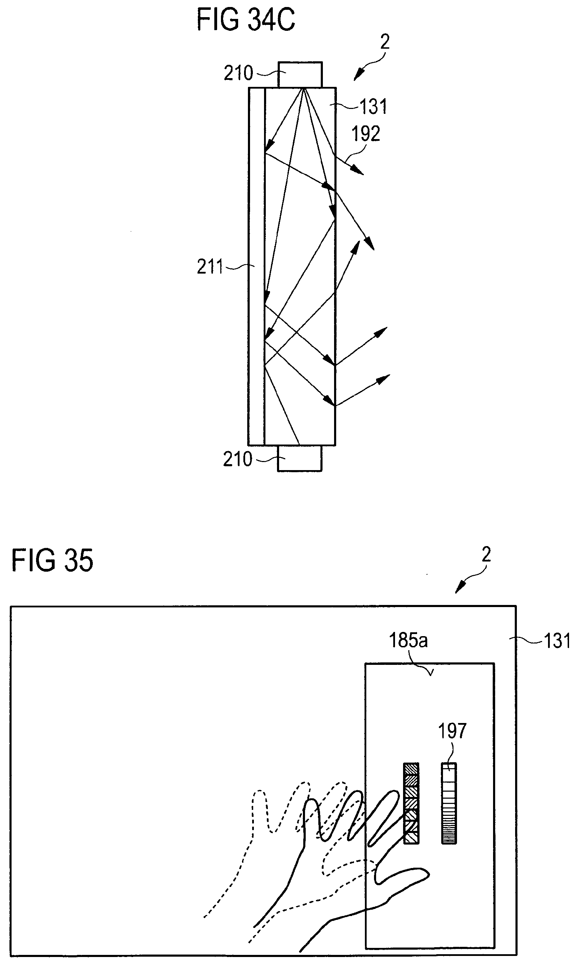

Wie in Verbindung mit der schematischen Schnittdarstellung der Figur 34C erläutert ist, bildet beispielsweise der zweite Träger 131 einen Lichtleiter für von den Leuchtdioden 210 erzeugte elektromagnetische Strahlung 192. Auf die der organischen Schichtenfolge 133 zugewandte Innenseite des zweiten Trägers 131 ist dabei vorzugsweise eine reflektierende Schicht oder Beschichtung 211 aufgebracht, die für in der organischen Schichtenfolge 133 erzeugte elektromagnetische Strahlung 190 durchlässig ist. Die reflektierende Schicht 211 ist hingegen für von den Leuchtdioden 210 erzeugte elektromagnetische Strahlung 192 reflektierend ausgebildet. Dabei kann die reflektierende Schicht 211 und/oder der zweite Träger 131 Strukturierungen aufweisen, die ein möglichst gleichmäßiges Verteilen der elektromagnetischen Strahlung 192 über die gesamte Fläche des zweiten Trägers 131 erlauben. Der zweite Träger 131 dient daher als flächiger Lichtleiter, der ein homogenes Abstrahlen der von den anorganischen Leuchtdioden 210 erzeugten elektromagnetischen Strahlung in den Innenraum der Dusche hinein erlaubt.

Bei den Leuchtdioden 210 handelt es sich vorzugsweise um anorganische Leuchtdioden, die zur Erzeugung von UV-Strahlung, Infrarotstrahlung und/oder sichtbaren Licht geeignet sind. Dabei ist es möglich, dass das Beleuchtungsmittel sowohl Leuchtdioden 210 zur Erzeugung von Infrarot- als auch von UV-Strahlung und/oder sichtbarem Licht umfasst.

Das Beleuchtungsmittel 2 kann beispielsweise einen Betriebsmodus umfassen, bei dem von den Leuchtdioden 210 Infrarotstrahlung 192 erzeugt wird. Diese Infrarotstrahlung wird vom zweiten Träger 131 sowie der reflektierenden Schicht 211 in das Innere der Duschkabine geleitet. Dort findet sie zum einen zum Erwärmen eines Benutzers statt, zum anderen kann die Strahlung nach Benutzung der Duschkabine zum schnelleren Austrocknen der Duschkabine Verwendung finden.

In einem weiteren Betriebszustand sind lediglich die UV-Licht abstrahlenden Leuchtdioden 210 des Beleuchtungsmittels 2 aktiviert. In diesem Betriebszustand findet die abgestrahlte Strahlung 192 zur Bräunung eines Benutzers und/oder zur Desinfektion der Dusche nach Beendigung ihrer Benutzung Verwendung.

In einem dritten Betriebszustand können infrarotes Licht und UV-Licht abstrahlende Leuchtdioden 210 gleichzeitig betrieben werden, wodurch Kombinationen der genannten Funktionen möglich sind. Darüber hinaus ist es auch möglich, dass das Beleuchtungsmittel 2 organische Leuchtdioden 1 umfasst, die geeignet sind, infrarote Strahlung zu erzeugen. Geeignete Emittiermaterialien sind beispielsweise in Verbindung mit den Figuren 1 bis 6 beschrieben.

Ferner ist es möglich, dass das Beleuchtungsmittel zumindest beim Betrieb der Dusche weißes Licht erzeugt, dem je nach Wassertemperatur beispielsweise durch entsprechende anorganische Leuchtdioden 210 oder organischen Leuchtdioden 1 rote Lichtanteile (für warmes Wasser) oder blaue Lichtanteile (für kaltes Wasser) beigemischt sind.

Schließlich sind Ausführungsbeispiele möglich, bei denen im Betrieb des Beleuchtungsmittels 2 Farbverläufe des abgestrahlten Lichts erzeugt werden oder eine gewünschte Farbtemperatur einstellbar ist. Dies kann beispielsweise durch entsprechende organische Leuchtdioden 1 und/oder anorganische Leuchtdioden 210 realisiert sein.

Insgesamt ist durch das in Verbindung mit den Figuren 33 und 34 beschriebenen Beleuchtungsmittel 2 eine besonders variable, großflächige Raumbeleuchtung realisiert, die gleichzeitig als Spritzwasserschutz in einer Dusche dient. Dabei können die Lichtfarbe, die Lichttemperatur sowie die Lichtintensität entsprechend den Wünschen des Benutzers einstellbar sein. Ferner kann das Beleuchtungsmittel 2 als Anzeigevorrichtung für die Wassertemperatur dienen, wodurch beispielsweise das Benutzen der Dusche bei zu kalten oder zu heißen Wassertemperaturen verhindert werden kann.

Darüber hinaus ist es möglich, dass die Lichtfunktionen wie Farbe, Farbtemperatur und/oder Farbintensität zeitlich geändert werden, wie dies beispielsweise in Verbindung mit dem Beleuchtungsmittel gemäß der Figuren 32A bis 32I näher erläutert ist.

In Verbindung mit der Figur 35 ist anhand einer schematischen Prinzipskizze erläutert, dass die Bedienung des Beleuchtungsmittels 2 durch Bedienelemente 197 erfolgen kann, die mittels eines Berührungssensors angesprochen werden. Dafür kann ein Berührungssensor Verwendung finden, wie er beispielsweise in Verbindung mit den Figuren 31A und 31B näher erläutert ist. Das Bedienelement kann dabei sowohl von der Innenseite der Dusche als auch von der Außenseite der Dusche her zugänglich sein.

Darüber hinaus ist es möglich, dass mittels des Bedienelements 197 nicht nur die Lichtfunktion des Beleuchtungsmittels 2 sondern beispielsweise auch die Mischbatterie der Dusche und damit die Wassertemperatur und die Wasserstärke geregelt werden.

Andererseits ist es jedoch auch möglich, dass beim Betrieb der Dusche die Regelung beispielsweise der Farbe des abgestrahlten Lichts des Beleuchtungsmittels 2 mittels der Mischbatterie erfolgt. Das heißt, über die Einstellung der Wassertemperatur kann zum Beispiel die Farbe des vom Beleuchtungsmittel 2 abgestrahlten Lichts angepasst werden.

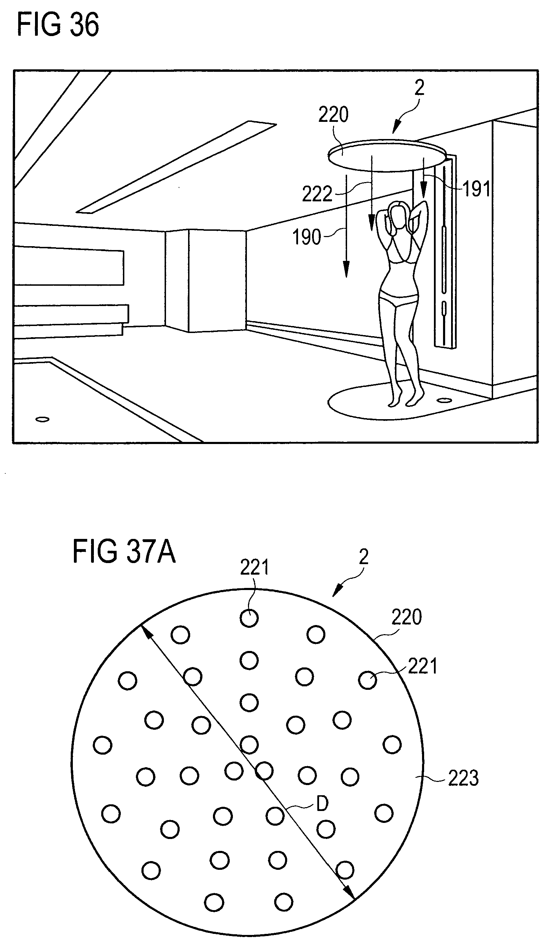

In Verbindung mit der perspektivisch schematischen Darstellung der Figuren 36 ist ein weiteres Ausführungsbeispiel eines hier beschriebenen Beleuchtungsmittels 2 näher erläutert. In diesem Ausführungsbeispiel kommt dem Beleuchtungsmittel 2 eine Doppelfunktion zu:
Zum einen dient das Beleuchtungsmittel 2 zu Allgemeinbeleuchtung. Es kann beispielsweise die Hauptleuchte in einem Badezimmer darstellen.

Zum anderen umfasst das Beleuchtungsmittel 2 einen Duschkopf für eine Dusche.

Das heißt, vom Beleuchtungsmittel 2 wird zum einen elektromagnetische Strahlung 190, 191 emittiert, zum anderen wird vom Beleuchtungsmittel 2 über den Duschkopf 220 Wasser verteilt. Das Beleuchtungsmittel 2 kann dabei geeignet sein, gleichzeitig oder aufeinander folgend elektromagnetische Strahlung 190, 191 mit unterschiedlichen elektromagnetischen Wellenlängen abzustrahlen. Das Beleuchtungsmittel 2 kann dazu beispielsweise mehrere organische Leuchtdioden 1 umfassen, die geeignet sind, elektromagnetische Strahlung von voneinander unterschiedlichen Wellenlängen zu erzeugen. Das Beleuchtungsmittel 2 kann dann beispielsweise gleichzeitig oder sequentiell Licht unterschiedlicher Farbe emittieren. Ferner kann das Beleuchtungsmittel geeignet sein, weißes Licht zu emittieren. Das Beleuchtungsmittel kann dazu eine oder mehrere organischen Leuchtdioden 1 umfassen, die jeweils im Betrieb weißes Licht emittieren. Darüber hinaus ist es möglich, dass das Beleuchtungsmittel 2 lediglich Licht einer einzigen Farbe emittiert. Das Beleuchtungsmittel kann dazu eine oder mehrere organische Leuchtdioden 1 umfassen, die jeweils im Betrieb farbiges Licht, zum Beispiel grünes oder rotes Licht, emittieren.

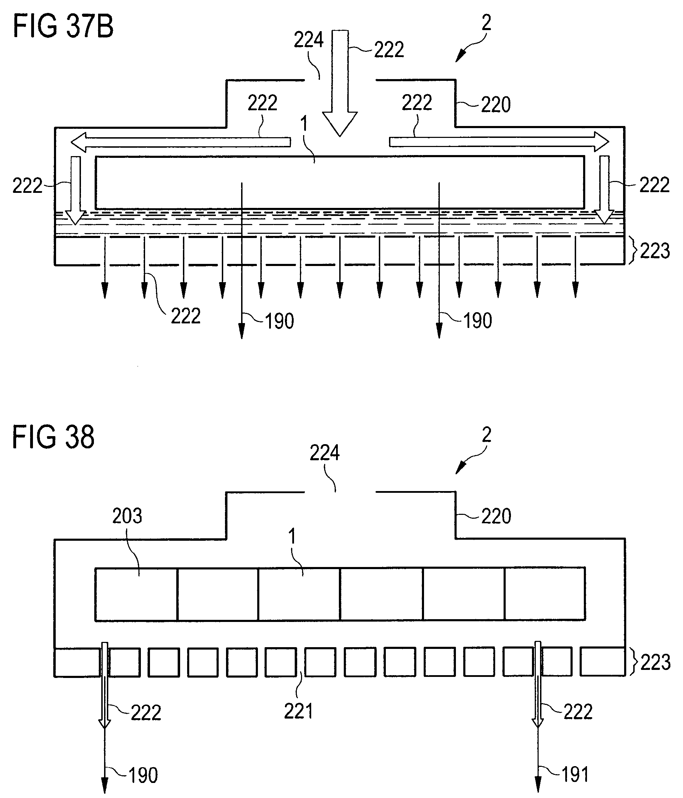

In Verbindung mit der schematischen Draufsicht der Figur 37A sowie der schematischen Schnittdarstellung der Figur 37B ist ein Ausführungsbeispiel eines Beleuchtungsmittels 2, das einen Duschkopf 220 umfasst, näher beschrieben.

Das Beleuchtungsmittel 2 umfasst den Duschkopf 220. Der Duschkopf 220 kann in der Draufsicht beispielsweise kreisrund, quadratisch oder in einer anderen Form ausgebildet sein. Bei dem Duschkopf 220 kann es sich zum einem um den Duschkopf einer Handbrause handeln, der einen Durchmesser D von wenigstens 5 cm und höchstens 20 cm aufweist. Darüber hinaus ist es möglich, dass es sich bei dem Duschkopf 220 um einen großflächigen Duschkopf handelt, der beispielsweise einen Durchmesser D von wenigstens 50 cm, vorzugsweise wenigstens 80 cm, besonders bevorzugt von wenigstens 100 cm aufweist. Ein solcher Duschkopf 220 ist dann bevorzugt direkt an die Decke beispielsweise eines Badezimmers montiert. Wasser 222 aus einem solchen Duschkopf 220 fällt wie Regen aus relativ großer Höhe und über eine relativ große Fläche verteilt auf den Benutzer des Beleuchtungsmittels 2.

Der Duschkopf 220 umfasst in diesem Ausführungsbeispiel zumindest eine organische Leuchtdiode 1, die beispielsweise geeignet ist, weißes Licht 190 zu emittieren. Die organische Leuchtdiode 1 kann dazu einen Schichtaufbau aufweisen, wie er in Verbindung mit den Figuren 1 bis 6 näher beschrieben ist. Darüber hinaus weist die organische Leuchtdiode eine Verkapselung auf, wie sie in Verbindung mit den Figuren 7 bis 20 näher erläutert ist. Auch Kombinationen der in den Figuren beschriebenen Schichtenfolgen sowie der in den Figuren beschriebenen Verkapselungen sind möglich.

Beispielsweise weist die organische Leuchtdiode 1 eine doppelte oder dreifache Versiegelung auf. So kann die organische Leuchtdiode 1 mittels einem ersten Träger 130, einem zweiten Träger 131 sowie einem Verbindungsmittel 140 versiegelt sein. Darüber hinaus kann die organische Leuchtdiode 1 eine Verkapselungsschichtenfolge 160 umfassen. Insgesamt wird für die organische Leuchtdiode 1 vorzugsweise eine besonders gute Verkapselung gewählt, da die organische Leuchtdiode 1 zumindest stellenweise in direktem Kontakt mit Wasser 222 steht. Das heißt, beispielsweise zumindest einer der Träger 130, 131 wird im Betrieb des Duschkopfs 220 des Beleuchtungsmittels 2 mit Wasser 222 benetzt.

Das Beleuchtungsmittel 2 umfasst den Duschkopf 220, der eine Durchlassöffnung 224 aufweist, mit der er an die Wasserversorgung angeschlossen ist. Über die Durchlassöffnung 224 gelangt Wasser 222 in den Duschkopf 220. Das Wasser 222 umfließt die organische Leuchtdiode 1 an ihren Außenflächen und gelangt auf diese Weise zur Deckplatte 223 des Duschkopfs. Die Deckplatte 223 weist Öffnungen 221 auf, durch welche das Wasser 220 aus dem Duschkopf gelangen kann.

In diesem Ausführungsbeispiel ist die Deckplatte 223 dabei strahlungsdurchlässig, beispielsweise transparent ausgebildet. Elektromagnetische Strahlung 190 aus der organischen Leuchtdiode 1 kann die Deckplatte sowohl durch die Öffnungen 221 als auch durch die anderen, nicht wasserdurchlässigen Bereiche der Deckplatte 223 verlassen.

Insgesamt ist die organische Leuchtdiode 1 im Ausführungsbeispiel der Figuren 37A und 37B in den Duschkopf 220 integriert.

In Verbindung mit der Figur 38 ist anhand einer schematischen Schnittdarstellung ein weiteres Ausführungsbeispiel eines hier beschriebenen Beleuchtungsmittels 2 mit Duschkopf 220 näher erläutert. In diesem Ausführungsbeispiel ist die organische Leuchtdiode 1 im Unterschied zum Ausführungsbeispiel der Figuren 37A und 37B in Segmente 203 aufgeteilt. In den Segmenten 203 wird dabei Licht mit voneinander unterschiedlichen Farben im Betrieb der organischen Leuchtdiode 1 emittiert.

Die Segmente 203 sind beispielsweise von einem gemeinsamen Trägerpaar 130, 131 und einem randseitig, rahmenartig angeordneten Verbindungsmittel 140 gemeinsam verkapselt. Die Segmente 203 können ferner gemeinsam oder jedes Segment für sich mittels einer Verkapselungsschichtenfolge 160 versiegelt sein. Die Segmente 203 können einzeln ansteuerbar sein, so dass Licht unterschiedlicher Farben gleichzeitig oder sequentiell erzeugt werden kann. Neben der beschriebenen Segmentierung der organischen Leuchtdiode 1 ist es jedoch auch möglich, dass das Beleuchtungsmittel 2 mehrere organische Leuchtdioden 1 umfasst, die geeignet sind, Licht voneinander unterschiedlicher Farbe zu erzeugen.

Als weiterer, optionaler Unterschied zum Ausführungsbeispiel, das in Verbindung mit den Figuren 37A und 37B näher erläutert ist, kann die Deckplatte 223 des Duschkopfs 220 in diesem Fall strahlungsundurchlässig ausgebildet sein. Das heißt, elektromagnetische Strahlung 190, 191 kann den Duschkopf 220 dann lediglich zusammen mit dem Wasser 222 durch die Öffnungen 221 verlassen. In diesem Fall können die Wasserstrahlen 222, die den Duschkopf 220 verlassen, als Art eines Lichtleiters für die in den Segmenten 203 der organischen Leuchtdiode 1 erzeugte elektromagnetische Strahlung 190, 191 dienen.

Das heißt, im Betrieb kann der Duschkopf 220 an unterschiedlichen Stellen unterschiedlich eingefärbte Wasserstrahlen 220 abgeben. Durch die strahlungsundurchlässige Ausbildung der Deckplatte 223 kann sich eine besonders gute Trennung der verschiedenen Lichtfarben ergeben. Beispielsweise kann auf diese Weise mit dem Duschkopf 220 ein Wasserschauer erzeugt werden, der aus einer Entfernung betrachtet in seinem Aussehen einem Regenbogen ähnelt.

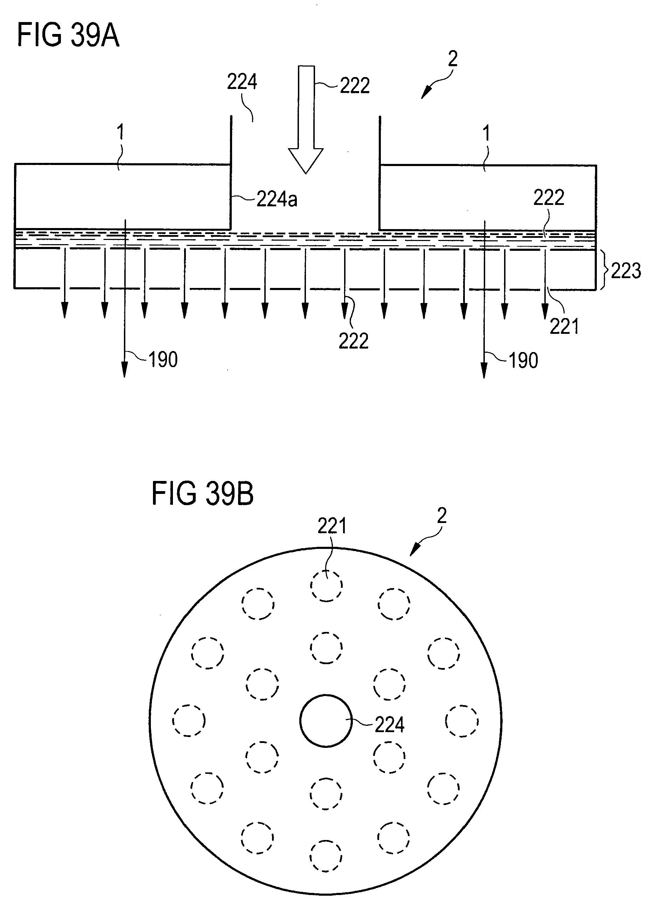

In Verbindung mit der Figur 39A ist anhand einer schematischen Schnittdarstellung ein weiteres Ausführungsbeispiel eines hier beschriebenen Beleuchtungsmittels 2 näher erläutert. Die Figur 39B zeigt eine schematische Draufsicht auf das Beleuchtungsmittel 2 von der den Öffnungen 221 abgewandten Seite des Duschkopfs 220 her.

In diesem Ausführungsbeispiel ist die organische Leuchtdiode 1 mit der Durchlassöffnung 224 versehen, die beispielsweise an zentraler Stelle durch die organische Leuchtdiode 1 hindurch angeordnet ist. Das heißt, die organische Leuchtdiode weißt ein Loch auf, durch das im Betrieb des Duschkopfs 220 des Beleuchtungsmittels 2 von Wasser durchspült wird.

An den Rändern 224a der Durchlassöffnung 224 kann die organische Leuchtdiode 1 beispielsweise mittels eines Glaslotes oder einer Glasfritte als Verbindungsmittel 140 versiegelt sein. Darüber hinaus kann das Verbindungsmittel 140 mit einer Verkapselungsschichtenfolge 160 versehen sein, welche das Verbindungsmittel zusätzlich versiegelt. Ein solcher Aufbau ist beispielhaft in Verbindung mit den Figuren 14B und 18 näher erläutert.

Die funktionellen Schichten 180 der organischen Leuchtdiode 1 können zusätzlich wiederum durch eine Verkapselungsschichtenfolge 160, eine Diffusionsbarriere 153, eine Dünnfilmverkapselung 154, eine Lackschicht 150 oder weitere Maßnahmen versiegelt sein.

Wasser 222 tritt durch die Durchlassöffnung 224 in einen Spalt, der zwischen der Deckplatte 223 des Duschkopfes 220 und der organischen Leuchtdiode 1 angeordnet ist. Die Deckplatte 223 umfasst wiederum Öffnungen 221, durch die das Wasser 220 gelangen kann. Die Deckplatte 223 kann dabei strahlungsdurchlässig, dann zum Beispiel transparent, oder strahlungsundurchlässig ausgebildet sein. Die organische Leuchtdiode 1 kann weißes Licht, farbiges Licht oder Licht unterschiedlicher Farben - wie es beispielsweise in Verbindung mit der Figur 38 erläutert ist - abstrahlen.

Im Vergleich zum Ausführungsbeispiel der Figuren 37 und 38 sind beim Ausführungsbeispiel der Figur 39 lediglich die der Deckplatte 223 zugewandte Unterseite der organischen Leuchtdiode 1 sowie die Seitenflächen der organischen Leuchtdiode 1 im Bereich des Randes 224 der Durchlassöffnung dem Wasser 222 direkt ausgesetzt. Andererseits müssen zur Verkapselung der organischen Leuchtdiode 1 besondere Träger 130, 131 bereitgestellt werden, welche eine Durchlassöffnung 224 aufweisen. Dies kann die Herstellung des Beleuchtungsmittels 2, wie es in Verbindung mit den Figur 39A und 39 B erläutert ist, verteuern.

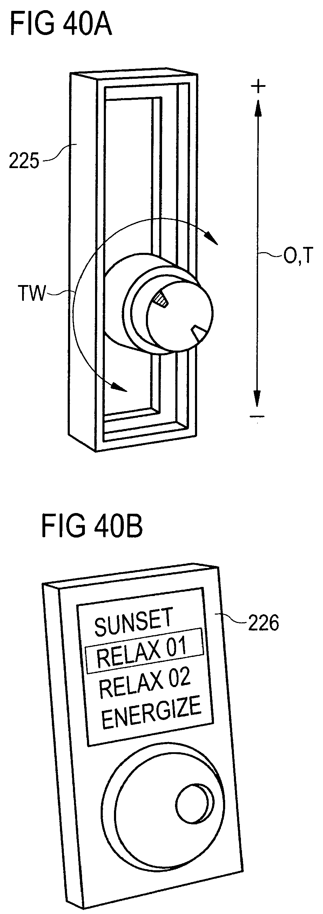

In Verbindung mit den Figuren 40A und 40B ist anhand schematischer Darstellungen die Ansteuerung des Beleuchtungsmittels 2 näher erläutert.

In der Figur 40A ist eine Mischbatterie schematisch gezeigt, mit der durch eine Drehbewegung des Wasserhahns 22a die Wassertemperatur TW eingestellt werden kann. Dabei ist es möglich, dass über die Wassertemperatur TW gleichzeitig die Farbe, das heißt der Farbort O und/oder die Farbtemperatur T des von der organischen Leuchtdiode 1 emittierten Lichts eingestellt wird. Darüber hinaus ist es möglich, dass die Einstellung des Farbortes O und/oder der Farbtemperatur T über eine Translationsbewegung der Mischbatterie erfolgt. Insgesamt kommt die in Verbindung mit der Figur 40A beschriebenen Mischbatterie 225 also bei Ausführungsbeispielen des Beleuchtungsmittels 2 zur Verwendung, bei denen über die Mischbatterie der Dusche auch der Farbort und die Farbtemperatur des von der organischen Leuchtdiode 1 erzeugten Lichts eingestellt werden kann.

Darüber hinaus ist eine Ansteuerung des Duschkopfes 1 auch über Berührung sensitiver Bedienelemente 197 möglich, wie sie beispielsweise in Verbindung mit der Figur 35 näher erläutert sind. Diese Bedienelemente können beispielsweise als berührungssensitive organische Leuchtdioden in eine Wandkachel, eine Fliese oder in eine Duschkabine integriert sein. Insbesondere kann das Beleuchtungsmittel 2 mit Duschkopf 220 auch mit dem Beleuchtungsmittel 2, das als Teil einer Duschkabine 215 ausgebildet ist, kombiniert werden. Das heißt, die in Verbindung mit den Figuren 33 bis 35 beschriebenen Ausführungsbeispiele können mit einem Beleuchtungsmittel 2 gemäß der Ausführungsbeispiele der Figuren 36 bis 40 in ein und derselben Dusche kombiniert werden.

Die Figur 40B zeigt anhand einer schematischen Darstellung eine weitere Möglichkeit zur Ansteuerung des Beleuchtungsmittels 2 wie es in Verbindung mit den Figuren 36 bis 39 näher erläutert ist. Beispielsweise ergänzend zu einer Mischbatterie 225 kann zur Ansteuerung die Regelvorrichtung 226 Verwendung finden, mittels der ein bestimmtes Duschprogramm voreingestellt werden kann. Mittels des Duschprogramms kann beispielsweise ein zeitlicher Verlauf der Wassertemperatur sowie des vom Beleuchtungsmittel 2 abgestrahlten Lichts voreingestellt werden.

Dabei kann ein Beleuchtungsmittel 2 mit Duschkopf 220 und zugleich ein Beleuchtungsmittel 2 mit einer Duschkabine 215 angesteuert werden. Wassertemperatur, Druck des Wasserstrahls, Farbtemperatur und/oder Farbort können dabei in zueinander koordinierter Weise von der Regelvorrichtung 226 in zeitlicher Abfolge geändert werden. Beispielsweise kann dabei ein simulierter Sonnenaufgang, wie er in Verbindung mit den Figuren 32H und 32I beschrieben ist, durch das Beleuchtungsmittel 2 simuliert werden, wobei gleichzeitig zum Beispiel die Wassertemperatur kontinuierlich oder in Schritten erhöht oder abgesenkt wird.

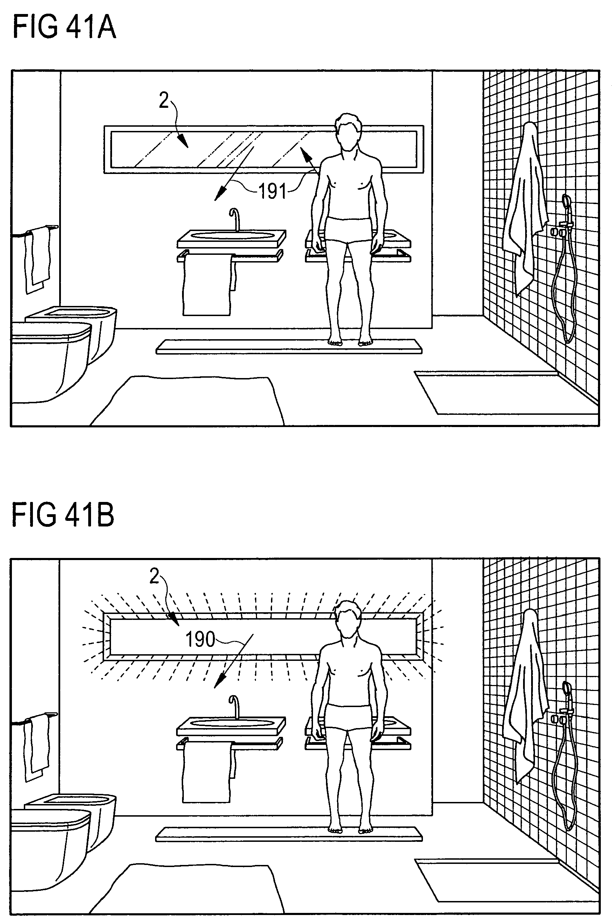

In Verbindung mit den schematischen Darstellungen der Figuren 41A bis 41D ist ein weiteres Ausführungsbeispiel eines hier beschriebenen Beleuchtungsmittels 2 näher erläutert. In diesem Ausführungsbeispiel umfasst das Beleuchtungsmittel 2 die Funktionen eines Spiegels, einer Leuchte zur Allgemeinbeleuchtung sowie einer Anzeigevorrichtung für einfache grafische Elemente.

Die Figur 41A zeigt dabei einen ersten Betriebszustand des Beleuchtungsmittels 2. In diesem Betriebszustand ist das Beleuchtungsmittel 2 nicht aktiv strahlungserzeugend. Das Beleuchtungsmittel 2 erscheint wie ein normaler Spiegel, der auf ihn treffende elektromagnetische Strahlung 191 zurückreflektiert. Ein solches Beleuchtungsmittel 2 kann beispielsweise als Badezimmerspiegel oder Garderobenspiegel Verwendung finden.

In Verbindung mit der Figur 41B ist ein zweiter Betriebszustand des Beleuchtungsmittels 2 grafisch dargestellt. In diesem Betriebszustand dient das Beleuchtungsmittel 2 als Leuchte zur Allgemeinbeleuchtung. Das Beleuchtungsmittel 2 strahlt in diesem Betriebszustand hauptsächlich elektromagnetische Strahlung 190 ab, die beispielsweise von einer organischen Leuchtdiode 1 des Beleuchtungsmittels 2 im Betrieb des Beleuchtungsmittels erzeugt wird. Das Beleuchtungsmittel 2 dient in diesem Betriebszustand nicht als Spiegel. Das heißt, auf das Beleuchtungsmittel 2 von außen treffende elektromagnetische Strahlung 191 wird in diesem Fall von der erzeugten elektromagnetischen Strahlung 190 überstrahlt.

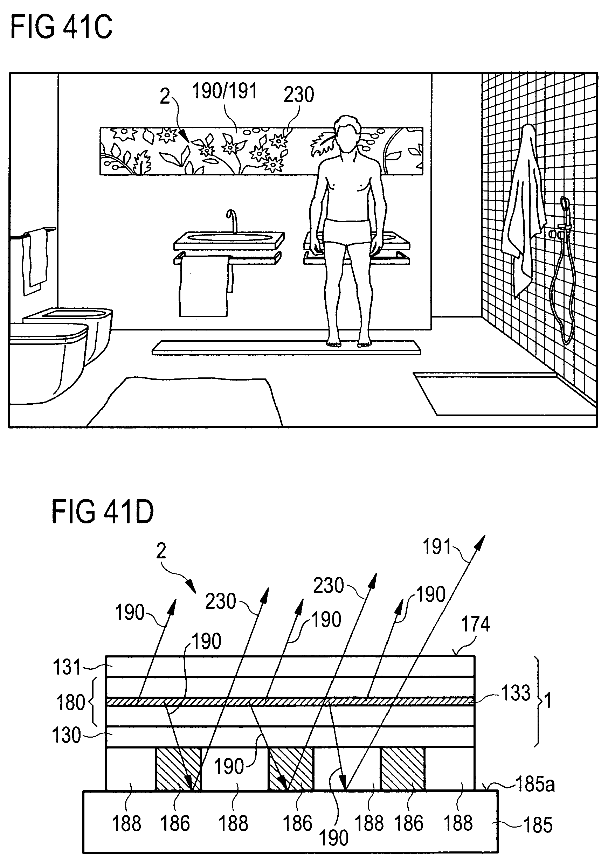

In Verbindung mit der Figur 41C ist ein dritter Betriebszustand des Beleuchtungsmittels 2 schematisch dargestellt. In diesem Betriebszustand werden vom Beleuchtungsmittel 2 Muster 230 dargestellt. Darüber hinaus kann das Beleuchtungsmittel 2 auftreffende elektromagnetische Strahlung 191 reflektieren und/oder aktiv elektromagnetische Strahlung 190 emittieren. Ob das Beleuchtungsmittel 2 erkennbare reflektive Eigenschaften aufweist, das heißt, ob elektromagnetische Strahlung 191, die auf das Beleuchtungsmittel 2 trifft, von diesem für den Benutzer wahrnehmbar reflektiert wird, hängt von der Lichtstärke ab, mit der aktiv elektromagnetische Strahlung 190 vom Beleuchtungsmittel 2 erzeugt wird. Die Lichtstärke der elektromagnetischen Strahlung 190, die vom Beleuchtungsmittel 2 aktiv erzeugt wird, kann beispielsweise über die Stromstärke, mit der das Beleuchtungsmittel 2 bestromt wird, eingestellt werden.

In Verbindung mit der Figur 41D ist anhand einer schematischen Schnittdarstellung ein Ausführungsbeispiel eines Beleuchtungsmittels 2 näher erläutert, das die in Verbindung mit den Figuren 41A bis 41C beschriebenen Betriebszustände aufweist. Der Aufbau des Beleuchtungsmittels 2 ist dabei ähnlich zum Aufbau der organischen Leuchtdiode 1, die in Verbindung mit der Figur 27 näher erläutert ist.

Das Beleuchtungsmittel 2 umfasst dabei eine transparente organische Leuchtdiode 1. Die transparente organische Leuchtdiode 1 kann funktionelle Schichten 180 umfassen, welche zwischen einem ersten Träger 130 und einem zweiten Träger 131 angeordnet sind. Vorzugsweise umfasst die organische Leuchtdiode 1 einen strahlungsemittierenden Bereich 104, der zur Erzeugung von weißem Licht geeignet ist. Die organische Leuchtdiode 1 strahlt elektromagnetische Strahlung 190 von ihren beiden Hauptflächen ab.

Zur Bildung der organischen Schichtenfolge 133 kann jedes Ausführungsbeispiel sowie jede Kombination von Ausführungsbeispielen, die in Verbindung mit den Figuren 1 bis 6 beschrieben ist, zum Einsatz kommen. Zur Verkapselung und hermetischen Versiegelung der organischen Leuchtdiode 1 kommen vorzugsweise Ausführungsformen, wie sie in Verbindung mit den Figuren 7 bis 20 beschrieben sind, oder Kombinationen dieser Ausführungsformen zum Einsatz. Wichtig ist im Ausführungsbeispiel des Beleuchtungsmittels 2 der Figur 41D lediglich, dass die organische Leuchtdiode 1 transparent ausgebildet ist.

Das Beleuchtungsmittel 2 umfasst darüber hinaus eine zu beleuchtende Fläche 185a eines zu beleuchtenden Elements 185. Bei dem zu beleuchtenden Element 185 handelt es sich um einen Spiegel, die zu beleuchtende Fläche 185a stellt die reflektierende Oberfläche des Spiegels dar.

Zwischen der organischen Leuchtdiode 1, das heißt zwischen dem ersten Träger 130 und der beleuchtenden Oberfläche 185a ist in strukturierter Weise ein elektrisch schaltbares optisches Element 186 angeordnet. Das elektrisch schaltbare optische Element 186 bildet im vorliegenden Fall das darzustellende Muster 230 aus. Es ist jedoch auch möglich, dass das elektrisch schaltbare optische Element 186 ein Negativbild des darzustellenden Musters 230 ist. An Stellen, wo sich zwischen zu beleuchtendem Element 185 und erstem Träger 130 kein elektrisch schaltbares optisches Element 186 befindet, ist ein transparentes Material 188 angeordnet, das beispielsweise aus einem transparenten Kunststoff oder Glas gebildet ist. Das heißt, der Raum zwischen der organischen Leuchtdiode 1 und der zu beleuchtenden Fläche 185a ist mit dem transparentem Material 188 und dem elektrisch schaltbaren optischen Element 186 ausgefüllt.

Das elektrisch schaltbare optische Element 186 weist nun beispielsweise zwei Betriebszustände auf: In einem ersten Betriebszustand ist das elektrisch schaltbare optische Element 186 transparent. In diesem Betriebszustand kann das Beleuchtungsmittel 2, wie in der Figur 41A gezeigt, als Spiegel betrieben werden oder, wie in der Figur 41B dargestellt, als Leuchte betrieben werden, wobei kein Muster 230 erkennbar ist.

Zum anderen weist das elektrisch schaltbare optische Element 186 zumindest einen zweiten Betriebszustand auf, in dem es für vom Beleuchtungsmittel erzeugter elektromagnetischer Strahlung 190 entweder absorbierend ist, dämpfend ist oder als Farbfilter wirkt. Auf diese Weise kann in diesem Betriebszustand durch Beleuchtung des strukturierten, elektrisch schaltbaren optischen Elements 186 ein Muster 230 erzeugt werden.

Je nach Ausführung des elektrisch schaltbaren optischen Elements 186 kann das Muster dunkel - beispielsweise schwarz - oder farbig erscheinen. Bei dem elektrisch schaltbaren optischen Element 186 handelt es sich beispielsweise um ein elektrochromes Element, wie es auch in elektrisch tönbaren Glasscheiben zur Verwendung kommt.

Wie bereits in Verbindung mit den Figuren 26 und 27 beschrieben, kann der Anteil der elektromagnetischen Strahlung 190, die direkt vom Beleuchtungsmittel nach außen trifft, ohne dabei vorher auf die zu beleuchtende Fläche 185a zu gelangen, mittels einer optischen Kavität eingestellt werden. Auf diese Weise kann vom Hersteller des Beleuchtungsmittels 2 der Kontrast, mit dem das Muster 230 im dritten Betriebszustand erscheinen soll, voreingestellt sein.

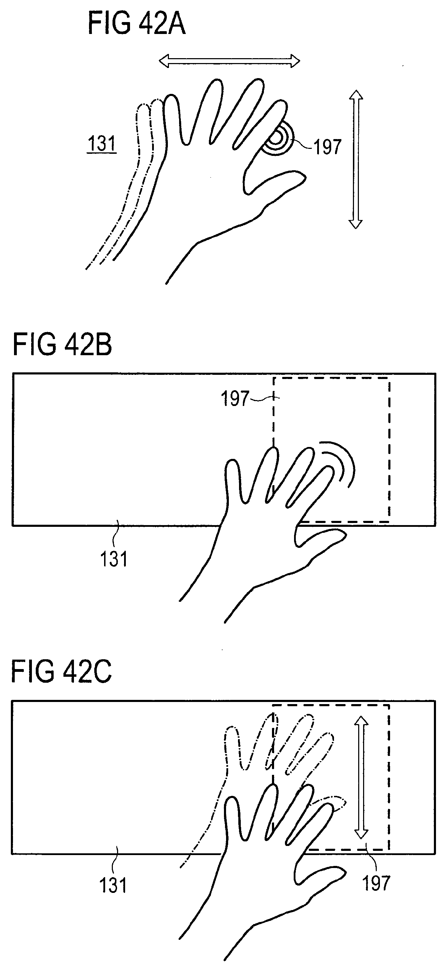

In Verbindung mit den Figuren 42A bis 42C ist anhand schematischer Darstellungen erläutert, dass das Beleuchtungsmittel 2 mit einem berührungssensitiven Bedienelement 197 bedient werden kann. Beispielsweise kann mittels Translationsbewegungen der Hand auf einem Bereich des zweiten Trägers 131 der organischen Leuchtdiode 1 der Betriebszustand gewechselt werden oder die Helligkeit des abgestrahlten Lichts erhöht beziehungsweise gesenkt werden (siehe Figur 42A sowie 42C).

Über ein Tippen, wie es schematisch in der Figur 42B dargestellt ist, auf dem Bedienelement 197 kann beispielsweise ein Aus- und Einschalten der Leuchtfunktion, das heißt ein Schalten zwischen dem ersten und dem zweiten Betriebszustand erfolgen. Insgesamt kann zur Bildung des Bedienelements 197 wiederum eine berührungssensitive organische Leuchtdiode 1 Verwendung finden, wie sie in Verbindung mit der Figur 31 näher erläutert ist.

Alternativ zu einer berührungssensitiven Steuerung des Beleuchtungsmittels 2 ist es jedoch auch möglich, dass eine Gestensteuerung des Beleuchtungsmittels 2 erfolgt. In diesem Fall, muss der Benutzer des Beleuchtungsmittels 2 die Strahlungsaustrittsfläche 174 des Beleuchtungsmittels nicht berühren. Vielmehr ist am oder in der Nähe des Beleuchtungsmittels 2 eine Kamera befestigt. Mittels einer Auswerteschaltung kann aus von der Kamera aufgenommenen Bildern ein bestimmter Befehl - beispielsweise ein Wechsel des Betriebszustands - berechnet werden kann. Dieser - im Vergleich zur Berührungssteuerung kompliziertere Aufbau bringt den Vorteil mit sich, dass kein Verschmieren der Strahlungsaustrittsfläche 174, beispielsweise durch Fingerabdrücke des Benutzers, erfolgt.

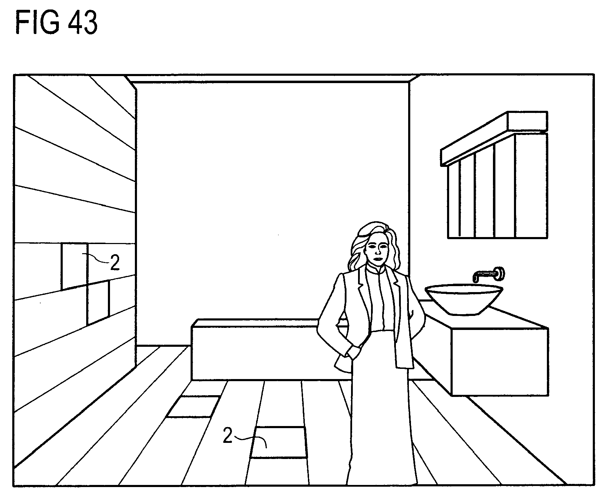

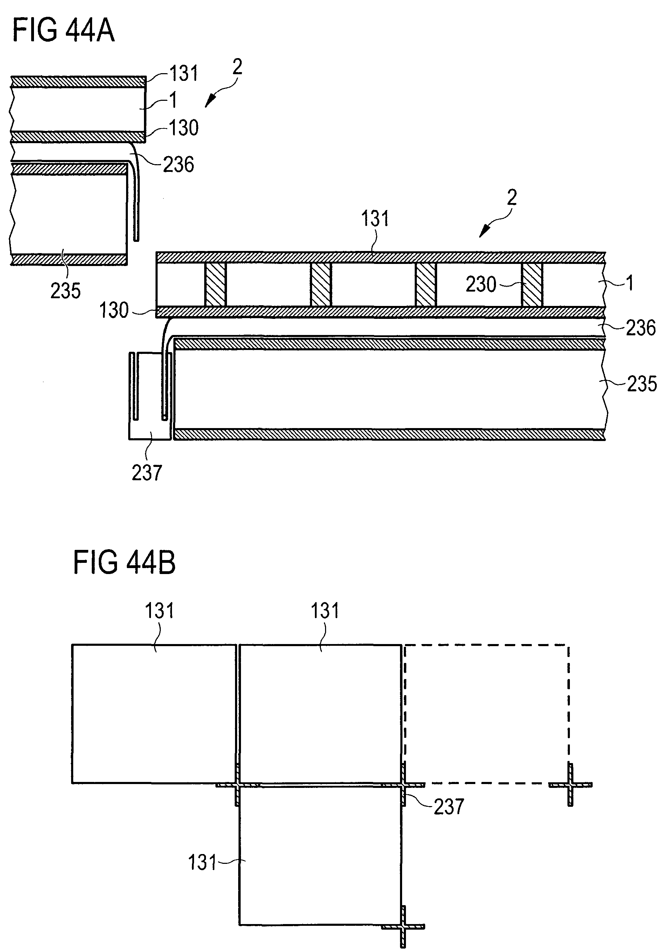

In Verbindung mit den schematischen Darstellungen der Figuren 43 und 44 ist ein weiteres Ausführungsbeispiel eines hier beschriebenen Beleuchtungsmittels näher erläutert. In diesem Ausführungsbeispiel ist das Beleuchtungsmittel 2 Teil einer Fliese 235.

Wie in Verbindung mit der Figur 43 schematisch dargestellt ist, kann das Beleuchtungsmittel 2 sowohl als Wandfliese als auch als Bodenfliese Verwendung finden.

In Verbindung mit den Figuren 44A und 44B ist schematisch ein Ausführungsbeispiel eines solchen Beleuchtungsmittels näher erläutert. Das Beleuchtungsmittel umfasst eine organische Leuchtdiode 1, die vorzugsweise trittfest ausgebildet ist. Dazu können der erste Träger 130 und der zweite Träger 131 der organischen Leuchtdiode 1 aus einem bruchfesten Glas gebildet sein. Zwischen den Trägern 130, 131 sind in regelmäßigem Abstand Abstandshalter 238 angeordnet, die beispielsweise ebenfalls aus einem Glasmaterial gebildet sein können. So kann es sich bei den Abstandshaltern 238 beispielsweise um Pfosten oder Dämme handeln, die mit einem Glaslot oder einem Glasfrittenmaterial gebildet sind. Die Abstandshalter 238 verhindern dabei ein Aufeinanderdrücken vom zweiten Träger 131 auf die funktionellen Schichten 180 der organischen Leuchtdiode 1.

Die organische Leuchtdiode 1 ist vorzugsweise als transparente organische Leuchtdiode ausgebildet. Die organische Leuchtdiode kann beispielsweise, wie in Verbindung mit den Figuren 26 und 27 beschrieben, zur Beleuchtung der Fliese 235 vorgesehen sein. In diesem Fall sind die Anschlussleiter 236 zum elektrischen Kontaktieren der organischen Leuchtdiode 1 randseitig an der organischen Leuchtdiode 1 angeordnet, dort wo Fugen der Fliesen 235 verlaufen. Die Anschlussleiter 236 stören auf diese Weise den optischen Eindruck der Fliesen nicht.

Wie in den Figuren 44A und 44B schematisch dargestellt ist, können benachbarte Beleuchtungsmittel 2 über elektrische Verbinder 237 elektrisch miteinander verbunden sein und auf diese Weise beispielsweise in Reihe oder parallel zueinander geschaltet sein. Es ist jedoch auch möglich, dass jedes der Beleuchtungsmittel 2 einzeln ansteuerbar ist. Elektrische Verbindungsleiter zum Ansteuern der Beleuchtungsmittel 2 verlaufen beispielsweise unterhalb der Fliesen 235.

Neben oder zusätzlich zur Erzeugung von weißem Licht oder farbigem Licht kann die organische Leuchtdiode 1 des Beleuchtungsmittels 2 auch zur Erzeugung von Infrarotstrahlung eingerichtet sein. Dazu kann beispielsweise eine organische Leuchtdiode 1 Verwendung finden, wie sie in Verbindung mit den Figuren 1 bis 6 näher erläutert ist. Ein Beleuchtungsmittel 2 mit einer solchen organischen Leuchtdiode 2 erzeugt im Betrieb der organischen Leuchtdiode 1 Wärme, und kann damit alternativ zu einer Wand oder Fußbodenheizung Verwendung finden.

In einer einfachen Ausführungsform des in Verbindung mit den Figuren 43 und 44 beschriebenen Beleuchtungsmittels 2 kann es sich bei der organischen Leuchtdiode 1 um eine transparente organische Leuchtdiode 1 handeln, die in einfacher Weise auf eine bereits verlegte Wand-, Decken- oder Bodenfliese aufgeklebt wird. Eine solche organische Leuchtdiode 1 kann beispielsweise flexibel ausgebildet sein, und nach Art eines Abziehbildes auf einer Fliese 235 befestigbar sein. Beispielsweise sind die funktionellen Schichten mit einer Verkapselungsschichtenfolge 160 versiegelt, wie sie weiter oben beschrieben ist. Die organische Leuchtdiode 1 kann dann insbesondere an der Außenfläche der Verkapselungsschichtenfolge 160 auf die Fliese 235 geklebt werden. Auf diese Weise kann das Beleuchtungsmittel in einfacher und kostengünstiger Art für bereits verlegte Fliesen Verwendung finden.

Neben einer Bestromung des Beleuchtungsmittels 2 über Anschlussleiter 236 ist beispielsweise auch eine induktive oder kapazitive Ansteuerung des Beleuchtungsmittels 2 denkbar. In diesem Fall kann auf die Anschlussleiter 236 verzichtet werden, die Bestromung kann beispielsweise mittels eines Senders von elektromagnetischer Strahlung erfolgen. Nachteilig kann sich hier ergeben, dass die Leuchtstärke des Beleuchtungsmittels 2 gegenüber einem mit elektrischen Anschlussleitern 236 bestromten Beleuchtungsmittel 2 reduziert ist.

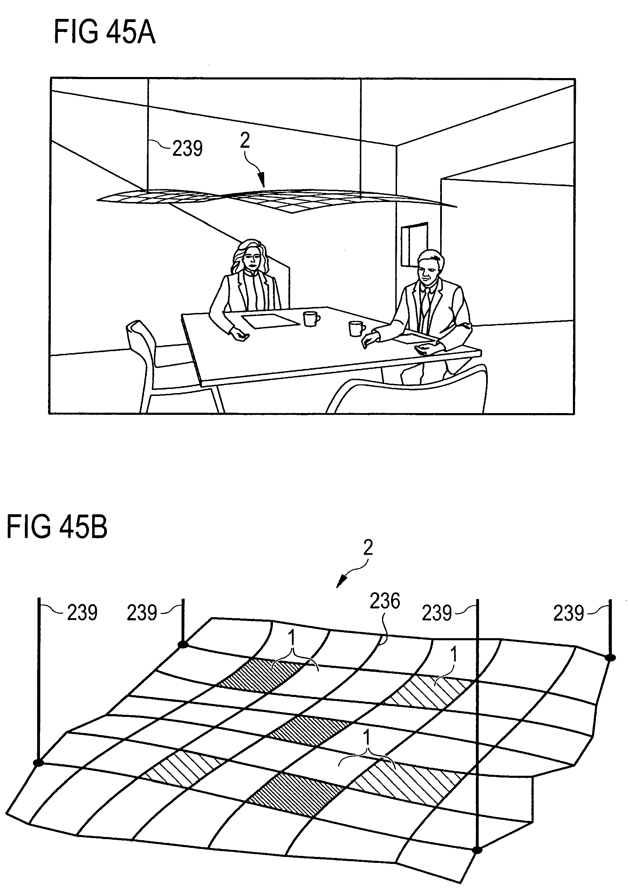

Die Figur 45A zeigt ein Ausführungsbeispiel eines hier beschriebenen Beleuchtungsmittels 2 anhand einer schematischen Perspektivdarstellung. Bei dem Beleuchtungsmittel 2 handelt es sich um ein großflächiges, segmentiertes Beleuchtungsmittel 2.

Das Beleuchtungsmittel 2 ist mittels Haltevorrichtungen 239 nach Art einer Deckenleuchte an der Decke eines Raums befestigt. Bei den Haltevorrichtungen 239 handelt es sich beispielsweise um Stromkabel, um Metalldrähte oder um Stangen, die ein elektrisch leitfähiges Material enthalten.

Mittels den Haltevorrichtungen 239 erfolgt - neben einer mechanischen Befestigung des Beleuchtungsmittels 2 - auch eine elektrische Kontaktierung und damit eine Bestromung des Beleuchtungsmittels 2.

Wie insbesondere aus der schematischen Darstellung der Figur 45B ersichtlich ist, umfasst das Beleuchtungsmittel 2 eine Vielzahl organischer Leuchtdioden 1. Das heißt, das Beleuchtungsmittel 2 ist in eine Vielzahl organischer Leuchtdioden 1 segmentiert. Die organischen Leuchtdioden 1 können beispielsweise flexibel oder starr ausgebildet sein.

Unterschiedliche organische Leuchtdioden 1 des Beleuchtungsmittels 2 können zur Erzeugung von Licht unterschiedlicher Farbe vorgesehen sein. Auf diese Weise ist das Beleuchtungsmittel 2 geeignet, im Betrieb Licht unterschiedlicher Farbe und/oder unterschiedlicher Farbtemperatur abzustrahlen. Das vom Beleuchtungsmittel 2 emittierte Licht kann damit flexibel an die Anforderungen seines Einsatzes angepasst werden. Beispielsweise kann mit dem Beleuchtungsmittel 2 ein tageslichtähnliches Licht erzeugt werden, das sich besonders gut zum Arbeiten eignet. Ferner ist es möglich, dass mittels desselben Beleuchtungsmittels 2 zu einer anderen Zeit rötliches Licht erzeugt wird, das beispielsweise als Abendbeleuchtung besonders gut geeignet ist.

Die organischen Leuchtdioden 1 sind vorzugsweise wie in Verbindung mit den Figuren 1 bis 31 beschrieben ausgeführt, oder stellen Kombinationen der dort beschriebenen organischen Leuchtdioden 1 dar.

Neben den organischen Leuchtdioden 1 umfasst das Beleuchtungsmittel 2 Anschlussleiter 236. Die Anschlussleiter 236 verlaufen beispielsweise nach Art eines Maschendrahtzauns, so dass sie - zum Beispiel rechteckige - Abschnitte begrenzen, in denen jeweils eine organische Leuchtdiode 1 angeordnet sein kann. Die Anschlussleiter 236 dienen zur elektrischen Kontaktierung der organischen Leuchtdioden 1 sowie zum mechanischen Verbinden der einzelnen organischen Leuchtdioden 1. Die organischen Leuchtdioden 1 können auf diese Weise in einer kombinierten Reihen- und Parallelschaltung angeordnet sein.

Darüber hinaus ist es möglich, dass mittels der Anschlussleiter 236 jede der organischen Leuchtdioden 1, oder Gruppen der organischen Leuchtdioden 1, die zur Erzeugung der gleichen Lichtfarbe vorgesehen sind, getrennt ansteuerbar sind. Die Anschlussleiter 236 sind in diesem Fall beispielsweise als Kabelstränge ausgebildet, die eine Vielzahl von einzelnen Stromleitungen aufweisen.

Neben ihrer Eigenschaft zur Bestromung der organischen Leuchtdioden 1 bilden die Anschlussleiter 236 ein Gerüst oder eine Matrize zur mechanischen Befestigung der organischen Leuchtdioden 1. Die Anschlussleiter 236 weisen dazu vorzugsweise eine gewisse Starrheit auf, die beispielsweise der Starrheit eines Kupferdrahtes entspricht. Die organischen Leuchtdioden 1 selbst können flexibel ausgebildet sein, und müssen nicht zur mechanischen Stabilisierung des Beleuchtungsmittels 2 dienen. Sind die Anschlussleiter 236 als Metalldrähte ausgeführt, so ist es darüber hinaus möglich, dass durch ein Verbiegen der Anschlussleiter 236 eine gewünschte Form des Beleuchtungsmittels 2, beispielsweise die in Figur 45A dargestellte wellenartige Form, vom Benutzer oder vom Hersteller des Beleuchtungsmittels 2 in einfacher Weise eingestellt werden kann.

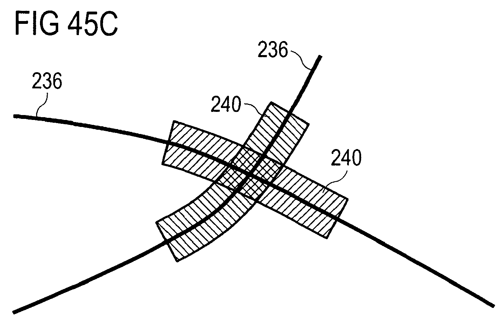

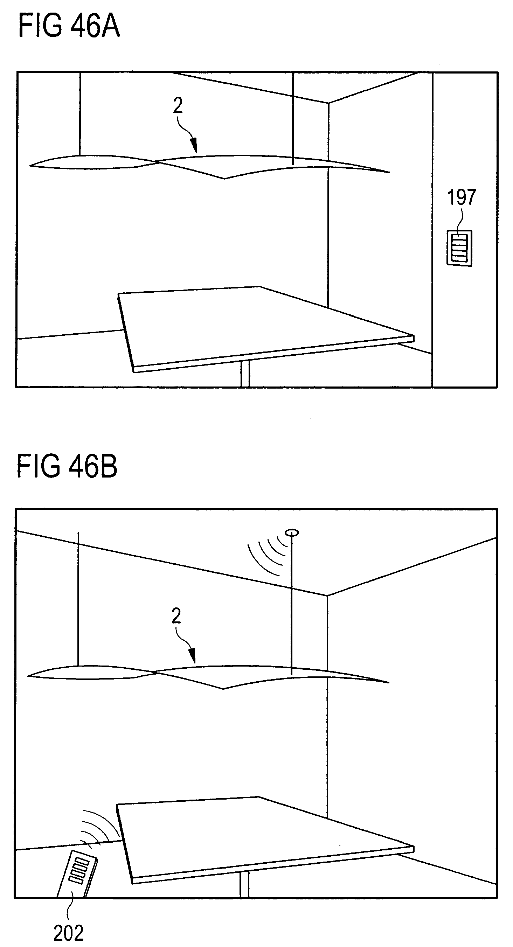

Bei dem Beleuchtungsmittel 2, das in Verbindung mit den Figuren 45 und 46 beschrieben ist, handelt es sich vorzugsweise um ein relativ großflächiges Beleuchtungsmittel. Das heißt, das Beleuchtungsmittel 2 kann Größen im Bereich von mehreren Quadratmetern aufweisen. Beispielsweise weist das Beleuchtungsmittel 2 eine Leuchtfläche von wenigstens 0,5 m², vorzugsweise wenigstens 1 m² auf. Die Leuchtfläche ist dabei durch die Summe der Strahlungsaustrittsflächen 174 der einzelnen organischen Leuchtdioden 1 gebildet. Jede einzelne organische Leuchtdiode 1 weist dabei vorzugsweise einen Flächeninhalt ihrer Strahlungsaustrittsfläche 174 von wenigstens 0,5 dm² auf.

In Verbindung mit der schematischen Darstellung der Figur 45C ist gezeigt, dass an Kreuzungspunkten der Anschlussleiter 236 ein Isolator 240 angeordnet ist, welcher die Anschlussleiter 236 elektrisch voneinander isoliert. Beispielsweise liegen die in der Figur 45B von links nach rechts verlaufenden Anschlussleiter 236 auf negativem elektrischem Potential. Die in Figur 45B von unten nach oben verlaufenden Anschlussleiter 236 liegen dann auf positivem Potential. Durch einen Isolator 240 zumindest im Bereich der Kreuzungspunkte der Anschlussleiter 236 ist ein Kurzschließen der Anschlussleiter 236 verhindert.

In Verbindung mit den schematischen Darstellungen der Figuren 46A und 46B sind kurz zwei alternativen Möglichkeiten zur Ansteuerung des Beleuchtungsmittels 2 erläutert. So kann das Beleuchtungsmittel 2 beispielsweise mittels eines Bedienelements 197, das an einer Wand angeordnet ist, angesteuert werden (vergleiche Figur 46A). Alternativ oder zusätzlich ist die Bedienung des Beleuchtungsmittels 2 mittels einer Fernbedienung 202 möglich (vergleiche die Figur 46B). Weiter ist es möglich, dass das Beleuchtungsmittel 2 mittels eines Berührungssensors oder einer Gestensteuerung ansteuerbar ist.

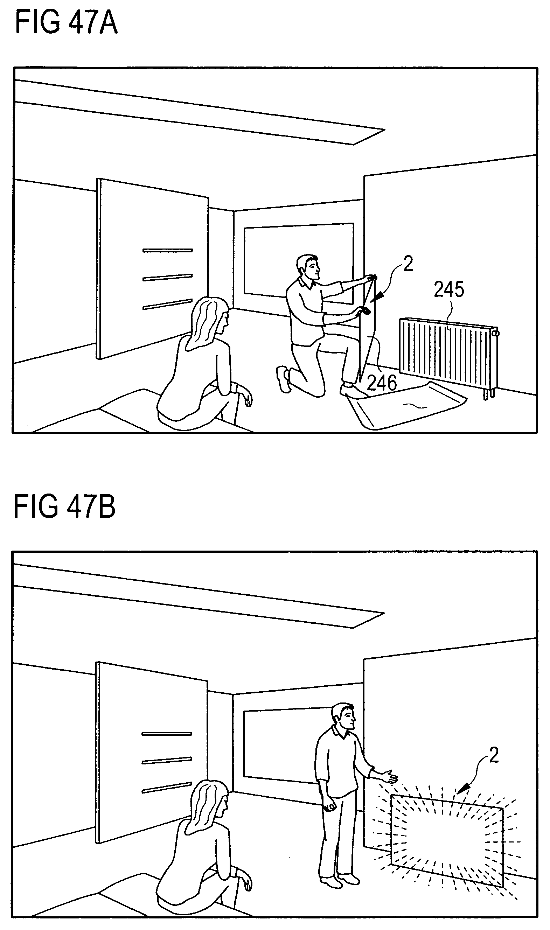

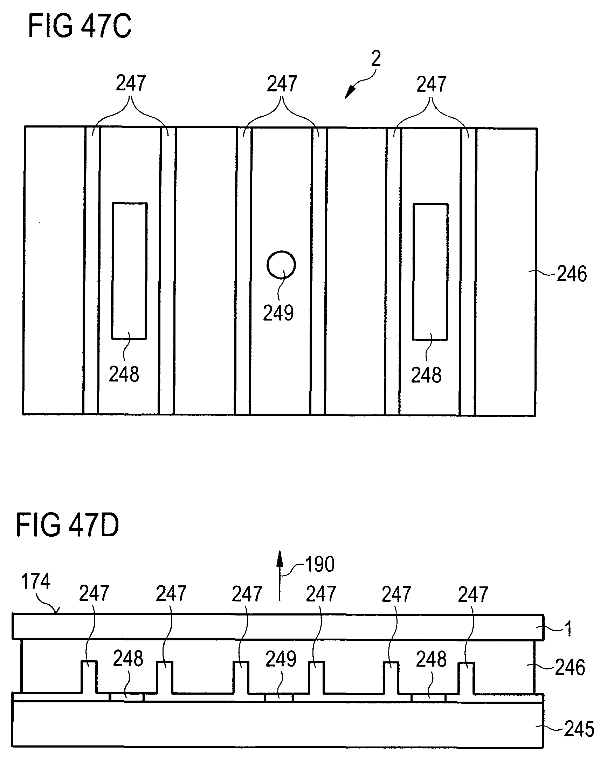

In Verbindung mit den schematischen Darstellungen der Figuren 47 bis 49 ist ein Ausführungsbeispiel eines hier beschriebenen Beleuchtungsmittels 2 näher erläutert, das zur Abdeckung eines Objekts dient. Beispielsweise dient das Beleuchtungsmittel 2 zur Abdeckung eines Heizkörpers 245.

Ein Heizkörper 245 besitzt in der Regel eine nicht glatte Oberfläche, zum Beispiel eine Oberfläche mit Heizlamellen, in der sich besonders leicht Staub festsetzen kann. Mit dem Beleuchtungsmittel 2, das zur Abdeckung des Heizkörpers Verwendung finden kann, können die staubempfindlichen Bereiche des Heizkörpers 245 verkleidet werden. Darüber hinaus verschönert das Beleuchtungsmittel 2 den optischen Eindruck des Heizkörpers 245. An die Stelle der sichtbaren Außenfläche des Heizkörpers 245 tritt das Beleuchtungsmittel 2, das als Leuchte zur Allgemeinbeleuchtung des Raums, in dem der Heizkörper angeordnet ist, dienen kann.

In Verbindung mit den Figuren 47A und 47B ist die Montage des Beleuchtungsmittels 2 am Heizkörper 245 gemäß einem Ausführungsbeispiel des Beleuchtungsmittels 2, das zur Abdeckung dienen kann, näher erläutert. Die Figur 47C zeigt anhand einer schematischen Ansicht eine Rückwand 246 des Beleuchtungsmittels 2, die bei montiertem Beleuchtungsmittel 2 dem Heizkörper 245 zugewandt ist. Die Rückwand 246 ist beispielsweise von mehreren Kühlkanälen 247 durchzogen, dies sich entlang der gesamten Breite der Rückwand 246 erstrecken können.

Wie aus der schematischen Draufsicht der Figur 47D auf die Oberseite des Heizkörpers 245 mit Beleuchtungsmittel 2 ersichtlich ist, sind die Kühlkanäle 247 als Einstülpungen in der Rückwand 246 des Beleuchtungsmittels 2 ausgebildet. Das heißt, im Bereich der Kühlkanäle 247 ist die Dicke der Rückwand 246 reduziert.

Wird der Heizkörper 245 nun betrieben, so findet entlang der Kühlkanäle 247 eine Konvektion von Luft statt, die beim Durchströmen der Kühlkanäle 247 die Rückwand 246 des Beleuchtungsmittels 1 kühlt. Auf diese Weise wird auch die organische Leuchtdiode 1 im Betrieb gekühlt, so dass sich kein zulässiges Erhitzen der organischen Leuchtdiode 1 ergeben kann. Zusätzlich können die Rückwand 246 und die organische Leuchtdiode 1 des Beleuchtungsmittels 2 durch eine thermische Isolationsschicht (nicht dargestellt) thermisch voneinander isoliert sein. Die thermische Isolationsschicht kann beispielsweise mit einem schlecht thermisch leitenden Material, wie Styropor, gebildet sein.

An der Rückwand 246 sind neben den Kühlkanälen 247 Befestigungsmittel 248 vorgesehen. Bei den Befestigungsmittels 248 handelt es sich in einem einfachen Ausführungsbeispiel um Klebestreifen, mittels denen das Beleuchtungsmittel 2 am Heizkörper 245 befestigt werden kann.

Es ist jedoch auch möglich, dass es sich bei den Befestigungsmitteln 248 um Magnete handelt, so dass das Beleuchtungsmittel 2 über magnetische Kräfte am Heizkörper 245 haftet. Auch andere Arten der Befestigungen wie zum Beispiel Verschrauben oder Klemmen sind möglich.

Ferner ist an der Rückwand 246 des Beleuchtungsmittels 2 ein Temperatursensor 249 angeordnet. Über den Temperatursensor 249 wird die Temperatur des Heizkörpers 245 gemessen. Abhängig von der gemessenen Temperatur kann beispielsweise die Lichtstärke und/oder der Lichtort und/oder die Lichttemperatur des vom Beleuchtungsmittel 2, das heißt von der organischen Leuchtdiode 1, abgestrahlten Lichts eingestellt werden. Das bedeutet, zwischen der Temperatur des Heizkörpers 245 und der vom Beleuchtungsmittel 2 durch die Strahlungsaustrittsfläche 174 der organischen Leuchtdiode 1 abgegebenen elektromagnetischen Strahlung 190 gibt es eine Korrelation. Das Beleuchtungsmittel 2 dient auf diese Weise also auch als Temperaturanzeige für die von der Heizung 245 im Betrieb erzeugte Wärme.

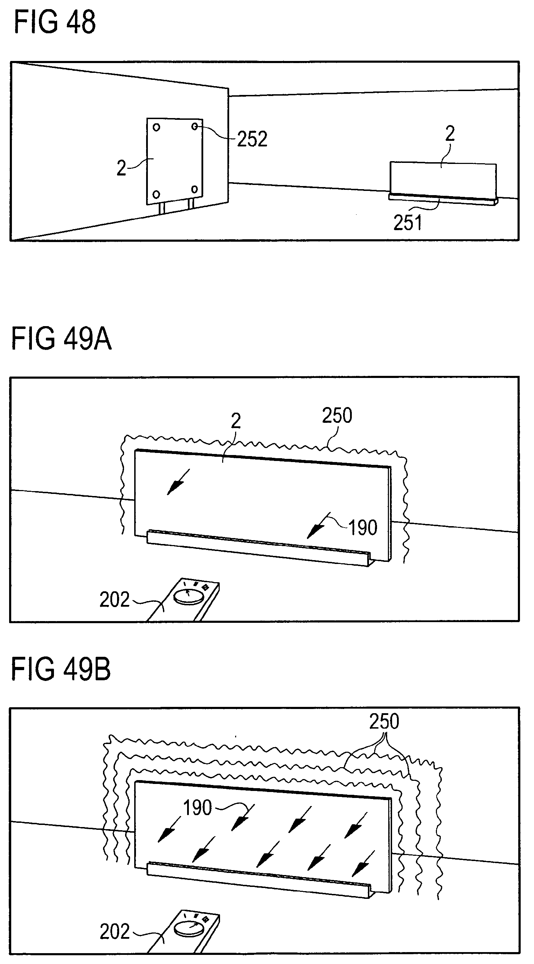

In Verbindung mit der schematischen Perspektivdarstellung der Figur 48 sind weitere Ausführungsbeispiele des Beleuchtungsmittels 2, das zur Verkleidung einer Heizung dient, näher erläutert. Das Beleuchtungsmittel 2 ist in diesen Fällen beispielsweise mittels eines Ständers 251 oder einer Schraubverbindung 252 vor einem Heizkörper 245 angeordnet, so dass dieser durch das jeweilige Beleuchtungsmittel 2 abgedeckt ist. In diesen Fällen besteht nicht zwingend eine Verbindung aus kondensierter Materie zwischen dem Heizkörper und dem Beleuchtungsmittel 2. Das Beleuchtungsmittel 2 kann also in einem Abstand vom Heizkörper 245 angeordnet sein, wobei der Spalt zwischen Heizkörper 245 und Beleuchtungsmittel 2 mit Luft gefüllt ist. In einem solchen Fall kann beispielsweise auf die in Verbindung mit den Figuren 47A bis 47D beschriebenen Kühlkanäle 249 verzichtet werden, da über den Spalt eine ausreichende Kühlung mittels Konvektion erfolgt.

In Verbindung mit den Figuren 49A und 49B ist anhand von schematischen Schnittdarstellungen ein weiteres Ausführungsbeispiel eines Beleuchtungsmittels 2, das zur Abdeckung eines Heizkörpers 245 Verwendung findet, näher beschrieben. In diesem Ausführungsbeispiel kann beispielsweise auf einen Temperatursensor 249 verzichtet sein. Stattdessen erfolgt eine Regelung der Wärme 250, die vom Heizkörper 245 abgegeben wird, gleichzeitig mit einer Regelung der vom Beleuchtungsmittel 2 abgegebenen elektromagnetischen Strahlung 190. Das heißt, mit einer Erhöhung der Temperatur, die vom Heizkörper 245 erzeugt wird, wird beispielsweise die Farbtemperatur T des vom Beleuchtungsmittel 2 emittierten Lichts 190 abgesenkt oder erhöht. Eine solche Regelung kann über eine Fernbedienung 202, über berührungssensitive Bedienelemente 197 und/oder über die Ventilsteuerung des Heizkörpers 245 erfolgen.

Insgesamt kann für das in Verbindung mit den Figuren 47 bis 49 beschriebene Beleuchtungsmittel jede Kombination der hier beschriebenen organischen Leuchtdioden 1 Verwendung finden. Dabei ist es beispielsweise auch möglich, dass die Rückwand 245 eine zu beleuchtende Fläche 185a aufweist, die von der organischen Leuchtdiode 1 des Beleuchtungsmittels beleuchtet wird, wie dies beispielsweise in Verbindung mit den Figuren 26 und 27 näher beschrieben ist. Beispielsweise ist die zu beleuchtende Fläche 185a die bildliche Wiedergabe eines Kaminfeuers. Mittels der organischen Leuchtdiode 1 des Beleuchtungsmittels 2 kann die zu beleuchtende Fläche 185a dann nach Art einer Kerze flackernd beleuchtet werden. Auf diese Weise entsteht der Eindruck eines lodernden Kaminfeuers im Bereich des Heizkörpers 245. Ein solches Flackern kann beispielsweise durch ein Betreiben der organischen Leuchtdiode 1 des Beleuchtungsmittels 2 mit zeitlich variierenden Stromstärken erfolgen. Dies ist durch eine Pulsweitenmodulationsschaltung auf einfache Weise erreichbar.

Auch ist es möglich, dass das Beleuchtungsmittel 2 segmentierte organische Leuchtdioden 1 oder eine Vielzahl von organischen Leuchtdioden 1 umfasst, die geeignet sein können, voneinander Licht unterschiedlicher Farbe zu erzeugen.

Neben einer Abdeckung für eine Heizung 245 kann das Beleuchtungsmittel 2 beispielsweise auch zur Abdeckung einer Klimaanlage oder eines Belüftungsschachtes in einem Niedrigenergiehaus Verwendung finden. Das Beleuchtungsmittel 2 eignet sich dabei, insbesondere wenn ein Temperatursensor 249 vorhanden ist, besonders gut zur Abdeckung und Verkleidung von Elementen, die zur Kühlung und/oder zum Heizen eines Raums Verwendung finden sollen. Das Beleuchtungsmittel 2 dient in diesem Fall als ästhetisch ansprechende, den Raum aufhellende, Temperaturanzeige.

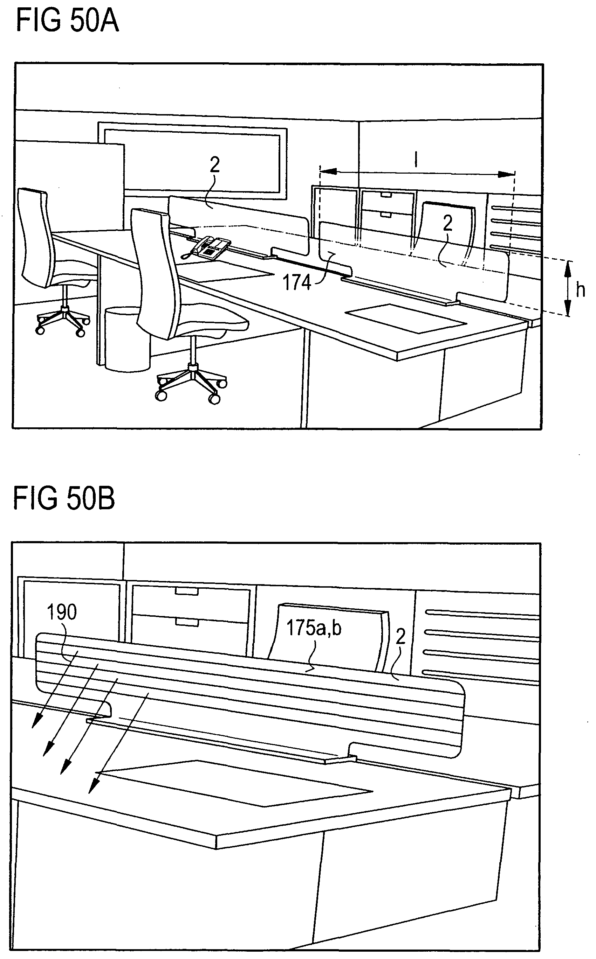

In Verbindung mit den Figuren 50A bis 50D ist ein weiteres Ausführungsbeispiel eines hier beschriebenen Beleuchtungsmittels 2 näher erläutert.

Die Figur 50A zeigt das Beleuchtungsmittel 2 in einer schematischen Perspektivdarstellung. Beim Beleuchtungsmittel 2 handelt es sich um eine Leuchte mit großflächiger Strahlungsaustrittsfläche 174, die beispielsweise als Schreibtischlampe zur Beleuchtung einer Arbeitsfläche Verwendung finden kann.

Das Beleuchtungsmittel 2 umfasst als Lichtquelle vorzugsweise zumindest eine organische Leuchtdiode 1, wie sie in Verbindung mit den Figuren 1 bis 31 näher beschrieben ist.

Das Beleuchtungsmittel 2 weist eine Strahlungsaustrittsfläche 174 auf, die eine Fläche von 0,1 m² oder mehr umfassen kann. Beispielsweise weist die Strahlungsaustrittsfläche 174 eine rechteckige Grundform mit einer Länge 1 von wenigstens 50 cm und einer Höhe h von wenigstens 20 cm auf.

Das Beleuchtungsmittel 2 kann dabei beidseitig abstrahlend ausgeführt sein, so dass es beispielsweise zwei gegenüberliegend angeordnete Arbeitsplätze im Betrieb beleuchten kann. Dabei kann das Beleuchtungsmittel 2 auch eine transparente organische Leuchtdiode 1 umfassen und auf diese Weise selbst transparent ausgeführt sein.

Darüber hinaus ist es möglich, dass das Beleuchtungsmittel 2 eine zu beleuchtende Fläche 185a aufweist, die auf der der Strahlungsdurchtrittsfläche 174 gegenüberliegenden Seite des Beleuchtungsmittels 2 angeordnet ist. Auf diese Weise kann das Beleuchtungsmittel 2 im ausgeschalteten Zustand beispielsweise ein Bild, einen Kalender oder ein Firmenlogo darstellen.

In Verbindung mit der Figur 50B ist schematisch dargestellt, dass das Beleuchtungsmittel 2 elektromagnetische Strahlung 190 in gerichteter Weise abstrahlen kann. Das Beleuchtungsmittel 2 umfasst dazu beispielsweise zumindest eine organische Leuchtdiode 1, die beispielsweise, wie in Verbindung mit den Figuren 21 bis 25 beschrieben, ausgeführt ist. Das heißt, die organische Leuchtdiode 1 umfasst eine strukturierte Strahlungsaustrittsfläche 175, die in Flächen 175a und 175b strukturiert ist, derart, dass elektromagnetische Strahlung 190 nach unten, beispielsweise zu einer Tischoberfläche hin, abgestrahlt wird. Mit Vorteil wird also keine elektromagnetische Strahlung 190 nach oben, beispielsweise von einer Tischoberfläche weg, ins Gesicht des Benutzers des Beleuchtungsmittels 2 abgestrahlt. Es handelt sich bei dem Beleuchtungsmittel 2 daher um ein blendfreies Beleuchtungsmittel, das besonders gut zur Schreibtischarbeit Verwendung finden kann.

Darüber hinaus erweist es sich als vorteilhaft, dass das Beleuchtungsmittel 2 besonders großflächig aufgeführt ist. Auf diese Weise ist für eine ausreichende Beleuchtung der Arbeitsfläche eine relativ geringe Leuchtdichte an der Strahlungsaustrittsfläche 174 ausreichend. Das heißt, im Beleuchtungsmittel 2 muss nicht eine hohe Leuchtdichte auf einer relativ kleinen Strahlungsaustrittsfläche konzentriert werden, wie dies beispielsweise bei einer herkömmlichen Schreibtischlampe mit Glühbirne oder Halogenlampe der Fall ist. Vielmehr kann das abgestrahlte Licht auf eine große Fläche verteilt werden und die Leuchtdichte daher reduziert sein. Damit ergibt sich ein Beleuchtungsmittel 2, das besonders blendfrei ist und ein tageslichtähnliches Licht - zumindest im Bereich der Arbeitsfläche - liefert.

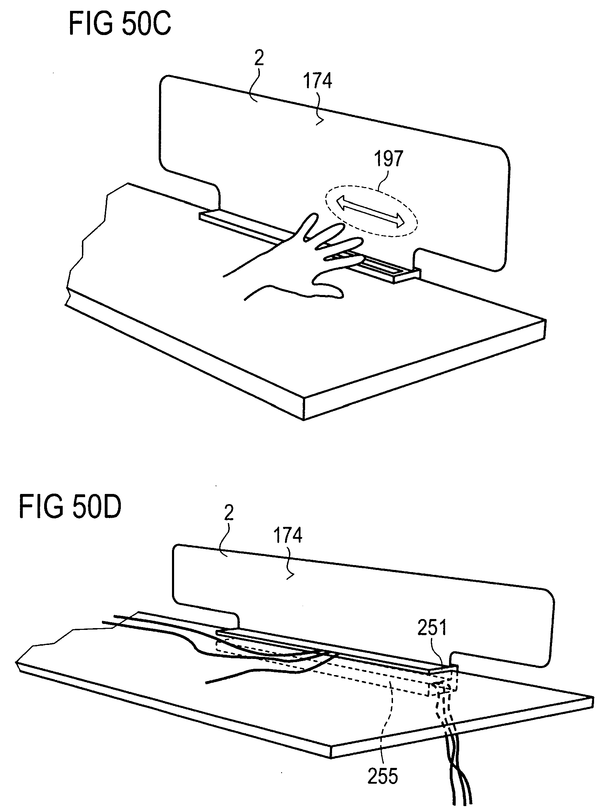

In Verbindung mit der Figur 50C ist ein Beispiel zur Bedienung des Beleuchtungsmittels 2 näher erläutert. Beispielsweise kann dabei eine berührungssensitive organische Leuchtdiode 1 mit einem berührungsempfindlichen Bedienelement 197 im Beleuchtungsmittel integriert sein. Durch das Überfahren eines Teils der Strahlungsaustrittsfläche 174 des Beleuchtungsmittels 2 kann dann ein Einschalten oder Dimmen des Beleuchtungsmittels 2 erfolgen.

In Verbindung mit der Figur 50D ist gezeigt, dass das Beleuchtungsmittel 2, aufgrund seiner relativ großen Länge 1 von beispielsweise wenigstens 50 cm, auch zur Führung von elektrischen Kabeln dienen kann. In diesem Fall ist in das Beleuchtungsmittel 2 ein Kabelschacht 255 integriert, der beispielsweise mit einem Ständer 251 des Beleuchtungsmittels 2 integral ausgebildet sein kann.

Das Beleuchtungsmittel 2 dient dabei, neben seinen Eigenschaften zur Allgemeinbeleuchtung, auch als Ordnungssystem.

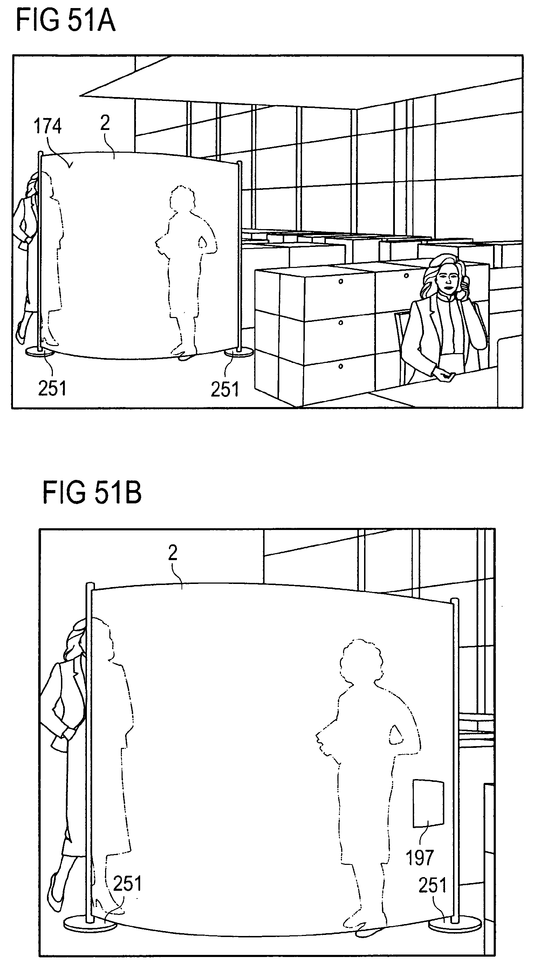

In Verbindung mit den Figuren 51 bis 53 sind weitere Ausführungsbeispiele eines hier beschriebenen Beleuchtungsmittels 2 näher erläutert. Das Beleuchtungsmittel 2 dient in diesem Fall zur Allgemeinbeleuchtung und als Raumteiler.

Bei dem Beleuchtungsmittel 2, wie es in Verbindung mit den schematischen Darstellungen der Figuren 51A und 51B gezeigt ist, handelt es sich um eine großflächige Leuchte. Das Beleuchtungsmittel weist eine Strahlungsaustrittsfläche 174 von vorzugsweise wenigstens 0,5 m², besonders bevorzugt von wenigstens 1 m² auf. Die Strahlungsaustrittsfläche 174 des Beleuchtungsmittels ist zwischen zwei Ständern 251 angeordnet, die auch zur elektrischen Kontaktierung des Beleuchtungsmittels 2 dienen können.

Das Beleuchtungsmittel 2 umfasst zumindest eine organische Leuchtdiode 1, vorzugsweise umfasst das Beleuchtungsmittel 2 eine Vielzahl organischer Leuchtdioden 1, die beispielsweise parallel und/oder in Reihe zueinander geschaltet sind. Die zumindest eine organische Leuchtdiode kann dann, wie in Verbindung mit den Figuren 1 bis 31 beschrieben, ausgeführt sein.

Das Beleuchtungsmittel 2 kann eine berührungssensitive organische Leuchtdiode 1 mit einem Bedienelement 197 umfassen. Über das Bedienelement 197 kann das Beleuchtungsmittel 2 beispielsweise ein- oder ausgeschaltet und/oder gedimmt werden. Ferner ist es möglich, dass mittels des Bedienelementes 197 die Auswahl einer Farbtemperatur T oder eines Farbortes O für die vom Beleuchtungsmittel 2 abgestrahlte elektromagnetische Strahlung erfolgen kann.

Bei dem Beleuchtungsmittel 2 kann es sich um ein beidseitig abstrahlendes Beleuchtungsmittel handeln, das diffus Licht streuend ausgebildet ist. Das heißt, das Beleuchtungsmittel 2 ist in diesem Fall nicht transparent, sondern beispielsweise nach Art einer Milchglasscheibe lediglich strahlungsdurchlässig ausgebildet. Das Beleuchtungsmittel 2 dient auf diese Weise, neben seinen Eigenschaften zur Allgemeinbeleuchtung, auch als Raumteiler, der einen Sichtschutz bietet. Ferner ist es möglich, dass das Beleuchtungsmittel 2 lediglich von einer Seite her elektromagnetische Strahlung 190 abgibt und von der anderen Seite her wie ein gewöhnlicher Raumteiler erscheint.

Mittels des Beleuchtungsmittels 2 ist es, aufgrund der großen Strahlungsaustrittsfläche 174, möglich, blendfreies Licht zu erzeugen, da relativ geringe Leuchtdichten notwendig sind, um einen Raum mittels des Beleuchtungsmittels 2 auszuleuchten.

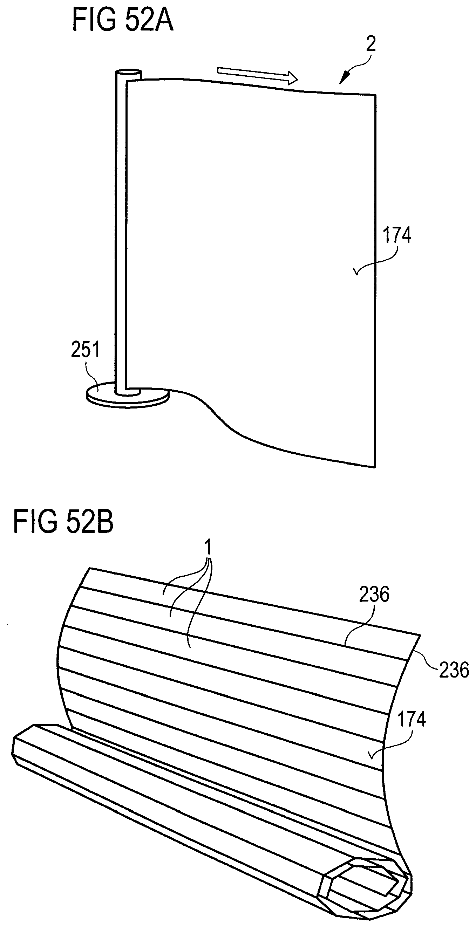

In Verbindung mit den Figuren 52A bis 52C ist dargestellt, dass das Beleuchtungsmittel 2, das als Raumteiler ausgebildet ist, eine Strahlungsaustrittsfläche 174 variabler Größe aufweisen kann. Dies kann beispielsweise dadurch erreicht sein, dass das Beleuchtungsmittel 2 eine aufrollbare und abrollbare Strahlungsdurchtrittsfläche 174 aufweist.

Das Beleuchtungsmittel 2 ist zu diesem Zweck beispielsweise, wie in Verbindung mit der Figur 52B dargestellt, in einzelne Lamellen unterteilt, welche jeweils durch starre organische Leuchtdioden 1 gebildet sein können. Die Lamellen, das heißt die einzelnen organischen Leuchtdioden 1, sind durch Anschlussleiter 236 mechanisch und elektrisch miteinander verbunden. Die Anschlussleiter 236 selbst sind flexibel ausgebildet, beispielsweise im Sinne eines ab- und aufrollbaren Stromkabels. Das Beleuchtungsmittel 2 umfasst in diesem Fall eine Vielzahl organischer Leuchtdioden 1, welche in einer Reihe hintereinander angeordnet sind.

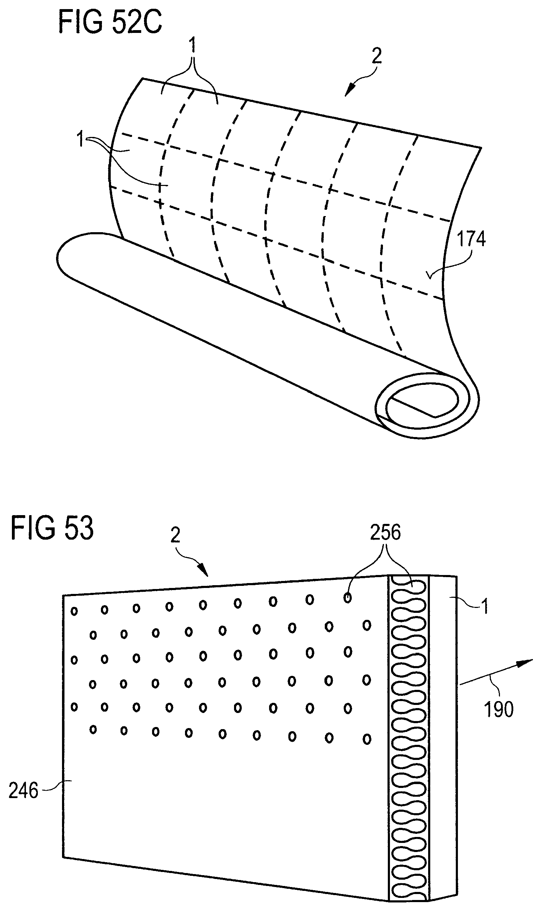

Darüber hinaus ist es möglich, dass das Beleuchtungsmittel 2, wie in Verbindung mit der Figur 52C dargestellt, eine Strahlungsaustrittsfläche 174 aufweist, die nicht in einzelne Lamellen unterteilt ist. Beispielsweise umfasst das Beleuchtungsmittel 2 dazu genau eine, großflächige organische Leuchtdiode 1. Darüber hinaus ist es möglich, dass das Beleuchtungsmittel 2, eine Vielzahl organischer Leuchtdioden 1 umfasst, die nach Art einer Matrix angeordnet sind. Bei den organischen Leuchtdioden 1 kann es sich um flexible organische Leuchtdioden handeln, welche zwischen zwei Folien eingebracht sind. Auf diese Weise kann ein großflächiges, auf- und abrollbares Beleuchtungsmittel 2 aus einer Vielzahl kleinerer, flexibler organischen Leuchtdioden 1 aufgebaut sein.

In Verbindung mit der Figur 53 ist dargestellt, dass es sich bei dem Beleuchtungsmittel 2, das einen Raumteiler bildet, auch um einen Schallschutz handeln kann. Das Beleuchtungsmittel 2 weist in diesem Fall eine Rückwand 246 auf, welche mit zumindest einem Dämmmaterial 256, das zur akustischen Dämmung geeignet ist, gebildet ist. In einem einfachen Fall kann es sich bei der Rückwand 246 um eine Styroporplatte handeln. Als Lichtquelle des Beleuchtungsmittels 2 ist dann zumindest eine organische Leuchtdiode 1 mit dem Dämmmaterial 256, welches die Rückwand 246 bildet, verbunden.

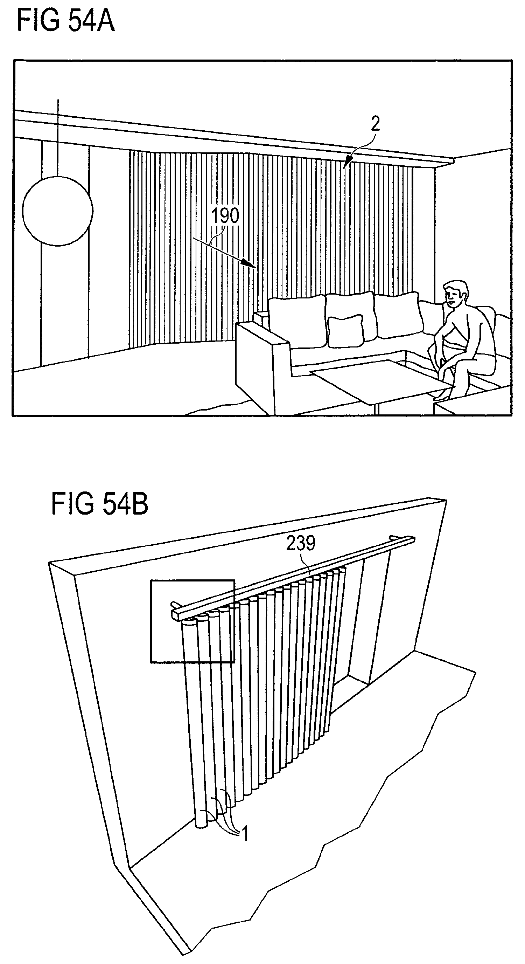

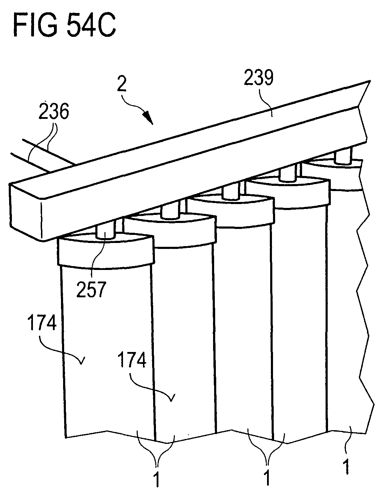

In Verbindung mit den Figuren 54A bis 54C ist ein Ausführungsbeispiel eines hier beschriebenen Beleuchtungsmittels näher erläutert, bei dem das Beleuchtungsmittel als Jalousie ausgebildet ist. Das Beleuchtungsmittel 2 umfasst in diesem Fall eine Vielzahl organischer Leuchtdioden 1, die über eine Haltevorrichtung 239 elektrisch kontaktiert und mechanisch gehalten sind. Die organischen Leuchtdioden 1 umfassen an einem stirnseitigen Ende einen Anschlussstecker 257, der in die Haltevorrichtung 239 eingreift. Ein elektrischer Anschluss des Beleuchtungsmittels 2 kann beispielsweise über Anschlussleiter 236 erfolgen. Bei der Haltevorrichtung 239 handelt es sich zum Beispiel um eine Schiene, in der die einzelnen organischen Leuchtdioden 1 mittels des Anschlusssteckers befestigt sind. Die organischen Leuchtdioden 1 können in der Schiene verschoben werden.

Die organischen Leuchtdioden 1 können in diesem Fall flexibel oder starr ausgeführt sein. Beispielsweise weisen die organischen Leuchtdioden 1 als ersten Träger 130 ein Metallblech auf, das reflektierende Eigenschaften hat. Auf diese Weise ist die der Strahlungsaustrittsfläche 174 abgewandte Seite einer jeden organischen Leuchtdiode 1 reflektierend ausgebildet. Das Beleuchtungsmittel 2 dient in diesem Fall neben seinen Eigenschaften zur Raumbeleuchtung auch zur Raumverdunkelung und/oder als Sichtschutz.

Das Beleuchtungsmittel 2 kann unterschiedliche organische Leuchtdioden 1 umfassen, so dass mittels des Beleuchtungsmittels 2 Licht unterschiedlicher Farbe oder unterschiedlicher Farbeffekte erzeugt werden kann. Das Beleuchtungsmittel 2 ist beispielsweise im Sinne eines Vorhangs oder einer Jalousie vor einem Fenster angeordnet, und erzeugt auf diese Weise auch bei schlechten äußeren Lichtverhältnissen eine tageslichtähnliche Beleuchtung des Raums, in dem das Beleuchtungsmittel 2 angeordnet ist. Das heißt, die Hauptleuchte des Raums befindet sich beispielsweise im Bereich des Fensters, in dem das Beleuchtungsmittel 2 angeordnet ist. Auf diese Weise findet bei eingeschaltetem Beleuchtungsmittel 2 eine ähnliche Beleuchtung des Raums wie durch das Fenster hindurch statt. Das Beleuchtungsmittel 2 kann dabei die Hauptlichtquelle eines Raums bilden, so dass auf weitere Lichtquellen im Raum verzichtet werden kann.

Die organischen Leuchtdioden 1, die als Lichtquellen des Beleuchtungsmittels 2 Verwendung finden, sind dabei vorzugsweise wie in einer der Figuren 1 bis 31 beschrieben oder als Kombination der dort beschriebenen organischen Leuchtdioden 1 ausgeführt.

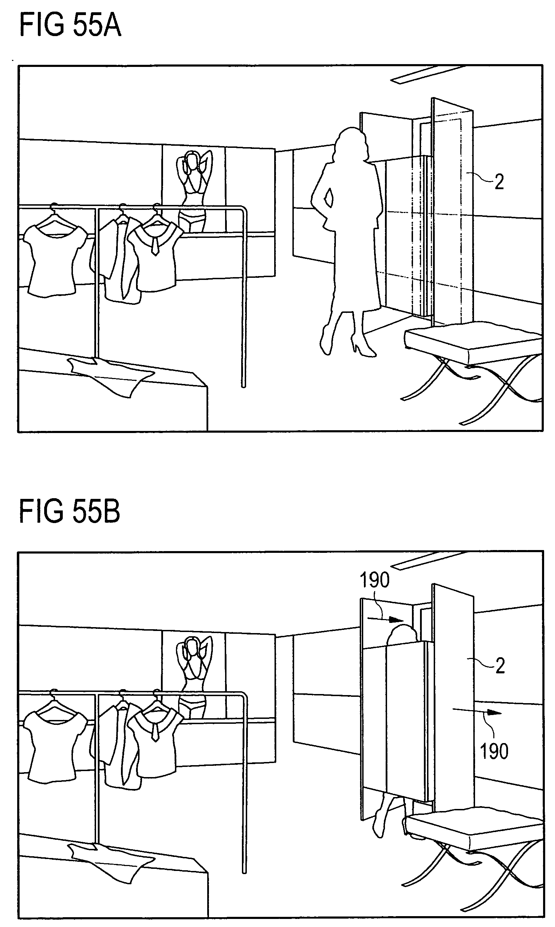

In Verbindung mit den Figuren 55A bis 55D ist ein weiteres Ausführungsbeispiel eines hier beschriebenen Beleuchtungsmittels 2 näher erläutert. In diesem Ausführungsbeispiel dient das Beleuchtungsmittel, neben seiner Funktion zur Allgemeinbeleuchtung, auch als Sichtschutz. Das Beleuchtungsmittel 2 weist beispielsweise wenigstens drei als Wände ausgebildete Strahlungsaustrittsflächen 174 auf.

In der schematischen Perspektivdarstellung der Figur 55A ist das Beleuchtungsmittel 2 in einem ausgeschalteten Betriebszustand gezeigt. In diesem ausgeschalteten Betriebszustand ist das Beleuchtungsmittel 2 transparent. Das Beleuchtungsmittel 2 umfasst dazu beispielsweise zumindest eine organische Leuchtdiode 1 als Lichtquelle, welche transparent ausgebildet ist.

In Verbindung mit der perspektivischen Prinzipskizze der Figur 55B ist das Beleuchtungsmittel 2 in einem eingeschalteten Betriebszustand gezeigt. In diesem eingeschalteten Betriebszustand strahlt das Beleuchtungsmittel 2 elektromagnetische Strahlung 190 ab. Dabei ist es möglich, dass die elektromagnetische Strahlung sowohl nach außen, in den Raum hinein, als auch nach innen, in die durch die Wände des Beleuchtungsmittels 2 umschlossene Kabine abgestrahlt wird. Das Beleuchtungsmittel 2 dient in diesem Fall sowohl zur Beleuchtung des Kabineninneren als auch als Anzeigevorrichtung dafür, dass die Kabine durch einen Benutzer belegt ist.

Ferner erscheint das Beleuchtungsmittel 2 im eingeschalteten Betriebszustand nicht mehr transparent, sondern es ist blickdicht. Dies ist beispielsweise dadurch erreicht, dass das Beleuchtungsmittel 2 ein elektrisch schaltbares optisches Element 186 umfasst, wie es in Verbindung mit der Figur 27 näher beschrieben ist. Beim elektrisch schaltbaren optischen Element 186 handelt es sich dann um einen elektrisch schaltbaren Diffusor oder ein elektrochromes Material. Das Schalten des Beleuchtungsmittels 2 in den eingeschalteten, leuchtenden und blickdichten Betriebszustand, wie er in der Figur 55B näher dargestellt ist, kann dabei beispielsweise durch das Betreten der Kabine erfolgen.

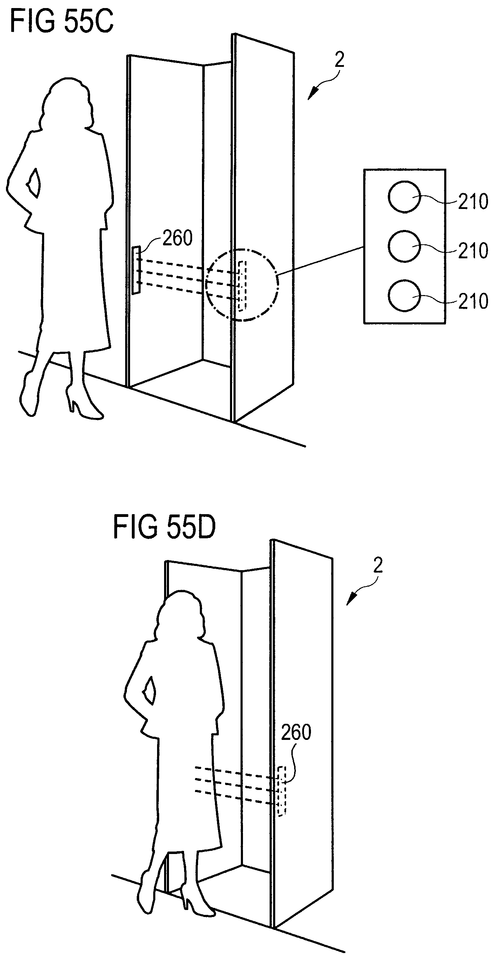

Beispielsweise kann ein Schalter mittels der Betätigung von Türen am Beleuchtungsmittel 2 betätigt werden. Darüber hinaus ist es möglich, dass das Beleuchtungsmittel 2 eine Lichtschranke 260 umfasst, wie dies beispielsweise in Verbindung mit den Figuren 55C und 55D näher erläutert ist. Beim Durchqueren dieser Lichtschranke, die zum Beispiel mehrere Leuchtdioden 210, Laserdioden und/oder optische Sensoren umfasst, wird das Beleuchtungsmittel 2 eingeschaltet.

Das beschriebene Beleuchtungsmittel kann dabei beispielsweise als Umkleidekabine Verwendung finden. Es ist in diesem Fall auch möglich, dass die Farbtemperatur T und/oder Farbort O des vom Beleuchtungsmittel 2 erzeugten Lichts durch den Benutzer des Beleuchtungsmittels 2 eingestellt werden kann. Auf diese Weise kann der Benutzer die Kleidung, die er anprobiert, bei unterschiedlichen Lichtgegebenheiten überprüfen. Er kann dadurch beispielsweise die Wirkung der Kleidung bei Tageslicht, Bürobeleuchtung, Dämmerung und dergleichen überprüfen.

Darüber hinaus kann das beschriebene Beleuchtungsmittel als Abtrennwand in einem Großraumbüro Verwendung finden. Das vom Beleuchtungsmittel emittierte Licht dient dann als Büroleuchte und signalisiert, dass der Arbeitsplatz, an dem sich das Beleuchtungsmittel 2 befindet, besetzt ist. Eine Schaltung zwischen transparent und diffus kann auch unabhängig von der Lichtemission durch das Beleuchtungsmittel erfolgen, so dass der Benutzer des Beleuchtungsmittels dieses bei Bedarf strahlungsundurchlässig, diffus streuend schalten kann, um eine privatere Arbeitsatmosphäre zu schaffen.

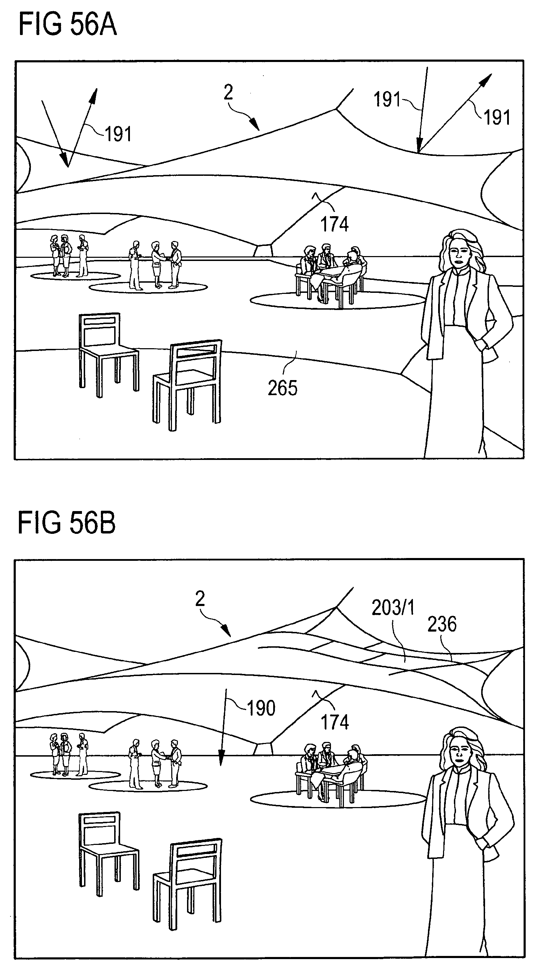

Die Figuren 56A bis 56C zeigen anhand schematischer Darstellungen ein weiteres Ausführungsbeispiel eines hier beschriebenen Beleuchtungsmittels 2. In diesem Ausführungsbeispiel bildet das Beleuchtungsmittel 2 - neben seinen Eigenschaften zur Allgemeinbeleuchtung - einen Sonnenschutz.

In der Figur 56A ist das Beleuchtungsmittel 2 anhand einer schematischen Schnittdarstellung in einem ausgeschalteten Betriebszustand gezeigt. In diesem ausgeschalteten Betriebszustand befindet sich das Beleuchtungsmittel 2 beispielsweise tagsüber, bei Sonneneinstrahlung. Das Beleuchtungsmittel 2 dient in diesem Betriebszustand zum Lichtschutz und wirft einen Schatten 265. Das Beleuchtungsmittel 2 weist an seiner der Strahlungsaustrittsfläche 174 abgewandten Oberseite dazu eine beispielsweise reflektierende Oberfläche auf, die die auftreffende Strahlung 191 reflektiert. Darüber hinaus ist es möglich, dass das Beleuchtungsmittel 2 an seiner der Strahlungsaustrittsfläche 174 abgewandten Oberseite als Solarzelle ausgeführt ist, die beispielsweise bei Sonneneinstrahlung Strom erzeugt, mittels dem das Beleuchtungsmittel 2 später, beispielsweise nachts, betrieben werden kann. Zum Beispiel die Druckschrift US 7,317,210 zeigt eine Kombination von organischer Leuchtdiode und Solarzelle, die in diesem Fall zum Einsatz kommen kann.

In Verbindung mit der schematischen Darstellung der Figur 56B ist das Beleuchtungsmittel 2 in einem angeschalteten Betriebszustand gezeigt. Im angeschalteten Betriebszustand emittiert das Beleuchtungsmittel 2 von seiner Strahlungsaustrittsfläche 174 her elektromagnetische Strahlung 190. Das Beleuchtungsmittel 2 umfasst dabei vorzugsweise eine Vielzahl von organischen Leuchtdioden 1 oder zumindest eine organische Leuchtdiode 1, die in eine Vielzahl von Segmenten 203 unterteilt ist. Jedes der Segmente, oder jede organische Leuchtdiode 1, kann geeignet sein, Licht einer anderen Farbe oder einer anderen Farbtemperatur zu erzeugen, als andere Segmente 203, oder Leuchtdioden 1, des Beleuchtungsmittels 2. Je nach Betrieb der organischen Leuchtdioden 1 beziehungsweise der Segmente 203 können so unterschiedliche Lichtstimmungen mittels unterschiedlicher Farborte und/oder Farbtemperaturen des emittierten Lichts erzeugt werden. Die unterschiedlichen Farborte und/oder Farbtemperaturen können dabei auch in unterschiedlichen Bereichen des Beleuchtungsmittels 2 erzeugt werden. Das heißt, beispielsweise Bereiche der Strahlungsaustrittsfläche 174 können zum Beispiel eher rötliches Licht abstrahlen, wohingegen andere Bereiche der Strahlungsaustrittsfläche 174 zum Beispiel eher bläuliches Licht abstrahlen. Die Bereiche der Strahlungsaustrittsfläche 174 umfassen dabei vorzugsweise jeweils eine Vielzahl organischer Leuchtdioden 1 beziehungsweise Segmente 203.

Der Aufbau des Beleuchtungsmittels sowie die Kontaktierung der einzelnen organischen Leuchtdioden 1, beziehungsweise der Segmente 203, kann wie in Verbindung mit der Figur 45 beschrieben sein.

Als organische Leuchtdioden 1 kommen vorzugsweise organische Leuchtdioden 1 zur Verwendung, wie sie in Verbindung mit den Figuren 1 bis 31 beschrieben sind.

Bei dem Beleuchtungsmittel 2 handelt es sich um ein großflächiges Beleuchtungsmittel, das vorzugsweise einen Flächeninhalt der Strahlungsaustrittsfläche 174 von wenigstens 5 m², besonders bevorzugt von wenigstens 10 m² aufweist. Die Strahlungsaustrittsfläche 174 des Beleuchtungsmittels 2 setzt sich dabei aus den Strahlungsaustrittsflächen der organischen Leuchtdioden 1 beziehungsweise der Segmente 203 zusammen.

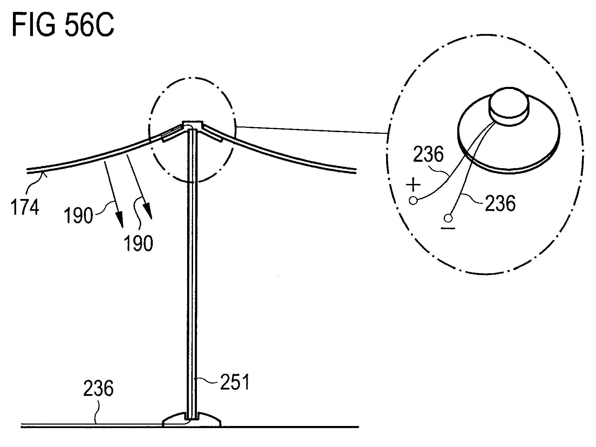

In Verbindung mit der Figur 56C ist schematisch dargestellt, dass eine Stromversorgung des Beleuchtungsmittels 2 über einen Ständer 251 erfolgen kann, in welchem Anschlussleiter 236 verlegt sind.

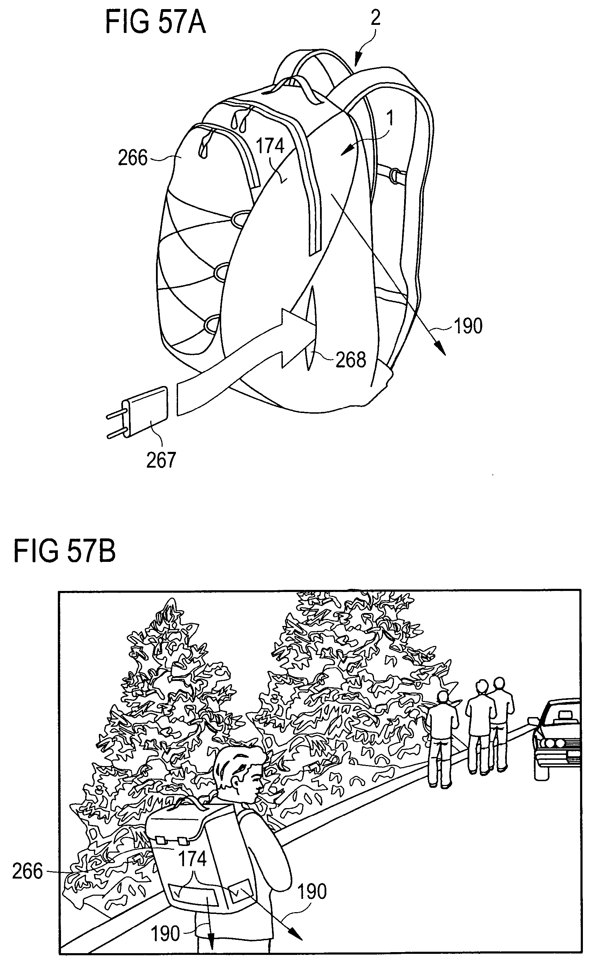

In Verbindung mit den Figuren 57A und 57B sind weitere Ausführungsbeispiele hier beschriebener Beleuchtungsmittel gezeigt. In diesen Ausführungsbeispielen ist das Beleuchtungsmittel 2 als Tasche 266 ausgeführt. Das Beleuchtungsmittel 2 kann beispielsweise als Rucksack oder als Schultasche Verwendung finden.

Dazu sind, zumindest auf Stellen der Tasche 266, organische Leuchtdioden 1 aufgebracht oder integriert. Die organischen Leuchtdioden 1 sind vorzugsweise flexibel ausgebildet, so dass sie sich den Konturen der Tasche 266 anpassen können. Das heißt, die Tasche 266 weist zumindest eine Strahlungseintrittsfläche 174 auf, durch die elektromagnetische Strahlung 190, vorzugsweise Licht, das Beleuchtungsmittel verlässt.

Das Beleuchtungsmittel 2 umfasst dabei zumindest eine organische Leuchtdiode 1, welche - wie in Verbindung mit den Figuren 29 und 30 beispielhaft beschrieben ist - einen Retro-Reflektor umfasst. Auf diese Weise reflektiert das Beleuchtungsmittel 2 auch bei nicht eingeschalteter organischer Leuchtdiode 1 auftreffende elektromagnetische Strahlung und dient somit auch in diesem Fall zur besseren Sichtbarkeit des Benutzers des Beleuchtungsmittels 2.

In Verbindung mit der schematischen Darstellung der Figur 57A ist ferner erläutert, dass die Tasche 266 beispielsweise einen Schlitz 286 aufweisen kann, in dem ein Akku 267 angeordnet ist, mittels dem die organische Leuchtdiode 1 des Beleuchtungsmittels 2 mit elektrischem Strom versorgt wird.

Alternativ oder zusätzlich zur Ausbildung des Beleuchtungsmittels 2 als Tasche ist es ferner denkbar, dass das Beleuchtungsmittel 2 als Schutzbekleidung, Arbeitsbekleidung, Stirnband, Kopfbedeckung oder dergleichen ausgeführt ist. In jedem Fall umfasst das Beleuchtungsmittel 2 zumindest eine organische Leuchtdiode 1, die einen Retro-Reflektor aufweist. Das Beleuchtungsmittel 2 dient somit sowohl im eingeschalteten als auch im ausgeschalteten Betriebszustand zur verbesserten Wahrnehmbarkeit seines Benutzers.

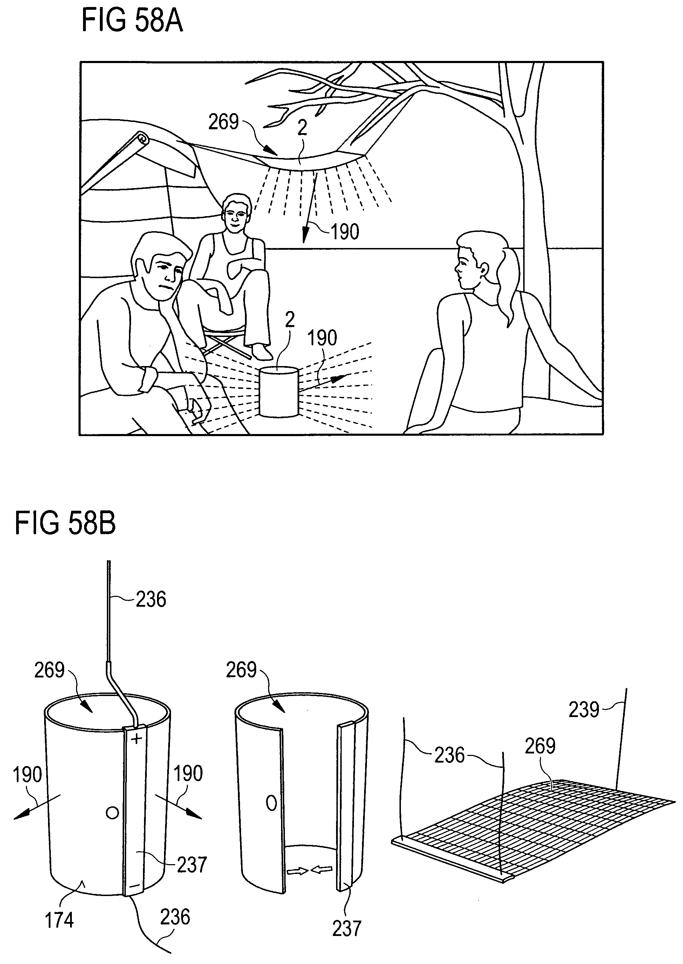

In Verbindung mit den schematischen Darstellungen der Figuren 58A und 58B sind weitere Ausführungsbeispiele eines hier beschriebenen Beleuchtungsmittels 2 näher erläutert. In diesen Ausführungsbeispielen dient das Beleuchtungsmittel 2 als Notbeleuchtung, beispielsweise als Campingleuchte.

Das Beleuchtungsmittel 2 weist eine Strahlungsaustrittsfläche 174 auf. Darüber hinaus weist das Beleuchtungsmittel 2 an der der Strahlungsaustrittsfläche 174 gegenüberliegenden Seite eine Solarzelle 269 auf. Bei der Solarzelle 269 kann es sich um eine folienartig ausgebildete, flexible anorganische oder organische Solarzelle handeln. Als Lichtquelle des Beleuchtungsmittels 2 dient zumindest eine flexible und vorzugsweise weißes Licht emittierende organische Leuchtdiode 1.

Das Beleuchtungsmittel 2 kann in zwei verschiedenen Betriebszuständen betrieben werden. Zum einen kann das Beleuchtungsmittel 2 zu einem Zylinder gerollt sein, der durch einen Verbinder 237 geschlossen ist. Am Verbinder 237 können sich Anschlussstellen zur Kontaktierung des Beleuchtungsmittels 2 über Anschlussleiter 236 befinden.

In einem anderen Betriebszustand kann das Beleuchtungsmittel 2 ausgerollt sein. In diesem Fall kann das Beleuchtungsmittel 2 beispielsweise über die Anschlussleiter 236 und gegebenenfalls einer Haltevorrichtung 239, die ebenfalls nach Art eines Drahtes oder Kabels ausgeführt sein kann, hängend betrieben werden. In Verbindung mit der Figur 58A ist beispielsweise dargestellt, dass das Beleuchtungsmittel 2 an den Ästen eines Baums hängt. Die Strahlungsaustrittsfläche 174 ist in diesem Fall dem Boden zugewandt, die Solarzelle 269 ist vom Boden weggerichtet.

Ein solches Beleuchtungsmittel 2 kann beispielsweise im hängenden Zustand, tagsüber, durch Sonneneinstrahlung geladen werden. Nachts gibt das Beleuchtungsmittel 2 dann kontinuierlich elektromagnetische Strahlung 190 durch die Strahlungsaustrittsfläche 174 ab. Das Beleuchtungsmittel 2 wird dabei vorzugsweise als Not- oder Campingbeleuchtung betrieben, so dass relativ geringe Leuchtdichten ausreichend sind.

Alternativ zu einem Solarbetrieb, der beispielsweise mittels eines in das Beleuchtungsmittel 2 integrierten Akkus realisiert sein kann, kann das Beleuchtungsmittel 2 über die Anschlussleiter 236 auch an eine externe Stromquelle, wie beispielsweise eine Autobatterie, angeschlossen werden.

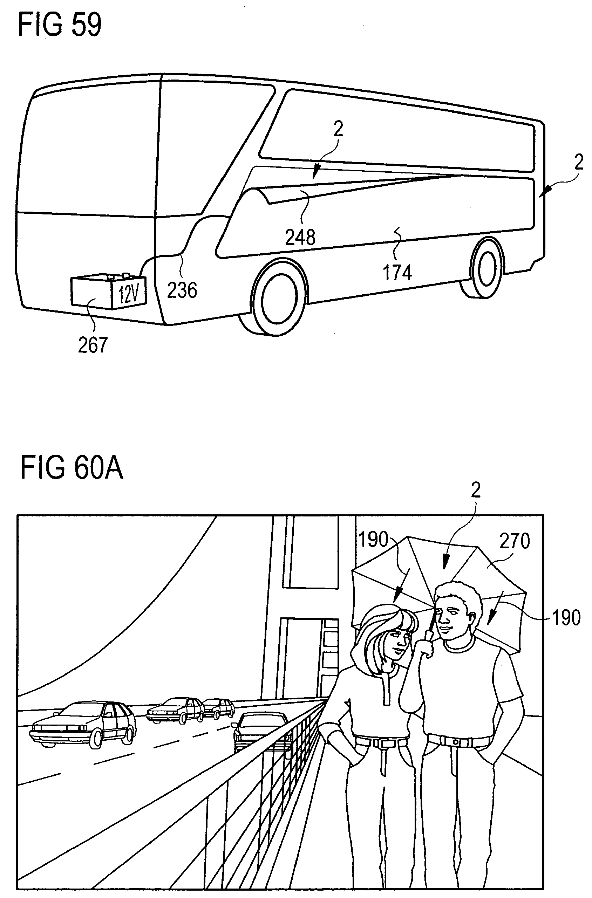

In Verbindung mit der Figur 59 ist anhand einer schematischen Perspektivdarstellung ein weiteres Ausführungsbeispiel eines hier beschriebenen Beleuchtungsmittels 2 näher erläutert. Bei dem Beleuchtungsmittel 2 handelt es sich um ein großflächiges Beleuchtungsmittel, das beispielsweise mittels eines Akkus 267 - vorliegend einer Autobatterie - betreibbar ist. Das Beleuchtungsmittel weist eine Strahlungsaustrittsfläche 174 auf. Das Beleuchtungsmittel ist beispielsweise mittels des Befestigungsmittels 248 an einem Kraftfahrzeug wie einem Automobil oder einem Bus befestigt. Bei dem Befestigungsmittel 248 kann es sich um einen Magneten oder um eine Klebeverbindung handeln.

Das Beleuchtungsmittel 2 umfasst vorzugsweise zumindest eine organische Leuchtdiode 1, wie sie hier beschrieben ist. Bei der organischen Leuchtdiode 1 kann es sich um eine flexible organische Leuchtdiode 1 handeln, die eine zu beleuchtende Fläche 185a beleuchtet. Bei der zu beleuchtenden Fläche 185a handelt es sich beispielsweise um ein Werbeplakat oder ein Firmenlogo. Das Beleuchtungsmittel 2 kann somit zu Werbezwecken auf Kraftfahrzeugen Verwendung finden.

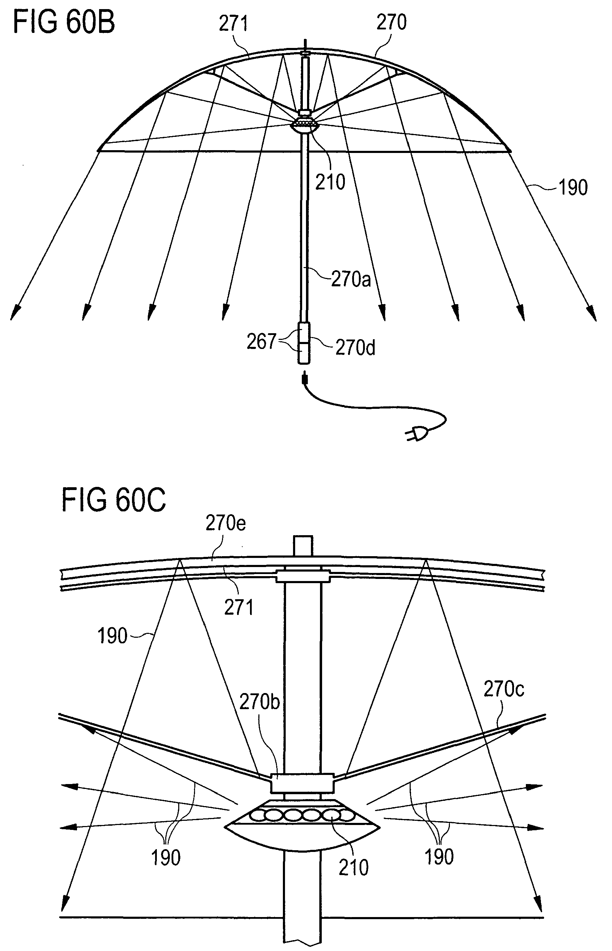

In Verbindung mit den Figuren 60A bis 60D ist ein weiteres Ausführungsbeispiel eines hier beschriebenen Beleuchtungsmittels näher erläutert. Das Beleuchtungsmittel 2 bildet in diesem Fall einen Regenschirm 270. Der Regenschirm 270 strahlt von seiner Innenfläche her elektromagnetische Strahlung 190 ab.

Dies kann zum einen dadurch realisiert sein, dass das Beleuchtungsmittel 2 zumindest eine organische Leuchtdiode 1 umfasst, die flexibel ausgeführt ist. Die organische Leuchtdiode 1 kann sich dann an der Innenseite der Krone des Regenschirms 270 befinden oder die Krone des Regenschirms 270 bilden.

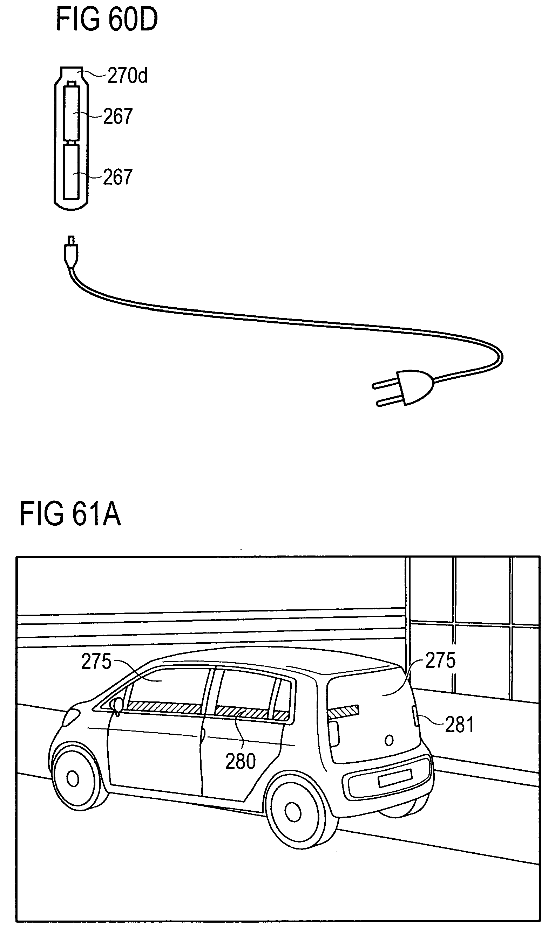

Beispielsweise erfolgt ein elektrisches Kontaktieren der zumindest einen organischen Leuchtdiode 1 durch die Verstrebungen oder Paragonstangen 270a des Regenschirms 270. Ein Bestromen der organischen Leuchtdiode 1 des Regenschirms 270 kann dann über zumindest einen Akku 267 erfolgen, der im Knauf oder Griff 270d des Regenschirms 270 angeordnet sein kann (vergleiche beispielsweise die Figur 60D).

Alternativ oder zusätzlich zu zumindest einer organischen Leuchtdiode 1 ist es möglich, dass der Regenschirm 270 zumindest eine anorganische Leuchtdiode 210 als Lichtquelle umfasst. Die zumindest eine anorganische Leuchtdiode 210 ist beispielsweise am oder im Stock 270a des Regenschirms 270 befestigt. Beispielsweise sind die anorganischen Leuchtdioden 210 am Schieber 270b oder unterhalb des Schiebers 270b des Regenschirms 270 befestigt. Die anorganischen Leuchtdioden 210 strahlen auf die Innenseite der Krone 270e des Regenschirms 270 ab, die als Reflektor 271 oder organische Leuchtdiode 1 mit einer reflektierenden Schicht ausgebildet ist.

Der Reflektor 271 kann dabei derart ausgebildet sein, dass er elektromagnetische Strahlung 190 gerichtet abstrahlt. Dadurch ist es möglich, dass der Regenschirm bei senkrechtem Halten in Bewegungsrichtung des Benutzers strahlt und auf diese Weise den vor dem Benutzer liegenden Weg ausleuchtet.

Vorzugsweise sind die anorganischen Leuchtdioden 210 fest mit dem Schieber 270b des Regenschirms 270 verbunden, so dass sie beim Öffnen des Regenschirms 270 in eine Position befördert werden, die dicht unterhalb der Krone 270e des Regenschirms 270 liegt. Ein Einschalten der Beleuchtung durch die anorganischen Leuchtdioden 210 kann dann gleichzeitig mit dem Hochschieben des Schiebers 270b erfolgen. Es ist jedoch auch möglich, dass die Beleuchtung separat eingeschaltet werden kann, so dass sie beispielsweise nur bei schlechten Sichtverhältnissen aktiviert wird.

In Verbindung mit der Figur 60d ist schematisch dargestellt, dass zumindest ein Akku 267 als Stromversorgung für die Lichtquellen des einen Regenschirm 270 bildenden Beleuchtungsmittels 2 im Griff 207d des Regenschirms angeordnet sein kann. Dies kann beispielsweise durch den Anschluss an eine elektrische Stromversorgung aufgeladen werden. Insgesamt stellt das Beleuchtungsmittel 2 des Ausführungsbeispiels der Figuren 60A bis 60D eine mobile Leuchte dar, die dem Benutzer bei schlechten Sichtverhältnissen auch im Straßenverkehr eine verbesserte Sichtbarkeit und eine verbesserte Sicht ermöglicht.

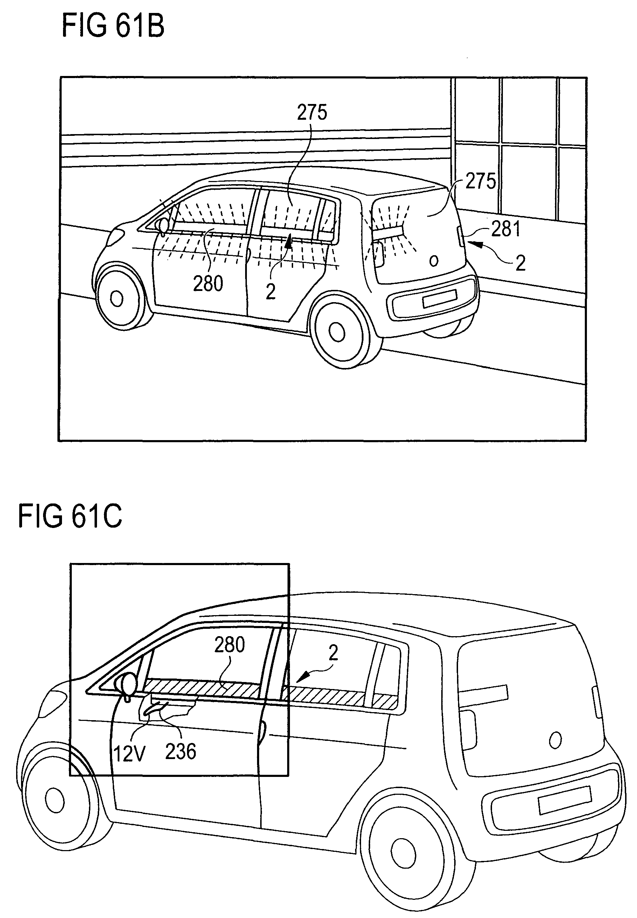

Die Figuren 61A bis 61C zeigen ein weiteres Ausführungsbeispiel eines hier beschriebenen Beleuchtungsmittels 2 in schematischen Darstellungen.

Bei dem Beleuchtungsmittel 2 handelt es sich vorliegend um eine Fahrzeugleuchte, wie beispielsweise eine Bremsleuchte, ein Blinklicht 280 und/oder ein Rücklicht 281. Den genannten Fahrzeugleuchten ist dabei gemein, dass sie in einem Fahrzeugfenster 275 integriert sind. Die Beleuchtungsmittel 2 umfassen beispielsweise eine transparente organische Leuchtdiode, deren erster Träger 130 und zweiter Träger 131 jeweils mit einem Glas gebildet ist. Die organischen Leuchtdioden 1 sind also als transparente organische Leuchtdioden in Teile der Fahrzeugfenster 275 integriert. Auf diese Weise lässt sich beispielsweise ein Blinklicht 280 bilden, das sich über die gesamte Länge des Fahrzeugs erstrecken kann. Dies erhöht die Aufmerksamkeit des Fahrzeugs im Straßenverkehr.

Als organische Leuchtdiode 1 für das als Fahrzeugleuchte ausgebildete Beleuchtungsmittel 2 kommen zum Beispiel die in Verbindung mit den Figuren 1 bis 31 beschriebenen organischen Leuchtdioden 1 zur Verwendung.

Handelt es sich bei dem Beleuchtungsmittel 2 um ein Rücklicht 281 oder ein Bremslicht, so kann das Beleuchtungsmittel eine organische Leuchtdiode 1 mit einem Retro-Reflektor umfassen, wie sie beispielsweise in Verbindung mit den Figuren 29 und 30 näher erläutert ist. Das Beleuchtungsmittel 2 kann dabei auch im ausgeschalteten Betriebszustand rotes Licht, beispielsweise bei Bestrahlung mit einem Autoscheinwerfer, zurückreflektieren.

Wie in Verbindung mit der schematischen Darstellung der Figur 61C erläutert ist, kann das Beleuchtungsmittel 2 über Anschlussleiter 236 mit der Autobatterie des Kraftfahrzeuges zur Stromversorgung verbunden sein.

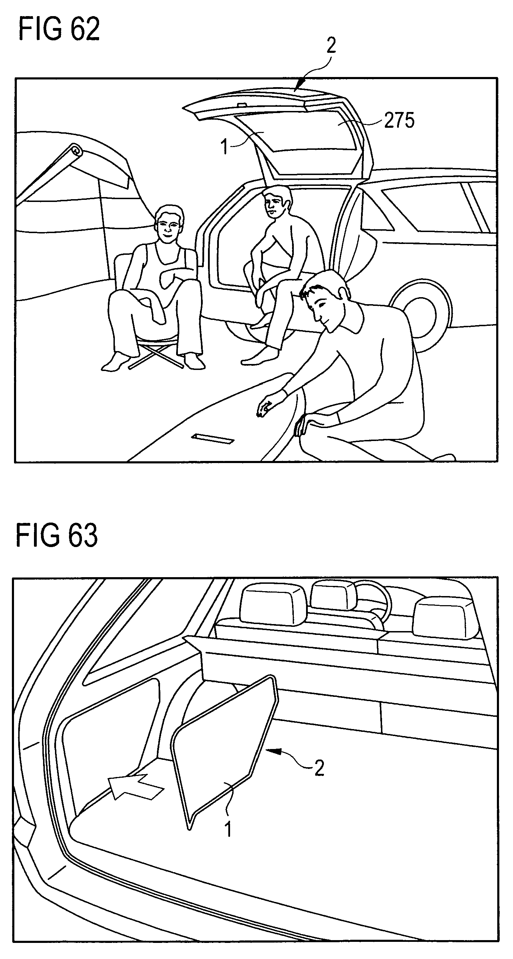

In Verbindung mit der Figur 62 ist anhand einer schematischen perspektivischen Darstellung ein weiteres Ausführungsbeispiel eines hier beschriebenen Beleuchtungsmittels näher erläutert. In diesem Ausführungsbeispiel ist zur Bildung des Beleuchtungsmittels 2 eine transparente organische Leuchtdiode ganzflächig in ein Fahrzeugfenster 275 - hier in das Heckfenster - integriert. Das heißt, das Heckfenster 275 ist durch eine transparente, organische Leuchtdiode 1 gebildet. Ein solches Beleuchtungsmittel 2 kann beispielsweise zur Beleuchtung des Innenraums eines Kofferraums dienen, wenn das Fahrzeug nicht fährt.

Darüber hinaus ist es möglich, dass die organische Leuchtdiode 1 ein Emittermaterial enthält, das zur Erzeugung von infraroter elektromagnetischer Strahlung geeignet ist. In diesem Fall kann die organische Leuchtdiode 1 auch zum Enteisen eines Fahrzeugfensters 275 Verwendung finden. Die organische Leuchtdiode 1 muss dann nicht zwingend auch zur Erzeugung von sichtbarem Licht geeignet sein. Insbesondere ist es in diesem Fall möglich, dass sämtliche Fahrzeugfenster 275 des Kraftfahrzeuges durch transparente organische Leuchtdioden gebildet sind, die im Betrieb zur Erzeugung von infraroter elektromagnetischer Strahlung geeignet sind. Auf diese Weise ist beispielsweise auch das Heizen eines Frontfensters des Kraftfahrzeuges möglich, ohne dass Heizdrähte das Fenster durchziehen oder im Fahrzeug ein Gebläse angeordnet sein muss, das das Fahrzeugfenster 275 mit heißer Luft bebläst. Auch das Beschlagen der Fahrzeugfenster 275 kann auf diese Weise verhindert werden.

Mittels einer optischen Kavität, wie sie in Verbindung mit den Figuren 26 und 27 näher erläutert ist, ist es möglich, dass die gesamte oder zumindest ein Großteil der erzeugten Infrarotstrahlung nach außen, aus dem Fahrzeug raus gerichtet wird. In diesem Fall kann beispielsweise auf den Fahrzeugfenstern 275 liegender Schnee besonders effizient abgeschmolzen werden.

In Verbindung mit der Figur 63 ist anhand einer schematischen Perspektivdarstellung ein weiteres Ausführungsbeispiel eines hier beschriebenen Beleuchtungsmittels 2 näher erläutert. In diesem Fall ist zur Bildung des Beleuchtungsmittels 2 eine organische Leuchtdiode 1 in Seitenflächen eines Kofferraums integriert. Die organische Leuchtdiode 1 ist rein beispielhaft in die Seitenflächen eines Kofferraums integriert. Prinzipiell ist es möglich, eine organische Leuchtdiode 1 an jeder Stelle des Innenraums des Kraftfahrzeuges anzubringen. Insbesondere kann eine organische Leuchtdiode 1 auch an die Innenseite des Fahrzeugdaches oder in den Kofferraumboden integriert sein. Die organische Leuchtdiode 1 erlaubt ein großflächiges Ausleuchten des Innenraums des Kraftfahrzeuges, ohne dass dazu - aufgrund der relativ großen Fläche der Lichtaustrittsfläche 175 der organischen Leuchtdiode 1 - hohe Leuchtdichten Verwendung finden müssen. Das bedeutet, die organische Leuchtdiode 1 erlaubt ein Ausleuchten des Innenraums des Kraftfahrzeuges mit relativ geringen Leuchtdichten, so dass eine blendfreie Beleuchtung gegeben ist.

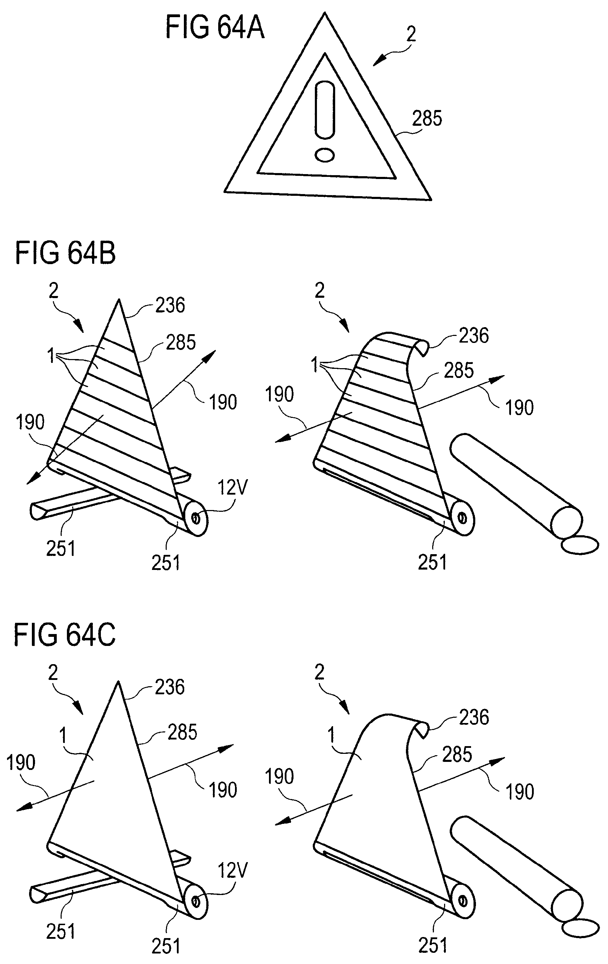

In Verbindung mit den Figuren 64A bis 64C ist anhand schematischer Darstellungen ein weiteres Ausführungsbeispiel eines hier beschriebenen Beleuchtungsmittels näher erläutert. In diesem Ausführungsbeispiel bildet das Beleuchtungsmittel 2 ein Warnschild 285, wie es beispielsweise im Straßenverkehr Verwendung finden kann. Das Warnschild 285 ist dabei, wie in den Figuren 64B und 64C gezeigt, flexibel ausgebildet, so dass es aufrollbar und abrollbar ist. In der Figur 64B ist erläutert, dass das Warnschild 285 dazu in einzelne organische Leuchtdioden 1 aufgeteilt sein kann, die mittels flexibler, auf- und abrollbarer Anschlussleiter 236 miteinander verbunden sind.

In Verbindung mit der Figur 64C ist gezeigt, dass das Warnschild 285 auch durch eine voll flexible organische Leuchtdiode 1 gebildet sein kann.

In beiden Ausführungsformen des Warnschildes 285 kann es sinnvoll sein, dass das Warnschild 285 von zwei Hauptflächen elektromagnetische Strahlung emittiert. Das heißt, das Warnschild 285 ist beispielsweise von zwei Seiten aktiv leuchtend. Zur Bildung des Warnschildes 285 kommt beispielsweise zumindest eine organische Leuchtdiode 1 mit Retro-Reflektor zur Anwendung, wie sie in den Figuren 29 und 30 näher erläutert ist. Insbesondere ist es möglich, dass das Warnschild 285 solche organische Leuchtdioden 1 an beiden Seiten aufweist, so dass es von beiden Seiten aktiv elektromagnetische Strahlung 190 abstrahlt und reflektiert.

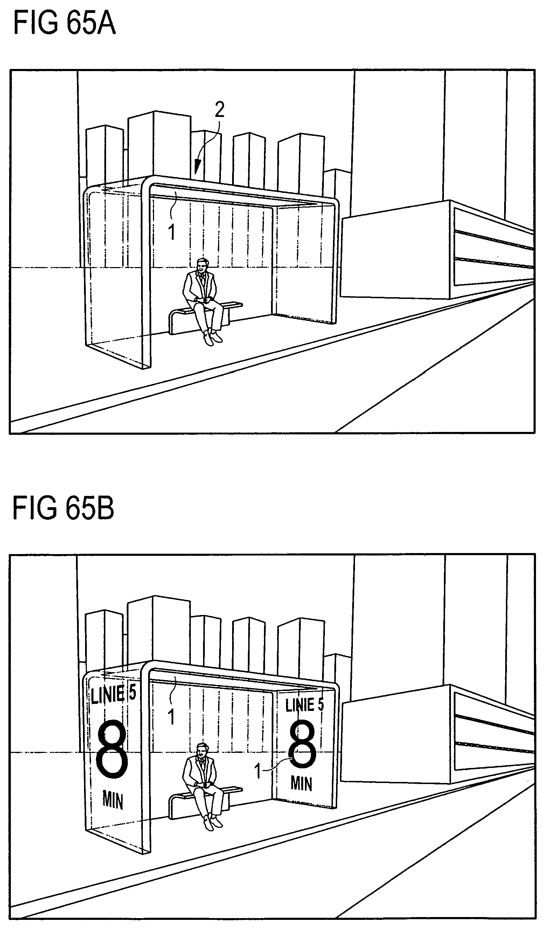

In Verbindung mit den Figuren 65A bis 65C sind weitere Ausführungsbeispiele eines hier beschriebenen Beleuchtungsmittels 2 näher erläutert. In diesem Ausführungsbeispiel bildet das Beleuchtungsmittel 2 einen Regenschutz, beispielsweise ein Bushäuschen. Das Beleuchtungsmittel 2 kann dabei mehrere organische Leuchtdioden 1 umfassen, die transparent ausgeführt sind. Beispielsweise bilden die Träger 130, 131 des Beleuchtungsmittels 2 den Grundkörper des Bushäuschens und damit den Regenschutz aus. Eine Verkapselung kann dann wie in Verbindung mit dem als Duschkabine ausgebildeten Beleuchtungsmittel 2 (vergleiche die Figuren 33 bis 35) ausgeführt sein.

Ferner ist es auch möglich, wie in Figur 65B angedeutet, dass zumindest eine der organischen Leuchtdioden 1 als großflächige Anzeigevorrichtung (Display) ausgebildet ist, die beispielsweise die nächsten Verkehrsverbindungen, die Uhrzeit, die Außentemperatur oder weitere einfache Informationen anzeigen kann.

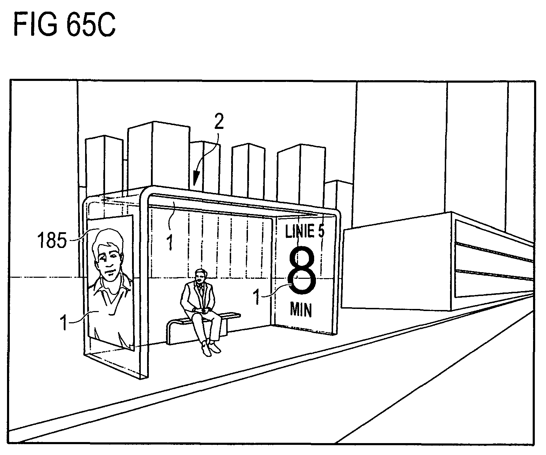

Schließlich ist es auch möglich, wie in Verbindung mit der Figur 65C näher beschrieben, dass eines der Beleuchtungsmittel 2 zur Ausleuchtung einer zu beleuchtenden Fläche 185a dient. Bei der zu beleuchtenden Fläche 185a handelt es sich beispielsweise um ein Werbemittel wie ein Poster oder dergleichen. Das zu beleuchtende Element 185 ist dabei austauschbar, so dass die zu beleuchtende Fläche 185a von Zeit zu Zeit gewechselt werden kann.

Diese Patentanmeldung beansprucht die Priorität der deutschen Patentanmeldung 102008061563.3.

Die Erfindung ist nicht durch die Beschreibung anhand der Ausführungsbeispiele auf diese beschränkt, sondern wird durch die Ansprüche definiert.

## Patentansprüche

1. Beleuchtungsmittel (2) mit Weckfunktion mit
- zumindest einer transparenten, klarsichtigen organischen Leuchtdiode (1),
- zumindest einer Ansteuervorrichtung (201), und
- zumindest einem berührungssensitiven Bedienelement (197), wobei
- die zumindest eine organische Leuchtdiode (1) dazu eingerichtet ist, weißes Licht zu emittieren,
- die zumindest eine organische Leuchtdiode einen strahlungsemittierenden Bereich (104) mit mehreren Emissionsschichten (111, 112, 113) umfasst,
- zumindest eine erste der Emissionsschichten (111) dazu eingerichtet ist, rotes Licht zu emittieren und ein phosphoreszentes Emittermaterial enthält,
- zumindest eine zweite der Emissionsschichten (112) dazu eingerichtet ist, grünes Licht zu emittieren,
- zumindest eine dritte der Emissionsschichten (113) dazu eingerichtet ist, blaues Licht zu emittieren und ein fluoreszentes Emittermaterial enthält,
- die zumindest eine organische Leuchtdiode (1) zumindest eine Verkapselung (160) umfasst, die eine Versiegelung des strahlungsemittierenden Bereiches (104) vor Umwelteinflüssen bildet,
- die zumindest eine Ansteuervorrichtung (201) dazu eingerichtet ist, die Lichtstärke des von der organischen Leuchtdiode (1) emittierten Lichts ab einer vorgebbaren Weckzeit (t1) zu erhöhen,
- das zumindest eine berührungssensitive Bedienelement (197) zumindest einen Berührungssensor umfasst, der in die zumindest eine organische Leuchtdiode (1) integriert ist,
- mit dem zumindest einen berührungssensitiven Bedienelement (197) die Weckzeit (t1) vorgebbar ist, und
- das Beleuchtungsmittel (2) dazu eingerichtet ist, Licht mit einer maximalen Lichtstärke (Imax) von wenigstens 1000 cd zu emittieren.

2. Beleuchtungsmittel (2) nach dem vorherigen Anspruch, bei dem die Ansteuervorrichtung (201), eingerichtet ist, ab der Weckzeit (t1) die Lichtstärke (I) des von der organischen Leuchtdiode (1) emittierten Lichts stufenweise zu erhöhen, wobei für vorgebbare Zeiten vom Beleuchtungsmittel (2) Licht einer konstanten Lichtstärke erzeugt wird, die in vorgebbaren Zeitintervallen (t2) erhöht wird.

3. Beleuchtungsmittel (2) nach einem der vorherigen Ansprüche,
bei dem das Beleuchtungsmittel (2) dazu eingerichtet ist, weißes Licht mit Farbtemperaturen (T) von wenigstens 4000K und höchstens 25000 K zu erzeugen und die Ansteuervorrichtung (197) dazu eingerichtet ist, die Farbtemperatur (T) des vom Beleuchtungsmittel (2) emittierten Lichts zu erhöhen.

4. Beleuchtungsmittel (2) nach einem der vorherigen Ansprüche,
bei dem die Ansteuervorrichtung dazu eingerichtet ist, die Lichtstärke (I) sowie die Farbtemperatur (T) des vom Beleuchtungsmittel im Betrieb erzeugten Lichts zu erhöhen, wobei mit der Erhöhung der Lichtintensität (I) eine Erhöhung der Farbtemperatur (T) erfolgt.

5. Beleuchtungsmittel (2) nach einem der vorherigen Ansprüche,
bei dem das Beleuchtungsmittel dazu eingerichtet ist, einen Sonnenaufgang im Zeitraffer zu simulieren.

6. Beleuchtungsmittel (2) nach einem der Ansprüche 3 bis 5, bei dem das Beleuchtungsmittel in eine Vielzahl von Segmenten (203) unterteilt ist, die unabhängig voneinander ansteuerbar sind und dazu eingerichtet sind, elektromagnetische Strahlung mit unterschiedlichen Wellenlängen zu emittieren.

7. Beleuchtungsmittel (2) nach einem der vorherigen Ansprüche,
bei dem die zumindest eine organische Leuchtdiode (1) eine beidseitig emittierende organische Leuchtdiode (1) ist.

8. Beleuchtungsmittel (2) nach einem der vorherigen Ansprüche,
bei dem zumindest eine der Emissionsschichten (112), ein Loch transportierendes Matrixmaterial und ein Elektronen transportierendes Matrixmaterial umfasst.

9. Beleuchtungsmittel nach Anspruch 1, bei dem
- die erste Emissionsschicht (111) im Betrieb rotes Licht emittiert und mit Ir(DBQ)₂acac (Iridium(III)bis(2-methyldibenzo-[f,h]quinoxalin)(acetylacetonat)) als Emittermaterial gebildet ist,
- die zweite Emissionsschicht (112) im Betrieb grünes Licht emittiert und mit Irppy (fac-Tris(2-phenyl-pyridyl)-iridium) als Emittermaterial gebildet ist, und
- die dritte Emissionsschicht (113) im Betrieb blaues Licht emittiert und mit DPVBi (4,4'-Bis(2,2-diphenyl-ethen-1-yl)-diphenyl) als Emittermaterial gebildet ist.

10. Beleuchtungsmittel nach Anspruch 1, bei dem
- das Beleuchtungsmittel (2) dazu eingerichtet ist, weißes Licht mit Farbtemperaturen (T) von wenigstens 4000K und höchstens 25000 K zu erzeugen und die Ansteuervorrichtung (197) dazu eingerichtet ist, die Farbtemperatur (T) des vom Beleuchtungsmittel (2) emittierten Lichts zu erhöhen, und
- das Beleuchtungsmittel in eine Vielzahl von Segmenten (203) unterteilt ist, die unabhängig voneinander ansteuerbar sind und dazu eingerichtet sind, elektromagnetische Strahlung mit unterschiedlichen Wellenlängen zu emittieren.

## Claims

1. Luminaire (2) with wake-up function comprising
- at least one transparent, pellucid organic light-emitting diode (1),
- at least one driving device (201), and
- at least one touch-sensitive operating element (197),
wherein
- the at least one organic light-emitting diode (1) is designed to emit white light,
- the at least one organic light-emitting diode comprises a radiation-emitting region (104) having a plurality of emission layers (111, 112, 113),
- at least a first one of the emission layers (111) is designed to emit red light and contains a phosphorescent emitter material,
- at least a second one of the emission layers (112) is designed to emit green light,
- at least a third one of the emission layers (113) is designed to emit blue light and contains a fluorescent emitter material,
- the at least one organic light-emitting diode (1) comprises at least one encapsulation (160) which forms a seal of the radiation-emitting region (104) against environmental influences,
- the at least one driving device (201) is designed to increase the light intensity of the light emitted by the organic light-emitting diode (1) starting from a predeterminable wake-up time (t1),
- the at least one touch-sensitive operating element (197) comprises at least one touch sensor integrated into the at least one organic light-emitting diode (1),
- the wake-up time (t1) can be predetermined by means of the at least one touch-sensitive operating element (197),
- the luminaire (2) is designed to emit light with a maximum light intensity (Imax) of at least 1000 cd.

2. Luminaire (2) according to the preceding claim,
wherein the driving device (201) is designed to increase the light intensity (I) of the light emitted by the organic light-emitting diode (1) in steps starting from the wake-up time (t1), wherein, for predeterminable times, the luminaire (2) generates light having a constant light intensity, which is increased in predeterminable time intervals (t2).

3. Luminaire (2) according to either of the preceding claims,
wherein the luminaire (2) is designed to generate white light having color temperatures (T) of at least 4000 K and at most 25 000 K, and the driving device (197) is designed to increase the color temperature (T) of the light emitted by the luminaire (2).

4. Luminaire (2) according to any of the preceding claims,
wherein the driving device is designed to increase the light intensity (I) and also the color temperature (T) of the light generated by the luminaire during operation, wherein the color temperature (T) is increased as the light intensity (I) is increased.

5. Luminaire (2) according to any of the preceding claims,
wherein the luminaire is designed to simulate a sunrise in time-lapse fashion.

6. Luminaire (2) according to any of Claims 3 to 5,
wherein the luminaire is subdivided into a multiplicity of segments (203) which can be driven independently of one another and are designed to emit electromagnetic radiation having different wavelengths.

7. Luminaire (2) according to any of the preceding claims,
wherein the at least organic light-emitting diode (1) is a organic light-emitting diode (1) which emits on both sides.

8. Luminaire (2) according to any of the preceding claims,
wherein at least one of the emission layers (112) comprises a hole transporting matrix material and an electron transporting matrix material.

9. Luminaire according to Claim 1, wherein
- the first emission layer (111) emits red light during operation and is formed with Ir(DBQ)₂acac (iridium(III)bis(2-methyldibenzo-[f,h]quinoxaline)(acetyl acetonate)) as emitter material,
- the second emission layer (112) emits green light during operation and is formed with Irppy (fac-tris(2-phenylpyridyl)iridium) as emitter material, and
- the third emission layer (113) emits blue light during operation and is formed with DPVBi (4,4'-bis(2,2-diphenylethen-1-yl)diphenyl) as emitter material.

10. Luminaire according to Claim 1, wherein
- the luminaire (2) is designed to generate white light having color temperatures (T) of at least 4000 K and at most 25 000 K, and the driving device (197) is designed to increase the color temperature (T) of the light emitted by the luminaire (2), and
- the luminaire is subdivided into a multiplicity of segments (203) which can be driven independently of one another and are designed to emit electromagnetic radiation having different wavelengths.

## Revendications

1. Moyen d'éclairage (2) à fonction de réveil, comportant
- au moins une diode électroluminescente organique (1) transparente et translucide,
- au moins un dispositif de commande (201), et
- au moins un élément de commande tactile (197), dans lequel
- l'au moins une diode électroluminescente organique (1) est conçue pour émettre de la lumière blanche,
- l'au moins une diode électroluminescente organique comprend une région d'émission de rayonnement (104) ayant plusieurs couches d'émission (111, 112, 113),
- au moins une première des couches d'émission (111) est conçue pour émettre de la lumière rouge et contient un matériau émetteur phosphorescent,
- au moins une deuxième des couches d'émission (112) est conçue pour émettre de la lumière verte,
- au moins une troisième des couches d'émission (113) est conçue pour émettre de la lumière blanche et contient un matériau émetteur fluorescent,
- l'au moins une diode électroluminescente organique (1) comprend au moins une encapsulation (160) qui forme un scellement de la région émettant un rayonnement (104) contre les influences de l'environnement,
- l'au moins un dispositif de commande (201) est conçu pour augmenter l'intensité lumineuse de la lumière émise par la diode électroluminescente organique (1) à partir d'un temps d'éveil pouvant être prédéterminé (t1),
- l'au moins un élément de commande tactile (197) comprend au moins un capteur tactile qui est intégré à l'au moins une diode électroluminescente organique (1),
- le temps d'éveil (t1) peut être prédéterminé au moyen de l'au moins un élément de commande tactile (197), et
- le moyen d'éclairage (2) est conçu pour émettre une lumière ayant une intensité maximale (Imax) d'au moins 1000 cd.

2. Moyen d'éclairage (2) selon la revendication précédente, dans lequel le dispositif de commande (201) est conçu pour augmenter par pas successifs l'intensité lumineuse (I) de la lumière émise par la diode électroluminescente organique (1) à partir du temps d'éveil (t1), dans lequel, pendant des temps pouvant être prédéterminés, une intensité lumineuse constante est générée par le moyen d'éclairage (2), laquelle intensité lumineuse est augmentée à des intervalles de temps pouvant être prédéterminés (t2).

3. Moyen d'éclairage (2) selon l'une quelconque des revendications précédentes,
dans lequel le moyen d'éclairage (2) est conçu pour générer une lumière blanche ayant des températures de couleur (T) d'au moins 4000 K et d'au plus 25000 K et le dispositif de commande (197) est conçu pour augmenter la température de couleur (T) de la lumière émise par le moyen d'éclairage (2).

4. Moyen d'éclairage (2) selon l'une quelconque des revendications précédentes,
dans lequel le dispositif de commande est conçu pour augmenter l'intensité lumineuse (I) et la température de couleur (T) de la lumière générée par le moyen d'éclairage lors de son fonctionnement, dans lequel une augmentation de la température de couleur (T) se produit en association avec l'augmentation de l'intensité lumineuse (I).

5. Moyen d'éclairage (2) selon l'une quelconque des revendications précédentes,
dans lequel le moyen d'éclairage est conçu pour simuler un lever de soleil accéléré.

6. Moyen d'éclairage (2) selon l'une quelconque des revendications 3 à 5,
dans lequel le moyen d'éclairage est subdivisé en une pluralité de segments (203) qui peuvent être commandés indépendamment les uns des autres et sont conçus pour émettre un rayonnement électromagnétique ayant des longueurs d'onde différentes.

7. Moyen d'éclairage (2) selon l'une quelconque des revendications précédentes,
dans lequel l'au moins une diode électroluminescente organique (1) est une diode électroluminescente organique (1) émettant par ses deux faces.

8. Moyen d'éclairage (2) selon l'une quelconque des revendications précédentes,
dans lequel l'au moins une des couches d'émission (112) comprend un matériau de matrice transportant des trous et un matériau de matrice transportant des électrons.

9. Moyen d'éclairage selon la revendication 1, dans lequel
- la première couche d'émission (111) émet de la lumière rouge lors de son fonctionnement et est constituée d'Ir(DBQ)₂acac (Iridium(III)bis(2-méthyldibenzo-[f,h]quinoxaline)(acétylacétonate)) en tant que matériau émetteur,
- la deuxième couche d'émission (112) émet de la lumière verte lors de son fonctionnement et est constituée d'Irppy (fac-Tris(2-phényl-pyridyle)-iridium) en tant que matériau émetteur, et
- la troisième couche d'émission (113) émet de la lumière bleue lors de son fonctionnement et est constituée de DPVBi (4,4'-bis(2,2-diphényl-éthén-1-yl)-diphényl) en tant que matériau émetteur.

10. Moyen d'éclairage selon la revendication 1, dans lequel
- le moyen d'éclairage (2) est conçu pour générer une lumière blanche ayant des températures de couleur (T) d'au moins 4000 K et d'au plus 25000 K et le dispositif de commande (197) est conçu pour augmenter la température de couleur (T) de la lumière émise par le moyen d'éclairage (2), et
- le moyen d'éclairage est subdivisé en une pluralité de segments (203) qui peuvent être commandés indépendamment les uns des autres et qui sont conçus pour émettre un rayonnement électromagnétique ayant des longueurs d'onde différentes.
